Europäisches Patentamt

European Patent Office

Office européen des brevets

(19)

(11) **EP 1 355 456 A1**

(12) **EUROPEAN PATENT APPLICATION**

(43) Date of publication:
**22.10.2003 Bulletin 2003/43**

(51) Int Cl.⁷: **H04L 12/64**

(21) Application number: **02008171.7**

(22) Date of filing: **16.04.2002**

(84) Designated Contracting States:
**AT BE CH CY DE DK ES FI FR GB GR IE IT LI LU MC NL PT SE TR**
Designated Extension States:
**AL LT LV MK RO SI**

(71) Applicants:
- **ROBERT BOSCH GMBH**
  **70442 Stuttgart (DE)**
- **DaimlerChrysler AG**
  **70567 Stuttgart (DE)**
- **BMW AG**
  **80788 München (DE)**
- **MOTOROLA, INC.**
  **Schaumburg, IL 60196 (US)**
- **General Motors Corporation**
  **Warren, MI 48090-9010 (US)**
- **Philips Intellectual Property & Standards GmbH**
  **20099 Hamburg (DE)**
  Designated Contracting States:
  **DE**
- **Koninklijke Philips Electronics N.V.**
  **5621 BA Eindhoven (NL)**
  Designated Contracting States:
  **AT BE CH CY DK ES FI FR GB GR IE IT LI LU MC NL PT SE TR**

(72) Inventors:
- **Forest, Thomas M.**
  **Macomb, MI 48042-2243 (US)**
- **Hedenetz, Bernd**
  **73770 Dekendorf (DE)**
- **Rausch, Mathias**
  **85570 Marktschwaben (DE)**
- **Temple, Christopher**
  **81825 München (DE)**
- **Eisele, Harald**
  **25421 Pinneberg (DE)**
- **Elend, Bernd**
  **22299 Hamburg (DE)**
- **Ungermann, Jörn**
  **22299 Hamburg (DE)**

- **Kühlewein, Matthias**
  **72070 Tübingen (DE)**
- **Belschner, Ralf**
  **72124 Pliezhausen (DE)**
- **Lohrmann, Peter**
  **73054 Eislingen (DE)**
- **Bogenberger, Florian**
  **81125 München (DE)**
- **Wuerz, Thomas**
  **85586 Poing (DE)**
- **Millsap, Arnold**
  **Leonard, MI 48367 (US)**
- **Heuts, Patrick**
  **6581 SJ Malden (NL)**
- **Hugel, Robert**
  **76199 Karlsruhe (DE)**
- **Führer, Thomas**
  **70839 Gerlingen (DE)**
- **Müller, Bernd**
  **71229 Leonberg (DE)**
- **Hartwich, Florian**
  **72762 Reutlingen (DE)**
- **Zinke, Manfred**
  **52066 Aachen (DE)**
- **Berwanger, Josef**
  **85586 Poing (DE)**
- **Ebner, Christian**
  **80997 München (DE)**
- **Weiler, Harald**
  **73033 Göppingen (DE)**
- **Fuhrmann, Peter**
  **52080 Aachen (DE)**
- **Schedl, Anton**
  **80798 München (DE)**
- **Peller, Martin**
  **80796 München (DE)**

(74) Representative: **Wörz, Volker**
**Dreiss, Fuhlendorf,**
**Steimle & Becker,**
**Postfach 10 37 62**
**70032 Stuttgart (DE)**

(54) **FlexRay communication protocol**

(57)     A Network-system with at least one node, whereby the at least one node is coupled to a communication line and with means for communication which are able to create a communication cycle on said com-

munication line whereby said communication cycle consists at least of a static segment and/or a dynamic segment and respective device, especially node, and respective method and respective computer program and respective computer program product.

**Description**

Table of Contents

FlexRay®
Requirements Specification

Introduction
Objectives

Basic Concepts
Node (ECU) Architecture
Topology
Frame Transfer
Constraints
Comment

Protocol Description
General Requirements
Frame Transfer
Static Segment
Dynamic Segment
Frame Format FlexRay
FlexRay Frame Format
*byteflight* Frame Format
Frame Scheduling - Multiplexing of
Sending Slots
Frame and Bit Coding
Frame Timing
Frame Timing for Static Segment
Frame Timing for Dynamic Segment
Start-up
Requirements
Principle of Operation - Protocol Modes
Shutdown
Clock Synchronization
Pure dynamic system
Pure Static and Mixed System
Principle of Operation
External Synchronization
Support of Application Agreement
Protocols
Support of Network Management

Hardware Specification
General Requirements
Topology
Automotive Constraints
Architecture - Power Modes
Communication Controller
States and Operating Modes

Table of Contents   (continued)

Logical Line Operation

Optical Driver

Electrical Bus Driver

Voltage Monitoring

States and Operating Modes

Bus Guardian

Wake-up

ECU → Bus Driver

Bus → Bus Driver

Bus Driver → Controller

Bus Driver → Power Supply

Controller → Bus Driver

Selective Sleep


Interfaces

Host ⇔ Communication Controller (CHI)

General Requirements

Frame Filtering and Masking

Interrupts

Host ⇔ Bus Guardian

Communication Controller ⇔ Bus Guardian

Communication Controller ⇔ Bus Driver

Bus Guardian ⇔ Bus Driver

Bus Driver ⇔ Power Supply


Error Handling

Requirements

Hardware Units

Interfaces


Constant Definitions

Communication Network Constants (Min/Max)


Glossary


Index

**Introduction**

This document contains a requirement specification and high-level system description for a dependable automotive network. The low-level (implementation) specifications must adhere to this document and should be written by the suppliers of the communication controller and physical layer.

Throughout the document the following structure is followed; at the beginning of each chapter (section) the requirements for this topic are defined, afterwards more detailed descriptions are provided. In the document UPPER CASE letters are used to denote constants. For a summary of all constants used in the document please refer to Chapter "Constant Definitions".

**Objectives**

The objectives pursued in the development of the dependable automotive network are the following:

- Support of two communication paradigms, deterministic (statically defined) communication and dynamic event driven communication.

- Configurable static and dynamic part within one communication cycle. Fully static and fully dynamic configuration has to be supported.

- Flexible extendibility, even after deployment.

- High data rate and bandwidth efficiency.

- Scalable fault tolerance (i.e., single channel and dual channel operation must be supported).

- Reliable error detection (bus guardian mechanism in the time domain, CRC in the value domain).

- Support of electrical and optical physical interfaces.

- Enable very low system level failure in time ratings

- Allow use of crystal oscillators and low tolerance ceramic resonators

- Support of active star and bus topologies

- Low overall system cost

- Enable re-use of carry over components without embedding knowledge of future platform partitioning.

**Objectives of the static segment:**

- Deterministic communication behavior in the time domain.

- Global time implemented by a fault tolerant clock synchronization algorithm.

- Immunity against accepting error-free subsequences of a message as valid messages (i.e. short message rejection).

**Objectives of the dynamic segment:**

- Event driven dynamic communication possibility.

- Flexible bandwidth allocation (for different nodes during runtime).

- No interference with the static segment.

- Support for prioritised bus access.

- Support of variable length messages with at least 200 data bytes.

**Global Requirements:**

- Support for fault tolerance, but operation without fault tolerance must also be possible, i.e., a single bus (channel) connection must be possible for non-fault-tolerant nodes.

- The communication network has to support a system architecture, where no single fault may lead to a functional degradation.

- Protection against faults in accordance with a well-defined fault hypotheses.

- Protect against up to and including five random bit errors per frame.

- The communication protocol should be independent as far as possible from the topology.

- For highly dependable and fault-tolerant applications an independent bus guardian to prevent the monopolisation of the communication medium by a communication controller is required.

- Errors in hardware and configuration data have to be detected during initialisation and operation by error detection mechanisms (EDMs). In case a critical error is detected the controller and transceiver must not be allowed to enter normal operation or immediately abort normal operation and report an error to the host.

- Support of serviceability of system- and component-level faults.

- The bit encoding technique must not introduce data dependent changes in the length of the resulting bit stream, e.g., bit stuffing is not allowed.

- Automotive qualification of the communication controller, bus guardian, and the physical layer is required.

- Configuration data must be readable/writeable by the host. It must be possible to prohibit writing during run-time.

- Support of comprehensive self test at system communication startup.

- Support of timely and highly reliable component re-integration and system-level startup.

- Support of master-less system startup and shutdown.

- Support of traceability of system- and component-level faults to identify root causes of failures.

- Support of synchronized system shutdown without error indications.

- Support of synchronous distributed application startup and shutdown with acceptable timing and fault tolerance characteristics.

- Support of node and network moding with high security against critical inadvertant mode changes.

- Logical line compatibility to the byteflight protocol (See byteflight specification at http://www.byteflight.com), when using an optical physical layer must be possible.

**Basic Concepts**

The communication protocol for the dependable automotive network described in this document has the following properties:

- Synchronous and asynchronous frame transfer.

- Multi-master clock synchronization.

- Guaranteed frame latency times and jitter during synchronous transfer.

- Prioritization of frames during asynchronous transfer.

- Error detection and signaling.

- Error containment on the physical layer through an independent bus guardian device.

- Scalable fault tolerance, e.g., one controller, one/two channels, one bus guardian for each channel.

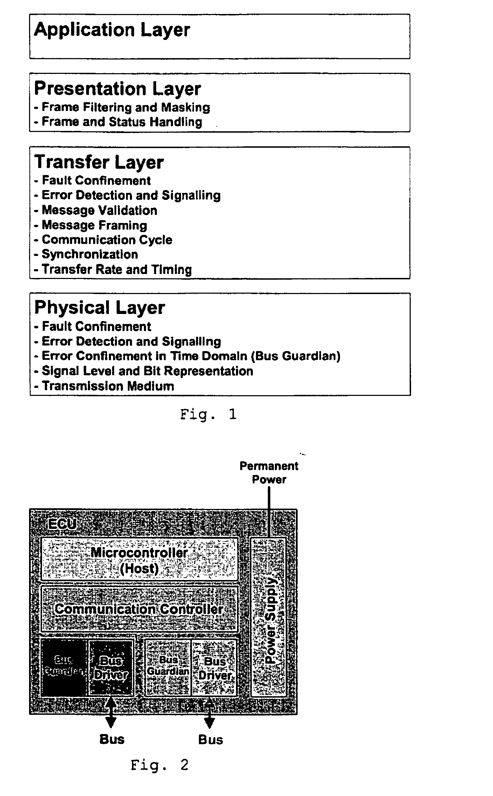

The layered architecture of the FlexRay protocol is shown in Figure 1.

- The <u>Physical Layer</u> defines how signals are actually transmitted. One task of the Physical Layer is to detect errors of the communication controller in the time domain. This is done by the so-called Bus Guardian (Chapter 0).

- The <u>Transfer Layer</u> represents the kernel of the protocol. It presents frames received to the presentation layer and accepts frames to be transmitted from the presentation layer. The transfer layer is responsible for timing, synchronization, message framing, error detection and signaling, and fault confinement (Chapter 0).

- The <u>Presentation Layer</u> is concerned with frame filtering and masking, frame status handling and contains the communication controller host interface (Chapter 0).

- The <u>Application Layer</u> is not part of this specification.

**Node (ECU) Architecture**

Figure 2 shows the architecture of a node (ECU). Every node consists of the five sub-components host, communication controller, bus guardian, bus driver, and power supply. This specification describes the requirements for the communication controller, the bus guardian, the bus driver and the interfaces to the host and the power supply. Two implementations for the communication controller are possible, one configuration of a communication controller that sends and receives on two redundant physical channels, and a second configuration which is solely connected to one physical channel.

**Topology**

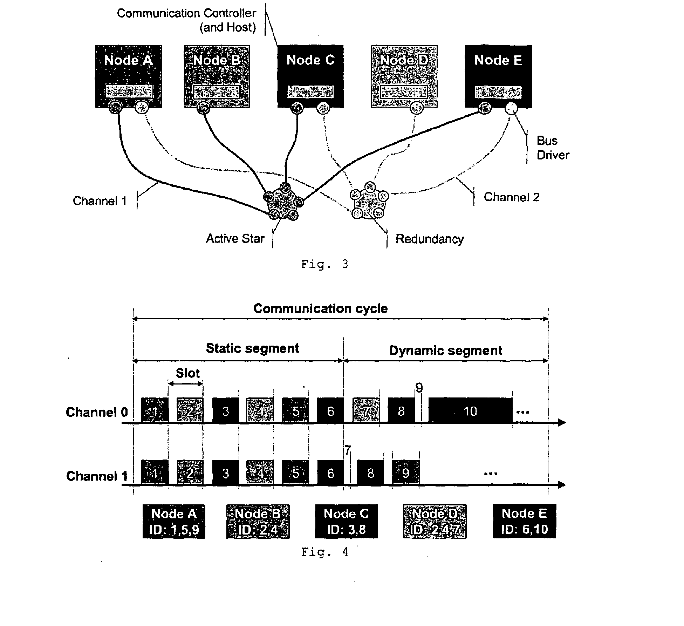

Figure 3 shows the possible topology configuration of the communication network. A node can either be connected to both channels 1 and 2 (node A, C, and E) or only channel 1 (node B) or only channel 2 (node D). A configuration, where all nodes are connected by 1 channel only is also possible.

**Frame Transfer**

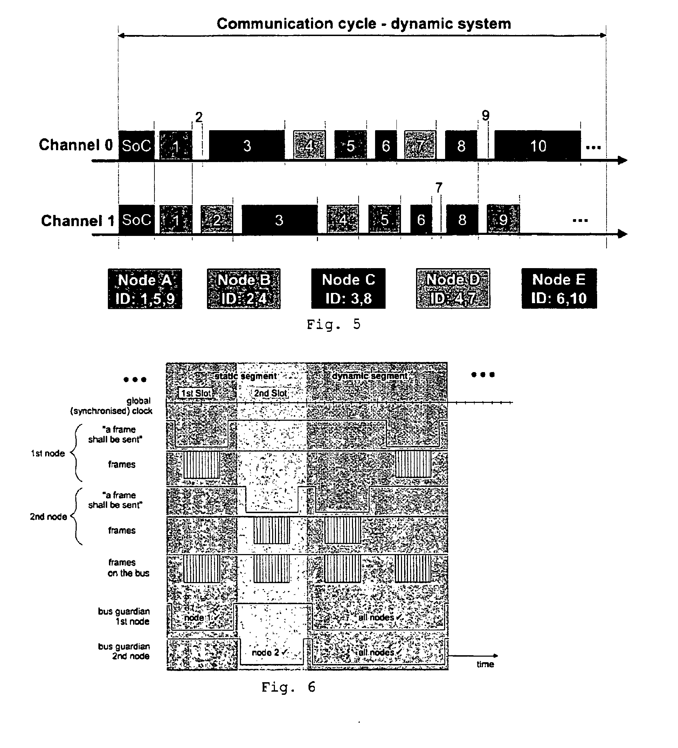

Communication is done in a communication cycle consisting of a static and a dynamic segment, where each of the segments may be empty. The first frame ID in a system with a static segment is ID number 1 (see Figure 4). In a pure dynamic system with the SOC symbol (see Figure 5). The sending slots are represented through the ID numbers that are the same on both channels.
The sending slots are used deterministically (in a pre-defined TDMA strategy) in the static segment. In the dynamic segment there can be differences in the phase on the two channels (see Figure 4). Nodes that are connected to both channels send their frames in the static segment simultaneously on both channels. Two nodes, that are connected to one channel only, but not the same channel, may share a slot in the static segment.
To guarantee the consistency of the clock synchronization only nodes can participate that send frames, which are received by all other nodes (e.g., node A, C and E in Figure 3). All nodes execute the clock synchronization algorithm, but only the frames of the static segment are considered. It is possible to send different data in the same sending slot on different channels.

**Constraints**

- The communication controller must allow to interface to an optical or an electrical physical layer.

- The communication controller must support a net data rate of at least 5 Mbit/s real application data transferred per seconds under the constraints of frame overhead (including CRC) and protocol timing overhead (IFG) in static communication mode.

- It must be possible to connect 2 up to CONTROLLER_MAX controllers to one communication channel.

- The maximum number of slots in the static segment is set to STATIC_SLOTS_MAX.

- The power supply for the bus driver (including the bus guardian) and the communication controller must meet automotive requirements.

**Comment**

Considering the FlexRay protocol as described in the previous sections the communication scheme of networked FlexRay nodes can be briefly characterized as follows:

- each node must be able to make use of the distributed clock

- each node must send frames inside a predefined static slot
  or/and
  inside the dynamic segment (collision free access)

the transmission of frames must be subdivided into 3 phases

1st a bus guardian must enable the access to the bus
2nd it must be signaled that a frame should be transmitted
3rd the transmission of the frame itself

**Protocol Description**

Throughout the document the following notation is used:

Req:    Requirements.
*Comment: Contains additional descriptions and explanations.*

**General Requirements**

- Req: The communication protocol shall be independent from the data rate.
  *Comment:*
  *It shall be possible to implement low end controllers e.g., 500 Kbit/s and high end controllers beyond 100 Mbit/s.*

- Req: The first communication controller must support a net data rate of at least 5 Mbit/s.
  *Comment:*
  *Net data rate: Real application data transferred per seconds under the constraints of frame overhead (including CRC) and protocol timing overhead (IFG) in static communication mode.*

- Req: A CRC code with a Hamming Distance of at least 6 must be used.

- Req: The communication controller shall be able to operate in a current byteflight environment, i.e., the two protocol controllers have to support the same physical interface and the same representation at the logical line level. The byteflight compatibility is required for the optical physical layer only.

*Comment:*

*Compatibility of the interfaces between host CPU and the protocol controller (CHI) is not required. The electrical physical layer does not need to support byteflight compatibility. The byteflight specification can be downloaded from the following web address: www.byteflight.com.*

## Frame Transfer

Data transfer in FlexRay is done in cycles, called communication cycles.

• Req: The communication cycle consists of a static and a dynamic segment as shown in Figure 4. Each of the segments may be empty, that means there are three possible configurations of the communication cycle (pure static, mixed static and dynamic (a mixed system consists of at least two static slots) and pure dynamic).

In a pure dynamic system the communication cycle starts with an SOC symbol. There are two different SOC symbols (alarm condition, normal condition). The sending slots are represented through the identifiers that are the same on both channels (see Figure 4).

The sending slots are used deterministically (in a pre-defined TDMA strategy) in the static segment. In the dynamic segment there can be differences in the phase on the two channels (see Figure 4). Nodes that are connected to both channels send their frames in the static segment simultaneously on both channels. A node that is connected to only one channel may share an identifier with another node that is only connected to the other channel.

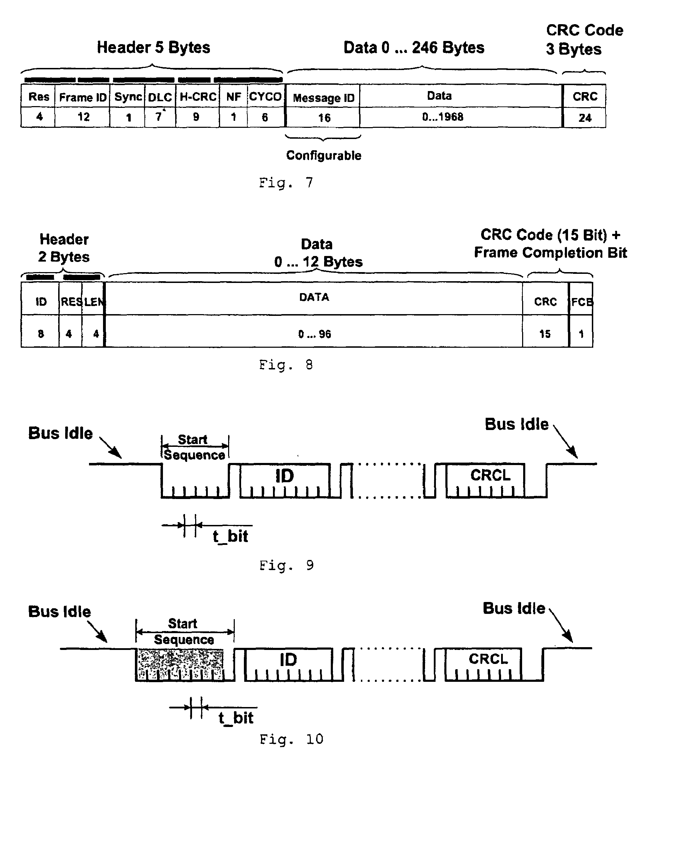

The current communication cycle is determined by a cycle counter that is consistently incremented in every cycle (see Figure 7).

• Req: The length of the communication cycle has to be stored in the configuration data.

*Fit Criteria:*

*The maximum cycle length is defined by CYCLE_LENGTH_MAX.*

• Req: A check mechanism has to be designed that ensures that no frame transmission is started within a certain interval so called forbidden region before the end of the communication cycle, to ensure that the beginning of the static segment in the next communication cycle is not disturbed.

• Req: Multiplexing of sending slots of one controller must be supported in such a way, that the contents of frames can be multiplexed for a certain sending slot in different communication cycles.

*Comment:*

*So a communication matrix with nearly any possible communication patterns (periods of certain frames) based on the principle of communication cycles can be built up.*

## Static Segment

• Req: If the static segment of the communication cycle is not empty it consists of STATIC_SLOTS_MIN $\leq$ NUMBER_OF_SLOTS $\leq$ STATIC_SLOTS_MAX.

• Req: The static segment is subdivided into a sequence of time slots. In each of these static slots only one controller may send one frame on each channel.

*Comment:*

*In the static segment of the communication cycle a TDMA media access strategy is used.*

• Req: There is one configuration parameter for the slot length (slot_length) in the static segment, that defines this value.. The length of the slots is configurable off-line but fixed during runtime.

## Dynamic Segment

• Req: In a pure dynamic system the communication cycle starts with the SOC symbol.

- Req: The dynamic segment of the communication cycle consists of zero or more dynamic identifiers (slots) within the communication cycle.

- Req: Bus access in the dynamic segment is done via static frame priorities according to the byteflight specification.
  *Comment:*
  *The byteflight specification can be downloaded from the following web address: www.byteflight.com.*

- Req: In the dynamic segment the media access strategy is based on wait times (mini-slotting scheme) and the priority of identifiers. Controllers transmitting frames with higher priority identifiers send before controllers transmitting lower priority frames.

- Req: The frame length in the dynamic segment is variable during runtime.

- Req: In pure dynamic mode an external triggered SOC generation and with it the start of the communication cycle has to be supported. The timing behavior of the external trigger has to be monitored by the communication controller.

**Frame Format FlexRay**

- Req: Two frame formats as specified below must be supported.
  *Comment:*
  *The mixture of the two frame formats need not be supported, i.e., all nodes connected to a FlexRay communication system can be configured using only the FlexRay format or the byteflight format.*

**FlexRay Frame Format**

- Req: It must be possible to use the FlexRay format in a pure static, in a combined static and dynamic, and in a pure dynamic configuration.

- Req: The first section of the data field in a frame must be configurable as a message ID field. This data field must be filterable by the receiver.

Figure 7 shows the FlexRay frame format:

Res: Reserved bits, 4 bit, for future protocol extensions.

ID: Identifier, 12 bit, value domain: ($1_{10}$ ... $4095_{10}$), defines the slot position in the static segment and defines the priority in the dynamic segment, see Figure 4. A lower identifier determines a higher priority. The identifier of a frame must be unique within a cluster. Each controller can have one or more identifiers (in the static and the dynamic segment).

SYNC: Synchronization field, 1 bit, indicates that the slot is used for clock synchronization.

DLC: Data length code field, 7 bit, DLC * 2 = number of data bytes ($0_{10}$, $2_{10}$, ..., $246_{10}$).

H-CRC: 9 Bit Cyclic Redundancy Check - Sequence. The H-CRC is calculated over the SYNC- and DLC-field.

NF: Null frame indication field, 1 bit, indicates that the corresponding data buffer is not updated by the host before sending.

CYCO: Cycle Counter, 6 bit, the cycle counter is increased simultaneously in all nodes by the controller at the start of each new communication cycle.

Message ID: The Message ID field is configurable to be used as the message identifier or as the first two data bytes.

D0 ... D246:     Data bytes, 0-246 bytes.

CRC:             24 Bit Cyclic Redundancy Check - Sequence. The CRC is calculated over the complete frame.

**byteflight Frame Format**

• Req: The byteflight frame format must be supported for pure dynamic configurations.

Figure 8 shows the byteflight frame format.

ID:             Identifier, 8 bit, value domain: ($1_{10}$ ... $255_{10}$), defines the priority in the dynamic segment, see Figure . A lower identifier determines a higher priority. The identifier of a frame must be unique within a cluster. Each controller can have one or more identifiers.

Res:            Reserved bits, 4 bits, for future protocol extensions.

LEN:            Length field, 4 bit, LEN = number of data bytes ($0_{10}$ ... $12_{10}$), a value higher than 12 is handled as LEN=12.

D0 ... D11:     Data bytes, 0-12 Bytes

CRC:            15 Bit Cyclic Redundancy Check - Sequence ($x^{15} + x^{14} + x^{10} + x^8 + x^7 + x^4 + x^3 + 1$).

FCB:            Fill completion bit: an additional bit is added to the 15 bit CRC to fill the complete word. The bit is set to "0" as LSB.

**Frame Scheduling - Multiplexing of Sending Slots**

• Req: The cycle counter can be used to distinguish between different frame contents.
  *Comment:*
  *For a sending slot different send and receive buffers can be defined in different cycles (slot multiplexing).*
  *Comment:*
  *The cycle counter can be used as a logical extension to the identifier (in the case of multiplexing).*

**Frame and Bit Coding**

• Req: The coding algorithm in the communication controller has to be robust against:

  - glitches

**Optical Physical Layer**

• Req: The controller must support at least the byteflight optical bit encoding.
  *Comment:*
  *In byteflight, frames on the communication media are composed of individual bytes consisting of a start bit, eight data bits and a stop bit.*
  *In addition, transmission of each frame begins with a start sequence consisting of 6 logical "0"bits. This is illustrated by the diagram in Figure 9.*

Figure 9 shows the transmission of the start sequence.
       *Due to certain effects in the optical transmission, it is possible for the start sequence to be become shorter or longer during optical transmission. This is why the receiver accepts start sequences in the region of 1-9 logical "0" bits. This is illustrated by the following diagram in Figure 10.*
Figure 10 shows the reception of the start sequence.

**Electrical Physical Layer**

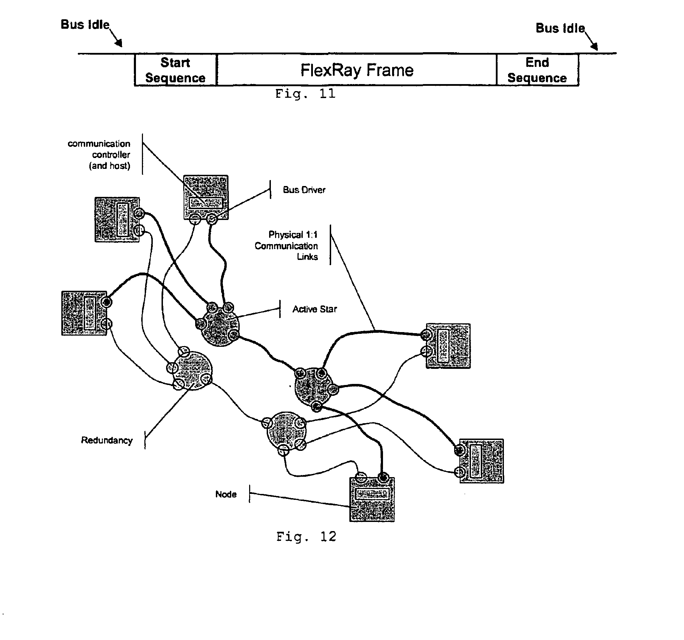

- Req: Frames on the communication media for the electrical physical layer are composed as shown in Figure 11. The frame end sequence may be empty.

Figure 11 shows the frame format for electrical transmission.

- Req: A suitable bit coding schema has to be selected, in accordance to bandwidth efficiency and EMC requirements.

**Frame Timing**

- Req: Frame timing of different communication controller implementations must be interoperable.

**Frame Timing for Static Segment**

- Req: The reception start window shall be defined in relation to the precision. I.e., the start window must be greater than the precision.
  *Comment:*
  *The actual value for the reception start window must be defined in the implementation specification.*

- Req: In the static segment accurate timing requirements have to be ensured for correct frame reception. Frames may only start within the reception start window.
  *Comment:*
  *The length of the frame determines the frame duration. Correct reception is given if the respective frame does not violate the temporal borders given by the access scheme. The judgement of temporal correctness is based on a rigid timing scheme.*

- Req: The time difference between the predicted start StartNom and the observed start of the frame (SOF) is used by the clock synchronization algorithm.

- Req: The length of the IFG has to be minimized, in order to optimize the net communication rate.

**Frame Timing for Dynamic Segment**

- Req: The frame timing in the dynamic segment must be defined due to the *byteflight* specification.

**Start-up**

**Requirements**

- Req: For each configuration (Pure Static Systems, Pure Dynamic and Mixed System) the start-up of the communication network has to be possible as soon as two nodes are able to communicate.

- Req: The integration of controllers that are powered on later must not disturb the start-up procedure of the other nodes.

- Req: The start-up and re-integration of controllers shall not disturb the normal operation of the network.

- Req: The worst-case start-up time under the fault conditions given above has to be provided and guaranteed by the supplier of the communication controller. The communication network must be operational after 100 ms.
  *Comment:*
  *The application designer has to consider the start-up time during the determination of the configuration parameters. Typical automotive applications require a worst case startup time of 100ms. For system configurations with extremely long communication cycles longer startup times are acceptable.*

- Req: During start-up a communication controller sets the cycle counter according to the value in the received frame. The cycle time is derived from the frame ID and set accordingly.

- Req: The startup must work without reliance on collision detection.
  *Comment:*
  *Collisions can occur on the bus during start-up and in the case of faults. In star topologies collision detection is not always feasible.*

**Principle of Operation - Protocol Modes**

**Pure Static System and Mixed System**

- Req: The start-up has to work as a distributed algorithm.

- Req: Only controllers that participate in clock synchronization (sync bit set) are allowed to start up the system.
  *Comment:*
  *In a dual channel system only controllers connected to both channels are allowed to execute the start-up in a heterogeneous topology (mixing controllers with single channel and controllers with dual channel).*
  *Controllers connected to only one channel are not allowed to start-up the bus because they may corrupt the traffic of this channel in case of an incoming-link failure by sending frames after the listen-timeout (listen_timeout).*

- Req: The start-up of the communication network, the integration of nodes powered on later and the re-integration of failed nodes must be fault-tolerant against:

  - the temporary/permanent failure of one or more communication controllers (down to one controller sending in the static segment for mixed or pure static configurations),
  - the temporary/permanent failure of one or more communication channel(s) in a redundant configuration, and
  - the loss of one or more frames.

**Pure Dynamic System**

- Req: A single master sends the SOC symbol. The master shall be defined at design time.

**Shutdown**

- Req: The co-ordinated shutdown of the FlexRay cluster, including all nodes and all stars initiated by the application must be possible. The interference with the wake-up mechanism must be handled.

- Req: The communication system has to support a synchronized system shutdown without error indications.

**Clock Synchronization**

*Comment:*
*The proper synchronization of the individual clocks of the communication controllers is a pre-requisite for the TDMA communication scheme.*

*This chapter contains the description of the FlexRay clock synchronization mechanism (based on the Fault-Tolerant Midpoint algorithm).*

**Pure dynamic system**

- Req: In a pure dynamic operation the clock synchronization is performed by a master (SOC).

**Pure Static and Mixed System**

- Req: The global time is a vector of two values. Global time = < cycle_counter, cycle_time >.

- Req: The cycle time is a counter incremented in units of macroticks. The cycle time is reset to 0 at the beginning of each communication cycle.

- Req: The macrotick defines the resolution of the global time within one cluster. A resolution of 1µs must be achievable in realistic configurations.

- Req: The macrotick shall be independent of oscillator frequency.
  *Comment:*
  *In the implementation each (local) macrotick is an integer multiple of the (local) clocktick, i.e. depends on the oscillator frequency, but the factors of two different macroticks can be different, so over a cycle, independence can be achieved.*

- Req: The microtick defines the accuracy of the clock difference measurement. A resolution of <=50 ns is required for the microtick.
  *Comment:*
  *Typical automotive applications require a resolution of 50 ns. For system configurations with low bandwidth, higher values are acceptable.*

- Req: The clock synchronization mechanism must be able to keep all fault-free controllers within the precision. A clock synchronization precision within the different controllers of better than 1 microsecond is required.
  *Comment:*
  *Typical automotive applications require a precision of 1 microsecond. For system configurations with lower precision requirements, greater values are acceptable.*

- Req: The absolute value of the global time must be the same at every controller, within the limits defined by the precision. During start-up the first sending node determines the value of the global time.

- Req: The fault tolerance of the clock synchronization mechanism must be scalable with the number of controllers. The level of fault tolerance depends on the number of actual nodes in the system (3k+1 to tolerate k asymmetric faults). . In a reduced fault-tolerant configuration of less than four controllers (e.g., 2 or 3, in a degraded mode of operation) the synchronization must be possible. For 4 to 6 controllers the clock synchronization mechanism must be fault-tolerant against 1 (asymmetric) fault. For 7 or more controllers the clock synchronization mechanism must be fault-tolerant against 2 (asymmetric) faults.

- Req: The clock synchronization mechanism must prevent the formation of cliques with different notions of time within the network.

- Req: The clock synchronization mechanism must be able to operate with oscillators that have automotive quality. In particular the clock synchronization mechanism must be able to deal with the physical phenomena (drift, deterioration) that can occur during an automobile lifetime.

- Req: A subset of controllers must be configured to send sync-frames (a frame with a set SYNC bit). In a dual channel system only controllers connected to both channels may belong to this subset.

- Req: Only one static sending slot of each controller is allowed to contribute to the clock synchronization mechanism, i.e., a controller may send at most one sync-frame per communication cycle.

- Req: Only correctly received sync-frames are used for clock synchronization.

- Req: Every node has to use all available sync-frames for clock synchronization.

- Req: The clock synchronization and the implementation of the clock synchronization shall be as resilient as possible against design violations resulting from environment or possible misuse.

**Principle of Operation**

**Obtaining the time values**

- Req: In the static segment every node measures the time difference between the actual receive time and the expected receive time for the sync-frames with a resolution of a microtick.

- Req: This time difference measurement is done for all channels.

- Req: An SOF-window is placed around the expected receive time of an SOF. The length of the receive-window is equal to the length of the SOF-window.

- Req: Time values are obtained for correct frames only.
  *Comment:*
  *Note that one of the reasons why a frame is considered incorrect is reception outside the receive window. The stringent application of the receive-window mechanism ensures that synchronization errors of nodes are detectable.*

**Measurement method**

- Req: The measurement of the clock deviations is done through measuring the differences between the expected arrival time and the actual arrival time . The expected arrival time of a frame is defined by the internal view of the cycle time.

**Synchronization algorithm**

- Req: The synchronization algorithm uses a fault-tolerant midpoint algorithm (FTM) that operates with an arbitrary number of controllers.
  *Comment, Description of the FTM:*
  *The measured values are sorted and the k largest and smallest values are discarded. k is adapted dynamically so that at least 2 measured values are remaining.*
  *The largest and the smallest of the remaining values are selected for the calculation of the midpoint value, i.e., average of those two values. The resulting value in a node describes the deviation of the own clock from the global time base and serves as a correction term.*

- Req: The resulting correction term(s) shall be used for error detection of the communication controller. If the correction term cannot be applied, an error has to be signaled to the host.

- Req: The clock correction term(s) calculated in the previous step shall be applied to the local clock.

- Req: If equal or more than half of the frames are received outside the reception start window a synchronization error is indicated to the host. The synchronization error is a fatal error the controller has to reintegrate.

*Comment:*
*This mechanism prevents* the *formation of*
*cliques.*

**External Synchronization**

- Req: External synchronization must be supported.
  *Comment:*
  *External synchronization is necessary for the synchronization of a FlexRay network to an external time reference,*
  *e.g., a GPS receiver or a DCF77 receiver, or to synchronize several FlexRay networks.*

- Req: Each controller can add an additional external clock correction term(s) to the calculated clock correction term
  (s).

- Req: The resulting clock correction term(s) shall not be greater than the maximum allowed correction term(s) or
  smaller than the minimum allowed term(s). The communication controller shall limit the applied correction term(s)
  to allowed values.

- Req: The host shall be able to read the current (local) correction term(s) (current clock value) and set the external
  correction term(s).

- Req: A hardware input signal at the communication controller for external synchronization is required.

- Req: The hardware input signal shall be connected to the internal soft-reset of the controller. It shall be possible
  to release the controller from soft reset at a specific time by the host.

**Support of Application Agreement Protocols**

- Req: The protocol has to support the realization of application agreement protocols. This requires multiple sending
  slots to achieve agreement within one communication cycle. .

**Support of Network Management**

- Req: Support of synchronous distributed application startup and shutdown with acceptable timing and fault tolerance characteristics.

- Req: Support of node and network modes with high security against critical inadvertant mode changes.

**Hardware Specification**

This chapter contains a description of hardware-related requirements for a FlexRay system.

**General Requirements**

Regarding the communication hardware, a distributed system of FlexRay nodes must offer some properties
when being designed by using active stars and passive busses:

- Req: One and two channel solutions have to be supported.

- Req: An electrical and optical physical layer must be supported.

- Req: Communication via redundant physical links is optional. The communication system must support both communication via redundant and non-redundant physical links. A mix of redundant and non-redundant physical links must be supported.

- Req: When using active stars several 1:1 links must be used.

- Req: Wake-up of nodes and stars via the communication system must be supported. Signaling on one channel is sufficient for wake-up.

- Req: A baud-rate from 500 Kbit/s up to 10 Mbit/s must be supported.

- Req: A power mode management must be supported.

**Topology**

- Req: The protocol has to be independent from the topology as far as possible. Mixed and homogeneous system topologies must be supported.

- Req: A FlexRay network using a passive bus must be possible.

- Req: A FlexRay network using a passive star must be possible.

- Req: A FlexRay network using a active star must be possible.

- Req: Support for different topologies/physical layers on different channels is desirable.

- Req: Support for different physical layers on one channel is desirable.

Figure 12 shows an example of a topology of a FlexRay network using active stars.

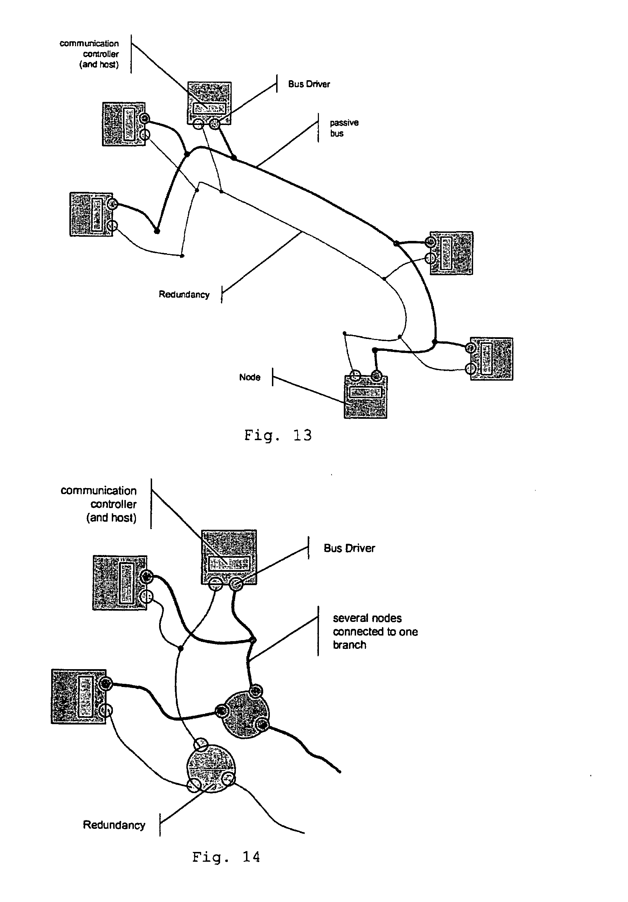

Figure 13 shows an example of a topology of a FlexRay network using a passive bus.

- Req: A distributed system of FlexRay nodes can be designed by combining the active star and the passive bus approach. Several nodes may be connected to a branch.

Figure 14 shows an example of a topology of a FlexRay network using an active star combined with a passive bus.
      Each node must adhere to the following requirements:

- Req: Within a node 1 or 2 bus drivers must be connected to a single communication controller

Figure 15 shows a block chart of a FlexRay node.
      Each active star must adhere to the following requirements:

- Req: No communication controller is required to perform the star functionality.

- Req: No host is required to perform the star functionality.
  *Comment:*
  *An implementation may integrate the star within an ECU.*

- Req: A branch of an active star has to be de-activated if a faulty communication signal is detected:

      1) permanent "0" on the bus
      or
      2) permanent "1" on the bus
      or
      3) permanent noise on the bus

- Req: A de-activated branch may not influence the communication of the active modules (fail silent).

- Req: A de-activated branch has to be re-activated if the failure condition which leads to a faulty communication signal is no longer available.

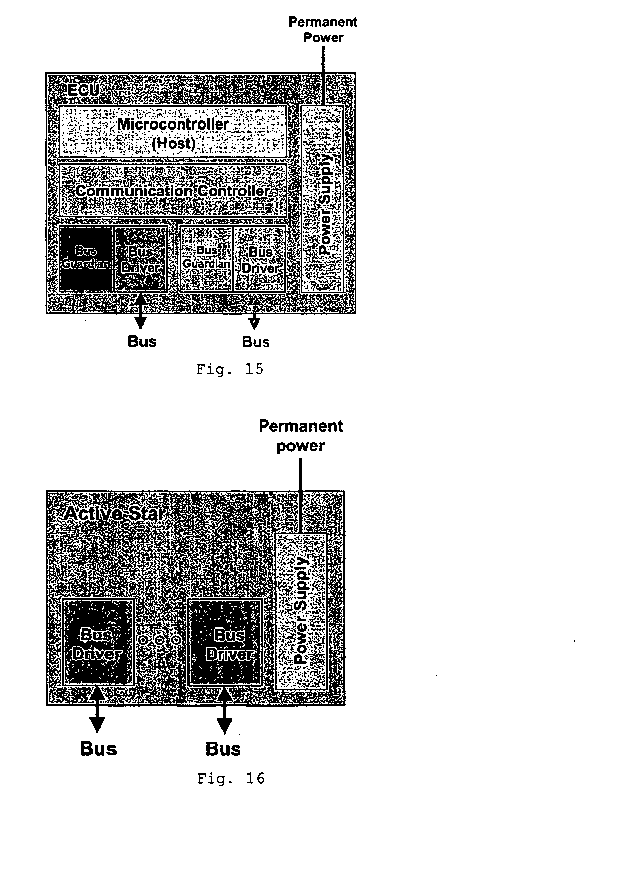

Figure 16 shows a block chart of an electrical active star.

**Automotive Constraints**

- Req: FlexRay devices must meet automotive temperature requirements.
  *Comment:*
  *General temperature requirements include a range of -40 to +125 degrees Celsius. Special applications may require higher temperatures, e.g., near braking actuators.*

- Req: Each product has to be optimised to meet the automotive and legal EMC requirements (for Strongest severity level see DaimlerChrysler: A0000007199, BMW: GS 95002). External filters may not be required.
  *Comment:*
  *Listed severity levels as named will not be achievable when using a passive bus.*

- Req: The power consumption during the normal operating mode and the low power mode has to be minimised.
  *Comment:*
  *Typical values are given in the following table:*

Table 1:

| Typical current consumption. | | | | | |
|---|---|---|---|---|---|
| Function | Min. | Typ. | Max | Unit | Remark |
| Quiescent current (from the permanent power) of the bus driver | | 10 | | µA | The bus driver monitors wake-up events, the voltage regulator is switched off |
| Current for the bus driver and the communication controller | | 10 | | mA | bus free - no actual communication |
| Current for the bus driver and the communication controller | | 50 | | mA | bus busy - communication active |

- Req: The voltage supply for the communication controller should be the same as for commercially available ECUs.
  *Comment:*
  *Today most ECUs support 5 V. For optimisations e.g., 3 V are allowed.*

- Req: All inputs and outputs of the bus driver and the communication controller which are directly coupled to the wire harness have to fit the known electric requirements (Schaffner pulses (high ESD), power voltage up to 60 V, see EMC Target Specifications). Support of future high supply voltages (36/42 V instead of 12 V) must be supported.

**Architecture - Power Modes**

The chapter summarises the requirements on the communication controller and the bus driver to run an ECU in several modes.

- Req: The power modes of the ECU must be sensitive to control signals from the host and wake-up signals from the transmission media, from the ECU internally (e.g., from the host) and optionally from the ECU externally (e. g., by a switch).

- Req: At least 3 power modes must be distinguished for communication controllers and bus drivers and stars:

  Normal (voltage regulator(s) active, communication possible)

Standby (voltage regulator(s) active, communication not possible)
Sleep (voltage regulator(s) not active, communication not possible)

Table 2:

| Power modes. | | |
|---|---|---|
| **Power Mode of the Node** | **Communication** | **Power Supply** |
| Normal | available | available |
| Standby | not available | available |
| Sleep | not available | not available |

• Req: The power modes of the active star must be controlled by the bus drivers automatically. It is not desireable that a dedicated 'wake-up' and 'shut-down' command is send to the star or additional wiring is required.

**Communication Controller**

• Req: A communication controller must include an interface (Has to be confirmed among the suppliers, the most commonly used µCs have to be connectable.) to connect a host.

• Req: Parts of the behaviour visible to the host, e.g., application control, configuration, message area, communication controller status, interrupts, etc. have to be confirmed among the suppliers and specified.

• Req: The time base of the redundant channels must be the same within each node (e.g., by a single state machine).

• Req: The functionality of the communication controller must be independent of the existence of a bus guardian.

• Req: For a stand-alone controller the pin-out must be completely specified and documented.

**States and Operating Modes**

• Req: Power-on and NOT (power-on) must be distinguished at least.

• Req: The controller has to be passive outside the mode power-on.

• Req: The controller has to be resetable externally.

• Req: The controller has to support at least one low-power mode.

• Req: The controller modes have to be defined in accordance with the bus driver modes.

**Logical Line Operation**

• Req: At least the following information has to be distinguished:

• bus busy: data or SOC symbol are transmitted.
• bus idle.

• Req: The encoding/decoding method has to allow both optical and electrical communication networks. At least one method has to be supported:

- NRZ (see byteflight specification).

- <u>Req</u>: Bit sampling must be robust against disturbances typically inside vehicles e.g., signal delay, edge jitter, baud-rate jitter

- <u>Req</u>: Bit sampling must be able to deal with e.g., temperature variations or tolerances of electrical and physical parameters.

**Optical Driver**

- <u>Req</u>: See the byteflight specification.

**Electrical Bus Driver**

- <u>Req</u>: For a bus driver the pin-out must be completely specified and documented.

- <u>Req</u>: For redundant configurations an implementation has to be chosen which minimizes the probability of common mode failures of both bus drivers ($\rightarrow$ each redundant communication is disturbed).
  *Comment:*
  *Two bus drivers to support* redundant *communication by a single communication controller may possibly not be implemented on a single die.*
  *Two bus drivers to support redundant communication by a single communication controller can be integrated in one package, if any common mode failure can be excluded.*

- <u>Req</u>: The bus driver must provide status information and diagnostics information which can be read by any µ-controller optionally.

- <u>Req</u>: The bus driver must be protected against electrical over-voltage and short-circuits.

**Voltage Monitoring**

- <u>Req</u>: The bus driver must monitor the battery voltage and has to provide status information.

- <u>Req</u>: The bus driver must detect an interrupted connection to the battery and has to provide status information.

**States and Operating Modes**

The bus driver has to support several states or operating modes:

- <u>Req</u>: Power-on and NOT(power-on) must be distinguished

  $\rightarrow$ permanent power

  $\rightarrow$ regulator voltage

- <u>Req</u>: The bus driver has to support at least two low-power modes.

- <u>Req</u>: The bus driver has to be able to signal an internal power down mode to an external voltage regulator.

- <u>Req</u>: the bus driver has to support a "shutdown mode"

  $\rightarrow$ this mode has to be reached by secured mechanisms on demand of the host

→ this mode must be left only by a power down

→ the bus driver has to be passive and has to signal to the voltage regulator to switch off.

- Req: The bus-levels have to be chosen by the bus driver automatically to support any net-wide power down modes.

**Bus Guardian**

- Req: The failure of a communication controller in the time domain, e.g., a communication controller sends in a time slot when it is not allowed to send, must be prevented by a bus guardian. The probability for common mode failures in the time domain affecting both, the communication controller and the bus guardian must be sufficiently low.

- Req: The bus guardian must protect the static slots (controller) from each other. In the dynamic segment the bus guardian grants all controllers access to the bus.
*Comment:*
*One of the main reasons for an error in the time domain is an erroneous internal state that leads to an incorrect (timing) access to the communication media.*

- Req: The bus guardian must be able to detect errors in the physical clock source as well as errors in the internal representation of the time base of the communication controller.
*Comment:*
*One of the main reasons for an error in the time domain is an error in the clock source of the communication controller. Hence, the clock source check mechanism of the bus guardian must concentrate on the main physically possible failure modes of the clock source of the communication controller.*
*The bus guardian may have a clock source of its own. Two bus guardians, which are connected to the same communication controller can use the same clock source.*

- Req: The bus guardian must not disable access to more than one channel, i.e., one bus guardian per channel is required.

- Req: It must be possible to implement the bus guardian as a stand-alone circuit. This circuit has to be combinable with the known state of the art physical layers.
*Comment:*
*The bus guardian could be integrated in the bus driver. The interface(s) towards the communication controller (and the bus driver) must be defined.*

- Req: It must be possible to implement the bus guardian as a stand-alone circuit in the star coupler. This circuit has to interact with the known state of the art physical layer.

- Req: The bus guardian has to check the correct enabling of the driver output stage.

- Req: The mechanism of separating the communication controller from the communication media must be checked. At least once per driving cycle (power on / power off) is sufficient.

- Req: The bus guardian is configured via a configuration data interface.

- Req: The bus guardian has to enable and disable the bus driver output stage according to a predefined timing pattern. If the bus guardian detects an error in the timing pattern of the communication controller it permanently disables access to the communication media and signals this.

- Req: If an error in the bus guardian occurs the communication channel must not be disturbed (monopolized).

- Req: The configuration data interface must be specified and documented. This mainly includes the logical contents of the timing pattern.

**Wake-up**

- <u>Req</u>: Several wake-up mechanisms have to be taken into consideration.

**ECU → Bus Driver**

- <u>Req</u>: The bus driver has to be woken up by any source inside or outside the ECU (local wake-up).

- <u>Req</u>: The wake has to be two edge sensitive.
  *Example:*
  *e.g., edge at a WU pin of the BD*

**Bus → Bus Driver**

- <u>Req</u>: From the host's point of view a general wake-up mechanism is required for both electrical and optical systems.

- <u>Req</u>: The bus driver should be woken up via standard communication (message-pattern).

- <u>Req</u>: The wake-up detector has to be robust against disturbances in vehicles like common mode signals by emission.

- <u>Req</u>: The bus driver may not be woken up by any noise.

**Bus Driver → Controller**

- <u>Req</u>: The bus driver has to wake up the controller by any signal on the interface. A dedicated wake-up line is not required.
  *Example:*
  *e.g., edge at the Rx pin produced by the bus driver*

**Bus Driver → Power Supply**

- <u>Req</u>: The bus driver has to signal its sleep state, e.g., to control the voltage regulator.
  *Exampie:*
  *inhibit signal*

**Controller → Bus Driver**

- <u>Req</u>: The controller must be able to wake-up the bus driver by any signal on the interface. A dedicated wake-up line is not required.
  *Example:*
  *Edge at the Tx pin*

**Selective Sleep**

- <u>Req</u>: The realisation of selective sleep has to be supported.

**Interfaces**

The interfaces between the single modules (host, controller, bus driver, bus guardian, and power supply) have to be agreed upon among the suppliers according to the general requirements defined in this document. Figure 17 shows an overview of all interfaces.

**Host ⇔ Communication Controller (CHI)**

**General Requirements**

- <u>Req</u>: The configuration data of the communication controllers must be securable (e.g., by soft reset) against accidental access and modifications.

- <u>Req</u>: Protect against improper host modification of BG and CC configuration data.

- <u>Req</u>: The interface between the host and the communication controller should be implemented as a 16 bit interface (selectable multiplexed/non-multiplexed bus interface).

- <u>Req</u>: Functional compatibility between different suppliers has to be guaranteed at CHI level.

- <u>Req</u>: The CHI has to be configurable into transmit and dedicated receive buffers and receive buffers with FIFO behavior.

- <u>Req</u>: If the FIFO queue is full and new data arrives the oldest data is overwritten. The FIFO queue must set a diagnosis bit when data in the buffer is overwritten.

- Req: MSB first is used for frame transmission.
  *Comment:*
  *The status area of the CHI contains communication controller status fields, which are written by the controller and which are read-only for the host. The status fields will be defined in the protocol specification and interface specification.*
  *The control area in the CHI contains fields that allow the host to control the behavior of the communication controller. The control fields will be defined in the protocol specification and interface specification.*
  *The message area in the CHI contains a memory area where the frames to be sent / received are stored together with status information for each frame. The layout of this memory area is determined in the configuration data of each communication controller. The message buffer status fields will be defined in the protocol specification and interface specification.*

- <u>Req</u>: Support of traceability of system- and component-level faults to identify root causes of failures.

- <u>Req</u>: The hardware implementation should verify that only one combination of frame ID and sync bit is considered valid for transmission.

**Frame Filtering and Masking**

- <u>Req</u>: Message Reception, every message buffer has to contain a channel, frame ID and cycle counter which are used for message filtering. Optionally the first two data bytes of each message buffer are used as message ID filter. Options for filtering:

1) Frame ID + channel

2) Frame ID + cycle counter + channel

3) Message ID + cycle counter + channel

_Comment:_

_Filtering: Filtering of messages means that for each message buffer the message's frame ID, cycle count and message ID are parameters that define in which message buffer the correctly (correct CRC, time, etc.) received messages is stored or if the message is discarded._

• Req: There must be at least one mask register per communication controller and channel that allows all combinations of masking.

_Comment:_

_Masking: Masking of message filters means that some (parts) of the filtering parameters may be configured to be disregarded (set to "don't care")._

• Req: Message transmission, filtering parameters for transmission are frame ID and cycle counter; there is no masking possible for the frame ID. Each transmit buffer has its own mask for the cycle counter.

**Interrupts**

• Req: The host computer has to be able to request different interrupts from the communication controller: at least read interrupt (buffer), write interrupt (buffer), 2 independent timer interrupts.

• Req: Timer interrupt: the host can request a time interrupt at any absolute point in the global time (across communication cycle borders).

• Req: One interrupt line is required for a standalone controller implementation.

• Req: Interrupts can be mapped to one or more interrupt lines in an integrated controller.

**Host ⇔ Bus Guardian**

• Req: The bus guardian configuration data is written during download and then stored in a local memory of the bus guardian.

• Req: During normal operation no configuration data transfer from the host to the bus guardian is allowed.

• Req: The bus guardian periodically updates a status field which can be accessed by the host / bus guardian interface containing at least the following status information:

  • State of the bus

  • State of the controller

**Communication Controller ⇔ Bus Guardian**

• Req: At least the following control information is required:

  • Arm signal

**Communication Controller ⇔ Bus Driver**

- Req: This interface has to be confirmed among the suppliers.
  *Example:*
  *Tx, TxEnable*
  *Rx, RxEnable*

**Bus Guardian ⇔ Bus Driver**

**Bus Driver ⇔ Power Supply**

- Req: To perform the wake-up and sleep functionality an interface between bus driver and power supply is required.

**Error Handling**

The communication system and its components shall offer adequate error management mechanisms to deal with faults arising from the following levels:

- media

- bit (coding)

- frame

- data

- topology and

- time.
  The communication system furthermore shall offer diagnosis information to the host computer with respect to controller, bus (channel), and incoming/outgoing link failures.

**Requirements**

- Req: The error management shall follow the "never-give-up" philosophy.
  *Comment:*
  *This means that the communication protocol has to support proper operation until a certain critical error states is reached.*

- Req: The non-arrival of periodic messages shall not be unrecognized.
  *Comment:*
  *It is okay, if, e.g. one, periodic message is missed, but this has to be detected. The fact, that a periodic message was missed should be signaled to the host.*

- Req: If a periodic message was missed, no random data shall be given to the host.

- Req: Data content of messages, (periodic and spontaneous) must not be changed by the communication protocol.

- Req: The change of data content shall be signaled to the host.

- Req: After an error was detected at a communication partner in the network, the functionality of the other communication partners shall not be influenced.

*Comment:*
*The correct function may not depend from the correct function of a certain host, of a certain communication controller or of a certain power supply.*
The communication controller shall detect the following list of errors:

- Req: Synchronization error. The communication controller is not any more synchronized to the global time on the bus.

- Req: The communication network must offer diagnosis information to the host computer with respect to the bus (channel), incoming/outgoing link failures.

- Req: The communication network must offer diagnosis information to the host computer within a defined maximum delay after the occurrence of the failure of the diagnosis element.

- Req: The communication network is not required to provide consistent and agreed diagnosis information to the host computer.

**Hardware Units**

The following faults have at least to be detected by the communication controller:

- Req: Defect time source (e.g., broken crystal).

- Req: Low voltage.
The following faults has to be recognized by the bus driver as errors:

- Req: Faulty communication signals caused by e.g. any faulty transmission media (e.g., a broken line, short circuit to ground,...).

- Req: Incorrect communication with the host e.g., communication via the data interface.

- Req: Incorrect communication with the communication controller e.g., bus-blocking transmit signals.

- Req: De-activated branch.

**Interfaces**

- Req: Status information on detected errors must be provided. Additionally it is required that maskable interrupts for certain detected errors can be requested by the host.

**Constant Definitions**

In this section the constants for a number of design parameters defined throughout the document are set to actual values.

**Communication Network Constants (Min/Max)**

Table 3:

| Definition of the constants used throughout the specification. | | |
|---|---|---|
| **Name** | **Value** | **Description** |
| CONTROLLER_MAX | 64 | Maximum number of controllers connected to one communication channel. |
| CYCLE_LENGTH_MIN | 250 µs | Minimum length of the configurable communication cycle. |

Table 3: (continued)

| Definition of the constants used throughout the specification. | | |
| --- | --- | --- |
| **Name** | **Value** | **Description** |
| CYCLE_LENGTH_MAX | 64 ms | Maximum length of the configurable communication cycle. |
| DATA_BYTES_MAX | 246 | Maximum number of data bytes. |
| DYNAMIC_IDS | 4095 | Maximum number of dynamic identifiers. |
| STATIC_SLOTS_MIN | 2 | Minimum number of static slots in a static segment of a communication cycle |
| STATIC_SLOTS_MAX | 4095 | Maximum number of static slots in a static segment of a communication cycle |

**Glossary**

| | |
| --- | --- |
| Bus | Consists of one or several *channels*. |
| Bus Driver | A bus driver connects a communication controller to one channel. |
| Bus Guardian | A bus guardian protects one channel from timing failures of the communication controller. It is therefore connected to one communication controller and one bus driver. The bus guardian must be independent from the protocol communication controller. |
| byteflight | Communication network developed by BMW AG, Motorola, ELMOS, Infineon, Siemens EC, Steinbeis Transferzentrum für Prozessautomatisierung, IXXAT. (See http://www.byteflight.com) |
| Channel | A channel is a physical connection between several communication controllers. A redundant channel consists of two channels connecting the same communication controllers. |
| CHI | Controller Host Interface. |
| Clique | Set of communication controllers having the same view of certain system properties, e.g., the global time value, or the activity state of communication controllers. |
| Cluster | Synonym for network within this specification. |
| Cluster time | Same as *cycle time*. |
| Communication Controller | A communication controller is connected to one or two channels where it can send and receive frames. |
| Communication Cycle | Periodic data transfer mechanism. Structure and timing are statically defined. However, a static and a dynamic segment allows for the transmission of both, state and event information. |
| Controller | see, *Communication Controller*. |
| CRC | Cyclic Redundancy Code attached to a frame. |
| CYCLE | The CYCLE field is used to transmit the cycle counter. The cycle counter is increased simultaneously in all nodes by the communication controller at the start of each new communication cycle. |
| Cycle Counter | Contains the number of the current communication cycle. |

| | |
|---|---|
| Cycle time | Contains the time within a communication cycle in units of macroticks. Same as *cluster time*. |
| DATA | Data field in a frame. |
| DLC: | Data length field |
| Dynamic Segment | Segment of the communication cycle where frames are transmitted according to a mini-slotting algorithm. The sending order is defined by a statically determined identifier. Identifiers with smaller numbers have priority over identifiers with higher numbers. A communication cycle may consist of the static segment only. |
| EOF | End Of Frame. An optical or electrical physical layer may require different end of frame sequences. |
| ECU | Electronic Control Unit. Same as *node*. |
| EMC | Electro Magnetic Compatibility. |
| FIFO | First In First Out. Buffers can be configured to work as a FIFO memory for frames. |
| Frame | A frame consists of all information transmitted in one slot (with one identifier) on one channel. |
| FTA | Fault Tolerant Average. The FTA is a fault tolerant clock synchronization algorithm that is able to tolerate up to a pre-defined number $k$ of maliciously faulty clocks. This algorithm is based on a sorted array of clock deviations. The lower and upper k clock deviation values are discarded. From the remaining clock deviation values the average value is calculated and then used for the clock correction. |
| FTM | Fault Tolerant Midpoint. The FTM is a fault tolerant clock synchronization algorithm that is able to tolerate up to a pre-defined number $k$ of maliciously faulty clocks. This algorithm is based on a sorted array of clock deviations. The lower and upper k clock deviation values are discarded. From the remaining clock deviation values the median value is chosen for the clock correction. |
| Gateway | A node may function as a gateway and connect two or more networks. |
| Global time | Contains the combination of cycle counter and cluster time. |
| Hamming Distance | Minimum distance of any two code words within a code. |
| Host | The host is the part of an ECU where the application software is executed, separated by the CHI from the communication network. |
| ID | The frame identifier defines the slot position in the static segment and defines the priority in the dynamic segment. A lower identifier determines a higher priority. Identifier 0 is reserved for the SOC symbol. The identifier of a frame must be unique within a cluster. Each controller can have one or more identifiers (in the static and the dynamic segment). |
| Identifier | see, *ID*. |
| IFG | Inter Frame Gap. |
| LEN | Length field of a frame. |
| LLI | Logical Line Interface. |

| | |
|---|---|
| LSB | Least Significant Bit/Byte. |
| MAC | Media Access Control. |
| Macrotick | Basic unit of time measurement within a network of communication controllers. The clock synchronization mechanism guarantees that the clock values at all non-faulty controllers are equal. The uncertainty in the clock values is bounded by the precision. |
| Message | Application data transported within a frame. Several messages may be packed together to constitute a frame. |
| Microtick | Basic unit of time measurement within a communication controller for measuring the time difference between the controllers clock and the clocks of the other communication controllers. Clock correction is done in units of Microtick. |
| MSB | Most Significant Bit/Byte. |
| Network | A network consists of a set of nodes (more than one node) connected by communication subsystem. Networks are connected by special nodes (gateways). Same as *Cluster*. |
| Node | A node may contain one or more communication controllers. Equivalent to *ECU* (Electronic Control Unit). |
| Nominal Precision | The nominal precision is the clock synchronization precision that can be reached by the local clock synchronization of a cluster. |
| NRZ | Non Return to Zero physical layer coding scheme. |
| Precision | The precision is a time interval bounding the deviations between the local clocks of all active communication controllers. If a communication controllers clock deviates more than the precision from the clocks of the other controllers it must not participate in the communication any longer. |
| Slot | Duration of time during which one communication controller may access the communication medium. |
| SOC | Start of Cycle. Defines the start of a communication cycle in the pure dynamic mode, and the start of communication for start-up. |
| SOF | Start of Frame. An optical or electrical physical layer may require different start of frame sequences. |
| Star Coupler | A star coupler is connected to one channel. |
| Static Segment | Segment of the communication cycle where frames are transmitted according to a statically defined TDMA scheme. A communication cycle may consist of the static segment only. |
| SYNC | Synchronization field. This field indicates that the slot is used for clock synchronization. |
| TDMA | Time Division Multiple Access. |

**Index**

### A

application
layer ................10
arm
signal ..............41
asymmetric ................24

### B

baud rate ................27
bit
decoding ............34
encoding
*NRZ* ..................*34*
synchronization .......34
timing ..............34
bus
driver, electrical ....34
driver, optical ......34
guardian ............9
byteflight ................34
compatibility ........15

### C

clique .....................24
clock
external
synchronizatio
n ...............26
synchronization .......23

*alogorithm* .............*25*
*measurement* ...........*25*
*scalability* ...........*24*
communication
controller ...........33
cycle
*counter* ...............*18*
*dynamic segment* .......*17*
*length* ................*16*
*static segment* ........*16*
*structure* .............*15*
CONTROLLER_MAX .............13
CRC ........................15
current
consumption ...........32
cycle
time ................23
CYCLE_LENGTH_MAX ...........16

### D

dominant
bits ................20

### E

ECU
architecture .........10
EMC ........................31
external
correction
*term* ..................*26*

**F**

frame
coding ...............19
format ...............17
timing ...............20
FTM .......................25

**G**

global
time ............23, 24

**H**

Hamming
distance .............15.
hardware ...................27

**I**

identifier ............18, 19
interface ................39
bus driver - power
supply ..........42
bus guardian - bus
driver ..........42
communication
controller -
bus driver .......41
communication
controller -
bus guardian .....41
host - bus guardian ...41
host -
communication
controller .......39
interrupt ................41

**J**

jitter ....................9

**L**

latency ...................9
logical
line .................34

**M**

Mbit/s ...............13, 15
medium
access ..............16
message
transfer ...........11
microtick ..................23
multiplexing ..............19

**N**

network
configuration ........11
node
architecture .........10
Null frame indication
field ...........18

**P**

physical
layer ................10
physical layer
electrical ...........20
optical ..............19
power
consumption ..........31
mode .................27
supply ..............13
power modes ...............33
precision ................23
presentation
layer ................10
protocol
description ..........15
pure

dynamic ...............15

static ...............15

**S**

scalable

      fault tolerance ........9

shutdown ..................23

SOC .....................23

SOF .....................21

      window ...............25

soft reset ................39

start-up .................21

STATIC_SLOTS_MAX .......13, 16

STATIC_SLOTS_MIN ..........16

synchronization

      error ...............44

      field ...............18

**T**

TDMA ....................16

temperature ..............31

timer

      interrupt ...........41

topology .............11, 27

      heterogeneous ........22

transfer

      layer ...............10

**V**

voltage

      battery .............32

      monitoring ..........35

      supply .............32

**W**

wake-up ...............27, 37

**Chapter 1**

**Introduction**

**Objectives / Scope of PWD**

To design a new protocol new ideas will be created, discussed and developed. To collect all of these ideas, the protocol working document (PWD) was created. In the appendix the documentation of the technical discussion is done. This means that different approaches and solutions are listed and reasons are found and documented to decide for one solution.

Parts which are agreed and which will not change in the future significantly will be well documented moves to the main part. These chapters will be the base for the protocol specification.

The owner of the PWD is the FlexRay consortium. Members are BMW, DaimlerChrysler, Philips, Bosch, General Motors and Motorola. All of these companies deliver input to the appendix but only one editor (Motorola) handles the inclusion in the document.

**Terminology**

| | |
|---|---|
| **Application Data** | Data produced and/or used by application tasks, in the automotive context the term 'signal' is often used for application data exchanged among tasks |
| **Bus** | A communication channel in bus topology. Sometimes the word "bus" is used as synonym for communication channel. |
| **Bus idle Clique** | A subset of nodes (and stars) in a cluster which understand each other but do not understand the nodes (and stars) outside of this clique. The existence of cliques is usually an failure and protocol mechanisms try to avoid the generation of cliques. |
| **Cluster** | A communication system is called cluster if two or more nodes are connected via at least one communication channel directly (bus topology) or by star couplers (star topology). Two or more cluster built a network. |
| **Communication Channel** | The physical connection between node/node, star/star, node/star or star/ node. The physical connection can work electrical or optical. |
| **Communication cycle Correct frame Cycle time** | Time for one communication cycle. |
| **Dynamic part Encoded Packet** | A packet encoded for transport on the physical communication media using, for example, NRZ 8N1 or Xerxes coding |
| **Frame** | A Structure used by the communication system to exchange information within the system, a frame consists of a header section, a payload section and a footer section; the payload section contains data fields, in which a message instance is copied. |
| **Header Message** | A block of application data (signals) to be exchanged among tasks (ECUs) |
| **Message Instance** | One copy of a message that is transmitted by the communication system. At the receiver multiple message instances may be used to generate a new single message by using, for example, an agreement algorithm. |
| **Network** | A network is a communication system built with clusters which are coupled via gateways. |
| **Node** | A unit built with a communication controller, a host CPU and a (quartz) oscillator. The communication controller is connected at least to one communication channel. |
| **Packet** | A frame or symbol amended with physical layer specific elements; so far these elements are the frame-start-sequence, the start-of-frame symbol and the frame-end-sequence. |
| **Payload Star** | A unit that connects nodes and others stars. Every star has |

| | |
|---|---|
| | more than two inputs/outputs. A star can be passive or active. |
| **Static part** | Part of the communication access time scheme where the media access works with a time division media access (TDMA). This means that every node owns one or more time slots statically and only this node is allow to write on the communication channel during this time. |
| **Sync frame** | |
| **Trailer** | Frame which is marked to use for clock synchronization. |

**Variable and Parameter Names**

Following is a description of the notation of variables, constants and parameters how it is used to document in the PWD and in the protocol specification.

Table 4:

| Naming Conventions | | |
|---|---|---|
| **Naming Convention** | **Information Type** | **Description** |
| cName | Constant | values used to define the protocol, is fixed for the protocol and can not be changed |
| vName | Variable | values which will be changed depending on time, events, etc. |
| gName | Global Parameter | parameter which must have the same value in all nodes in a cluster, is initialized during soft reset, can only be changed during soft reset |
| pName | Local Parameter | parameter which may differ in nodes of a cluster, is initialized during soft reset, can only be changed during soft reset |
| fName | Variable for frame content | fName-variables are set in the transmitter node and read in the receiver node |
| xdName | Time Duration | value (variable, parameter, etc.) describing a time duration, time between two time points |
| xtName | Time | value (variable, constant, etc.) describing a instant |
| xsName | Set | set of values (variables, parameters, etc.) |
| x | | stands for one of c, v, g, or p |

**Code Conventions**

To specify functions and algorithms short code pieces are used. For the notation of this code the MATLAB syntax is used. Following is a short description of the used functions and elements.

Table 5:

| Pseudocode Conventions | |
|---|---|
| **Function or Element** | **Description** |
| x=LENGTH(list) | returns the number of elements of the list "list" |
| list = [list, x] | appends the list "list" by the element "x" at the end of the list |
| x = list(i) | x is the element i of the list "list" |
| x = SORT(list) | returns a sorted list of list "list" following: list(1) >= list(2) >= list(3) >= >= list(n-1) >= list(n) |
| x = MIN(a,b) | minimum, returns a if a < b, otherwise b; if a invalid returns b, if b invalid returns a, if a and b invalid returns an empty set |

Table 5:   (continued)

| Pseudocode Conventions | |
| --- | --- |
| **Function or Element** | **Description** |
| x = MIDTERM(list) | fault tolerant midterm algorithm, see section Fault-tolerant Midpoint Algorithm |
| x = Int[a] | returns the integer part of the (real) number a |
| x = \|a\| | returns the absolute value of a (a without sign) |

**Chapter 2**

**Basic Concepts (Prerequisites)**

**Protocol Layers**

**Architecture**

**Network Topologies**

A network can be configured as a single-channel or dual-channel bus network, a single-channel or dual-channel star network.

**Bus Topology**

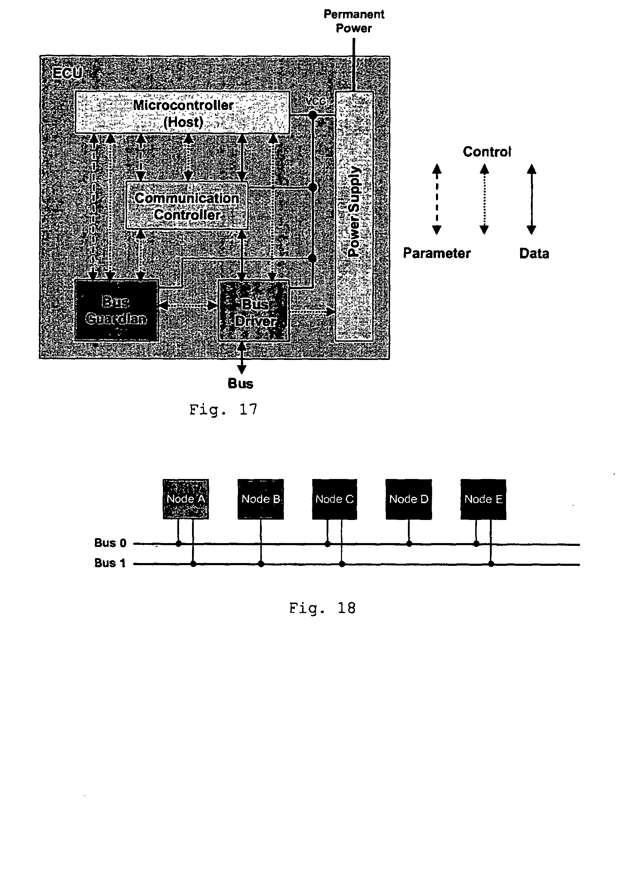

*Figure 18* shows the possible topology configuration of the communication network as a dual bus. A node can either be connected to both channels 0 and 1 (nodes A, C, and E), only to channel 0 (node D) or only to channel 1 (node B).

The FlexRay communication network can also be a single bus. In this case, all nodes are connected to this bus.

**Star Topology**

**Valid Star Network Configurations**

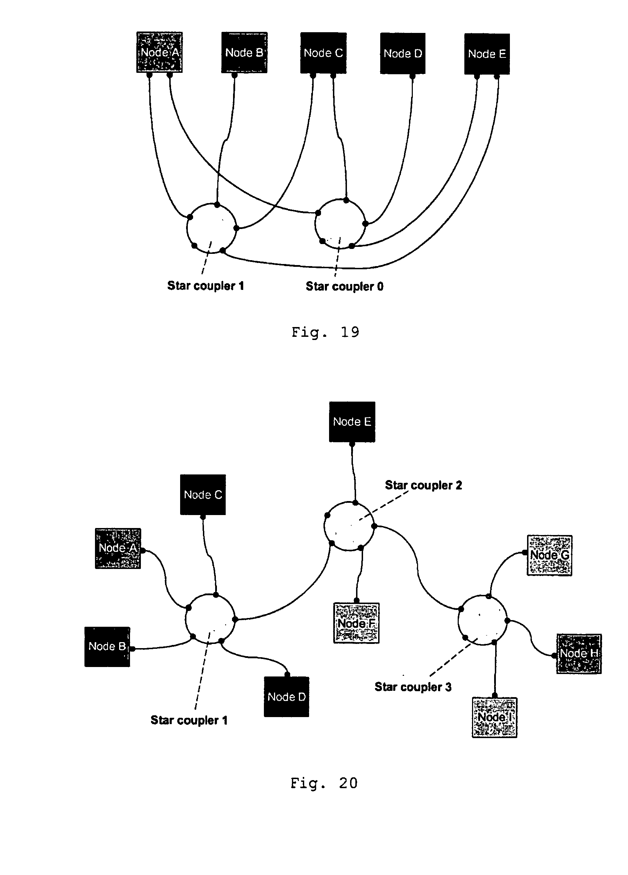

A FlexRay communication network can be built as a multiple star topology. Similar to the bus topology, the multiple star topology can be set up redundantly. Each network channel must be free of closed rings, and there may only be 1 up to *cStarCouplersMax* sequentially connected (cascaded) star couplers (the total number of star couplers may be more than *cStarCouplersMax* if there are branches in the network). Each network line between communication node and the star coupler or between two star couplers represents a properly terminated point-to-point connection. The incoming signal received by the star coupler is actively driven to all communication nodes Figure 19 shows a single redundant star coupler configuration

**OpenTopic:** We assume that the star coupler drives all connected nodes and star couplers except the reception line. Also we assume that one a line erroneously driven by the star coupler and another instance will show a signal causing an encoding error in any case. We assume that other lines driven by the star coupler are not affected by such a conflict.

If two or more inputs of the star coupler are start to be driven at the same time or in a time window shorter than *gdBit* we assume that one of this will cause a signal with encoding violation on all outputs driven by the star coupler.

SUGGESTION: this is part of the error model or star node description MJ).

Figure 20 shows a single channel network with three star couplers.

The configuration of a single redundant star network is shown in *Figure 19*. The logical structure of this topology is identical with the logical bus structure shown in *Figure 18*. A topology which has a single non-redundant star, which has the logical bus structure of the single bus mentioned above, is also possible.

*Figure 20* shows a single channel network built with three star couplers. Each node has a point-to-point-connection to one of the three star couplers. Two of the star couplers (No. 1 and 3) are directly connected to the third star coupler (No. 2).

**Open Topic:** A mixed star/bus topology is not yet discussed.

**Star Coupler Behavior and Protocol Impact**

**Open Topic:** What is the complete state diagram for the star coupler (later there is mentioned an "initial state")? Does it support a sleep mode, and if so has the wake-up an impact on the protocol? Does it have a reset state, a startup state or an error state? How is it tested? How does it behave after a short power down?

**Open Topic:** Open topic: For the modeling project it is assumed that all connections of a star coupler are set up for reception per default. When the first bits (this time is called "configuration setup delay" and is configurable in the model) of a Frame Start sequence are detected on one receive line this causes the other receive lines to be reconfigured for transmission. A sequence of correctly encoded bits is assumed to cause this reconfiguration, though (pessimistic assumption). Noise does not cause this reconfiguration. If the condition for this reconfiguration is observed on two or more receive lines within a time window of 1 *gdBit* the star coupler generates a signal with illegal encoding on all other lines that will then be reconfigured as transmit lines. Actually in the model the same signal is generated like for a bus with overlapping frames.

This reconfiguration remains until an idle signal is recognized on (all) the receive line(s). As soon as this is recognized all lines are reset to the default configuration.

- For each node connected to a star coupler, the star coupler contains a bi-directional connection operating in half-duplex mode.

- Before transmitting a frame, the connections must be set up as either receive or send in each star coupler

- The frame format in FlexRay defines a Frame Start Sequence (FSS, see xxx), which is used to initiate a proper connection setup throughout the network before the actual FlexRay message is transmitted. The transmission of the FSS is interpreted and handled by the star coupler as a connection setup request. There is no Frame End Sequence defined in FlexRay, and the star coupler is returned to it's idle state after the bus has been released to the idle state by the last transmitting node.

**Open Topic:** Should there be a frame end sequence?

- The detection of activity generated by the FSS transmission causes the star coupler to turn on the driver devices accordingly. The line on which activity was first monitored remains the input to the star coupler, i.e. available for the reception of the message sent by the transmitting node. The star coupler activates all remaining line drivers as outputs to the nodes and other star couplers that should receive the message.

- The FSS may degenerate by propagating through the star coupler.

- The FSS must be detected by all cascaded star couplers and by all receiving end nodes in the network. This imposes requirements on the minimum length of the Frame Start sequence, since each communication element consumes a portion of the Frame Start sequence. *Table 6* gives an overview of maximum configuration setup delays.

**Open Topic:** What does "Detection Events" mean and does this term make sense in a point to point configuration?

**Open Topic:** Is this table valid for optical and electrical transmission medium?

**Open Topic:** 'Detection Events' actually means 'Detectors' i.e. in a point to point, there is only one detector - the receiving node - and no portion of the Frame Start sequence is consumed, in a single star network, there are two detectors - star-coupler and receiving node - and the first of those will consume part of the Frame Start sequence, and so on. The point-to-point connection defines the minimum Frame Start sequence and so does make sense to include it in this table.

**Open Topic:** needs to be clarified, but probably isn't due to the different optical device characteristics.

**Comment:** Detection Events detailed in *Table* 6 actually means 'Detectors' i.e. in a point to point or broadcast bus topology, there is only one detector - the receiving node - and no portion of the FSS is consumed, in a single star network, there are two detectors - star-coupler and receiving node - and the first of those will consume part of the Frame Start sequence, and so on. The point-to-point connection defines the minimum FSS.

Table 6:

| Maximum Frame Start Sequence Durations wrt Network Topology | | | |
|---|---|---|---|
| **Network Topology** | **Detection Events** | **Frame Start Sequence [ns]** | **e.g. number of *gdBit* @ 10 Mbps** |
| Point to point/Bus | 1 | 200 | 2 |
| Single Star | 2 | 400 | 4 |
| 2 Cascaded Star Couplers (not supported FPGA V4) | 3 | 600 | 6 |
| 3 Cascaded Star Couplers (not supported FPGA V4) | 4 | 800 | 8 |

- At the end of each frame transmission, all star couplers must return to the initial state before the next configuration request is initiated. This ensures that the star coupler is able to process the next configuration request correctly.

- The overall time needed to return a network to the initial state is determined by the individual configuration release delays in the star couplers. In a cascaded star coupler network, these delays sum up, similar to the configuration setup delays. *Table 7* gives an overview of the maximum configuration release delays.

Table 7:

| Maximum Release Sequence Durations wrt Network Topology | | | |
|---|---|---|---|
| **Network Topology** | **Release Events** | **Release Sequence [ns]** | **e.g. number of *gdBit* @ 10 Mbps** |
| Point to point/Bus | 1 | 200 | 2 |
| Single Star | 2 | 400 | 4 |
| 2 Cascaded Star Couplers (not supported FPGA V4) | 3 | 600 | 6 |
| 3 Cascaded Star Couplers (not supported FPGA V4) | 4 | 800 | 8 |

- The minimum idle time between two consecutively transmitted frames must accomodate both the Release and Detection events detailed in the above tables. (overall configuration release delay and the overall configuration setup delays)

**Comment:** Consolidate terminology: communication channel, bus, star

**Node Architecture**

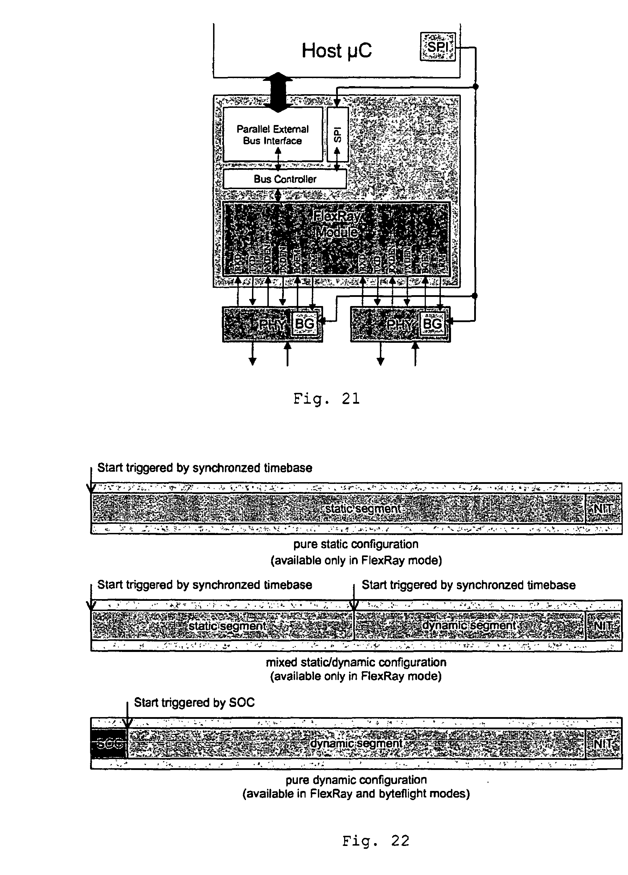

*Figure 21* shows an example of the architecture of a node.
Every node consists of the four sub-components host, communication controller, bus guardian and physical driver.
The sub-components may be discrete, or certain combinations of them may be integrated together e.g. bus guardian and physical layer (as shown) and host and communications controller.

**Protocol Services**

- Message transfer

- Synchronized time base

- Sleep, Shutdown

- Diagnosis

**Dependability Issues**

**Failure Resilience Requirements**

**Assumed Fault Models**

**Assumed Fault Hypothesis**

**Design Principles**

**Chapter 4**

**Media Access Scheme**

In FlexRay media access is performed within a periodically recurring communication cycle. The structure of this communication cycle is described in this section.
Within one communication cycle FlexRay offers the choice of two media access schemes. These are

- a static time division multiple access (TDMA) scheme (static segment), and

- a dynamic byteflight-compatible mini-slotting based scheme (dynamic segment).

The duration of each segment is configurable. A pure static mode, a mixed mode containing a static as well as a dynamic scheme and a pure dynamic mode may be configured. Section "Static Segment (TDMA Access)" of the specification focuses on the static TDMA scheme and Section "Dynamic Segment" covers the dynamic mini-slotting based scheme.
The FlexRay protocol offers the option of implementing clusters with a single communication channel (channel A only) or with dual communication channels (channel A and channel B). In the case of a dual channel cluster the channels are synchronized to one another. In the dual channel case nodes may be connected to either one or both of the communication channels. Dual channel systems support nodes connected to only one of the communications channels of the cluster. Such single channel nodes can be connected to either channel A or channel B.

**Communication Cycle**

The communication cycle is the fundamental element of the media access scheme within FlexRay. In order to accommodate both communication schemes within one communication cycle the communication cycle consists of a combination of two segments: a static segment and a dynamic segment.

- Within the static segment the static TDMA scheme is used to control access to the communication media.

  - The internally synchronized time base of each communication controller controls the static TDMA scheme.

- Within the dynamic segment the mini-slotting based scheme is used to access to communication media.

  - A Dynamic Communication Trigger (DCT) initiates the mini-slotting scheme.

- The communication cycle is concluded by a communication traffic free period known as the Network Idle Time (NIT).

- The maximum duration of a communication cycle is *cdCycleTimeMax*.

- The duration of the communication cycle is set in *gdCycleTime* such that *gdCycleTime <= cdCycleTimeMax*.

Depending on the type of configuration either one or both segments exist:

- In a pure static configuration only the static segment exists.

- In a mixed static/dynamic configuration the static segment is succeeded by the dynamic segment.

- The DCT is derived from the synchronized time base.

- Each node triggers the DCT at the end of the static segment.

- In a pure dynamic configuration only the dynamic segment exists.

- The DCT is derived from an explicitly sent Start of Cycle (SOC) symbol.

The availability of the different configurations differ between the FlexRay mode and byteflight mode:

- In FlexRay mode it is possible to chose among the pure static, the mixed static/dynamic, or the pure dynamic configuration.

- The FlexRay frame format is used for all configurations.

- In byteflight mode only the pure dynamic configuration is available.

- The byteflight frame format is used.

The interdependencies between operating mode, configuration, frame format and media access schemes are summarized in Table 8.

Table 8:

| Relationship between operating mode, configuration, frame format and media access scheme Figure 22 illustrates the different communication cycle configurations that are available. | | | | | |
|---|---|---|---|---|---|
| *Mode* | *Configuration* | *Frame Format* | *Static Segment* | *DCT* | *Dynamic Segment* |
| *FlexRay* | *Pure Static* | FlexRay | exists | - | - |
| | *Pure Dynamic* | FlexRay | exists | synchronized timebase | exists |
| | *Mixed Static/ Dynamic* | FlexRay | - | SOC | exists |
| *byteflight* | *Pure Dynamic* | byteflight | - | SOC | exists |

**Static Segment (TDMA Access)**

The communication cycle contains a static segment in

- FlexRay mode pure static configuration and in

- FlexRay mode mixed static/dynamic configuration.

**Principle**

Within the static segment access to the communication media is controlled by a static Time Division Multiple Access (TDMA) scheme.

**Structure**

- The static segment is divided into a number of static communication slots (or "static slots"). Within a given cluster all static slots have equal duration, which is an integral number of macroticks.

- The duration of a static slot is defined by the parameter *gdSlot* in multiples of macroticks.

- The number of static slots available within a communication cycle is defined on a per cluster basis in *gNumberOf-StaticSlots.*

- The overall duration of the static segment (in macroticks) is defined in *gdStaticPart* such that *gdstaticPart = gdSlot \* gNumberOfStaticSlots*.

- A unique slot ID ranging from 1 to *gNumberOfStaticSlots* is assigned to every static slot in ascending order starting with 1. Slot IDs match on both channels.

- The maximum number of static slots available in any FlexRay cluster is determined by *cStaticSlotMax*.

- The static segment starts with the start of the first static slot.

- The start of a static slot coincides with the start of a macrotick.

- The static segment ends with the end of the last static slot.

**Slot Assignment**

- A static slot is assigned on a per channel basis to a specific communication controller for transmission.

- A maximum of *cStaticSlotMaxPerNode* static slots may be assigned to a single communication controller.

- Static slots may remain unassigned.

- Two different nodes can share a slot only if both nodes are single channel nodes and the nodes are connected to different channels of a dual channel system.

**Frame transmission**

- Transmission of a frame occurs in the slot in which the slot ID matches the Frame ID.

- Frames have a fixed length within the static slots.

- A frame is only transmitted if the payload length code that is used in the frame matches the cluster-specific configuration parameter defining the payload length for static frames. (*fPayloadLength* is compared with *gPayloadLengthStatic*)

**Consequences**

- The frame ID determines the position of each frame within the static segment.

- All frame ID's are unique per communication channel during one communication cycle.

- Depending on the allocation of slots and of the configuration of a given node it sends either no, one or multiple frames within the static segment.

As a result the following transmission patterns are possible:

- Assuming that for a given slot both channels are assigned to one communication controller, it is possible for the communication controller to send

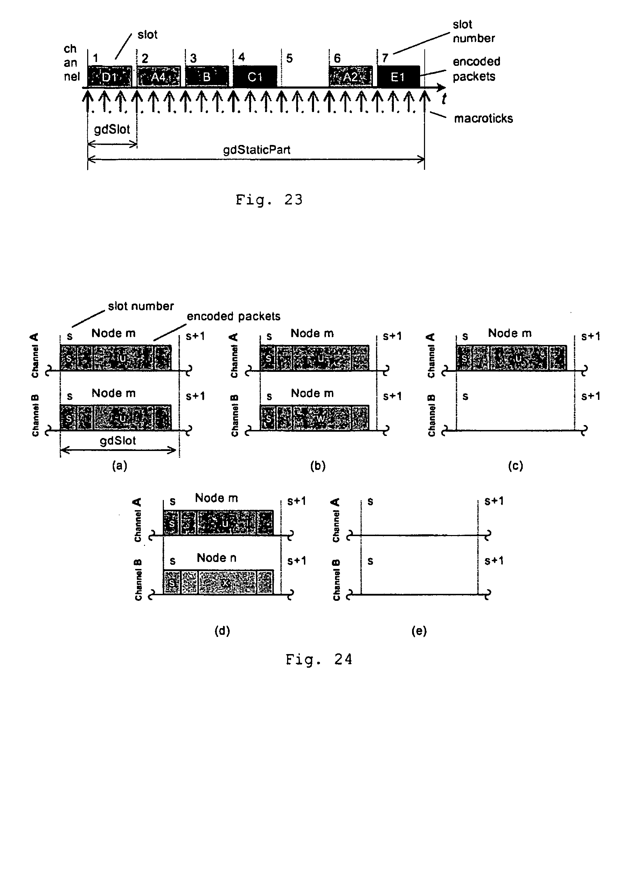

1. a frame with identical content on each of the two channels, as shown in Figure 24 (a), or

2. a frame with different content on each of the two channels, as shown, for example, in Figure 24 (b), or

3. a frame on one channel but no frame on the other channel, as shown, for example, in Figure 24 (c), or

4. no frame at all, as shown in Figure 24 (e).

- Assuming that for a given slot only one channel is assigned to one communication controller, it is possible for the communication controller to send

    1. a frame on the assigned channel, as shown, for example, in Figure 24 (c) for channel A, and in Figure 24 (d) for the case that the other channel is assigned to another communication controller, or

    2. no frame at all, as shown, for example, in Figure 24 (c) for channel B and Figure 24 (e) for both channels.

Figure 23 shows the transmission slot layout within the static segment of the communication cycle.
Figure 24 shows the basic media access patterns for two channels. (add explanation of figure here)

**Frame Validation**

Receive buffers are only updated in Normal Mode; receive buffers are not updated during startup.
All of the following (channel individual) checks must be successful for a static frame in a receiver before the frame may be copied into a receive buffer:

**Context and coding checks**

- CheckIdlebeforeFrame_x

- CheckFrameCoding_x

- CheckHeaderCRC_x

- CheckCRC_x

**Content checks**

- CheckFrameIDStaticRange_x

- CheckStaticPayloadLength_x

- CheckFrameID_x

- CheckCycleCount_x

- CheckReceivedPayloadLength_x

**Timing checks**

- CheckT_RW1_x

**Dynamic Segment**

The communication cycle contains a dynamic segment in

- FlexRay mode mixed static/dynamic configuration, in

- FlexRay mode pure dynamic configuration, and in

- byteflight mode.

**Principle**

Within the dynamic segment access to the communication media is controlled by a byteflight-compatible flexible time-division multiple access (FTDMA) scheme.

**Overview**

- Media arbitration is performed by means of priorities and slot counting.

- The priorities are given by the frame ID's. Priority is actually determined by the time the frame is sent (i.e., the slot counter value). The frame ID should be set to the same value as the slot counter, but if it is not it has no bearing on the priority (the frame will be rejected, though).

    - The highest priority equals the lowest frame ID.

    - If the dynamic segment is preceded by a static segment then the highest priority is determined by the number of static slots reserved in the static segment. The highest priority in the dynamic segment is defined to be *gNumberOfStaticSlots* + 1.

    - Each priority, and thus each frame ID, is unique per communication channel for every communication cycle. Therefore a frame ID of a given value can appear only once per communication channel during one communication cycle.

- Each node maintains channel specific slot counters denoted *vSlotCounter_A* and *vSlotCounter_B* respectively.

- At the start of the dynamic segment the slot counters are initialized with *gNumberOfStaticSlots*. This accounts for the potential of a preceding static segment. In FlexRay pure dynamic or byteflight mode *gNumberOfStaticSlots* is set to zero (0).

- An ongoing frame reception from the static segment is aborted when the dynamic segment begins. The incomplete received frame is treated as an error (warning level) that is signaled to the host. The portion of the frame that remains in the dynamic segment is treated as bus activity and therefore will stop the slot counters in a manner similar to normal noise that is detected at the start of the dynamic segment.

- For dual channel systems, the channels operate independently. Independent operation means that there is no synchronization of the slot counters on the two channels. The beginning and end of the dynamic segment occurs at the same time for both channels, however.

**Start of the dynamic segment**

- The dynamic segment starts with the dynamic communication trigger (DCT).

**Mixed Static/Dynamic Configuration**

• In mixed static/dynamic configurations the DCT coincides with the end of the last static slot.

• All nodes are initially considered receivers.

**Pure Dynamic Configuration**

• In pure dynamic configurations a predesignated node sends an SOC symbol. In this case the DCT coincides with the end of the SOC symbol.

• In a dual channel system the SOC is sent simultaneously on both communication channels.

• For a node connected to both channels in a dual channel system the first valid SOC that is received on either of the channels acts as the DCT for both channels.

• The node that sends the SOC symbol is the DCT transmitter, the remaining nodes are DCT receivers.

    • The DCT sender subsequently waits for the duration *pdWx0Tx + pdWxDelta* before incrementing the channel-specific local slot counter by one.

    • The DCT receivers subsequently wait for the duration *pdWx0Rx + pdWxDelta* before incrementing the channel-specific local slot counter by one.

The following pseudocode describes the initialization and start of the dynamic segment.

```
VSlotCounter_x = gNumberOfStaticSlots;          //
                                        //
if pMaster == true and gNumberOfStaticSlots == 0       //
   TransmitSOC();                      //
   TimeOut(pdWx0Tx);                   //
   vdWaitTime = pdWxDelta;                 // The second
part of the wait occurs in
                                    // the parallel section
of the main


                                    // transceive loop
   else                                 //
      vdWaitTime = pdWx0Rx + pdWxDelta;        //
      end;                              //
```

**Comment:** When is the slot counter incremented (Check, explain)? Proposal: put the pseudocode together; explain meaning vdWaitTime.

During the dynamic segment each node is engaged in one of three activities: waiting for a minislot in which it will transmit a frame, frame transmission, or monitoring channel activity and frame reception. These are described subsequently. Note that the following activities are performed independently for each communication channel.

**Waiting**

- The node waits for an initial duration that is either *pdWx0Tx* or *pdWx0Rx*.

- The slot counter is subsequently incremented by one after each *pdwxDelta* period of time passes.

**Frame transmission**

- If the frame ID of a frame that is scheduled for transmission matches the value of the slot counter the respective frame is transmitted.

- After finishing transmission the sender waits for *pdWx0Tx w + pdWxDelta*. However, during the period of *pdWx0Tx* the sender disables its receiver.

- A frame is only transmitted if the value calculated for *fPayloadLength_x* is not greater than the maximum allowed value according to the frame format definition.

**Channel activity and frame reception**

- Any channel activity causes the slot counting mechanism to stop.

- If a frame transfer is causing the channel activity, the frame is received.

- Once the channel activity ends the node waits for *pdWx0Rx + pdWxDelta.*

- If the frame ID of the received frame differs by one compared to the respective slot counter then the respective slot counter is readjusted to the value of the received frame ID.

The following pseudocode summarized the three activities described above

```
while vSlotCounter_x <= cSlotIDMax                    //
                                                 //
   if NextScheduledFrameID_x == vSlotCounter_x AND vMacrotick
<= pdLatestTX //
      TransmitFrame();                           //
      TimeOut(pdWx0Tx);                          //
      vdWaitTime = pdWxDelta;                    //
   end;                                         //
                                          // first task to
terminate ends the
   parallel                                // parallel
section: this is either
      {timeout vdWaitTime};                    // a timeout ->
next minislot
      {monitor channel};                       // or channel
activity
   end;                                      //
                                          //
   if vChannelActivity_x == true                      //
      ReceiveFrame();                          //
                                          //
      if (CheckFrameIDDynamicRange_x == 'T')          //
```

```
        if (((fFrameID_x + 1) == vSlotCounter_x ) OR          //
correct frame ID if missmatch by
            ((fFrameID_x - 1) == vSlotCounter_x ))          // one
            vSlotCounter_x = fFrameID_x;             //
        end;                                      //
                                                  // if the received
frame has a frame
        if (vSlotCounter != fFrameID_x)              // ID that
is valid for the dynamic
            {signal slot missmatch error};           // segment
the frame is stored
        end;                                      // regardless whether
it has caused
                                                  // a slot missmatch or
not
        {store received frame using fFrameID};
    else
        {signal slot missmatch error};
    end;

    vdWaitTime = pdWx0Rx + pdWxDelta;            //
  end;                                            //
end;                                              //
```

Pseudocode: {timeout *vdWaitTime*}

```
TimeOut(vdWaitTime);                          //
VSlotCounter_x++;                             //  //
vdWaitTime = pdWxDelta;                       //
```

Pseudocode: {monitor channel}

```
while vChannelActivity_x == false                   //
end;                                          //
```

In the pseudocode above, the function ReceiveFrame() performs frame validation. This function returns

• at the end of a correct frame or

• as soon as an error is detectable and channel idle is signaled

**Termination of the Dynamic Segment**

The dynamic segment terminates if either of the following two conditions is met:

• The respective slot counter reaches the maximum available Slot ID contained in *cSlotIDMax*, i.e. *vSlotCounter_x > cSlotIDMax.*

• The start of the network idle time is reached, i.e. *vMacrotick == gtStartNIT.*

**Frame Validation**

Receive buffers are only updated in Normal Mode; receive buffers are not updated during startup.

All of the following (channel individual) checks must be successful for a dynamic frame in a receiver before the frame may be copied into a receive buffer:

**Context and coding checks**

- CheckIdleBeforeFrame_x

- CheckFrameCoding_x

- CheckHeaderCRC_x

- CheckCRC_x

- CheckIdleAfterFrame_x

**Content checks**

- CheckFrameIDDynamicRange_x

- CheckCycleCount_x

- CheckReceivedPayloadLength_x

**Examples**

The examples given in the following sections are for a pure dynamic system. A mixed static/dynamic system would behave in a similar manner, except a constant value of *gNumberOfStaticSlots* would be added to all slot counters and Frame ID's in the examples.

**Examples of Fault-Free Situations**

The examples below show how a DCT or frame transmission/reception synchronizes the node's slot counters and how the slot counters are incremented during the wait time *vdWaitTime*.

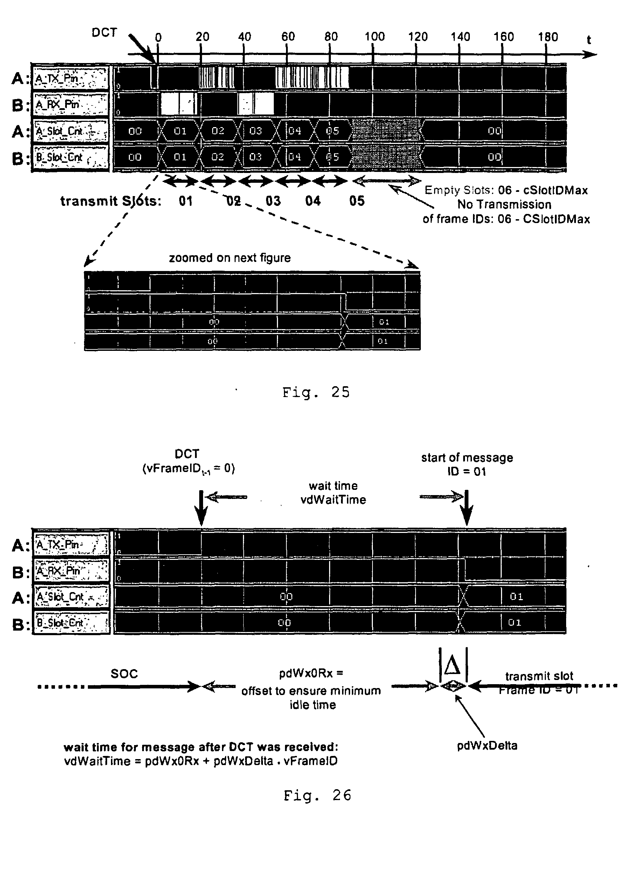

Figure 25 shows distributed synchronized slot counters of nodes A and B. Node A sends the ID's 2, 4 and 5. Node B sends the ID's 1 and 3. Figure 26 below demonstrates how the waiting time for the frame with Frame ID = 1 is calculated. At the end of the SOC (which in this case serves as the DCT) the waiting time begins. It consists of the fixed part *pdWx0Rx* and the period *pdWxDelta* for the frame ID = 1. As soon as the waiting time is over, the slot counters switch the value to 1 in all nodes - in this case, node B, since it has a transmit request for Frame ID 1, starts transmitting. If a node recognizes a bus activity, e.g. because of a received frame, it stops its slot counter. In this way, the slot counter remains synchronized with the received or transmitted frame ID (Provided, of course, that the values for calculating the waiting time of the nodes are set correctly.). Bus activity detection is performed after the glitch filter. Bus activity is detected if at least one period of *gdBit* is recognized as bus active (The 1 * gdBit period of activity is equivalent to the minimum duration of the Frame Start Sequence). For a 2-State physical layer, bus activity equals the logical '0' level. For a 3-state physical layer, bus activity equals either a logical '0' or a logical '1' with the RX_enable signal active.

Figure 26 shows the calculation of *vdWaitTime* after DCT.

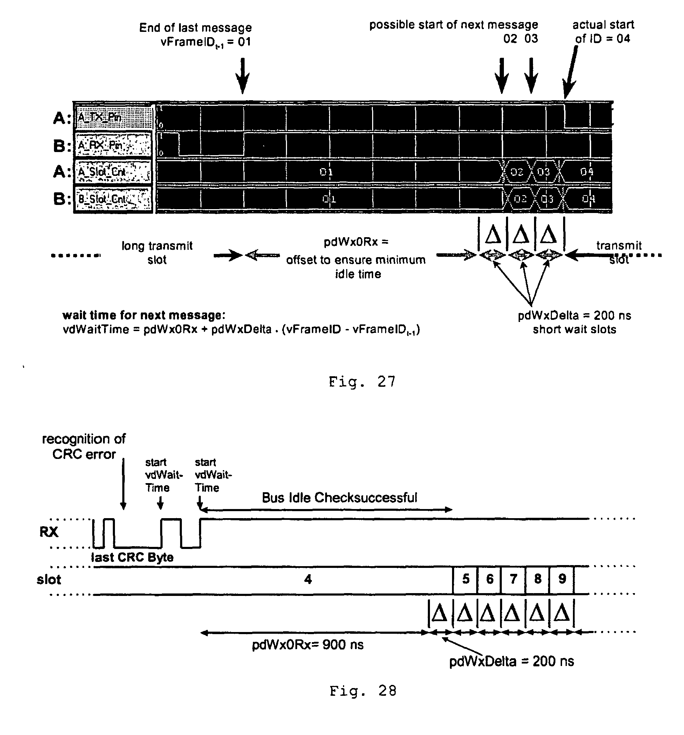

Figure 27 shows the waiting time (*vdWaitTime*) calculation between the frames that carry Frame ID = 1 and Frame ID = 4:

All slot counters in transmit slot 1 have a value of 1. At the end of the frame with frame ID = 1 the wait time starts. It consists of the fixed part *pdWx0Rx* and three times *pdWxDelta* waiting slots for the frame ID = 4. Each time one of the *pdWxDelta* times is over, the slot counters are incremented by one. Frame IDs 2 and 3 are now able to transmit. However, in this communication cycle no transmissions take place because there is no transmit request for these two frames. After the waiting time for Frame ID = 4 is over, node B, which in this case has a transmit request for Frame ID 4, starts transmitting.

To apply the example to a mixed static/dynamic configuration it is necessary to add the parameter *gNumberOfStaticSlots* as an offset to all slot counter and frame ID values.

### Examples of Slot Counter Behavior in Case of Errors

The following diagrams are intended to explain the waiting time calculation after frame format errors. They all show the reception line (RX) and the slot counter (referred to as slot) of a node.

Figure 28 shows the slot counter after a frame format error, in particular an example of a CRC error detected in the last CRC byte on a 2-State physical layer. As soon as the ascending flank and the bus idle occurs at the receiving line the wait time *vdWaitTime* is started (at least hypothetically). Since activity is again detected on the bus before the slot counter is incremented, the wait time *vdWaitTime* is started again at the next ascending flank. In this case the time (*pdWx0Rx* + *pdWxDelta*) elapses without any further bus activity and the slot counter is increased by one. Transmitting and receiving is now possible again starting with slot 5.

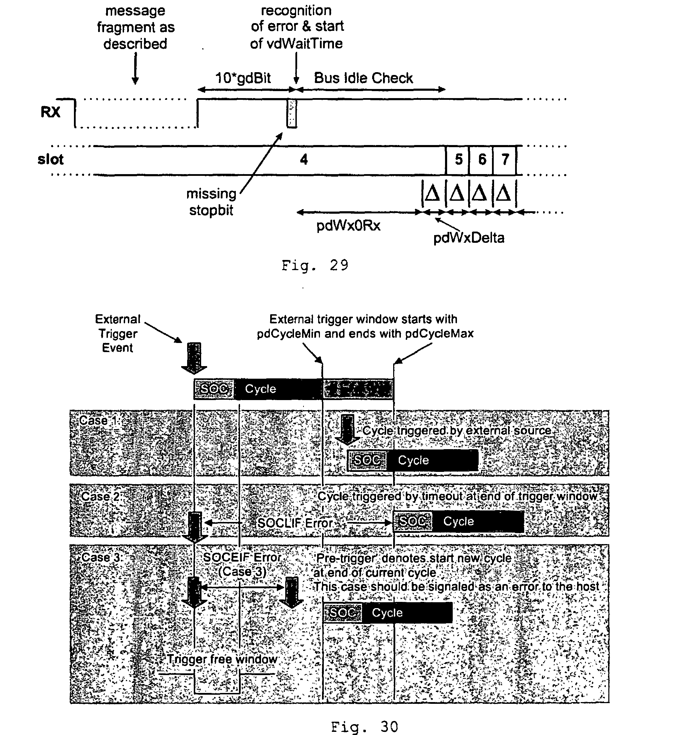

Figure 29 shows an example of what happens when the receiving device is able to detect an error some time after the last ascending flank of the error or of the frame fragment (slot counter after frame fragments). This is the case, for example, when using a optical physical layer with NRZ coding, if the receiving device expects the size of the frame (byteflight frame format) to be larger than it actually is because of a bit error in the data length field of the frame. The error can only be detected with the last missing stop bit, which is 10 * *gdBit* after the last rising flank. The same effect occurs if a frame fragment that looks like a valid Frame Start Sequence is detected on the receiving line. A format or coding error can only be discovered 10 * *gdBit* after the ascending flank because the frame fragment is accepted as a valid Frame Start Sequence and is only detected due to the missing stop bit.

In all these cases, the waiting time *vdWaitTime* begins as soon as the error is detectable and the receive line has reached the bus inactive state.

The error handling methods described above are applied in pure dynamic configurations and during the dynamic segment in a mixed static/dynamic configurations.

### Network Idle Time

The duration of the network idle time is denoted *gdNIT*.

The network idle time starts at

*gtStartNIT = gdCycleTime - gdNIT*

The parameter *gdNIT* depends on the signal propagation delay, the clock synchronization execution time, and an additional time period that ensures the ability of a node to properly handle the reception of a frame that starts up to 0.5 * *gdSlot* before the first slot of the cycle begins.

Any ongoing frame reception is aborted when the Network Idle Time begins. The incompletely received frame is treated as an error (warning level) that is signaled to the host.

### Modes and Configuration

### FlexRay Pure Static Mode

In FlexRay pure static mode the communication cycle contains the static segment and the network idle time. This mode is available in single and dual channel configurations.

### Cluster Specific Configuration

At least 2 static communication slots must be configured.

At least 2 synchronization frames must be exchanged.

**Comment:** synchronization frames - is not introduced, to be explained

**Comment:** Crosscheck with clock sync chapter. A system should continue working even if only one Sync frame is left.) What happens if two nodes are in operation and one node fails. Does this cause the remaining node to stop?

### Node Specific Configuration

The following parameters must be configured:

- *gNumberOfStaticSlots* (number of static slots)

- *gdSlot* (the duration of one static slot)

- *gdCycle* (the duration of the communication cycle)

- *gdNIT* (the duration of the network idle time)

- The configuration must satisfy *gdCycle* = (*gNumberOfStaticSlots* * *gdSlot*) + *gdNIT*

**FlexRay Mixed Static/Dynamic Mode**

In FlexRay mixed static/dynamic mode the communication cycle contains the static segment, the dynamic segment and the network idle time.

- This mode is available in single and dual channel configurations.

- All nodes execute the clock synchronization using the frames of the static segment.

- It is possible to configure nodes that transmit frames only within the dynamic segment. These nodes have a static segment configured but have no transmit buffer configured to send frames with a Frame ID less than or equal to *gNumberOfStaticSlots*.

- Nodes that transmit only during the dynamic segment take part in the clock synchronization by receiving sync frames and determine the start of the dynamic segment in the same way as nodes that also transmit frames in the static segment.

- During the dynamic segment the frame sequence on the two channels is independent and may be different, i.e., any node may send different frames with different Frame ID's on the two channels, resulting in a different frame sequence on the two channels.

- The length of frames transmitted in the dynamic segment may be different for every communication cycle, i.e., frames with the same Frame ID may have variable length. A frame's length is derived from the payload length field in the frame header.

- A frame is only transmitted during the dynamic segment if the corresponding transmit buffer was marked as "ready for transmission", i.e., no "null frame" will be sent if the host does not update the data. This is in contrast to the static segment, where the CC will send a null frame if a buffer is configured for a slot but the host does not mark the buffer "ready for transmission".

- For a given communication cycle the dynamic segment may be empty, i.e., no frames are transmitted with dynamic medium access control. This may be because no frame with a frame ID greater than *pNumberOfStaticSlots* is configured in any transmit buffer, or because no dynamic segment frame has been marked "ready for transmission" by its host.

- The startup mechanism for this mode is the same as for the pure static mode.

- In this mode startup is only performed by coldstart nodes.

**Cluster Specific Configuration**

- At least 2 static communication slots must be configured.

- At least 2 synchronization frames must be exchanged.

The following parameters must be configured:

- *gNumberOfStaticSlots* (number of static slots)

- *gdSlot* (the duration of one static slot)

- *gdCycle* (the duration of the communication cycle)

- *gdNIT* (the duration of the network idle time)

- *pdLatestTx* (latest starting point for a frame in the dynamic segment)

- The duration of the dynamic segment is calculated by: *gdDynamicPart = gdCycle - gdNIT - (gNumberofStaticSlots * gdSlot)*.

- The node must be configured in a way that the dynamic segment is active, i.e. *gdDynamicPart* must be long enough and the parameter *pdLatestTx* must be configured in a way so that it is possible to transmit at least one frame during dynamic segment.

- The parameter *pdLatestTx* is be configured in Macroticks individual for each node in a way so that the longest frame to transmit by the node does not overlap with *gdNIT*.

- *pdWxDelta* must be configured.

**Node Specific Configuration**

- *pdWx0Tx*

- *pdWx0Rx*

**FlexRay and byteflight Pure Dynamic Mode**

- This mode is available in single and dual channel configurations

- In this mode startup and synchronization is performed by means of the SOC symbol that serves as DCT.

- The first received DCT starts the dynamic media access scheme on both channels at the same time.

- In this mode one node of the cluster is configured as SOC master by its host.

- There are two different SOC symbols: SOC Normal and SOC Alarm. Refer to the coding chapter for further details.

- The SOC master generates SOC symbols at the beginning of each communication cycle. The duration of one cycle is configured by *gdCycle*.

- After startup the SOC master generates SOC Normal symbols.

- The SOC master may be switched to generate SOC Alarm symbols by the host. The SOC master switches back automatically to generating SOC Normal symbols after 1023 * *gdCycle.* The host of the SOC master may trigger the generation of SOC Alarm symbols again before 1023 * *gdCycle* is elapsed. In that case the SOC master restarts the timer to count the period of 1023 * *gdCycle*. The host may switch immediately from the generation of SOC Alarm symbols to the generation of SOC Normal symbols before the period of 1023 * *gdCycle* is elapsed by accessing the host interface. When switching from SOC Normal to SOC Alarm (or vice versa) the duration of one communication cycle remains *gdCycle*.

- SOC Normal and SOC alarm symbols are treated identically with respect to media access.

- All non-SOC master nodes use the SOC symbol for synchronizing their local clock that determine media access during the cycle. Therefore no media access is possible if there is no valid SOC present or if the last valid SOC was received more than *gdCycle* ago.

- The frame sequence on the two channels is independent and may be different, i.e., any node may send different frames with different Frame ID'S on the two channels, resulting in a different frame sequence on the two channels.

- The length of frames transmitted in the dynamic segment may be different for every communication cycle, i.e., frames with the same Frame ID may have variable length. A frame's length is derived from the payload length field in the frame header for FlexRay frames, and from the data length field in the header for byteflight frames.

- A frame is only transmitted during the dynamic segment if the corresponding transmit buffer was marked as "ready for transmission", i.e., no "null frame" will be sent if the host does not update the data.

- For a given communication cycle the dynamic segment may be empty, i.e., no frames are transmitted with dynamic medium access control. This may be because no frame has been marked "ready for transmission" by its host.

**Cluster Specific Configuration**

- The number of static slots *gNumberofStaticSlots*, the parameters *pdLatestTX* and *gdNIT* and the duration of the communication cycle *gdCycle* must be configured. The duration of the dynamic segment is calculated by: *vdDynamicPart = gdCycle - gdNIT - gdSOC*.

- A node is in dynamic mode if the number of static slots *gNumberofStaticSlots* is configured equal zero.

- The parameter *pdLatestTx* must be configured individual for each node in a way so that the longest frame to transmit by the node does not overlap with *gdNIT.*

- *pdWxDelta* must be configured.

**byteflight Mode Configuration**

In order to ensure compatibility with byteflight-specific hardware in byteflight compatibility mode the following parameter configuration must be chosen:

- byteflight frame format

- coding: NRZ 8N1

- physical layer: 2 state physical layer

- *gNumberOfStaticSlots*: 0

- *gdBit*: 100 ns

- *pdLatestTx* should be configured so that it equals 231 µs

- *gdNIT* should be configured so that it equals 0 µs

- *gdCycle*: 250 µs

- *gdCycleMin*: 249.725 µs

- *gdCycleMax*: 250.275 µs

- *gBitRate*: 10 Mbit/s

- type of physical layer concerning wake-up method: optical byteflight

**Node Specific Configuration**

- *pdWx0Tx*
- *pdWx0Rx*

**Implementation Notes**

Some physical layers generate echoes of signals transmitted by the communication controller which may be seen with a certain delay on the Rx Input of the communication controller's receiver. For example, this may happen if a communication controller is connected directly to an electrical star without using a bus driver device or if the physical layer device features a loop back function which causes a significant delay (at least 0.5 * *gdBit*). In order to prevent the receiver from detecting noise and signaling this to the host, the Rx Pin should not be evaluated for that purpose during *pdWx0Tx* after the transmission of a message or a SOC symbol has ended.

**External Trigger Mode (optional for V5)**

In dynamic configuration it is possible to start the communication cycle by means of an external trigger.

- This mode is enabled/disabled by a configuration parameter.

- This mode is available in FlexRay mode and in byteflight mode.

- The external trigger starts the communication cycle either

  - by a falling edge on an external trigger pin or

  - by the host by writing to a dedicated trigger control bit.

- The timing of the external trigger cycle is monitored through the two parameters *pdCycleMin* and *pdCycleMax*.

- If the external trigger appears later than *pdCycleMin* and earlier than *pdCycleMax* (case 1): No Error is signaled and the SOC is triggered by the external trigger

- If the external trigger does not appear before *pdCycleMax* (case 2): A SOCLIF (SOC Lost Interrupt Flag) Error is signaled and the SOC is triggered after *pdCycleMax*.

- If the external trigger appears earlier than *pdCycleMin* (case 3): A SOCEIF (SOC Early Interrupt Flag) Error is signaled and the SOC is triggered after *pdCycleMin*.

Figure 30 shows an externally triggered SOC.

**Comments**

**Comment:** Explain rules for calculating the values pdWx0Tx, pdWx0Rx, pdWxDelta, ... in a extra subchapter (similar to byteflight spec) after simulation investigation with cascaded stars has been done.

**Comment:** VdWaitTime **calculation is based on uncorrected** Microticks (V5). If a controller supports corrected microticks the parameter pdWxDelta could be minimized.

**Open Topic:** OT96: semantic of receive window, include figure showing receive windows.

**Chapter 5**

**Frame and Symbol Formats**

This chapter describes the supported frame, symbol, and packet formats used by the FlexRay protocol. The first section focuses on the frame and symbol formats, the second section describes the packet format and the subsequent section describes the coding schemes.

The relationship between frame, packet and encoded packet is such that the frame is embedded in a packet before it is coded for the physical layer. This separation decouples the frame format from the format required on the physical layer. This decoupling allows the FlexRay protocol to make use of different physical layers that require distinct coding methods.

**Frame and Symbol Formats**

**Frame Formats**

The FlexRay protocol supports two distinct frame formats:

the FlexRay frame format

the byteflight frame format

All controllers in a cluster must be configured to use the same frame format. Specifically, a system in which some controllers use the FlexRay frame format while other controllers use the byteflight frame format is not a valid system configuration.

The FlexRay frame format may be used for systems with pure static, pure dynamic, and mixed (static plus dynamic) media access methods.

The byteflight frame format may only be used in systems operating in byteflight compatibility mode.

Both frame formats contain a header segment, a payload segment and a trailer segment, each of which contains specific fields.

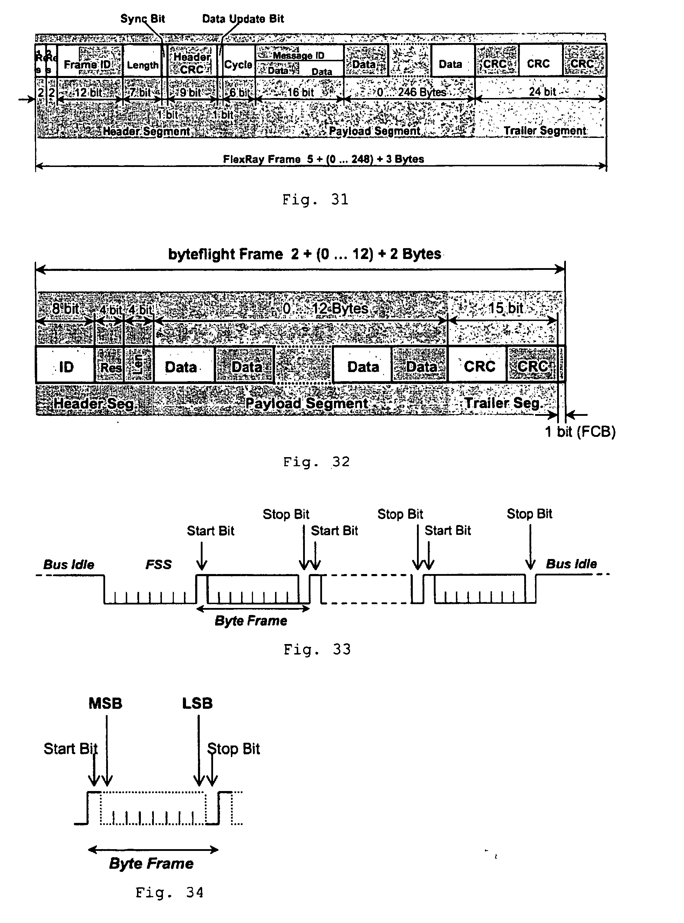

These are described for the FlexRay and byteflight frame formats, respectively in Sections "FlexRay Frame Format" and "byteflight Frame Format", and illustrated, respectively, in Figure 31 and Figure 32.

**Symbol Formats**

The FlexRay protocol makes use of four distinct symbols. These symbols exist outside of the normal frame/packet formats. The FlexRay symbols are:

Start-of-Cycle (SOC) symbol (two types)

SOC Normal Symbol

SOC Alarm Symbol

Wake-Up Symbol

Collision Avoidance Symbol

The symbol formats and their use are described in Section "Symbol Format".

**FlexRay Frame Format**

An overview of the FlexRay frame format is given in Figure 31. The frame shall be transmitted on the network such that the header segment appears first, followed by the payload segment, and then followed by the trailer segment, which is transmitted last.

**FlexRay Header Segment**

The FlexRay header segment consists of 5 bytes that contain several distinct fields; two fields of reserved bits, the Frame ID, a Payload Length field, a Sync Bit, a Header CRC field, a Data Update Bit, and a Cycle Counter field. These fields are described in detail in the following sections.

Within the header segment the fields shall be transmitted in the order indicated in Figure 31, moving from left to right (i.e., the Reserved 1 field is transmitted first and the Cycle Counter field is transmitted last).

**Reserved 1 (2 bits - *fAcknowLength*)**

This field consists of two reserved bits. In subsequent versions of the protocol these bits may be used to indicate the length of an optional acknowledgement vector contained within the payload segment of the frame. When used for this purpose, this field has the following meaning:

$$fAcknowLength = (00)_2 \text{ - no acknowledgement vector}$$

$$fAcknowLength = (01)_2 \text{ - acknowledgement vector of 1 byte}$$

$$fAcknowLength = (10)_2 \text{ - acknowledgement vector of 2 bytes}$$

$$fAcknowLength = (11)_2 \text{ - acknowledgement vector of 3 bytes}$$

The Reserved 1 field shall be transmitted such that most significant bit of *fAcknowLength* is transmitted first.
**Version 5 Solution:** FPGA V5 does not support acknowledgement vectors. An FPGA V5 implementation shall transmit this field with $fAcknowLength = (00)_2$. This is consistent with the lack of an acknowledgement vector.

**Reserved 2 (2 bits - *fReservedBits*)**

This field consists of two bits that are reserved for future protocol use. These bits shall not be used by the application.
   The Reserved 2 field shall be transmitted with both bits set to logical '0'. As the bits are identical, transmission order is not defined.

**Frame ID (12 bits - *fFrameID*)**

This field contains the Frame Identifier for the frame. Each frame that may be transmitted in a cluster has a frame ID *fFrameID* assigned.
The frame ID *fFrameID* is a unique number per communication channel per communication cycle and defines the slot in which the frame is transmitted
Valid values for *fFrameID* range from $(0000\ 0000\ 0001)_2$ to $(1111\ 1111\ 1111)_2$.
The Frame ID field shall be transmitted such that the most significant bit of *fFrameID* is transmitted first with the remaining bits of *fFrameID* being transmitted in decreasing order of significance.

**Payload Length (7 *bits - fPayloadLength*)**

The Payload Length field consists of a single parameter, *fPayloadLength,* that is related to the number of bytes contained in the payload segment of the frame. Specifically, *fPayloadLength* indicates the number of bytes in the payload segment divided by two. For example, a frame that contains a payload segment consisting of 72 bytes would be sent with *fPayloadLength* = 36. Refer to Section "FlexRay Payload Segment" for a detailed definition of the contents of the payload segment of a FlexRay frame.
The payload length field does not include the number of bytes within the header and the trailer segments of the FlexRay frame.
The maximum payload length is *cPayloadLengthMax*, which corresponds to a payload segment containing 2 * *cPayloadLengthMax* bytes. The payload field shall be less than or equal to the maximum payload length: *fPayloadLength* $\leq$ *cPayloadLengthMax*.
The payload length shall be fixed for all frames in the static segment of a communication cycle. For these frames the payload length field shall be transmitted with *fPayloadLength* = *gPayloadLengthStatic*.
The payload length *fPayloadLength* may be different for different frames in the dynamic segment of a communication cycle. In addition, the payload length of a specific dynamic segment frame may vary from cycle to cycle. Finally, the payload lengths of a specific dynamic segment frame may be different on each configured channel. All dynamic segment frames, however, shall have $0 \leq$ *fPayloadLength* $\leq$ *cPayloadLengthMax.*

The Payload Length field shall be transmitted such that the most significant bit of *fPayloadLength* is transmitted first with the remaining bits of *fPayloadLength* being transmitted in decreasing order of significance.

**Sync Bit (1 bit - *fSyncBit*)**

The sync bit *fSyncBit* determines whether the frame is to be used for clock synchronization.

The condition *fSyncBit* = 1 is one of several conditions that must be true for the frame to be used for clock synchronization. If *fSyncBit* = 0 the frame can not be used for clock synchronization. For details see the clock synchronization chapter (TBD).

All frames transmitted in the dynamic segment (if present) shall be sent with *fSyncBit* = 0.

If a node transmits a given frame on more than one channel it shall set *fSyncBit* to the same value on each channel.

**Header CRC (9 bits - *fHeaderCRC*)**

The Header CRC field contains a Cyclic Redundancy Check code (CRC) computed over the Payload Length and Sync Bit fields of the frame.

The CRC is computed in the same manner on all configured channels. The CRC polynomial (This 9 bit CRC polynomial generates a code that has a minimum Hamming distance of 6 for codewords up to 17 bits in length. The codeword consists of the data to be protected and the CRC. This corresponds to protection of a data field of up to 8 bits in length. In this application, this CRC protects exactly 8 bits of data (7 bits payload length + 1 bit sync = 8 bits).) shall be

$$x^9 + x^6 + x^5 + x^4 + x^3 + 1 = (x+1)(x^8 + x^7 + x^6 + x^4 + x^2 + x + 1)$$

The initialization vector of the header CRC shall be $(1A)_{HEX}$.

With respect to the computation of *fHeaderCRC*, the Payload Length and Sync Bit fields shall be fed into the CRC generator in network order, specifically the most significant bit of the Payload Length field shall be shifted in first, followed by subsequent bits of the Payload Length, and then the Sync Bit field.

The Header CRC field shall be transmitted such that the most significant bit of *fHeaderCRC* is transmitted first with the remaining bits of *fHeaderCRC* being transmitted in decreasing order of significance.

**Comment:**An example for CRC calculation should be given.

**Data Update Bit (1 bit - *fDataUpdateBit*)**

The data update bit *fDataUpdateBit* indicates whether the host has updated the data.
If the data update bit is set to *fDataUpdateBit* = 1 the data was updated by the host.
If the data update bit is set to *fDataUpdateBit* = 0 the data was not updated by the host.

The behavior of the FlexRay controller with respect to the data update bit is described in Section "Data Update Bit Handling".

**Cycle Counter (6 bits - *fCycleCount*)**

The Cycle Counter field indicates the transmitting node's view of the cycle counter *vCycle* at the time of frame transmission

The Cycle Counter field shall be set to *fCycleCount* = *vCycle* before transmitting a frame.

The Cycle Counter field shall be transmitted such that the most significant bit of *fCycleCount* is transmitted first with the remaining bits of *fCycleCount* being transmitted in decreasing order of significance.

**FlexRay Payload Segment**

The FlexRay payload segment contains 0 to 246 bytes of data written by the host.

Because of the limitations imposed on the representation of the length of the payload segment by the Payload Length field (*fPayloadLength*) of the header segment, the FlexRay Payload Segment shall consist of an even number of bytes.

The first two bytes of the FlexRay payload segment may optionally be used as a message ID field, allowing receiving nodes to filter or steer data based on the contents of this field.

Future versions of the protocol may utilize certain bytes of the payload segment to implement an acknowledgement vector used in a protocol-level acknowledgement service.

**Open Topic:** Acknowledgement mechanism needs to be defined.

**Version 5 Solution:** FPGA V5 does not support an acknowledgement service at the protocol level.

The individual bytes within the Payload Segment shall be transmitted such that the most significant bit of the byte is transmitted first with the remaining bits of the byte being transmitted in decreasing order of significance.

**FlexRay Trailer Segment**

The FlexRay trailer segment contains a single field, a 24-bit CRC for the frame.

**Frame CRC (24 bits - *fFrameCRC*)**

The Frame CRC field contains a Cyclic Redundancy Check code (CRC) computed over the Header and Payload segments of the frame. The computation includes all fields in these segments (This includes the header CRC, as well as any Communication Controller-generated "padding" bytes that may be included in the Payload segment.).

The CRC is computed using the same generator polynomial on both channels. The CRC polynomial (This 24 bit CRC polynomial generates a code that has a minimum Hamming distance of 6 for codewords up to 2048 bits in length. The codeword consists of all frame data and the CRC. This corresponds to protection of a frame (Header + Payload) of up to 2024 bits (253 bytes) in length. As defined, the maximum FlexRay frame (Header + Payload) is 5 + 246 = 251 bytes in length.) shall be

$$x^{24} + x^{22} + x^{20} + x^{19} + x^{18} + x^{16} + x^{14} + x^{13} + x^{11} + x^{10} + x^8 + x^7 + x^6 + x^3 + x + 1$$
$$= (x+1)^2 (x^{11} + x^9 + x^8 + x^7 + x^5 + x^3 + x^2 + x + 1)(x^{11} + x^9 + x^8 + x^7 + x^6 + x^3 + 1)$$

The generation process of the CRC differs slightly depending on which channel the frame is being transmitted (Different initialization vectors are defined to prevent a node from communicating if it has crossed channels, connection of a single channel node to the wrong channel, or shorted channels (both controller channels connected to the same physical channel) in an easy and inexpensive way.):

a. The initialization vector of the CRC generator shall be (FE DC BA)$_{HEX}$ for frames sent on channel A.

b. The initialization vector of the CRC generator shall be (AB CD EF)$_{HEX}$ for frames sent on channel B.

With respect to the computation of *fFramerCRC*, the frame fields shall be fed into the CRC generator in network order (that is, the first thing into the generator is the most significant bit of the Reserved 1 field, and the last thing into the generator is the least significant bit of the last byte of the Payload Segment).

The Frame CRC field shall be transmitted such that the most significant bit of *fFrameCRC* is transmitted first with the remaining bits of *fFrameCRC* being transmitted in decreasing order of significance.

**Comment:** An example for CRC calculation should be given.

**byteflight Frame Format**

An overview of the byteflight frame format is given in Figure 32. The frame shall be transmitted on the network such that the header segment appears first, followed by the payload segment, and then followed by the trailer segment, which is transmitted last.

**byteflight Header Segment**

The byteflight header segment consists of 2 bytes that contain several distinct fields; the Frame ID, a field of reserved bits, and the frame length. These fields are described in detail in the following sections.

Within the header segment the fields shall be transmitted in the order indicated in Figure 32, moving from left to right (i.e., the Frame ID field is transmitted first and the Frame Length field is transmitted last).

**Frame ID (8 bits - *fBfFrameID*)**

This field contains the Frame Identifier for the frame. Each frame that may be transmitted in a cluster has a frame ID *fBfFrameID* assigned.

The frame ID *fBfFrameID* is a unique number per communication channel per communication cycle and defines the minislot in which the frame is transmitted Valid values for *fBfFrameID* range from $(0000\ 0001)_2$ to $(1111\ 1111)_2$.

The Frame ID field shall be transmitted such that the most significant bit of *fBfFrameID* is transmitted first with the remaining bits of *fBfFrameID* being transmitted in decreasing order of significance.

**Reserved Bits (4 bits - *fBfReservedBits*)**

This field consists of four bits that are reserved for future protocol use. These bits shall not be used by the application.

The Reserved Bits field shall be transmitted with all bits set to logical '0'. As the bits are identical, transmission order is not defined.

**Frame Length (4 bits - *fBfFrameLength*)**

The Frame Length consists of a single parameter, *fBfFrameLength*, that indicates the number of data bytes that are contained in the payload segment of the frame.

The frame length field does not include the number of bytes within the header and the trailer segment of the byteflight frame.

The shortest possible length is 0 bytes ( *fBfFrameLength* = $(0000)_2$ ), the longest length is 12 bytes (*fBfFrameLength* = $(1100)_2$ ). A frame which is received with *fBfFrameLength* greater than 12 shall be treated as an error.

The Frame Length field shall be transmitted such that the most significant bit of *fBfFrameLength* is transmitted first with the remaining bits of *fBfFrameLength* being transmitted in decreasing order of significance.

**byteflight Payload Segment**

The byteflight payload segment consists of 0 to 12 bytes of data written by the host.

The individual bytes within the Payload Segment shall be transmitted such that the most significant bit of the byte is transmitted first with the remaining bits of the byte being transmitted in decreasing order of significance.

**byteflight Trailer Segment**

The byteflight trailer segment consists of 2 bytes that contain two distinct fields; a Frame CRC and the Frame Completion Bit. These fields are described in detail in the following sections.

Within the trailer segment the fields shall be transmitted in the order indicated in Figure 32, moving from left to right (i.e., the Frame CRC field is transmitted first and the Frame Completion Bit is transmitted last).

**Frame CRC (15 bits - *fBfFrameCRC*)**

The Frame CRC field contains a Cyclic Redundancy Check code (CRC) computed over the Header and Payload segments of the frame. The computation includes all fields in these segments.

The CRC generator polynomial (This is the same polynomial as used in the CAN protocol as defined in International Standards Organization (1993). Road Vehicles - Interchange of Digital Information - Controller Area Network (CAN) for High Speed Communication. ISO11898, 1993. It is optimized for code words of up to 127 bits.) shall be

$$x^{15} + x^{14} + x^{10} + x^8 + x^7 + x^4 + x^3 + 1$$

The initialization vector of the byteflight Frame CRC shall be $(00)_{Hex}$.

With respect to the computation of *fBfFramerCRC*, the frame fields shall be fed into the CRC generator in network order (that is, the first thing into the generator is the most significant bit of the Frame ID field, and the last thing into the generator is the least significant bit of the last byte of the Payload Segment)

The Frame CRC field shall be transmitted such that the most significant bit of *fBfFrameCRC* is transmitted first with the remaining bits of *fBfFrameCRC* being transmitted in decreasing order of significance.

**Frame Completion Bit (1 bit - fBfFCB)**

The Frame Completion Bit, *fBfFCB*, is a single bit whose sole purpose is to allow the byteflight frame to end on a byte boundary.

The Frame Completion Bit field shall be transmitted with *fBfFCB* = 0.

**Open Topic:** Is the 11-bit bus idle necessary for end-of-frame detection? (move this to the validation checks in general as this applies for FlexRay format)

**Symbol Format**

The FlexRay protocol makes use of four distinct symbols. The FlexRay symbols are:

Start-of-Cycle (SOC) symbol (two types)

SOC Normal Symbol

SOC Alarm Symbol

Wake-Up Symbol

Collision Avoidance Symbol

The following sections describe the symbols and their use.

**SOC Symbols**

The FlexRay protocol makes use of two distinct Start-of-Cycle symbol (SOC) symbols, an SOC Normal symbol and an SOC Alarm symbol. These symbols have the following definition:

a. A SOC Normal symbol is defined as a sequence of 30 logical 0's
b. A SOC Alarm symbol is defined as the sequence of 10 logical 1's followed by 20 logical 0's.

Note: The SOC Normal and SOC Alarm symbols have the same duration (30*$gdBit$), and both symbols start at the same point in time relative the beginning of a normal communication frame.

**Comment:** How to detect the start of such a symbol? --> tolerances must be increased

The SOC Normal symbol is used in systems operating in the byteflight compatibility mode or in the FlexRay pure dynamic mode. The SOC Alarm symbol is only used in systems operating in the byteflight compatibility mode.

The conditions under which these symbols are transmitted are described in the chapter "Media Access Scheme".

**Collision Avoidance Symbol**

The Collision Avoidance Symbol (CAS) is used to minimize the possibility of collisions during the startup phase of FlexRay systems which feature a static segment (i.e., systems operating in the pure static or mixed static operating modes). Refer to the chapter "Startup" for further information.

The Collision Avoidance Symbol shall have the same definition as the SOC Normal described in Section "SOC Symbols".

The Collision Avoidance Symbol is sent once during cold start before the first communication cycle in pure static or mixed static-dynamic FlexRay mode (for details see the "Start-up" and "Media Access Scheme" chapters).

The Collision Avoidance Symbol shall not be used in systems operating in the FlexRay pure dynamic or byteflight compatibility modes.

**Wake-up Symbol**

The Wake-up symbol is used to allow a node to transition from a low power consumption standby state to a state in which it is able to communicate (i.e., to "wake up") based solely on signals received on the communications link(s). Differences in the physical characteristics of the physical layers cause the existence of two distinct Wake-up symbols, one for the electrical physical layer and one for the optical physical layer.

**Electrical Wake-up Symbol (not for V5)**

**Open Topic:** Description for wake-up symbol

**Optical Wake-up Symbol**

6,4μs low; 6,4μs high over 10ms (10 MBit/s data rate) --> is described in sleep and wake-up chapter.

**Dependencies**

**Host Interface Requirements**

**Header CRC Calculation**

Among its other uses, the Header CRC field of a FlexRay frame is intended to provide protection against improper modification of the Sync Bit field by a faulty communication controller (CC). The CC that is responsible for transmitting a particular frame shall not compute the Header CRC field for that frame. Rather, the CC shall be configured with the appropriate Header CRC for a given frame by the host. This makes it unlikely that a fault in the CC that causes the value of a Sync Bit to change would result in a frame that is accepted by other nodes in the network because the CRC would not match. This is possible because, for fixed length frames at least, the Header CRC would be constant. Removing the capability of the transmitter to generate the CRC minimizes the possibility that a CC fault would have a proper header CRC.
The CC that is responsible for the reception of a frame shall perform the CRC computations required to check the correctness of the Header CRC field relative to the other information that is received in the frame.

**Data Update Bit Handling**

The Data Update Bit shall be set to *fDataUpdateBit* = 0 during soft reset.
The Data Update Bit shall be set to *fDataUpdateBit* = 1 by the host when it updates a transmit message buffer. (Note - the host would set this bit even if the data has not actually changed. This bit may be though of as a representation by the host that the data that is transmitted within the frame is "fresh" and usable by the receiver. This bit does not represent a "data changed" condition within the host.)
The Data Update Bit shall be set to *fDataUpdateBit* = 0 by the FlexRay controller after the transmission process has started. (The mechanism used shall be such that the value transmitted on the datalink represents the value of the field at the time of the start of the transmission)
The value of *fDataUpdateBit* in the message buffer is transmitted in every frame as it is stored in the message buffer.

**Message ID (optional, 16 bits - *fMessageID*) not relevant for V5**

The first two bytes of the payload segment of the FlexRay frame format are receiver filterable data called Message ID.
The Message ID is an application determinable number that describes the contents of the data segment.
The Message ID is 16 bits long.
The Message ID must be consistent in the whole cluster.
If this mechanism is used, the most significant bit of *fMessageID* shall be placed in the most significant bit of the first byte of the payload segment. Subsequent bits of *fMessageID* shall be placed in the next payload bits in order of decreasing significance.
**Version 5 Solution:** FPGA V5 does not support Message ID's. All bytes in the Payload segment of a FlexRay frame shall be treated as normal host-generated data bytes by both receiving and transmitting nodes.

**Acknowledgement Vector (optional, 0/8/16/24 bits - *fAcknowVector*) not relevant for V5**

The third, fourth and fifth byte of the payload segment may be used as for acknowledgement information.
These bytes may be used for acknowledgement information.
The Acknowledgement Vector field shall be transmitted such that the most significant bit of *fAcknowVector* is transmitted first with the remaining bits of *fAcknowVector* being transmitted in decreasing order of significance.
**Version 5 Solution:** FPGA V5 does not support an Acknowledgement Vector. All bytes in the Payload segment of a FlexRay frame shall be treated as normal host-generated data bytes by both receiving and transmitting nodes. (Note that this is the same behavior that would be implied for a FlexRay system that does support acknowledgement vectors in the case that the frame is indicated as having no acknowledgement vector (fAcknowLength = $(00)_2$). This is the FPGA V5 required value for that field.)

**Error Handling**

**Comment:** What happens when the data update bit fDataUpdateBit is set 0 in the dynamic part? --> It is an error! (may be map this error with another error) --> add in the check table.

**Chapter 6**

**Coding**

This chapter describes the coding methods used by the FlexRay system.
**Comment:** The only coding method currently described is the NRZ 8N1 method. Other coding methods, if adopted as part of the FlexRay system, will be added after they are approved.
**Version 5 Solution:** FPGA V5 only supports NRZ 8N1 coding.

**Coding with NRZ 8N1**

This section describes the FlexRay coding method referred to as NRZ 8N1. The mechanism is given this name because it uses a Non-Return to Zero (NRZ) signaling method that uses symbols consisting of 8 data bits, no parity bits, and 1 stop bit (8N1).

**Frame Packaging**

This section describes the frame packaging. Packaging adds physical layer specific elements to frames. The additional information for NRZ 8N1 consists of the Frame Start Sequence (FSS).

**Frame Start Sequence (FSS)**

The transmission of each frame shall begin with a Frame Start Sequence (FSS) consisting of 8 consecutive bits sent as logical "0". The FSS shall be transmitted without any start or stop bits.
**Version 5 Solution:** This definition of the FSS is valid for FPGA V5 only. It may change for future versions of the protocol.
Due to certain effects on the physical transmission medium (e.g., optical transmission, truncation due to connection setup in the star coupler, etc.), it is possible that the FSS seen by a receiver may be shorter or even longer than the FSS that was sent by the transmitter. All receivers shall accept Frame Start Sequences with a duration of 1-9 bit times.

**Symbol (SOC) Packaging**

No additional information is needed for symbol packaging, i.e., the symbols shall be transmitted without any start and stop bits.

**Frame Coding**

Figure 33 shows the frame coding when using NRZ 8N1.
The frame is composed of a Frame Start Sequence and an integral number of byte frames, each of which convey 8 bits of higher layer data.

**Byte Coding**

- Byte frames within a frame shall be sent without idle phases in between, i.e., there is no interruption of the bit stream.

- Each byte frame shall begin with one start bit (logical "1"), followed by 8 data bits and one stop bit (logical "0"). There is no parity bit.

- Transmission of the data bits within a byte frame shall be such that the most significant bit of the data is transmitted first with the remaining bits of the data being transmitted in decreasing order of significance. This is shown in Figure 34.

**Symbol Coding**

The NRZ 8N1 coding mechanism defines three distinct symbols; two different Start of Cycle (SOC) symbols, SOC Normal and SOC Alarm, and a Collision Avoidance Symbol (CAS). The coding of these symbols is described in the following sections.

**SOC Normal Symbol**

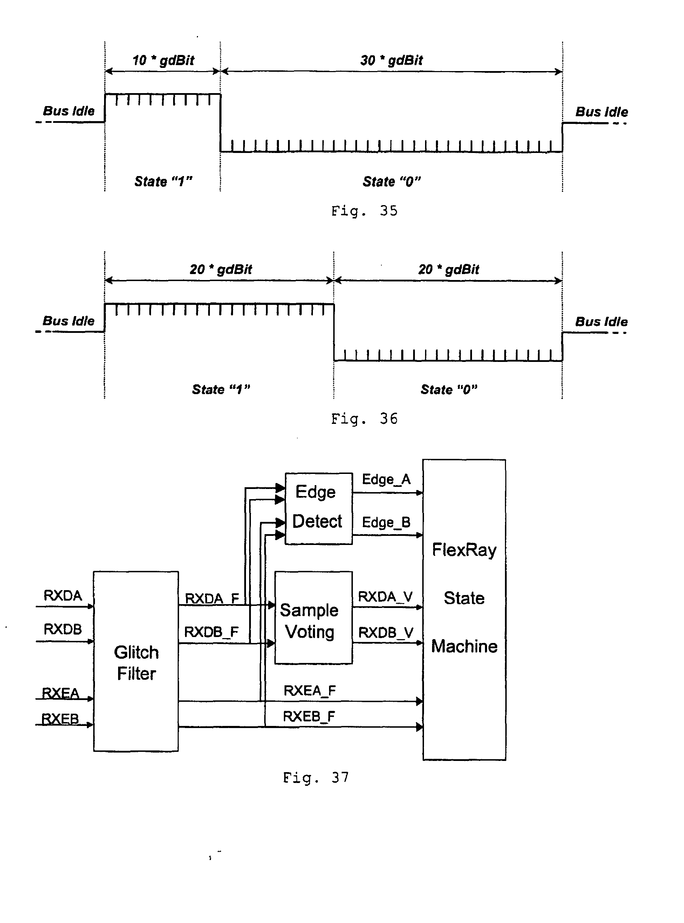

The SOC Normal symbol shall be transmitted as 10 *gdBit* times at a logical "1" level followed by 30 *gdBit* times at a logical "0" level as is shown in Figure 35.
The receivers of an SOC Normal signal shall tolerate the following variations from the nominal definition of the signal:

- Due to certain effects on the physical transmission medium (e.g optical transmission, truncation due to connection setup in the star coupler, etc.), it is possible for the 10 *gdBit* times of logical "1" sent by the transmitter to appear to be shorter at the receiver. Therefore, all receivers shall accept an SOC Normal symbol starting with a period of 0-10 *gdBit* times at logical "1".

- The duration of the 30 *gdBit* time at logical "0" may vary by ± 1.5 * *gdBit*, i.e., all receivers shall accept an SOC Normal symbol with a range of 28.5 to 31.5 *gdBit* times at logical "0" .

**Version 5 Solution:** The preceding definition of the acceptance criteria of an SOC Normal symbol applies to the FPGA V5 implementation only. A different definition may be used in future versions of the protocol.
The SOC Normal symbol is used in pure dynamic configurations for synchronization. The SOC Normal symbol is sent by a single configured master.
Note that the SOC Normal symbol is coded with neither start nor stop bits. (Rationale: This is an intentional code violation of the NRZ 8N1 frame coding rules).

**SOC Alarm Symbol**

The SOC Alarm symbol shall be transmitted as 20 *gdBit* times at a logical "1" level followed by 20 *gdBit* times at a logical "0" level as is shown in Figure 36.
The receivers of an SOC Alarm signal shall tolerate the following variations from the nominal definition of the signal:

- Due to certain effects on the physical transmission medium (e.g., optical transmission, truncation due to connection setup in the star coupler, etc.), it is possible for the 20 *gdBit* times of logical "1" sent by the transmitter to appear to be shorter at the receiver. Therefore, all receivers shall accept an SOC Alarm symbol starting with a period of 10-20 *gdBit* times at logical "1".

- The duration of the 20 *gdBit* times at logical "0" may vary by ± 1.5 * *gdBit,* i.e., all receivers shall accept an SOC Alarm symbol with a range of 18.5 to 21.5 *gdBit* times at logical "0".

**Version 5 Solution:** The preceding definition of the acceptance criteria of an SOC Alarm symbol applies to the FPGA V5 implementation only. A different definition may be used in future versions of the protocol.
The SOC Alarm symbol is used in pure dynamic configurations for synchronization (same functionality as SOC Normal). The SOC Alarm signal is sent by a single configured master (the same master that sends the SOC Normal signal). The SOC Alarm symbol can be used to indicate a different operation mode.
Note that the SOC Alarm symbol is coded neither with start bits nor with stop bits. (Rationale: This is an intentional code violation of the NRZ 8N1 coding rules).

**Collision Avoidance Symbol (CAS)**

For NRZ 8N1 coding, the Collision Avoidance Symbol (CAS) shall be encoded in the same manner as the SOC Normal symbol described in Section "SOC Normal Symbol".

Transmitters of the CAS have the same coding requirements as transmitters of the SOC Normal symbol.

Receivers of the CAS have the same tolerance requirements as receivers of the SOC Normal signal.

The Collision Avoidance Symbol is used at startup in pure static and mixed static/dynamic configurations for collision avoidance (see "Startup" chapter for further details).

**Bit Timing Tolerances**

Clock oscillator differences and distortion on the transmission line may distort the timing of edges of received signals. As a result, the receiver of signals must accept signals with the following tolerances:

- The tolerance of the bit timing is determined by the quality of the oscillators. Nodes shall tolerate oscillator frequency differences of up to $\pm$ 1500 PPM (Parts Per Million).

- A receiver shall tolerate deviations of $\pm$ 35% concerning the parameter *gdBit*, i.e., single bit edges must be detected even if they are up to $\pm$ 0.35 * *gdBit* times earlier or later than expected.

**Version 5 Solution:** In FPGA V5 the sample voting mechanism (see Section "Edge Detection") can be configured to achieve the tolerances mentioned above. No additional mechanism is required to support bit timing tolerances in V5.

**Glitch Filtering and Sample Voting**

**Version 5 Solution:** The following requirements on glitch filtering and sample voting apply to FPGA V5 only. Future protocol versions may use a different filtering/voting mechanism.

The block diagram in Figure 37 shows the control flow of the receive and receive-enable signals through the glitch filter and sample voting mechanism.

The following input and output signals are involved in the glitch filtering and sample voting mechanism.

Table 9:

| Input and Output Signals for Glitch Filtering and | |
| --- | --- |
| RXDA | Receive signal on FlexRay channel A |
| RXDB | Receive signal on FlexRay channel B |
| RXEA | Receive enable signal on FlexRay channel A |
| RXEB | Receive enable signal on FlexRay channel B |
| RXDA_F | Glitch filtered version of RXDA |
| RXDB_F | Glitch filtered version of RXDB |
| RXEA_F | Glitch filtered version of RXEA |
| RXEB_F | Glitch filtered version of RXEB |
| RXDA_V | Result of sample voting on RXDA_F |
| RXDB_V | Result of sample voting on RXDB_F |

Sample Voting

**Glitch Filtering**

Glitch filtering is performed on the receive signals of all configured channels (RXDA and/or RXDB) and on the receive enable signals of all configured channels (RXEA and/or RXEB).

Glitch filtering shall be performed by the following mechanism:

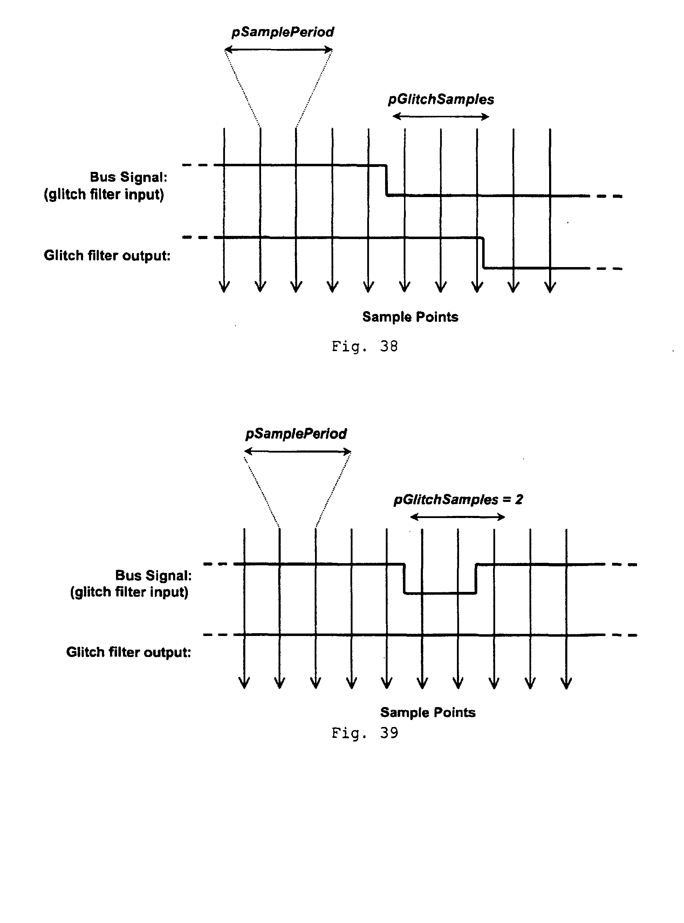

- A number of samples *pGlitchSamples* is configured that determines the glitch length to be filtered out by the glitch filter (see Figure 38). A configuration of *pGlitchSamples* = 0 means that no glitches are filtered out.

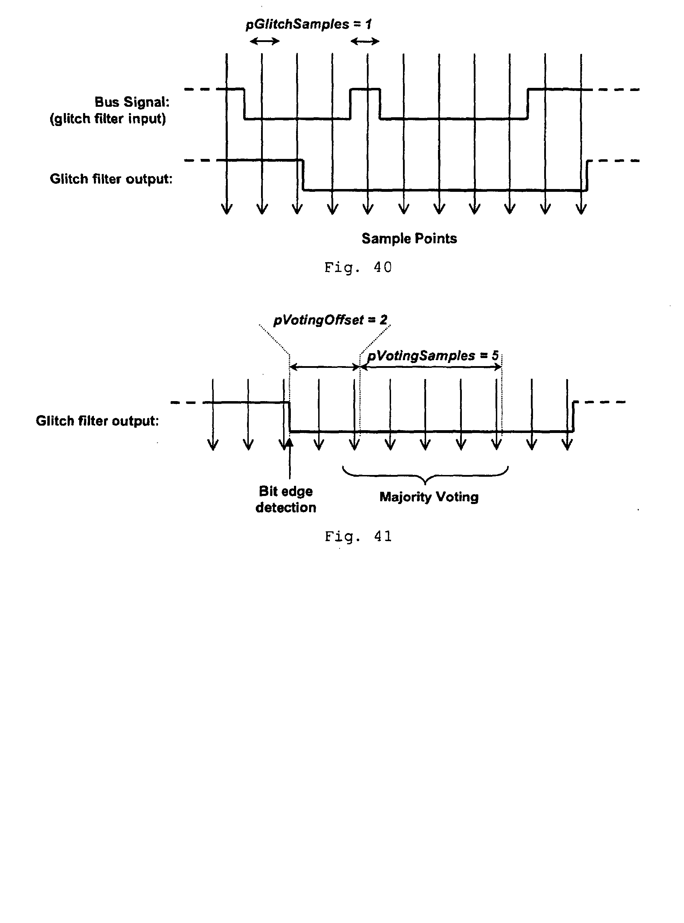

- All pulses with a duration shorter than *pGlitchSamples * pSamplePeriod* shall be filtered out. That means that the output of the glitch filter shall only change its logical value if more than *pGlitchSamples* equal samples are detected at the glitch filter's input (see Figure 38). Figure 39 and Figure 40 show examples of glitches that are filtered out by the glitch filter mechanism.

**Edge Detection**

The edge detection process shall be performed on the glitch filtered version of the receive and receive-enable signals (RXDA_F, RXDB_F, RXEA_F, RXEB_F).

Edge detection is used for resynchronizing the bit sampling and voting process at the rising edge that results from the stop bit to start bit transition at the end of a byte. The edge detection process is also used to determine the end of an SOC or Collision Avoidance Symbol, and to detect the end of a frame in the dynamic part in order to start the slot counter mechanism.

**Sample Voting**

The sample voting process shall be performed on the glitch filter output of the receive signals (RXDA_F and/or RXDB_F).

The sample voting process defines a "window" of samples that are used to make the determination of the value of a received bit. This window is characterized by two parameters, *pVotingOffset* and *pVotingSamples*. An example showing the relationship of these two parameters is shown in Figure 41.

The parameter *pVotingOffset* specifies the offset of the start of the voting window from the start of the bit cell. This offset defines the first sample of the bit that will be considered for the voting.

The *pVotingSamples* parameter specifies the number of samples in the voting window. The window is defined by taking *pVotingSamples* consecutive samples starting with the sample indicated by *pVotingOffset.*

The bit value shall be determined by majority voting over the samples within the voting window (This implies that the number of samples within the voting window, *pVotingSamples,* must be odd.), i.e., if a majority of samples within the voting window have logical value "0", the output value of the sampled bit shall be "0"; if a majority of samples within the voting window have logical value "1" the output value of the sampled bit shall be "1".

The voting window and the bit sampling shall be resynchronized with every start bit.

**Bit Rates and Sampling**

**Version 5 Solution:** The configuration parameters in this section (indexes, clock period, bit rates, etc.) only apply to FGPA V5. These requirements will be modified in future versions of this specification.

FPGA V5 uses an 80 Mhz oscillator with a 12.5 ns oscillator period. FPGA V5 shall support the bit rates, prescalers, and sampling configurations defined in the following table.

| Index | Sample Clock Prescaler | Sample Clock Period (ns) | Samples per Bit | Bit Time (ns) | Bit Rate (Mbps) |
|---|---|---|---|---|---|
| 1 | 1 | 12.5 | 8 | 100 | 10.000 |
| 2 | 1 | 12.5 | 10 | 125 | 8.000 |
| 3 | 2 | 25.0 | 8 | 200 | 5.000 |
| 4 | 2 | 25.0 | 10 | 250 | 4.000 |
| 5 | 4 | 50.0 | 8 | 400 | 2.500 |
| 6 | 4 | 50.0 | 10 | 500 | 2.000 |
| 7 | 8 | 100.0 | 8 | 800 | 1.250 |
| 8 | 8 | 100.0 | 10 | 1000 | 1.000 |
| 9 | 16 | 200.0 | 8 | 1600 | 0.625 |
| 10 | 16 | 200.0 | 10 | 2000 | 0.500 |

| System Constants, Parameters and Variables | | | |
|---|---|---|---|
| Name | Description | Range/Value | Unit |
| *pSamplePeriod* | Time interval between two consecutive sampling points | | ns |
| *pGlitchSamples* | Number of samples that are filtered out by the glitch filter mechanism | [0-*pSamplesPerBit* /2] | |
| *pSamplesPerBit* | Number of samples per bit | 8 or 10 (V5 solution) | |
| *pVotingOffset* | Defines the first sample that is considered for the voting mechanism based on the glitch filter output | [0-*pSamplesPerBit* ] | |
| *pVotingSamples* | Defines the number of samples that are considered for the voting mechanism based on the glitch filter output | 1, 3, 5, 7, or 9 | |

**V6 Topics**

**Frame packaging**

**Open Topic:** For V5 NRZ8N1 is used only. For the final silicon the decision about the coding is still open (NRZ 8N1, Xerxes or another coding). Decision should be made before the middle of April 2002 (before the FlexRay workshop). One common coding scheme is preferred by all partners.

**Glitch Filter**

**Open Topic:** Analyze mechanism in a noisy environment. With configuration of a large *pGlitchSamples* (e. g., *pGlitchSamples*=5) a signal that is interrupted by several short glitches (within intervals shorter that 5) might lead to a rejection of the signal. Proposal: Use an up-down counter (integrator) that changes the detected value when the number of glitch samples is reached.

**Chapter 7**

**Clock Synchronization**

**Introduction**

In a distributed communication system every node has its own clock. Because of temperature and voltage changes and because of production tolerances of the timing source (normally quartz crystals are used) the internal time base diverges between the nodes after a short time, even if all internal time bases of the nodes are started concurrently.

The basis for a time triggered system is that, within tolerances, every node in the cluster has the same view of time and this common global view of time is used as the local time base for each node. In this context, "the same" means that the differences between the nodes' views of the global time are bounded and that a maximum value for this difference can be guaranteed.

To guarantee a bound on the time differences between these nodes, clock synchronization is necessary.

Two types of time differences between nodes can be distinguished, offset (phase) differences and rate (frequency) differences. To synchronize the local time base between nodes, methods are known for offset correction and for rate correction. In FlexRay a combination of both is used.

**Clock Synchronization Modes**

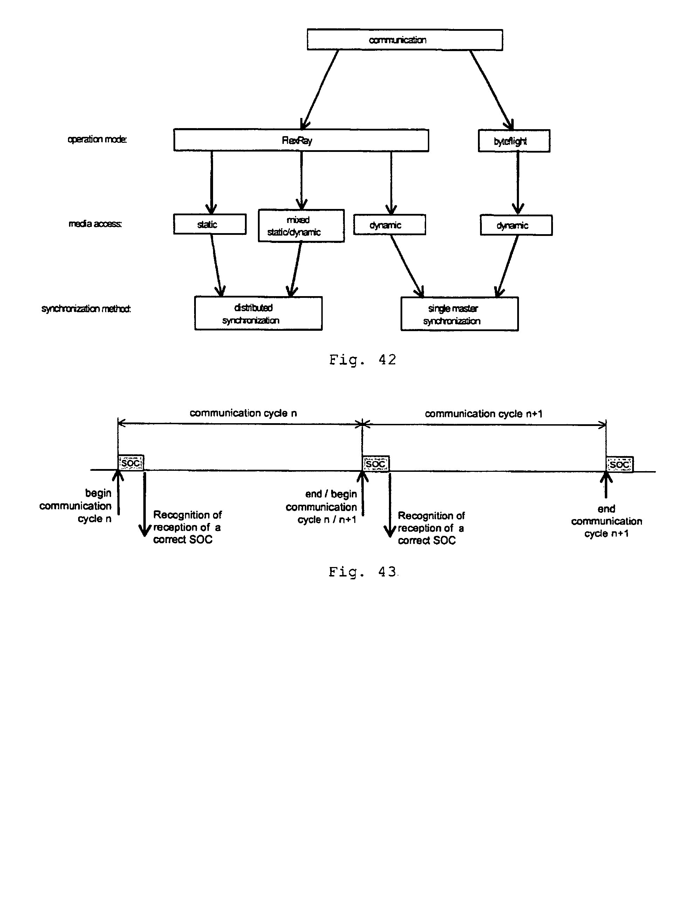

FlexRay supports two methods for synchronization of the local time base. Which synchronization method is used depends on the configuration (see Figure 42). Figure 42 shows the relation between the operation mode, media access and clock synchronization.

**Single-Master Clock Synchronization**

- If no static segment is configured for the cluster (*gNumberOfStaticSlots* = 0) the communication cycle timing is based on the Start-Of-Cycle (SOC) symbol. No distributed clock synchronization is performed.

- The cycle length *gMacroPerCycle* is configured and measured in nominal (uncorrected) macroticks.

- The cycle starts with the beginning of the SOC and ends with the beginning of the next SOC (see Figure 43). If no SOC is received (due to a fault) the macrotick counter should be incremented until it reaches its maximum value. No further incrementing is done.

- A single master provides the SOC. If the master fails, a backup master can take over the task of transmitting the SOC if another host intervenes to configure its communication controller to do so. There is no automatic protocol mechanism that will cause a new master to be established.

- When a slave recognizes the reception of a valid SOC, it sets its local clock to cyclestart+ *gdSOC*. The *gdSOC* is configured during soft reset and quantifies the duration of the SOC, including the time for recognition and checking of its correctness. The time in a slave runs from the predefined constant value *gdSOC* to *gMacroPerCycle* + *gdSOC.*

**Distributed Clock Synchronization**

Distributed clock synchronization is only performed if the cluster is configured with a static segment (*gNumberOfStaticSlots* > 1). The time representation and the principles of the distributed clock synchronization are described in the Sections "Time Representation" through Section "External Clock Synchronization".

**Time Representation**

**Local Time Representation in a Node**

- Internally, nodes can time their behavior with microtick resolution. Microticks are time units derived from the (external) oscillator clock tick, optionally using a prescaler. Microticks are controller-specific units. They may have different durations in different controllers. The precision of a node's local time difference measurements is a microtick.

- Local controller time is based on cluster-wide synchronized cycle and macrotick values provided by the distributed clock synchronization mechanism. Finer resolution local timing is done using the node-specific microtick.

- *vCycle* is the (controller-local) cycle number and is increased once every communication round. At any given time all nodes should have the same value for *vCycle* (except due to imperfect synchronization at cycle boundaries.

- Cycle counter values (*vCycle*) range from zero $(00\ 0000)_2$ to *cCycleMax* $(11\ 1111)_2$.

- The maximum cycle counter value is configurable for a given cluster (*gCycleMax*). The first time the cycle counter (*vCycle*) is incremented after *gCycleMax* is reached, it is reset to zero.

- *gCycleMax* must be less than or equal to *cCycleMax.*

- *gCycleMax* must be an odd number (see Procedure 2).

- *vMacrotick* is the current value of the (controller-local) macrotick counter.

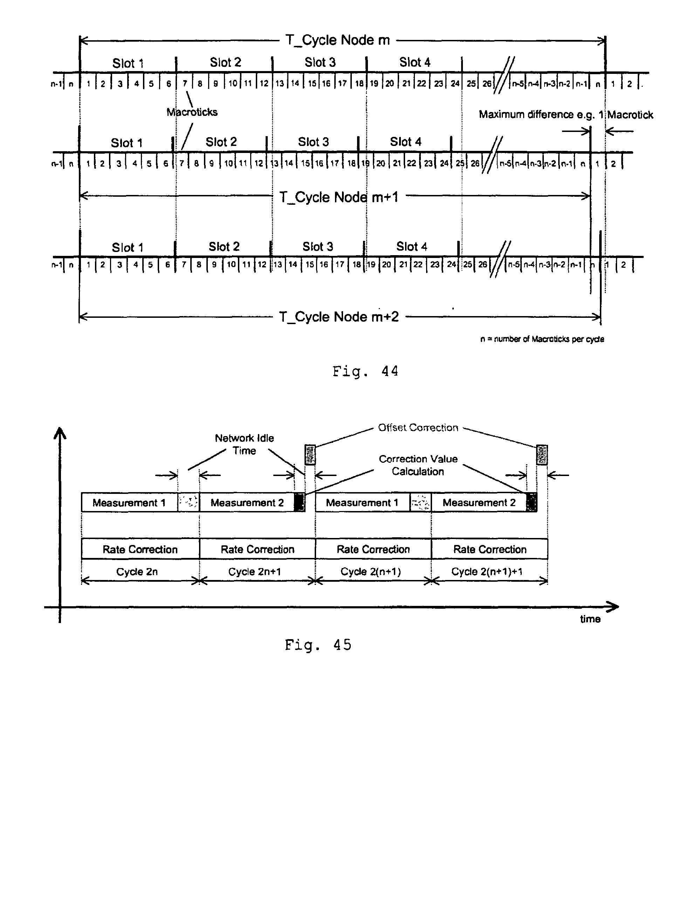

- *gMacroPerCycle* defines the (integer) number of macroticks per cycle (see Figure 44).

- Within tolerances, the duration of a macrotick is constant throughout the cluster on synchronized nodes.

- Every node in the system has its own local view of the global time. The local view of global time is represented by a vector consisting of the current cycle number (*vCycle*) and the current macrotick value (*vMacrotick*). The value *vCycle.vMacrotick* is the (controller-local view of the) global time in the cluster. It is visible to the application.

- *pMicroPerMacroNom* is the (controller-specific) nominal number of microticks per macrotick.

- *vMicroOverheadPerCycle* is the (integer) number of microticks that has to be added to the *pMicroperMacroNom* * *gMacroPerCycle* microticks in the current cycle to produce the correct cycle length. *vMicroOverheadPerCycle* may be negative. The value of *vMicroOverheadPerCycle* is determined by the clock synchronization algorithm. It may only change once (usually at the beginning) per cycle.

- *pMicroOverheadPerCycleNom* is the initial configuration value of *vMicroOverheadPerCycle*.

- The duration of the current controller-local macrotick is an integer multiple of controller-local microticks and is represented by *vMicroPerMacroCorr*. The value of *vMicroPerMacroCorr* within one controller may change from macrotick to macrotick.

- In any given cycle, *vMicroOverheadPerCycle* microticks must be distributed across the *gMacroPerCycle* macroticks comprising the cycle in order to adjust the cycle length to the proper duration. Consequently, *vMicroPerMacroCorr* does not remain constant. In general, *vMicroOverheadPerCycle* is nonzero and is not a multiple of *gMacroPerCycle*. Consequently, the process of distributing the *vMicroOverheadPerCycle* microticks across the *gMacroPerCycle* macroticks conceptually introduces fractional macroticks.

- At the beginning of the first communication cycle the "local time variables" are initialized (see Procedure 1).

***Procedure 1: Initialization of a node***

```
[vCycle, vMacrotick, vMicrotick, vMicroPerMacroCorr] =
NodeInitialization()   //
   vCycle = 0;                                    //reset cycle
counter
   vMacrotick = 0;                           //reset
macrotick counter
   vMicrotick = 0;                           //reset
microtick counter
   vMicroPerMacroCorr = pMicroPerMacroNom;          //set the
                                        predefined value
                                        for
   vMicroOverheadPerCycle = pMicroOverheadPerCycleNom
   //microticks per macrotick
```

- The initialization of the first three values differs if the node reintegrates into a running cluster (see TBD section Startup and Reintegration).

*Procedure 2: Incrementing the Cycle Count*

```
[vMacrotick, vCycle] = ChangeOfCycleCount(vMacrotick, vCycle)
   //
   if vMacrotick >= gMacroPerCycle                    //
      vCycle++;                            //increment cycle
counter
      vMacrotick = 0;                            //reset
macrotick counter
      if vCycle > gCycleMax                    //
         vCycle = 0;                         //reset cycle
counter
      end;                            //
   end;                            //
```

- The host is able to read the cycle counter and the macrotick counter. The update of the cycle counter and the macrotick counter has to be atomic.

- The duration of a Macrotick is a whole number of a Microticks, however, the number of microticks per macrotick may differ from macrotick to macrotick. Before the first correction value is calculated the clock synchronization algorithm works with nominal macroticks, using *vMicroPerMacroCorr = pMicroPerMacroNom + pMicroOverhead-PerCycleNom* (see 0).

- The number of microticks per nominal macrotick may differ between nodes and depends on the oscillator frequency and the prescaler.

- The duration of one cycle is a whole number of a macroticks. The number of macroticks per cycle is identical in all nodes in a cluster (see Figure 44).

***Procedure 3:*** **Incrementing the *Macrotick Counter***

```
[vMicrotick, vMacrotick] =
IncrementMacrotickCounter(vMicroPerMacroCorr, vMicrotick,
vMacrotick)
                                                  //uses microtick
pulses
   while(1)                                      //
      wait(Microtick_duration);                  //every
microtick increase
      vMicrotick++;                              //microtick
counter by one
      if vMicrotick >= vMicroPerMacroCorr                  //




         vMicrotick = 0;                          //Reset
microtick counter
         vMacrotick++;                            //Increment
macrotick counter
      end;                          //
   end;                             //
```

- For a given cycle (without offset correction) the average length of a macrotick is given by *pMicroPerMacroNom +  vMicroOverheadPerCycle / gMacroPerCycle.*

***Procedure 4: Uniform Distribution of Microticks***

**Comment:** The following example only addresses the distribution of microticks over the macroticks comprising the cycle. The more complete solution must also deal with offset corrections and is described in 0

```
InitRateStartOfCycle(vMicroOverheadPerCycle)
   //execute at beginning of cycle
                                     //sufficient every
second cycle
   vMicroPerCycle = gMacroPerCycle * pMicroPerMacroNom  //total
number of microticks
      + vMicroOverheadPerCycle;              //for this
cycle
   vRatioMicroMacro = vMicroPerCycle/gMacroPerCycle;    //real
division, not integer
   vIntegerRatio = Int[vRatioMicroMacro];
   //Integer part of ratio
   vRest = vRatioMicroMacro - vIntegerRatio;
   //Fractional part of ratio
   vRemainingSumOfFractionalParts = vRest;
   //Initialization values for
```

```
    vDeltaCorrect=0;                                  //variables
                                              //
DistributeMicroOverMacroRate                          //
while(1)                                      //
    vMicroPerMacroRateCorr = vIntegerRatio + vDeltaCorrect;
    //Calculate new MicroPerMacro
    vRemainingSumOfFractionalParts =
vRemainingSumOfFractionalParts + vRest; //update
                                    //fractional history
term
    if vRemainingSumOfFractionalParts >= 1         //If sum
of fractional parts
        vDeltaCorrect = 1;                     //becomes
greater
        vRemainingSumOfFractionalParts =
vRemainingSumOfFractionalParts -1;// than 1
                                    // increase macrotick
length by 1
    else                                //
        vDeltaCorrect = 0                     //
        vMicroPerMacroCorr = vMicroPerMacroRateCorr;   //if no
offset correction present
    end;                                //
[vMicrotick, vMacrotick] =
IncrementMacrotickCounter(vMicroPerMacroCorr, vMicrotick,
vMacrotick)
```

Notes on the above Procedure:

- The variable *vIntegerRatio* is not necessarily equal to *pMicroPerMacroNom* (may be important for implementation).

**Open Topic:** Not clear at the moment, whether *vDeltaCorrect* should be initialized every cycle or once at the controller start.

- Offset correction has an additional influence. Therefore there is a difference between the variables *vMicroPerMacroCorr* and *vMicroPerMacroRateCorr*.

- Since there is no real division available in hardware, the implementation will not precisely replicate the above procedure. Most likely the variable *vMicroPerMacroCorr* will not be explicitly calculated in hardware.

- As is typically true with pseudocode, the above procedure provides insight into the behavior of the mechanism, but not its implementation.

**Global Time Representation**

Figure 44 shows the local timing of three nodes and their relation to each other. In FlexRay node activities, including communication, are based on the concept global time, even though each individual node maintains its own view of it. It is the clock synchronism mechanism differentiates the FlexRay cluster from other node collections with independent clock mechanisms. The global time is a vector of two values, the cycle (cycle counter) and the macrotick counter (cycle time).

**General Concepts**

- The node (or nodes in the case of a startup with collisions) that transmit the first CAS during startup, initializes the cycle counter and the cycle time to zero at the beginning of the communication cycle following the transmission of the CAS. See TBD for details.

- The duration of a static slot *gdSlot*, a communication cycle *gdCycle*, and the idle time at the end of a communication cycle *gdNetworkIdle* are all expressed as a whole number of macroticks.

- Each node with *pChannels == gChannels* that is configured to send in the static segment of the communication cycle can send at most one frame per communication cycle with the sync bit set.

- The sync bit may only be set in frames that are transmitted on all channels *(gChannels* - one or two channel configuration).

- Not all nodes that are configured to send in the static segment of the communication cycle need to send frames with the sync field set.

- The communication controller has to count all correctly received frames each cycle where the sync bit is set. This number is accessible to the host.

- If a controller receives more than *gMaxSyncFrames* the first *gMaxSyncFrames* are used for clock synchronization.

- All controllers execute the synchronization algorithm approximately at the same time. The calculation of the correction terms take place every second communication cycle during the network idle time.

The clock synchronization is realized with four processes called measurement, calculation, offset correction, and rate correction. The offset correction, measurement, and calculation processes are performed sequentially. Rate correction is performed in parallel to the other three. Figure 45 shows the relative execution timing of these four processes.

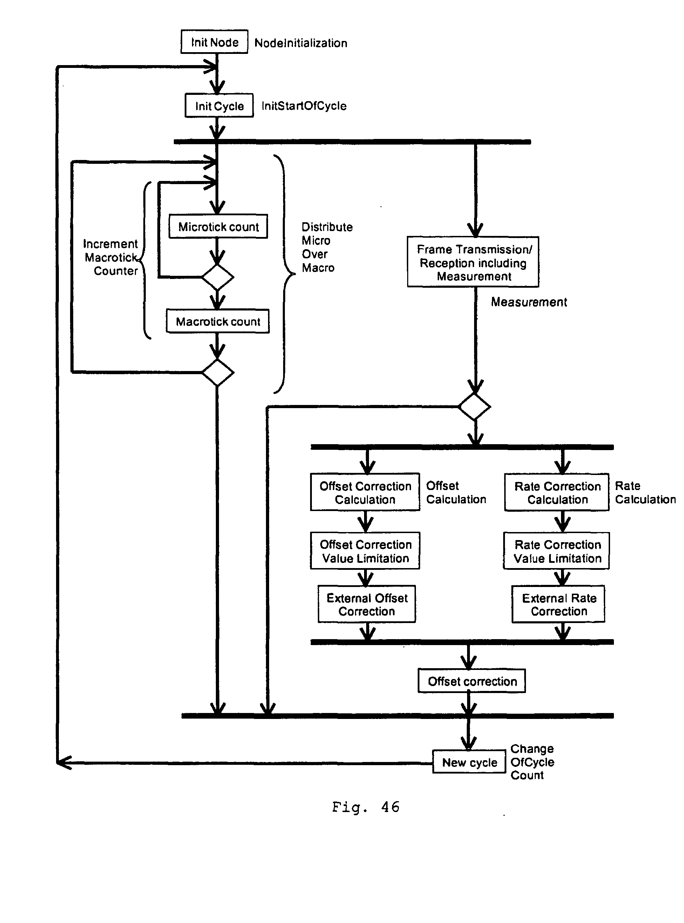

Figure 46 illustrates the internal structure of the clock synchronization mechanism in more in detail. The blocks in the illustration correspond to the pseudocode procedures in this chapter. The black boxes describe the tasks performed and the adjacent blue text gives the corresponding procedure name.

**Time Measurement**

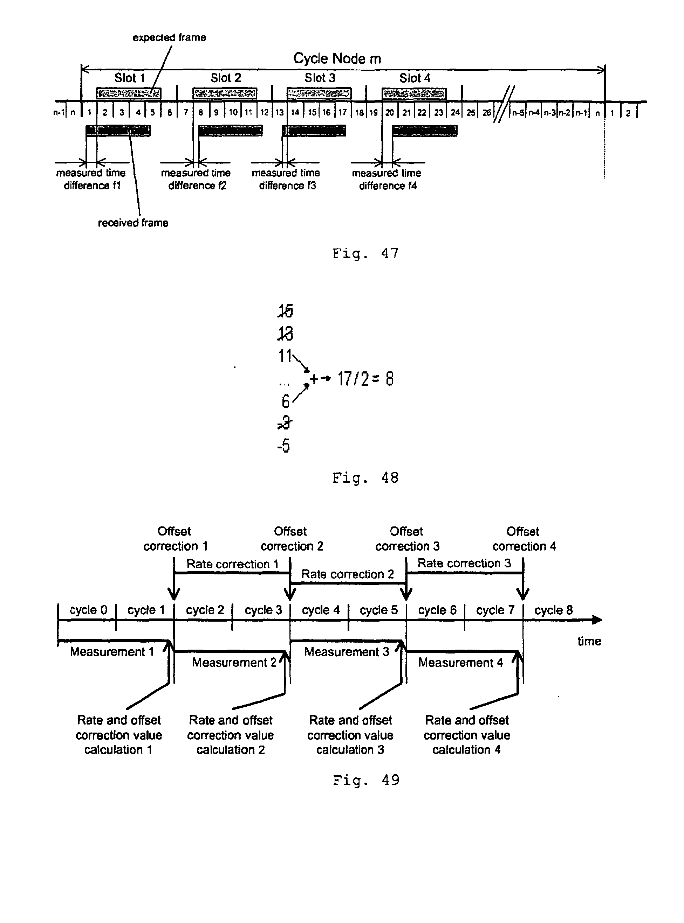

Figure 47 shows a time difference measurement (expected vs. observed arrival times).

- Every node measures and stores the time differences (in microticks) between the expected and the actual observed arrival time of all sync frames received during the static segment.

- The expected arrival time of a frame is calculated relative to the beginning of a slot (slot boundary). The time (in microticks) between the start of a slot and the expected reception of the time reference point is calculated as follows:

  - *pExpectedArrivalTimeChA = gdFrameStartSequence + gdTimeReferencePoint + pDelayCompensationChA*
  - *pExpectedArrivalTimeChB = gdFrameStartSequence + gdTimeReferencePoint + pDelayCompensationChB*

- The global parameters *gdFrameStartSequence* and *gdTimeReferencePoint* are specified in fractional macroticks but represented internally in microticks. This is necessary because the only global time unit available is the macrotick, since microtick durations are node-specific. Fractional macroticks are necessary because greater precision is needed than can be provided by the macrotick.

- The Observed Arrival Time is defined as the elapsed time between the start of a slot and the reception of the time reference point for the frame. The unit of measure is the microtick.

- The Time Difference measurement is the difference between the Expected Arrival Time and the Observed Arrival Time. It is calculated and stored after each Observed Arrival Time measurement. A bit marks this value as invalid until the frame is received completely and passes the required validity checks.

- The sync frame validity checks used during startup and reintegration are described in Section TBD

- A valid sync frame during normal operation means

  - *vCheckFrameCoding* == true

  - *vCheckCRC* == true

  - *vCheckSyncBitSet* == true

  - *vCheckStaticPayloadLength* == true

  - *vCheckFrameIDMatch* == true

**Open Topic:** How to define the Delay Compensation value? Background: using the time value of the first frame can bring problems if we over compensate the wire/star delay --> explain how to define

- For NRZ 8N1 bit coding the time reference point is defined as the rising edge at the end of the frame start.

- The time difference measurement is done for all channels *pChannels*.

- If there are time difference measurements from more than one channel for a given sync frame, the smallest value is taken.

- If only one valid frame is received within a given static sending slot, this single observation is used for the Time Difference Measurement.

- Every node has to be able to store measurement values for *gSyncNodeMax* sync nodes. A counter will be increased when a valid sync frame is received. If a node receives more than *gSyncNodeMax* sync frames in one communication cycle it raises an interrupt to the host but uses the first *gSyncNodeMax* observations for the calculation of the rate and drift correct values.

- The Frame Identifiers of sync frames expected to be received are not stored in the configuration of a node.

- Individual delay compensation values (*pDelayCompensationChA* and *pDelayCompensationChB*) can be configured for each channel.

### *Procedure 5: Measurement*

The following procedure is executed during normal operation following the reception of each frame in the static segment.

```
[vMeasureOddList, vMeasureEvenList] = Measurement(vCycle,
vMeasureOddList, vMeasureEvenList);

   if sync_bit == 1;                              //sync bit
in message set
      if messageChA == valid                      //message is
valid
         vMeasureChA = arrival_time_chA -
   //measurement on channel A
         pExpectedArrivalTimeChA - pDelayCompensationChA;   //
minus compensation value
      else                                //
         vMeasureChA = 'invalid';                 //mark
message as invalid
      end;                                //
      if messageChB == valid                      //message is
valid
         vMeasureChB = arrival_time_chB -
   //measurement on channel B
         pExpectedArrivalTimeChB - pDelayCompensationChB;   //
minus compensation value
      else                                //
         vMeasureChB = 'invalid';                 //mark
message as invalid
      end;                                //
      vMeasureMin = MIN(vMeasureChA, vMeasureChB);      //save
the minimum value of
                                          // both
      if MODULO(vCycle, 2) == 1                       //separate
in odd and even
                                          // cycles
```

```
        vMeasureOddList = [vMeasureOddList, vMeasureMin]; //
add minimum to list
    else                                     //measured value
        vMeasureEvenList = [vMeasureEvenList, vMeasureMin];
    //add minmum to list
    end;                                     //measured value
end;                                         //
```

**Correction Term Calculation**

**Fault-tolerant Midpoint Algorithm**

The technique used for the calculation of the correction terms is a fault-tolerant midpoint algorithm (FTA/FTM) [10 xref TBD]. The algorithm works as follows (see Figure 48 and Procedure 6):

1. The measured values are sorted and the k largest and the k smallest values are discarded (k is the number of tolerated failures per re-synchronization period).

2. The value of k is adapted dynamically to the number of values in the sorted list.

Table 10:

| FTA/FTM Term Deletion as a Function of List Size | |
|---|---|
| **Number of Values** | **k** |
| 1 - 2 | 0 |
| 3 - 7 | 1 |
| 8 - *cControllerMax* | 3 |

3. The largest and the smallest of the remaining values are averaged for the calculation of the midpoint value. The resulting value is assumed to represent the node's deviation from the global time base and serves as the correction term. Figure 48 shows the algorithm for clock correction value calculation for k=2.

*Procedure 6: FTM/FTA Algorithm*

```
function: vCorrectValue = Midterm(list);


    n = LENGTH(list);                                //number of
elements in the list
    if n > 0                                         //
        list = SORT(list);                               //order list by
values
        if n < 3                             //k=0
            vCorrectValue = (list(1) + list(n)) / 2;
    //choose largest and smallest value
        else                                //
            if n < 8                                //k=1
                vCorrectValue = (list(2) + list(n-1)) / 2;
    //choose second largest and second
            else                                 //smallest value
                                                 //k=2
                vCorrectValue = (list(3) + list(n-2)) / 2;
    //choose third largest and third
            end;                                 //smallest value
        end;                                 //
    else                                     //
        vCorrectValue = 0;                               //
    end;                                     //
```

- If the list contains only one value this value is used for clock synchronization.

**Calculation of the Offset Correction Value**

1. The Offset Correction Value *vOffsetCorrection* is a (signed) integer indicating by how many microticks the node should shift its start of the cycle.

2. Offset calculation must be finished before start of cycle, and it may only start after end of last synchronization slot.

3. The node's own offset value (most likely zero, depending on the measurement principle used) must be included if it transmits a sync Frame.

4. The calculation of the offset correction value is done every second communication cycle, in the odd numbered cycles.

5. If the node transmits sync frames, its own offset time is included by adding one instance of the value zero (depending on measurement method) to the list of measured time difference values from the last cycle

6. The offset correction value is determined by applying the FTA/FTM to the list of measured time differences.

***Procedure 7: Offset Correction Value Calculation***

```
vOffsetCorrection = OffsetCalculation(vMeasureOddList)
   list = [];                                       //initialize list
   for i=1 to LENGTH(vMeasureOddList)          //for every
element of the list
       if vMeasureOddList(i) == 'valid'             //check if
valid
           list = [list, vMeasureOddList(i)];       //if yes
write in new list
       end;                                    //
   end;                                        //
   if MODULO(vCycle, 2) == 1                         //if cycle
number is odd
       if sync_master == 1                            //if node is a
sync master (means the
                                          //node transmits sync
messages)
           list = [list,    0];                      //add one zero
value to the list


       end;                                    //
       if LENGTH(list) > 0                            //at least one
value
           vOffsetCorrection = Midterm(list);        //calculate
offset correction term
       else                                    //
           vOffsetCorrection = 0;                     //no offset
correction, warning!
       end;                                    //
   end;                                        //
```

**Calculation of the Rate Correction Value**

1. The calculation of the rate correction value is done after every second communication cycle, in the odd numbered cycles (see Figure 49). Figure 49 shows the timing of measurement and correction.

2. The rate correction value is determined by comparing the corresponding measured time differences from two successive cycles. Specifically, a new list of values is created whose elements are calculated by taking the differences between the most recent cycle's measured time difference and the previous cycle's measured time difference. Only time values corresponding to frames passing the validity checks on both channels are used.

3. If the node transmits sync frames its own rate correction influence is considered by adding an instance of the value zero to the list of calculated time difference.

4. In the next step the FTA/FTM algorithm described in Section "Fault-tolerant Midpoint Algorithm" is applied to the list of time difference values built in the previous two steps.

5. After calculating the correction term, the stored measurement values are deleted so that the next calculation starts with a new set of values.

6. The ideal new rate correction value is the sum of the value calculated in the previous step and the current correction value.

7. To prevent cluster drift that can result from an accumulation of rounding errors the rate correction term actually used is not the ideal rate correction, but a slight modification of this term towards the configuration value. The modification term is a positive integer *pClusterDriftDamping* that is part of nodes static.

***Procedure 8: Rate Correction Value Calculation***

```
vMicroOverheadPerCycle = RateCalculation(vMeasureOddList,
vMeasureEvenList, vCycle, vMicroOverheadPerCycle)

if MODULO(vCycle, 2) == 1                        //if cycle
number is odd
    j=1;                                    //
    for i=1 to LENGTH(vMeasureOddList)            //for all
elements of list1 and list2
        if (vMeasureEvenList(i) == 'valid') AND        //
        (vMeasureOddList(i) == 'valid')            //check if
both values are valid
            vMeasureDiffList(j) = vMeasureOddList(i) -
vMeasureEvenList(i);   // if yes, build difference
            j = j +1;                            //and save it in
a new list
        end;                            //
    end;                            //
                                    //
    if sync_master == 1 AND (two successful sync transmissions
last two cycles) //
```

```
                                              //if node is a sync
master
        vMeasureDiffList = [vMeasureDiffList, 0];              //add
one instance of zero to list
     end;                            //
     if LENGTH(vMeasureDiffList) > 0              //at least
one value in the list
        vChangeInRateCorrection = Midterm(vMeasureDiffList);
     //calculate the rate correction term
     else                            //
        vChangeInRateCorrection = 0;              //no new
rate correction value,
     end;                            //warning!
                                     //
     vIdealRateCorrection =              ·              //ideal new
value is sum of old
        vMicroOverheadPerCycle + vChangeInRateCorrection; //and
change
     if vIdealRateCorrection >= vMicroOverheadPerCycleNom +
pClusterDriftDamping     //
        vMicroOverheadPerCycle = vIdealRateCorrection -
pClusterDriftDamping;  //
     elseif vIdealRateCorrection <= vMicroOverheadPerCycleNom -
pClusterDriftDamping     //
        vMicroOverheadPerCycle = vIdealRateCorrection +
pClusterDriftDamping;  //
     else                                  //
        vMicroOverheadPerCycle = vIdealRateCorrection;    //
     end;                                  //
  end;                                     //
```

**Open Topic:** The last line could also use the configuration value or anything in between.
**Version 5 Solution:** Use configuration parameter *pClusterDriftDamping* (8bit)

• After calculation of the correction values the memory for the measurement values is cleared and marked empty.

**Value Limitations**

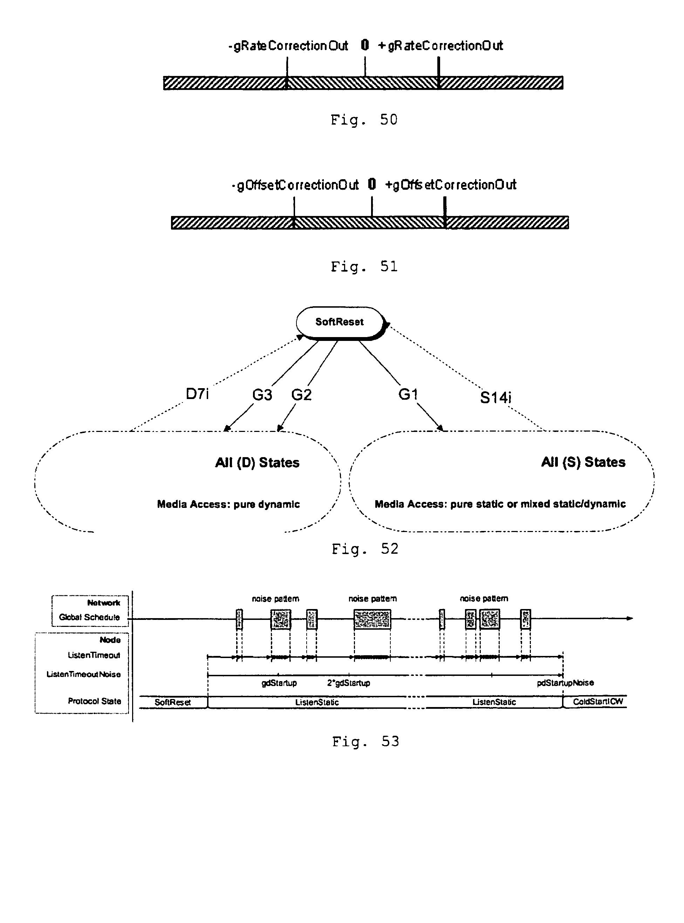

Before applying them, the calculated correction values are checked against pre-configured limits. These limits define two regions that are referred to as the "red" and "green" regions, where the colors reflect the acceptability of the calculated value (see Figure 50).
If correction values are in the green region, the node is fully synchronized. No further actions are necessary.
If one of the correction values is in the red region, the node is out of synchronization. This is a serious problem. Additional information on the handling of this situation is specified in chapter 8 "Error handling".

- The correction values are in the green region if:

  - *-gRateCorrectionOut <= vMicroOverheadPerCycle <= + gRateCorrectionOut*

  - *-gOffsetCorrectionOut <= vOffsetCorrection <= + gOffsetCorrectionOut*

- If both correction values are in the green area the correction is done.

- *-gRateCorrectionOut* is the lower boundary and *+gRateCorrectionOut* is the upper boundary of the green area for the rate correction.

- *-gOffsetCorrectionOut* is the lower boundary and *+gOffsetCorrectionOut* is the upper boundary of the green area for the offset correction.

Figure 50 shows the assessment of the calculated rate correction value.

- The correction value is in the red region if

  - *- gRateCorrectionOut > vRateCorrection* OR *+gRateCorrectionOut < vRateCorrection*

  - *- gOffsetCorrectionout > vOffsetCorrection* OR *+ gOffsetCorrectionOut < vOffsetCorrection*

- The significance of having correction values in the red region depends on whether the node is in the process of startup, or not. During normal operation this is a critical error. During startup and reintegration it must be treated differently (see Section TBD).

- The values of *gRateCorrectionOut* and the *goffsetCorrectionOut* are identically specified for all nodes in the cluster They are defined in terms of in macroticks or partial of a macroticks. From these cluster-wide values the configuration data for each node is calculated (measured in microticks). These values are included in the configuration interface. These calculations are summarized as follows:

  - *pOffsetCorrectionOut = gOffsetCorrectionOut * pMicroPerMacroNom*

  - *pRateCorrectionOut = gRateCorrectionOut * pMicroPerMacroNom*

- If the communication controller is in "normal mode" and if one correction value is in the red area the node goes to passive.

Figure 51 shows the assessment of the calculated offset correction value.

**Clock Correction**

Once calculated, the correction terms are used to modify the local clock in a manner that synchronizes it more closely with the global clock. This is accomplished by using the correction terms to adjust the number of microticks in each macrotick.

- Rate correction is accomplished by modifying the value of *vMicroOverheadPerCycle* (see Procedure 8), which is subsequently distributed over the macroticks comprising the next cycle.

- Offset correction is accomplished by modifying the value of *vOffsetCorrection* (see Procedure 7), which is subsequently distributed over the macroticks comprising the current Network Idle Time.

**Offset Correction**

- Offset correction is done during the network idle time by increasing or decreasing the size of each macrotick..

- It is not necessary that all controllers perform their offset correction identically. However, they must perform the offset correction in the Network Idle Time.

- The offset correction term, *vOffsetCorrection*, is a signed integer that is visible to the application.

- It cannot be assumed that the magnitude of the offset correction term, |*vOffsetCorrection*|, is less than a macrotick. However, it is necessary to make assumptions on the maximum value |*vOffsetCorrection*| can achieve under all application and fault scenarios. (The maximum offset correction value assumed has a significant influence on the macrotick length, slot length and other critical timing parameters.)

- The maximum number of microticks that at macrotick can be increased (due to offset correction and rate correction combined) is bounded by a configuration constant *pMicroPerMacroMax*. The offset correction term, *vOffsetCorrection*, is distributed across the first, and subsequent macroticks to the limit allowed by *pMicroPerMacroMax*, until the total offset term is distributed.

- The maximum number of microticks that at macrotick can be decreased (due to offset correction and rate correction combined) is bounded by a configuration constant *pMicroPerMacroMin*. The offset correction term, *vOffsetCorrection*, is distributed across the first, and subsequent macroticks to the limit allowed by *pMicroPerMacroMin*, until the total offset term is distributed.

- *pMicroPerMacroMax* is the maximum length of a macrotick in microticks.

- *pMicroPerMacroMin* is the minimum length of a macrotick in microticks.

### *Procedure 9: Offset Correction*

[*vMicroPerMacroCorr*] = OffsetCorrection(*vOffsetCorrection, vMicroPerMacroRateCorr*)

```
if networkIdleTime == true                          //
  if vOffsetCorrection > 0                          //positive
offset
    if vOffsetCorrection > pMicroPerMacroMax -
vMicroPerMacroRateCorr;   //
      vMicroPerMacroCorr = pMicroPerMacroMax;       //
      vOffsetCorrection = vOffsetCorrection -         //
        (pMicroPerMacroMax - vMicroPerMacroRateCorr);   //
    else                                  //
      vMicroPerMacroCorr = vOffsetCorrection +
vMicroPerMacroRateCorr;   //
      vOffsetCorrection = 0;                    //
    end;                                //
  else                                  //
    if (vMicroPerMacroRateCorr - pMicroPerMacroMin) <
|vOffsetCorrection| //negative offset
      vMicroPerMacroCorr = pMicroPerMacroMin;       //
      vOffsetCorrection = vOffsetCorrection +         //
        (vMicroPerMacroRateCorr - pMicroPerMacroMin);   //
    else                                //
      vMicroPerMacroCorr = vMicroPerMacroRateCorr +
vOffsetCorrection;   //
      vOffsetCorrection = 0;                  //
    end;                              //
  end;                                //
else                                  //
  vMicroPerMacroCorr = vMicroPerMacroCorr;          //
end;                                  //
```

**Rate Correction**

- The rate correction term is uniformly distributed over the entire cycle (see Figure 49).

*Procedure 10: Distribution of Microticks Over Macroticks*

```
[vIntergerRatio, vRest, vRemainingSumOfFractionalParts,
vDeltaCorrect, vOffsetRemainder] =
InitStartOfCycle(vMicroOverheadPerCycle, vOffsetCorrection)
    //This replaces InitRateStartOfCycle
                                        //execute at the
beginning of every
    vMicroPerCycle = gMacroPerCycle * pMicroPerMacroNom
    //second cycle
      + vMicroOverheadPerCycle;                    //
    vRatioMicroMacro = vMicroPerCycle / gMacroPerCycle     //
    vIntegerRatio = Int[vRatioMicroMacro];            //
    vRest = vRatioMicroMacro - vIntegerRatio;          //value
between 0 and 1
    vRemainingSumOfFractionalParts = vRest;           //
    vDeltaCorrect = 0;                      //
    vOffsetRemainder = vOffsetCorrection;
    //Additional variable


[vMicroPerMacroCorr, vIntegerRatio, vDeltaCorrect,
vRemainingSumOfFractionalParts, vRest, vOffsetRemainder] =
DistributeMicroOverMacro(vIntegerRatio, vDeltaCorrect,
vRemainingSumOfFractionalParts, vRest, vOffsetRemainder)
    //This replaces DistributeMicroOver
                                        //MacroRate
while(1)                               //
    vMicroPerMacroRateCorr = vIntegerRatio + vDeltaCorrect;
    //Rate correction part
    vRemainingSumOfFractionalParts =
vRemainingSumOfFractionalParts + vRest; //
```

```
    if vRemainingSumOfFractionalParts >= 1              //
       vDeltaCorrect = 1;                               //
       vRemainingSumOfFractionalParts =
vRemainingSumOfFractionalParts -1; //
    else                                     //
       vDeltaCorrect = 0;                              //
    end;                                     //
    vMicroPerMacroCorr = OffsetCorrection(vOffsetRemainder,
    vMicroPerMacroRateCorr)   //
       [vMicrotick, vMacrotick] =
IncrementMacrotickCounter(vMicroPerMacroCorr, vMicrotick,
       Macrotick)
end;                                        //
[vMacrotick, vCycle] = ChangeOfCycleCount(vMacrotick,
vCycle)//
```

Procedure notes:

- This is only an example.

- As previously mentioned, it seems to be unlikely that the variable *vMicroPerMacroRateCorr* can be calculated explicitly in hardware. It is more likely that the IncrementMacrotickCounter procedure will be an intrinsic part of at least the rate part of the microtick distribution state machine.

**External Clock Synchronization (only for V5)**

During normal operation, two independent clusters can drift significantly during normal operation (e.g., by the damping factor of each cluster). If synchronous operation is desired across the two clusters, external synchronization is necessary; even though the nodes within each cluster are synchronized. This can be accomplished with the synchronous application of host-deduced rate and offset correction terms to both clusters.

- Both the external rate and external offset correction have to be performed in the same cycle.

- The external correction terms (offset and rate correction terms) have to be available to the communication controller when the network idle time starts.

- The external correction terms will be checked against limits and applied following the corresponding tasks are performed for the internal correction terms. This takes place during the Network Idle Time.

- Following the Network Idle Time, an aggregate rate correction term

- The aggregate offset correction term, consisting of correction components from the internal and external offset correction terms, will be applied in the remainder of the Network Idle Time, before the next cycle starts.

**Open Topic:** In soft reset, the initial external rate correction can be accomplished two ways:

- Option 1: by setting the external rate correction term

- Option 2: by setting the variable *vMicroOverheadPerCycle*

**Dependencies**

**Host Interface**

The following table summarizes the host interface registers supporting external clock correction:

Table 11:

| Host Interface Registers for External Clock Correction | |
|---|---|
| Register | Size |
| External offset correction register | 8 Bit |
| Internal offset correction register | 8 Bit |
| *gOffsetCorrectionExternalOut* | 8 Bit |
| External rate correction register | 8 Bit |

**Comment:** *gOffsetCorrectionOut + gOffsetCorrectionExternalOut* must be configured such that their sum is less than or equal to the reserved bandwidth for offset correction within the network idle time.

**Checks**

The following rate and offset correction limit checks are performed:

- check internal offset correction value *vOffsetCorrection* against *gOffsetCorrectionOut*,

- check external offset correction value separately against *gOffsetCorectionExternalOut*

- check sum of internal and external rate correction against *gRateCorrectionOut*.

**Error Handling**

The following error conditions can arise from the rate and offset limit checks:

- sum of internal and external rate correction is in the red region

- internal rate correction in the red region

- internal offset correction in the red region

**Chapter 8**

**Startup and Reintegration**

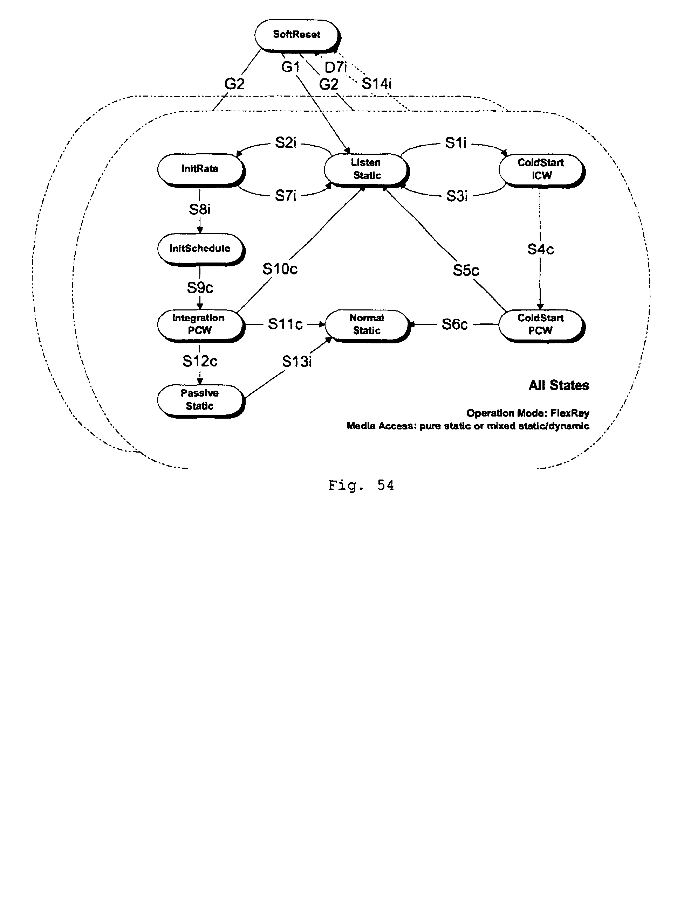

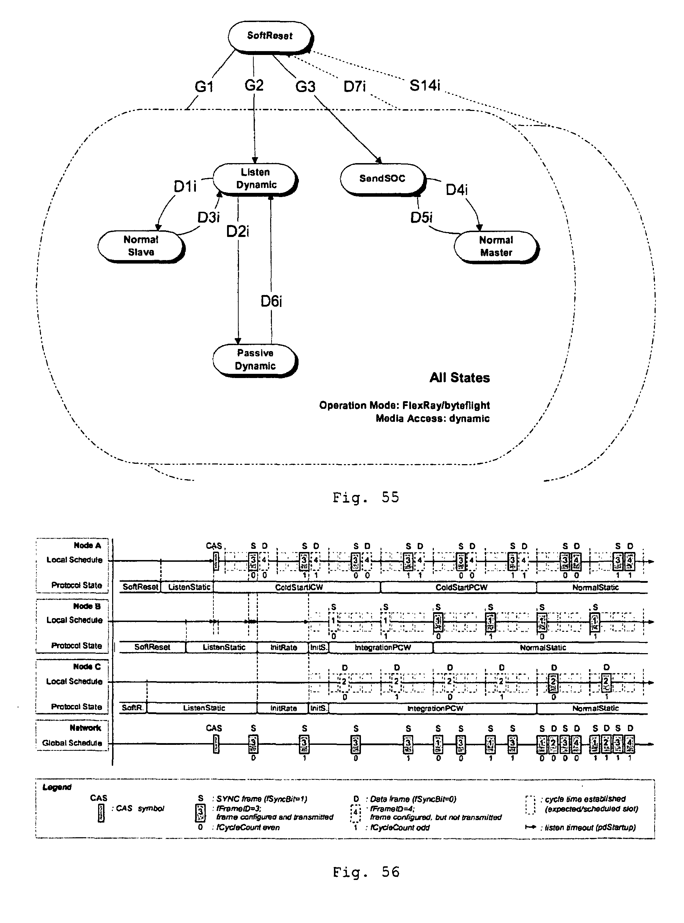

Corresponding to the two supported protocol operation modes and their media access schemes, two different mechanisms for communication startup are specified. Networks operating in FlexRay mode with a static segment configured follow a fault-tolerant, distributed startup strategy (refer to transitions indicated by prefix 'S'; see Figure 54), while networks configured with a pure dynamic media access scheme perform a master driven startup (state transitions with prefix 'D'; see Figure 55). The protocol operations related to synchronization of the running communication schedule, integration of further nodes to a running cluster, media access rules and error handling are different for the two configuration alternatives. Therefore, configuration-specific state diagrams for each of these configurations with state descriptions and state transitions are given in the following sections. The general startup mechanism is described in Section "Protocol Startup". The protocol state machine does not include the 'wake-up' path. The network wake-up must precede the communication startup, in order to ensure that all mechanisms defined for the startup work properly. After initial wake-up the whole network behaves like a broadcast medium.

**Startup States - Global Structure**

Figure 52 shows a global structure of a protocol state diagram. From the *SoftReset* state, one of two distinct startup state machines is entered depending on how the configuration settings are chosen. For pure static or mixed static/dynamic configurations the fault-tolerant, distributed startup is triggered by the transition G1. For pure dynamic configurations it depends on whether a node is a master node or not, when deciding which transition (G2 or G3) the startup state machine has to take.

State transitions marked with the suffix 'c' are aligned to cycle boundaries, state transitions tagged with an 'i' are executed immediately, i.e. as soon as the specific condition becomes true.

| State Transition | Transition Direction | | Condition for Transition | |
|---|---|---|---|---|
| | from | to | | |
| G1 | *SoftReset* | *ListenStatic* | | soft reset released (in the respective control register) |
| | | | AND | static segment configured (*gNumberofStaticSlots* greater than one[1]) |
| G2 | | *Listen Dynamic* | | soft reset released (in the respective control register) |
| | | | AND | pure dynamic media access configured (*gNumberofStaticSlots* equal to zero) |
| | | | AND | slave role configured (*pMaster* not set) |
| G3 | | *Normal Master* | | soft reset released (in the respective control register) |
| | | | AND | pure dynamic media access configured (*gNumberofStaticSlots* equal to zero) |
| | | | AND | master role configured (*pMaster* set) |

**Table 12:** Global Startup State Transitions and Respective Conditions for Execution

[1] A minimum of at least two static slots is required for a pure static or mixed configuration in FlexRay

**SoftReset State**

The *SoftReset* state is part of the overall protocol state diagram and is not just a component of startup and reintegration. The host configures the communication controller while it is in *SoftReset* state. If the communication controller is in any other state, the host must force the communication controller to re-enter the SoftReset state in order to change it's configuration.

**Startup States - FlexRay Mode with Static Segment Configured**

In general, a node may enter communication (i.e., the *NormalStatic* state) via the coldstart path (*ColdStartICW* and *ColdStartPCW* state sequence) initiating the schedule synchronization, or via the integration path (*InitRate, InitSchedule*, and *IntagrationPCW* state sequence) integrating into an existing communication schedule. Only sync nodes are allowed to enter via the coldstart path, and they have to check in advance whether there is already network channel activity, or not (see Section 0). A node is called a SYNC node if the host has set *pSyncNode* in the host interface. For a non-SYNC node, *pSyncNode* is set to False. The configuration parameter can only be set or cleared in the *SoftReset* state. The transmission of more than SYNC frame within one cycle has to be prevented by the communication controller.

For networks with a static segment configured, the initial synchronization of the periodic TDMA schedule must be coordinated among all connected communication nodes. Since all sync nodes are authorized to initiate the schedule synchronization, simultaneously started and conflicting attempts by different sync nodes must be resolved. Each node initially transmits a Collision Avoidance Symbol (CAS, see Section "Frame Validation") specifically for this purpose, before initiating the periodic schedule. This symbol represents a kind of arbiter, which is used to resolve initial collisions of nodes trying to set up the communication schedule at the same time.

Non-sync nodes as well as sync nodes start passive integration as soon as they receive sync frames from which to derive the TDMA schedule information. During integration the node has to adapt its own clock to the global clock (rate and offset) and has to make its cycle time consistent with the global schedule observable at the network. Afterwards, these settings are checked for consistency with all available network nodes. Only if these checks are passed, can the node leave the integration phase and actively participate in communication.

Several modes are supported, which restrict the node's ability to communicate or to initiate the startup actively (see Sections "Listen-Only Mode" and "ColdStart-Inhibit Mode"). These modes are configurable by the host and are explained within in their respective sections.

**Frame Validation**

The semantic information that can be derived from the received data stream varies with the protocol state of the node. Certain frame validation checks have to be passed by a received frame or symbol, in order to be an appropriate input for the related logic block.

| | VCheckFrameCoding_x | VCheckHeaderCRC_x | VCheckCRC_x | VCheckSyncBitSet_x | vCheckSyncBitMatch[2] | VCheckFrameIDStaticRan | VCheckFrameID_x | vCheckFrameIDMatch | VCheckCycleCount_x | vCheckCycleCountMatch | VCheckCycleCountEven_x | VCheckIdleBeforeRecept | VCheckIdleAfterRecepti | vCheckStaticPayloadLen | VCheckNormalSymbol_x | VCheckAlarmSymbol_x | VCheckWakeupSymbol_x | VCheckNodleDuringRecep |
|---|---|---|---|---|---|---|---|---|---|---|---|---|---|---|---|---|---|---|
| Corrupted frame pattern[3] | F | x | x | x | x | x | x | x | x | x | x | T | x | x | x | x | | |
| | T | F | x | x | x | x | x | x | x | x | x | T | x | x | F | F | | |
| | T | T | F | x | x | x | x | x | x | x | x | T | x | x | x | x | | |
| | T | T | T | x | x | x | x | x | x | x | x | T | F | x | x | x | | |
| | T | T | T | x | x | x | x | x | x | x | x | T | x | F | x | x | | |
| Valid header pattern | T | T | x | x | x | x | x | x | x | x | x | T | x | x | x | x | | |
| Valid CAS[4] | T | x | x | x | x | x | x | x | x | x | x | T | T | x | T | x | | |
| Valid SOC[5] | T | x | x | x | x | x | x | x | x | x | x | T | T | x | T | F | | |
| | T | x | x | x | x | x | x | x | x | x | x | T | T | x | F | T | | |
| Valid DataFrame_startupPCW | T | T | T | F | x | T | T | x | T | x | x | T | T | T | x | x | | |
| Valid | T | T | T | T | x | T | x | x | x | x | T | T | T | T | x | x | | |

mode

| | | | | | | | | | | | | | | | | | | |
|---|---|---|---|---|---|---|---|---|---|---|---|---|---|---|---|---|---|---|
| SYNCFrame$_{StartupEven}$ | | | | | | | | | | | | | | | | | | |
| Valid SYNCFrame$_{StartupOdd}$ | T | T | T | T | x | T | x | x | x | x | F | T | T | T | x | x | | |
| Valid SYNCFrame$_{StartupPCW}$ | T | T | T | T | T | T | T | x | T | x | x | T | T | T | x | x | | |
| Invalid DataFrame$_{StartupPCW}$ | T | T | T | T | T | T | x | x | F | x | x | T | T | T | x | x | | |
| | T | T | T | T | T | T | F | x | T | x | x | T | T | T | x | x | | |

T – Test outcome is True
F – Test outcome is False
x – Test outcome is irrelevant

**Table 13:** Frame Check Sets

[2]     All checks based on a comparison of the information gained from the different channels are considered passed (T) if only one value is available.

[3]     The term 'corrupted frame pattern' does also include corrupted symbols

[4]     The syntax of the CAS (Collision Avoidance Symbol) is the same as the SOC Normal symbol used in pure dynamic configurations (refer also to the coding chapter).

[5]     The term SOC is used to aggregate the two dynamic SOC symbols, SOC Normal and SOC Alarm without distinguishing which one is observed. In essence, a SOC is observed if either an SOC Normal symbol or an SOC Alarm symbol is observed.

Table 13 above, enumerates the relevant sets of checks that have to be passed in order to conclude that certain startup-relevant events have occurred.

**Listen-timeout and Listen-timeout with Noise**

A sync node maintains two different timers, *vdStartup* and *vdStartupNoise*, which serve as listen-timeouts in order to leave the initial sensing phase (*ListenStatic* state) with the intention to start up the communication.

The node local listen-timeout *vdStartup* has the same length (*gdStartup*) for each node in the system, which is configured to send an initial CAS during startup (sync node). *vdStartup* limits the listen time that used by a node to determine if there is already communication between other nodes or at least one sync node actively requesting the integration of others. If communication channel activity is detected on one of the configured *pChannels* channels while the node is in the *ListenStatic* state, the listen-timeout *vdStartup* is restarted. (Any signal edge detectable at the receiver (i.e., a signal edge, which has passed the glitch filter) is referenced to as "channel activity". In case a 3-level physical layer representation is used, the same definition applies for an edge visible at the signal port, which indicates a level at the channel different from idle. Again, this is checked after the signal has traversed the glitch filter.) The reception of a valid SYNCFrame$_{StartupEven}$ causes the node to enter the integration path. Upon leaving the *ListenStatic* state, the listen-timeout is stopped.

As soon as the listen-timeout *vdStartup* expires (*vdStartup=gdStartup*) a node that is configured to initiate the startup actively enters the coldstart path and attempts the active network startup. Figure 53 shows listen-timeouts *vdStartup* and *vdStartupNoise*.

At the same time as the listen-timeout *vdStartup* is started the first time, the second timeout *vdStartupNoise* is started. This additional timeout is used to improve reliability of the startup procedure in the presence of noise. As soon as the timeout *vdStartupNoise* expires (*vdStartupNoise=pdStartupNoise*gdStartup*) without a valid SYMCFrame$_{StartupEven}$ being received on any of the configured communication channels, the sync node enters the coldstart path and assumes responsibility for initiating communication startup. Since the timeout *vdStartupNoise* won't be reset if channel activity is sensed (see Figure 53), this timeout defines the fallback solution that guarantees that a node tries to startup the communication cluster even in the presence of noise. The expiration of *vdStartupNoise* and the resulting entry into the coldstart path is captured in the variable *vNoise* (*vNoise* is set to 'true').

Version 5 Solution: A node in *ColdStartICW* state (see Section Startup State Diagram) shows a certain robustness against noise due to the definition of a valid header pattern (see Table 13), which has to be received in order to return to the *ListenStatic* state. If this specification is changed in the future in a way that the node in *ColdStartICW* state is also susceptible to noise (= corrupted frames), the variable *vNoise* has to be evaluated during the coldstart phase. With that value, the node is able to distinguish whether the *ColdStartICW* state has been entered due to expiration of *vdStartupNoise* or not. If *vNoise* is true, the node must sustain the coldstart phase (i.e., remain in *ColdStartICW* state) even in the presence of noise. At least for this specific case a definition of valid header pattern that is distinguishable from noise must exist!

The time-out interval *gdStartup* is constrained by the following inequality. *gdStartup* is derived internally from the given configuration parameters *gdCycle* and *gdMaxDrift*. In addition, the upper boundary for the listen timeout *vdStartupNoise* is a multiple of *gdStartup* and is configurable using the parameter *pdStartupNoise*.

$$gdStartup \geq gdCycle + gdMaxDrift$$

Due to the initial clock drift between nodes that are already actively communicating (transmitting sync frames) and the node that is attempting to integrate, the listen-timeout must cover the maximum accumulated drift over the free-running, unsynchronized period.

The maximum allowable drift between any two clocks in the network is an important system parameter and known at design time. This 'worst case' period has to be covered by configuring *gdMaxDrift* (unit: macroticks) accordingly. Furthermore, the nominal time between two trigger events caused by regular communication pattern is always smaller than one communication cycle *gdCycle.*

**Listen-Only Mode**

The 'listen-only' mode is configured by setting *vListenOnly* while in the *SoftReset* state. *vListenOnly* cannot be set after leaving the *SoftReset* state, but can be cleared at any time. In listen-only mode, the node is able to receive all frames after integration to the running communication; i.e. the node is fully synchronized and performs the clock synchronization in order to keep this status. In comparison to the normal operation mode (*NormalStatic* state) the node does not actively participate in communication, i.e. neither symbols nor frames are transmitted.

This mode supports communication diagnosis ('monitoring') as well as dedicated wake-up strategies, which require host interaction (*vListenOnly* subsequently cleared) in order to actively participate in communication after wake-up.

In listen-only mode, sync nodes behave like non-sync nodes during startup. Specifically, this applies to the prerequisites for transitioning from *IntegrationPCW* to *StaticPassive*. Passing the plausibility check requires that at least two different sync nodes are already synchronized and able to communicate. Please refer to the description of the plausibility check in Section "*InitSchedule* State".

**ColdStart-Inhibit Mode**

The node can be prevented from initializing the TDMA communication schedule by setting *vColdStartInhibit* in the *SoftReset* state. *vColdStartInhibit* cannot be set after leaving the *SoftReset* state, but can be cleared at any time. *vColdStartInhibit* can be mapped to the *gColdStartMax* configuration parameter, which utilizes the zero value as to keep the node from starting the network on its own initiative (refer to the chapter "host interface"). It has to be checked whether the parameter *gColdStartMax* can be accessed during run time, i.e., after leaving *SoftReset* state, as this is required for the "coldstart inhibit" function.

If the host has set *vColdStartInhibit,* the node is not allowed to initialize the cluster communication after having checked on existing communication. The node is allowed to integrate to a running cluster or to acknowledge another node, which initially tries to start the cluster communication.

Once the node is synchronized, *vColdStartInhibit* does not restrict the node's ability to receive frames or to transmit frames.

**Startup State Diagram**

Figure 54 shows a startup state diagram - FlexRay Mode with Static Segment Configured.

| State Transition | Transition Direction | | Condition for Transition | |
|---|---|---|---|---|
| | from | to | | |
| S1i | *ListenStatic* | *ColdStart ICW* | | node is configured as a sync node (*pSyncNode*==true; *gColdStartMax*>0) |
| | | | **AND** | *vColdStartCount < gColdStartMax* |
| | | | **AND** | *vListenOnly* is not set |
| | | | **AND** | *vColdStartInhibit* is not set |
| | | | **AND** ( | listen-timeout *vdStartup* expired (*vdStartup*==*gdStartup*) |
| | | | **OR** ) | listen-timeout with noise *vdStartupNoise* expired (*vNoise*==1) |
| S2i | | *InitRate* | | reception of a valid SYNCFrame<sub>StartupEven</sub> on one of *pChannels* channels[6] |

---

[6]     Since the state transition is performed immediately (indicated by suffix i), a 'pick first' strategy for SYNCFrame<sub>StartupEven</sub> interpretation is specified. The node does not check, whether there is also a corresponding SYNCFrame<sub>StartupEven</sub> at the second channel or not. As soon as one valid SYNCFrame<sub>StartupEven</sub> has been received, an ongoing reception at the other channel can be aborted. In no case should the subsequent delayed reception of

| State Transition | Transition Direction | | Condition for Transition | | |
|---|---|---|---|---|---|
| | from | to | | | |
| | | | **AND** ( | | $vRefSync == 0$ (no integration history available) |
| | | | | **OR** | $fFrameID$ is different from $vRefSync$ |
| | | | ) | | |
| **S3i** | ColdStart ICW | ListenStatic | ( | | end of current cycle (derived from local cycle time) |
| | | | | **AND** | $vColdStartCount$ is equal to $gColdStartMax$ [7] |
| | | | ) **OR** | | reception of a valid CAS symbol on one of $pChannels$ channels |
| | | | | **OR** | reception of a valid header pattern on one of $pChannels$ channels |
| **S4c** | | ColdStart PCW | not S3i | | |
| | | | **AND** ( | | end of current cycle (derived from local cycle time) |
| | | | | **AND** | $vdInitialCheckWindow$ expired ($vdInitialCheckWindow$ == |
| | | | ) | | $gdInitialCheckWindow$) |

---

a corresponding SYNCFrame$_{StartupEven}$ at the second channel be interpreted as the trigger event for the succeeding state transition S8i!

[7]      Due to this definition it is possible that a node stops current startup process (re-enter *ListenStatic* from *ColdStartICW*), even though there hasn't been any possibility for other nodes to answer until then.

| State Transition | Transition Direction | | Condition for Transition | | |
|---|---|---|---|---|---|
| | from | to | | | |
| **S5c** | *ColdStart PCW* | *ListenStatic* | **(** | | end of current cycle (derived from local cycle time) |
| | | | | **AND** | *vColdStartCount* is equal to *gColdStartMax* |
| | | | **)** | **AND** | not S6c |
| | | | **OR (** | | end of current cycle (derived from local cycle time) |
| | | | **)** | **AND** | *vInvalidSyncCount* ≥ *vValidSyncCount* |
| | | | **OR (** | | end of current cycle (derived from local cycle time) |
| | | | **)** | **AND** | $\lvert vOffsetCorrection \rvert > pOffsetCorrectionOut$[8] |
| | | | **OR (** | | end of current cycle (derived from local cycle time) |
| | | | **)** | **AND** | $\lvert vMicroOverheadPerCycle \rvert > pRateCorrectionOut$[9] |
| **S6c** | *ColdStart PCW* | *Normal Static* | | | end of current cycle (derived from local cycle time) |
| | | | **AND** | | *vInvalidSyncCount* < *vValidSyncCount* |
| | | | **AND** | | *vSyncPairs* is true |
| | | | **AND** | | $\lvert vOffsetCorrection \rvert \leq pOffsetCorrectionOut$ |
| | | | **AND** | | $\lvert vMicroOverheadPerCycle \rvert \leq pRateCorrectionOut$ |

---

[8]    It is assumed that the vOffsetCorrection is set to zero for cycles with even cycle counter value [(vCycle MOD 2)=0] by the clock synchronization unit

[9]    This check reflects the check on 'matching the valid range' for the rate correction term. The current definition in the chapter 'clock synchronization' refers to vRateCorrection, but is not consistent in the adhering description

| State Transition | Transition Direction | | Condition for Transition | |
|---|---|---|---|---|
| | from | to | | |
| S7i | InitRate | ListenStatic | | timer *vdInitRateMLate* expired (valid SYNCFrame$_{startupOdd}$ with *fFrameID = vRefSync* too late) |
| | | | OR ( | valid SYNCFrame$_{startupOdd}$ with *fFrameID = vRefSync* received |
| | | | AND | timer *vdInitialRateMEarly* has not been started |
| | | | ) | (occurrence of frame too early) |
| S8i | | InitSchedule | | not S7i |
| | | | AND | valid SYNCFrame$_{startupOdd}$ with *fFrameID = vRefSync* received[10] |
| S9c | InitSchedule | Integration PCW | | end of current cycle (derived from local cycle time) |

---

[10]    'Pick first' strategy is applied; refer also to transition S2i

| State Transition | Transition Direction | | Condition for Transition |
|---|---|---|---|
| | from | to | |
| **S10c** | *Integration PCW* | *ListenStatic* | ( end of current cycle (derived from local cycle time)<br>**AND** *vInvalidSyncCount ≥ vValidSyncCount*<br>)<br>OR ( end of current cycle (derived from local cycle time)<br>**AND** *vOffsetOut* == true (an offset correction value greater than *pOffsetCorrectionOut* has already been accepted once)<br>**AND** \|*vOffsetCorrection*\| > *pOffsetCorrectionOut*<br>)<br>OR ( end of current cycle (derived from local cycle time)<br>**AND** \|*vOffsetCorrection*\| > 2* *pOffsetCorrectionOut*<br>)<br>OR ( end of current cycle (derived from local cycle time)<br>**AND** \|*vMicroOverheadPerCycle*\| > *pRateCorrectionOut*<br>) |
| **S11c** | | *Normal Static* | not S10c<br>**AND** end of current cycle (derived from local cycle time)<br>**AND** *vInvalidSyncCount* < *vValidSyncCount* and (*vCycle* MOD 2) == 1)<br>**AND** *vSyncPairs* is true<br>**AND** *vListenOnly* is false<br>**AND** \|*vOffsetCorrection*\| ≤ *pOffsetCorrectionOut*<br>**AND** \|*vMicroOverheadPerCycle*\| ≤ *pRateCorrectionOut* |

| State Transition | Transition Direction | | Condition for Transition | |
|---|---|---|---|---|
| | from | to | | |
| S12c | | *Passive Static* | | not S10c |
| | | | AND | end of current cycle (derived from local cycle time) |
| | | | AND | $vInvalidSyncCount < vValidSyncCount$ and ($vCycle$ MOD 2) == 1) |
| | | | AND | $vSyncPairs$ is true |
| | | | AND | $vListenOnly$ is true |
| | | | AND | $|vOffsetCorrection| \leq pOffsetCorrectionOut$ |
| | | | AND | $|vMicroOverheadPerCycle| \leq pRateCorrectionOut$ |
| S13i | *Passive Static* | *Normal Static* | | end of current cycle (derived from local cycle time) |
| | | | AND | $vListenOnly$ is false |
| S14i | *All States* | *Soft Reset* | | soft reset initiated (in the respective control register) |

**Table 14:** State Transitions and Corresponding Conditions for Execution

### *ListenStatic* State

All nodes enter the *ListenStatic* state after being released from the *SoftReset* state. In this state the communication controller is ready to attempt network startup or enter a running network. When entering the *ListenStatic* state from *SoftReset* or re-entering from integration path (*InitRate*, *InitSchedule*, and *IntegrationPCW* state sequence), sync nodes start their listen-timeout *vdStartup* and their listen-timeout with noise *vdStartupNoise*. Network activity on any of *pChannels* channels, which is different from a valid SYNCFrame$_{StartupEven}$ causes a restart of the listen-timeout *vdStartup*. If *ListenStatic* is entered from *ColdStartICW* or *ColdStartPCW* because the maximum number of coldstart attempts has been reached (*vColdStartCount = gColdStartMax*), the listen-timeouts are not re-started. If the node just failed due to the ICW or PCW checks (see Sections "ColdStartICW State" and "ColdStartPCW State"), the listen timeout vdStartup is restarted and *vdStartupNoise* is resumed from the latest value. Non-sync nodes do not have any listen-timeouts.

When either timeout (*vdStartup* or *vdStartupNoise*) expires, the other is also halted in the transition to the *ColdStartICW* state.

In order to maintain a fallback strategy to apply after an integration attempt fails (see Section "Protocol Startup"), nodes in *ListenStatic* start the timer *vdCycleWithHistory* if *vRefSync* is nonzero. This timer covers the same period gdStartup as the *vdStartup* timeout, but its restart condition is defined differently. If a valid SYNCFrame$_{StartupEven}$ with *fFrameID* equal to *vRefSync* is received, no transition into InitRate takes place. Only if *vdCycleWithHistory* expires, is *vRefSync* cleared. This setting (*vRefSync*=0) prevents the restart of *vdCycleWithHistory*. Channel activity different from valid SYNCFrame$_{StartupEven}$ does not restart *vdCycleWithHistory*. Before entering *InitRate* on reception of a valid SYNCFrame$_{StartupEven}$ (*vRefSync*=0 or *fFrameID* not equal to *vRefSync*) *fFrameID* is stored to *vRefSync* and *vdCycleWithHistory* is cleared and halted.

When re-entering *ListenStatic* state from any state, the rate correction value has to be reinitialized with *pMicroOverheadperCycleNom*.

***ColdStartICW* State** (The acronym "ICW" stands for Initial Check Window)

Only sync nodes are allowed to enter the *ColdStartICW* state. These nodes leave *ListenStatic* when a listen-timeout or listen-timeout with noise occurs before receiving a valid SYNCFrame$_{StartupEven}$. In *ColdStartICW* state, a sync node transmits the initial CAS and then cyclically transmits its configured sync to enable the startup of the entire network. If more than one sync node's listen-timeout or listen-timeout with noise expires before a valid SYNCFrame$_{StartupEven}$ is received, they all enter *ColdStartICW*. In *ColdStartICW* normal data frames (without sync bit set) are not transmitted.

With the transition into *ColdStartICW* the variable *vColdStartCount* is incremented by one. At the end of each cycle, *vColdStartCount* is compared to the allowed maximum *gColdStartMax.* After having spent *gColdStartMax* cycles attempting to achieve communication with another node (transition to *NormalStatic* state), the node re-enters *ListenStatic*. This measure ensures that a node unable to receive a valid SYNCFrame$_{StartupPCW}$ from at least one of *pChannels* channels, i.e. a node with 'incoming link failure', stops transmission after a predefined interval of time and thereby enables other nodes to assume the responsibility for starting communication for the cluster.

With each new cycle-start in the *ColdStartICW* state, *vColdStartCount* is incremented by one.

The node remains in *ColdStartICW* for a period determined by the initial check window (*gdInitialCheckwindow*). The timer *vdInitialCheckWindow* is started, when *ColdStartICW* is entered, and thus covers the initial slot used for CAS transmission as well as three complete communication cycles (refer to definition of *gdInitialCheckWindow* in Section TBD). Consequently, *gdInitialCheckWindow* determines the time a node stays in *ColdStartICW* before entering *ColdStartPCW*. In order to take all reception events into account, this window does not have any gap, i.e. it also includes the network idle time (compare with the definition for *gdPlausibilityCheckWindow*!) Due to the fact that the node is not capable to receive during its own transmissions, the network observation is suspended during them.

The reception of a valid CAS symbol or valid header pattern causes the node to immediately re-enter *ListenStatic*. With the transition into another state the timer *vdInitialCheckWindow* is stopped.

***ColdStartPCW* State** (The acronym "PCW" stands for Plausibility Check Window)

In *ColdStartPCW* the node continues transmitting its sync frame periodically. In addition, the node performs a plausibility check in order to assess the network image gained during a bounded receive period determined by the plausibility check window *gdPlausibilityCheckWindow*.

**Version 5 Solution:** Since running receptions are stopped with the beginning of the network idle time and no further reception events during network idle time are considered for the actual cycle, the *gdPlausibilityCheckWindow* period starts with each new cycle and ends with transition into network idle time.

After each observation phase (*gdPlausibilityCheckWindow*) the node evaluates the results. The node re-enters *ListenStatic* if an inconsistency is observed regarding the number of valid SYNC frames received, and the node's observation matches the minority. On the other hand, the node is allowed to enter *NormalStatic* if the plausibility check is passed (*vInalidSyncCount<vValidSyncCount;* see also the conditions for counter increment below). Two event counters *(vValidSyncCount* and *vInvalidSyncCount*) are administrated in order to support decision-making. In accordance with the receive window definition, a clear distinction between several possible cases can be made for each slot. These slot scenarios are judged and counters are incremented according to the following rules (where x stands for channel A or B and y stands for the respective other channel):

```
if valid SYNCFrameStartupPCWx        and
   (
   nothing at the other channel y      or
```

```
            corrupted frame pattern y       or
            valid SYNCFrame_startupPCWy
            )

                 vValidSyncCount++;
            end;

            elseif (invalid SYNCFrame_startupPCWx       and
                (
                nothing at the other channel y     or
                corrupted frame patterny       or
                valid SYNCFrame_startupPCWy       or
                invalid SYNC_FrameStartupPCWy       or
                valid DataFrame_startupPCWy
                ))                       or
                (valid SYNCFrame_startupPCWx       and
                valid DataFrame_startupPCWy)

                 vInvalidSyncCount++;
            end;
```

The plausibility checks are initialized as follows:

*vValidSyncCount* =1;

*vInvalidSyncCount* =0;

The plausibility check is passed, if *vValidSyncCount* is greater than *vInvalidSyncCount*. The transition to *NormalStatic* is only permitted, if the check is passed with *vValidSyncCount*>1, since the node considers itself correct and has therefore initialized the counter accordingly. If the value of *vValidSyncCount* is still one, there has been no valid determination so far and the node remains in *ColdStartPCW* state for another cycle.

With the transition to *ColdStartPCW* and with each new cycle start in *ColdStartPCW*, the variable *vColdStartCount* is incremented by one. At the end of each cycle, *vColdStartCount* is compared to the allowed maximum *gColdStartMax*.

In *ColdStartPCW* the node continues executing the global clock synchronization for offset and rate according to the regular rules (already started during *ColdStartICW* state). According to the definition of the regular rate measurement phase, all sync frames are registered and pair-wise (sync frames with same frame identifier) evaluated for clock synchronization.

The offset measurement phase is applied in accordance to the regular scheme, too. This means that for each cycle with an odd cycle counter value the related sync frames are used to determine next offset correction term.

The node in *ColdStartPCW* state requires at least one additional matching pair of sync frames suitable for rate measurement (same frame identifier, consecutive occurrence in 'even/odd' cycle order), in order to fulfill one of the necessary prerequisites for entering *NormalStatic.* As long as the node does receive a response, it performs the clock correction based on one "pair of matching sync" frames, namely its own transmissions (the value 0 is assumed). As soon as another node is recognized that answers with two valid SYNCFrame_startupPCW transmissions in even/odd cycle order, the node in *ColdStartPCW* is acknowledged by at least one other sync node and *vSyncPairs* is set to true. With the beginning of each rate measurement phase in *ColdStartPCW* state, the variable *vSyncPairs* is reset to false.

In addition to the prerequisite that necessary sets of measurement samples are available (*vSyncPairs* is true), the quality of the resulting correction terms for clock synchronization is assessed. The node is only permitted to execute transition into *NormalStatic* state, if the correction terms for both, rate and offset are below the configured limit settings ($|vOffsetCorrection| \leq pOffsetCorrectionOut$ and $|vMicroOverheadPerCycle| \leq pRateCorrectionOut$). If one of the correction terms violates the limit settings, the node has to re-enter *ListenStatic* state.

**InitRate State**

All nodes in *ListenStatic* state enter *InitRate* after receiving a valid SYNCFrame_StartupEven, if the prerequisites for a state transition into *ColdStartICW* state have not already been met. *vRefSync* contains the identifier of the sync frame that was used to enter the integration path. The sync node corresponding to this reference frame is called the reference node. *InitRate* is used to derive an initial rate correction value in order to adjust the local macrotick timing to the timing given by the reference node. To accomplish this, the time between the initial occurrence of the reference frame and its next occurrence is measured and the difference from the nominal cycle length is applied as the rate correction term. The initial reception of the reference frame (which causes the state transition into *InitRate*) starts a timer. This timer covers *gdCycle* running in local macroticks and according to this timer a receive window is opened. *pdInitRateMEarly* microticks before the timer expires, the early receive window is opened and with the expiration of the timer, *pdInitRateMLate* is applied to form the late receive window.

For two nodes running with exactly the same clock rate (with same macrotick period) the next reference frame would occur after *gdCycle*.

If next valid reference frame (valid SYNCFrame$_{StartupOdd}$ with *fFrameID == vRefSync*) matches with one of these two windows, the corresponding rate correction value can be directly derived.

As soon as the rate correction term is available, the node runs with the corrected rate (direct application of the correction term).

### *InitSchedule* State

The reference frame used for initial rate correction (which causes the state transition into *InitSchedule* state) is also used to determine the nominal schedule position, using the received identifier *fFrameID*. The node sets its local cycle time accordingly, i.e. it synchronizes the micro- and macrotick counters to the SOF in the received sync frame. In addition, the cycle counter value *fCycleCount* of the received sync frame is extracted and used to initialize the local cycle.

At this point the local schedule has been established according to the information derived from the reference node.

The node follows the local schedule until the end of the current cycle without transmitting actively. Any further reception is ignored and neither rate nor offset measurements are performed. At the end of the cycle, the transition is made from *InitSchedule* to *IntegrationPCW*.

### *IntegrationPCW* State

As long as the node stays in *IntegrationPCW* state, the node is not allowed to schedule transmissions.

In *IntegrationPCW* the node tries to confirm the settings copied from the reference node with the overall network communication scheme. For this purpose the node performs a cycle-based plausibility check similar to the check defined for the *ColdStartPCW* state (see Section "ColdStartPCW State").

The observation phase *gdPlausibilityCheckWindow* and the conditions for incrementing the counters (*vValidSyncCount* and *vInvalidSyncCount*) are the same. Since the node still behaves passively, the initialization of these counters differs from that for a node in *ColdStartPCW* (which transmits an own sync frame and thus, participates actively to the plausibility check). The values used are:

> *vValidSyncCount* =0;
> *vInvalidSyncCount* =0;

The plausibility check is passed if *vValidSyncCount* is greater than *vInvalidSyncCount*. Transition into *NormalStatic* can only take place if the check has been passed, but there are additional checks to pass (see clock correction term assessment and next paragraphs, respectively) before a node is allowed to join communication with the transition into the *NormalStatic* state. The plausibility check always runs concurrently with these additional checks until the plausibility check itself fails or a state transition due to another condition is executed.

When the node enters *IntegrationPCW*, a regular measurement phase for the next rate correction term is started. The definition of state transitions for the protocol state machine automatically keeps the required 'grid' (starting with a cycle with an even cycle counter value). According to the definition of the regular rate measurement phase, all sync frames are registered and pair-wise (sync frames with same frame identifier) evaluated for clock synchronization. The offset measurement phase is applied in accordance to the regular scheme, too. This means that for each cycle with an odd cycle counter value the related sync frames are used to determine next offset correction term.

An integrating sync node requires at least one matching pair of sync frames suitable for rate measurement (same frame identifier, consecutive occurrence in 'even/odd' order) in order to fulfill one of the necessary prerequisites to enter *NormalStatic* state. Using this pair of sync frames, the node can acknowledge an existing node in *ColdStartPCW* or simply integrate to a synchronized cluster. For sync nodes that do not operate in listen-only mode (*vListenOnly* is false), *vSyncPairs* is set to true as soon as the first matching pair of sync frames is received. If a sync node is configured as a listen-only node (*vListenOnly* is true), it has to fulfill the same condition as non-sync nodes. These nodes need to receive at least two matching pairs of sync frames suitable for rate measurement (same frame identifier, consecutive occurrence).

Only if there is already a communication established including at least two sync nodes (nodes in *NormalStatic* state) can the non-sync nodes (or sync nodes in listen-only mode) join in.

For these nodes *vSyncPairs* is set to true as soon as two matching sync frames are part of current rate measurement period.

With the beginning of each rate measurement phase in *IntegrationPCW* state, the variable *vSyncPairs* is reset to false.

In addition to the prerequisite that necessary sets of measurement samples are available (*vSyncPairs* is true), the quality of the resulting correction terms for clock synchronization must be acceptable. The node is only allowed to join active communication (transition into *NormalStatic* state), if the correction terms for both, rate and offset are below the configured limit settings (|*vOffsetCorrection*| $\leq$ *pOffsetCorrectionOut* and |*vMicroOverheadPerCycle*| $\leq$ *pRateCorrectionOut*). If one of the correction terms violates the limit settings, the node has to re-enter *ListenStatic*. The only exception to this rule is for the first time an offset correction value is available in *IntegrationPCW* state. In this special case the correction value *vOffsetCorrection* may exceed the configured limit *vOffsetCorrectionOut* as long as |*vOffsetCorrection*| $\leq$ 2* *pOffsetCorrectionOut*. If this relaxed requirement can be met, the node remains in *IntegrationPCW* state, but does not transit into *NormalStatic* state. After the first application of an offset correction term in *IntegrationPCW* state, the variable *vOffsetOut* is set to true (*vOffsetOut* is initialized with its default value (*vOffsetOut* is set to false), when *IntegrationPCW* is entered from *InitSchedule*). This variable is always evaluated, if a new offset correction term should be checked against the configured limit settings. Thus, the described exception is only made once, i.e., when the first offset correction term is available.

The combination of all these checks ensures that the node only becomes an active transmitter if the local time base (including the cycle counter and the clock synchronization parameters) is consistent with the global time as represented by the majority of active sync nodes in the system.

### *Normalstatic* State

As soon as the node that transmitted the first CAS symbol (resolving the potential access conflict and entering startup via coldstart path) and one additional node have entered Normal Static state, the startup phase is finished. In *NormalStatic* state, all configured messages will be scheduled for transmission. This includes all data frames as well as the sync frame.

The message interface to the host is served and the error management is performed.

### *PassiveStatic* State

In the *PassiveStatic* state a node does not transmit any of its configured frames. Nevertheless, the node does not stop all activities. It continues clock synchronization, the reception of messages and the full support of the host interface.

In addition, the *PassiveStatic* state is used to support the 'listen only' protocol feature, where nodes are fully synchronized and receive all available frames (including receive buffer update), but do not transmit anything. This mode is indicated by *vListenOnly*, which can be set by the host in the *SoftReset* state only. As soon as the host clears *vListenOnly NormalStatic* state is entered at the beginning of the next cycle.

### Startup States - FlexRay/byteflight Mode with pure dynamic segment

### Startup State Diagram

Figure 55 shows a protocol state diagram - pure dynamic segment.

| State Transition | State Direction | | Condition for Transition |
| --- | --- | --- | --- |
| | from | to | |
| D1i | Listen Dynamic | Normal Slave | reception of a valid SOC at one of pChannels channels<br><br>**AND** vListenOnly is false |
| D2i | | Passive Dynamic | reception of a valid SOC at one of pChannels channels<br><br>**AND** vListenOnly is true[11] |
| D3i | Normal Slave | Listen Dynamic | network idle time reached (vMacrotick== gdCycle- gdNetworkIdleTime; decided on local timers) |
| D4i | SendSOC | Normal Master | transmission of the SOC finished |
| D5i | Normal Master | SendSOC | end of current cycle (derived from local cycle time) |
| D6i | Passive Dynamic | Listen Dynamic | network idle time reached (vMacrotick== gdCycle- gdNetworkIdleTime; decided on local timers) |
| D7i | All States | Soft Reset | soft reset initiated (in the respective control register) |

**Table 15:** State Transitions and Corresponding Conditions for Execution

[11] 'Listen-only' mode is an invalid configuration for a master node!

### SOCSend State

A single node that has been configured as sync master (*pMaster* is set) sends the SOC. With the end of the transmission the timers (of the receiver unit) are started according to the definitions in the media access chapter and the node enters *NormalMaster* state.
When a node enters *SOCSend* state while a frame reception is ongoing the reception process is stopped.

### NormalMaster State

The node sends and receives messages in the *NormslMaster* state according to its configuration. Upon entering the *NormalMaster* state, i.e. after the transmission of the SOC, the startup phase is completed. The master node does not need any acknowledgement from other nodes.

### ListenDynamic State

All slave nodes (*pMaster* is false) wait in the *ListenDynamic* state for a valid SOC transmission. All connected channels are independently monitored. The transition into *NormalSlave* and therefore the synchronization of both channels to the master is done on reception of the first valid SOC. After initialization of the wait timers, both channels can operate asynchronously with respect to the required frame mini-slotting on each of the channels.

*NormalSlave* **State**

Slave nodes synchronies to a valid SOC and transmit and receive messages in *NormalSlave* state according to their configuration.

*PassiveDynamic* **State**

In *PassiveDynamic a* node does not transmit any of its configured frames. Still, the node does not stop all activities, but continues the synchronization to SOC (via *ListenDynamic* state) and the reception of messages.

The *PassiveDynamic* state is used to support the 'listen only' protocol feature, where the node is fully synchronized and receives all available frames (including receive buffer update), but does not transmit anything. This mode is indicated by *vListenOnly*, which can be set by the host in the *SoftReset* state only. As soon as the host clears *vListenOnly*, *NormalSlave* state is entered with beginning of the next cycle.

Since the protocol controller still performs the transition to *ListenDynamic* state with every communication cycle, it is still synchronized to the master node. Therefore, the node is allowed to directly re-enter *NormalSlave* from *ListenDynamic* (with the begin of next cycle), if the host sets *vListenOnly* to false.

**Protocol Startup**

**FlexRay Mode with Static Segment configured**

**Startup Constraints**

- The configuration must ensure that only nodes connected to all configured communication channels (*pChannels* = *gChannels*) are configured as sync nodes. Thus, in the absence of faults, the transmissions of a sync node that initiate the schedule synchronization are visible to every node.

- It has to be ensured that all nodes integrating to a communication schedule perform their clock synchronization synchronously. Specifically, this applies to the process of applying the clock correction terms (offset and rate). Since rate measurement phases take two cycles, it has to be guaranteed that there is no spontaneous time shift in the schedule (due, perhaps to offset correction) while nodes are assessing their rate terms. Otherwise it cannot be prevented that offset correction harms the rate measurement process.

- The maximum single-cycle drift offset between two nodes operating with unsynchronized clocks must be a known system parameter. *gdMaxDrift* must be configured accordingly.

- During startup, no update of message buffers is carried out.

**General Startup Mechanism**

- A correctly configured communication controller enters the startup sequence after leaving the *SoftReset* by the transition to *ListenStatic*.

- Upon leaving *SoftReset,* each node that is correctly configured as a sync node waits for a configurable time (listen-timeout; *gdStartup*) and monitors all connected *pChannels* channels for activity.

- If communication channel activity is detected on one of the configured channels while in *ListenStatic*, the listen-timeout is restarted. Every reception (including valid CAS symbols) different from a valid SYNCFrame$_{StartupEven}$ causes this restart.

- At the same time as the listen-timeout *vdStartup* is started, a second timeout *vdStartupNoise* is started. This additional timeout is used to improve reliability of the startup procedure in the presence of noise. Since the timeout *vdStartupNoise* won't be reset if channel activity is sensed, this timeout defines a fallback solution that guarantees that a node tries to start up the communication cluster even in the presence of noise.

- As soon as either listen-timeout (*vdStartup* or *vdStartupNoise*) expires, a node that is configured to initiate the startup enters the coldstart phase (represented by *ColdStartICW* and *ColdStartPCW* state sequence) and transmits an initial CAS. This is followed by the cyclic transmission of the configured sync frame on all configured communication channels, *pChannels*.

- If two or more nodes simultaneously enter the coldstart phase, their CAS symbols do collide. However, the nodes themselves can resolve this scenario. This is due to the unambiguous assignment between nodes and fixed sync slots in the global communication schedule.

- During the first period of the coldstart phase (*ColdStartICW* state) a sync node reacts very conservatively on network activity. This is due to the fact that during this period the detected transmission may have been initiated either by another node in coldstart phase or by a faulty node. In both cases the node in *ColdStartICW* gives up performing the cluster startup and starts the process of integrating to an existing communication scheme.

- One cycle before the node in coldstart phase expects a response (sync frame reception) to its global schedule initialization attempt, the next phase (*ColdStartPCW*) is entered. In this phase the node expects sync frames to be sent out by other nodes in response to the initiated communication pattern.

- A node in coldstart phase continuously performs the regular clock synchronization, including the rate and offset measurements and the correction phase.

- It is required that the sync frames transmitted in response to the node in coldstart phase are consistent with the coldstart node with respect to

  - timing (rate and offset correction value must not exceed limit settings)

  - schedule position and cycle counter

- The node in *ColdStartPCW* compares the observed communication pattern to its own view. Only if the majority (including one vote for the reference node itself) confirms the reference node does the node proceed with normal operation (i.e, enter *NormalStatic*).

- It is sufficient to receive just one valid SYNCFrame$_{StartupEven}$ (on one channel) in order to leave *ListenStatic* and start the clock initialization phase (represented by *InitRate* and *InitSchedule* states).

- The Clock initialization phase is part of the integration path. The integration path additionally includes the confirmation phase (*IntegrationPCW* state), which is entered after clock initialization phase.

- Both the integration path and the coldstart path lead to the *NormalStatic* state if communication startup is performed successfully. During the integration phase a node transmits neither sync frames nor data frames. In the coldstart phase a node transmits sync frames only. In the *NormalStatic* state all configured frames (sync frames and data frames) are transmitted.

- The sync node that transmits the valid SYNCFrame$_{StartupEven}$ that causes other nodes to enter the clock initialization phase is treated as a reference. During clock initialization phase each integrating node adjusts its 'clock rate' (only the macrotick "clock" is affected by this rate correction) according to the reference node's rate as measured and derived in the *InitRate* state. All other nodes and their transmissions are ignored during the clock initialization phase.

- Each integrating node initializes its own cycle counter with the value received from the reference node and adjusts its schedule (cycle time) to the cycle time implied by the occurrence of the reference frame (*InitSchedule* state).

- If the reference node does not support the integrating node through the whole clock initialization phase (e.g. the valid SYNCFrame$_{StartupOdd}$ for schedule alignment is missing), the integrating node re-enters ListenStatic after a timeout expires.

- Upon completion of the clock initialization phase, the integrating node's communication schedule is synchronized to the observed reference schedule and it's clock synchronization algorithm is already initialized with a rate correction value.

- Upon entering the confirmation phase (*IntegrationPCW* state) the node continuously performs the regular clock synchronization. This includes both rate and offset measurement, and the correction phase aligned to the even/odd cycle grid (see Section TBD).

- During the confirmation phase, the node checks its local settings, which were initially derived from a single reference node, against the globally available information with respect to

  - timing (rate and offset correction value must not exceed preset limits).
    If the reference node with its clock representation is near to the maximum correctable deviation, it might happen (due to the additional propagation delay and certain topology characteristics) that the integrating node recognizes an offset correction value that exceeds the limit settings (*pOffsetCorrectionOut*) after first offset measurement. In this case a value up to twice the limit is accepted and a further offset application phase together with a new measurement period is performed. After this sequence the value
    *vOffsetCorrection* must fulfill the limits
    ($|vOffsetCorrection| \leq$
    *pOffsetCorrectionOut*).

  - schedule position and cycle counter

- Nodes in the *IntegrationPCW* state check the observed communication pattern against their own expected timing pattern, which is based on their own view of time. Only if the majority of sync frames observed confirm their view, does the node proceed with normal operation (enter the *NoimalStatic* state).

- If an integrating node has to return to the *ListenStatic* state (due to a detected fault during the clock initialization phase or the confirmation phase), its rate correction value is reset to its default value. The node does not immediately use the same reference node for the next integration attempt. The node ignores the former reference node until the timeout *vdCycleWithHistory* expires or an attempt to integrate using a different reference node also fails. This timeout covers a whole communication cycle and enables the possibility that another node (if available) could become the new reference. The fallback mechanism is the same for all nodes, regardless of whether they are sync nodes or not.

**FlexRay/byteflight Mode with Pure Dynamic Segment**

- A correctly configured sync master communication controller (*pMaster* is true) enters the startup sequence via the transition from *SoftReset* to *NormalMaster*.

- Only one node should be configured as the sync master node, which must send a SOC symbol on all *gChannels* channels. For the sync master node *pChannels* must be equal to *gChannels*.

- A correctly configured slave node communication controller (*pMaster* is false) enters the startup sequence via the transition from *SoftReset* to *ListenDynamic*.

- All slave nodes synchronize to the SOC transmitted by the sync master node. If that node does not start, the system does not start up.

- Slave nodes start their communication cycle on both channels with the reception of the first valid SOC on one of the *pChannels* channels.

**Startup Examples - Network in FlexRay Mode with Pure Static Configuration**

For all startup sequences described in this chapter the assumption is made that the correction terms for clock synchronization exactly match the limit settings of the quality assessment criterion (see Section TBD). Therefore, the node is allowed to proceed directly into normal operation (*ListenStatic* state) after having performed the offset measurement, correction phase, and regular rate measurement phase the first time.

**Startup without Collisions**

Figure 56 shows a collision-free Startup.

The scenario illustrated in Figure 56 depicts three nodes with two of them configured to initiate the startup actively (sync nodes A and B). Node C does is not configured to schedule any sync frames and therefore is not allowed to enter *ColdStartICW*. The first cycle counter value received by nodes B and C is in the sync frame sent by node A and it is even.

Node A enters *ColdStartICW* and transmits the initial CAS before any other node. Triggered by the reception of the CAS, node B restarts its listen-timeout *vdStartup*. With the first sync frame sent by node A all other nodes enter *InitRate*. At this point Node A becomes the reference node (*vSyncRef*= 3) and the measurement phase for initial rate correction term is started. The next occurrence of node A's sync frame stops the rate measurement phase. Nodes B and C transit to *InitSchedule* where they directly apply the determined rate correction term to their local clock rate (i. e. to their local macrotick generation unit). In addition, the actual schedule position is determined based on the reference frame ID, and the micro- and macrotick timers are synchronized to the SOF of the received sync frame.

Nodes B and C follow the current schedule until cycle end and then transition into the *IntegrationPCW* state. Still these nodes behave passively, i.e., they do not participate the communication schedule with their own frames. After one complete rate measurement period (2 cycles) and the corresponding offset measurement and correction phase (during the second cycle), the sync node B is allowed to enter normal operation. The plausibility checks evaluates in the *IntegrationPCW* state are passed because on the reception of the reference sync frame *vValidSyncCount* is incremented, while *vInvalidSyncCount* remains unchanged. Consequently, with the start of next cycle, node B enters *NormalStatic* and starts to transmit messages according to its configuration. On reception of the sync frame pair sent by another node (node B), which is synchronized to its own, the node that initially sent the CAS (node A) then enters *NormalStatic* at the start of next communication cycle (after a whole rate measurement period has been concluded). In *NormalStatic* all configured frames are scheduled for transmission. As soon as the node that initially sent the CAS and one other node have entered the *NormalStatic* state, the startup phase is concluded.

Node C enters *NormalStatic* in the same cycle as node A, as soon as it performs the regular rate measurement phase based on 2 (or more) pairs of corresponding sync frames (*vSyncPairs* is true).

**Startup with Initial Collision**

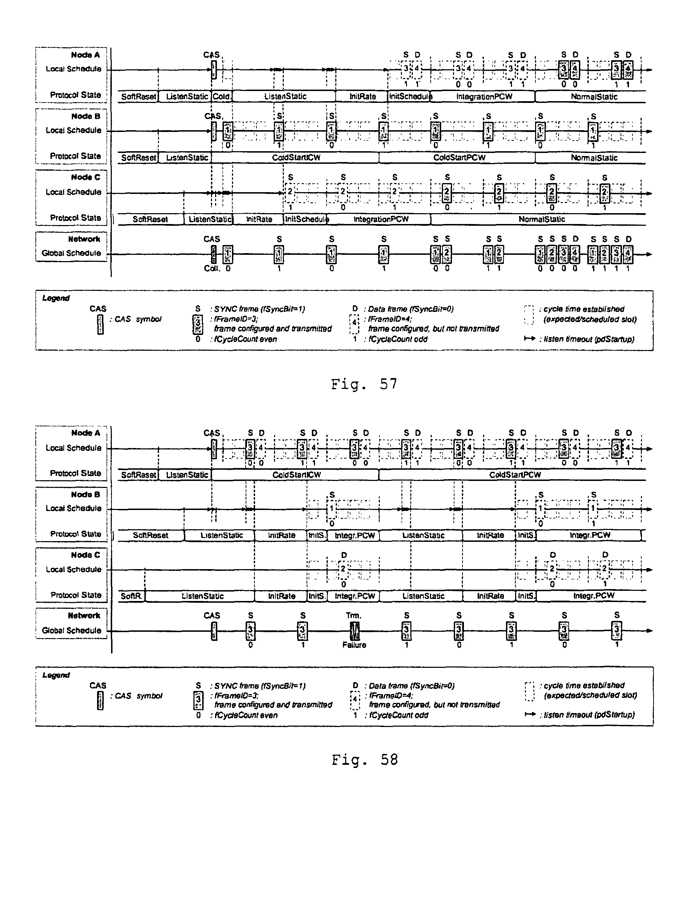

Figure 57 shows a Startup with a collision on the CAS symbol.

The scenario illustrated in Figure 57 depicts three nodes with all of them configured to initiate the startup actively (sync nodes). A collision during startup results when two sync nodes leave *SoftReset* state at the same, or nearly the same time. In this case, two nodes (nodes A and B) enter *ColdStartICW* simultaneously and send their initial CAS at the same, or nearly the same time. Both nodes are then prepared to send their first sync frame. The node with the sync frame having the lower identifier sends its frame first (node B; *fFrameID*= 1). On reception of this sync frame, the other node (node A), which currently resides in the *ColdStartICW* state, returns to *ListenStatic* and waits for the next valid SYNCFrame<sub>StartupEven</sub>. The figure depicts the case where a node A integrates in the sixth cycle after the cycle in which the collision occurred.

Depending on the network topology and channel characteristics, non-sync nodes may detect activity but no valid CAS because of the collision, while others may detect a valid CAS (because the topology prevents collisions). For both cases the reaction is the same, since valid CAS symbols are treated like network activity that cannot be interpreted. The nodes remain in *ListenStatic* and wait for the occurrence of a valid SYNCFrame<sub>StartupEven</sub>.

**Startup with Nodes Failed Due to the Plausibility Check**

Figure 58 shows a Startup with a plausibility check in *IntegrationPCW* failed.

The scenario illustrated in Figure 58 depicts nodes B and C starting integration to the reference node (node A). While nodes B and C are in the *IntegrationPCW* state the reception of the sync frame transmitted by the reference node fails at both nodes. Thus, the plausibility check at both nodes fails, too. At the end of this cycle both nodes have to re-enter the *ListenStatic* state. Since *vRefSync* is different from 0 (*vRefSync*=3)*,* the first sync frame from the former reference node (node A) is ignored. Because no other sync frame occurs during *gdCycleWithHistory, vRefSync* is cleared at the end of this cycle. With the next occurrence of the sync frame sent by node A (*vRefSync* is set to 3 again), node B and C start another integration attempt. Via the integration path, both nodes finally synchronize on timing of node A. Meanwhile, Node A remains in *ColdStartPCW* state for the entire period because it does not detect a valid response.

**Sync Master Failure and Reintegration**

**FlexRay Mode with Static Segment Configured**

- Cluster synchronization is maintained by the global clock synchronization mechanism that is executed locally by each node based on its received sync frames. This mechanism is robust in the sense that, with limits, cluster synchronism is maintained even when faults reduce the number of sync frames upon which the mechanism relies. However, the protocol does not support any autonomous handling or countermeasures to be used to dynamically correct a loss of synchronization. This situation requires host intervention and the affected node has to be reintegrated via the *SoftReset* state with all the subsequent steps that commence upon transitioning to the *ListenStatic* state.

- Nodes that reintegrate after having withdrawn from communication from a running communication cluster behave the same as nodes that integrate the first time. All nodes that do not start the network by themselves (via *ColdStartICW*) have to take the integration path (*InitRate, InitSchedule*, and *IntegrationPCW* states).

**Pure Dynamic Network**

- The sync master node cannot detect that its SOC transmission has failed. Thus, it continues normal operation until it is forced into the *SoftReset* state by the host.

- All slave nodes either starting up initially or reintegrating, enter *ListenDynamic* and wait until next SOC reception, which triggers their transition into the *NormalSlave* state.

**Supplements**

Chapter 14 'System Constants, Parameters and Variables'

| Name | Description | Range/Value | Unit |
|---|---|---|---|
| | | | |
| *gdMaxDrift* | maximum drift offset between two node that operate with unsynchronized clocks over one communication cycle | | MT |
| *gdStartup* | upper limit for the listen-timeout in *ListenStatic* state (before a sync node is allowed to become a coldstart node); this is not a configuration parameter! | *gdStartup = gdCycle+gdMaxDrift* | MT |
| *gdInitialCheckWindow* | period for which a node remain in *ColdStartICW* state, if no incident causes the transition into *ListenStatic* beforehand; this is not a configuration parameter | *3\* gdCycle + gdSlot* | MT |
| *gdPlausibilityCheckWindow* | plausibility check interval applied in *ColdStartPCW* and *IntegrationPCW* state | **Version 5 Solution:** *gdCycle - gdNetworkIdleTime* | MT |
| | | | |
| *pdStartupNoise* | upper limit for the listen-timeout with noise in S state given as a multiple of *gdStartup* | | — |
| *pdCycleWithHistory* | upper limit for timeout that covers a period, which is large enough that any periodic transmission that complies to the global communication schedule is visible for an unsynchronized node at least once; | *gdStartup* | MT |

| Name | Description | Range/Value | Unit |
|---|---|---|---|
|  |  |  |  |
|  | this is not a configuration parameter |  |  |
| *pMaster* | denotes that the node is configured as the sync master in FlexRay/byteflight mode with pure dynamic segment | **Boolean** | — |
| *pdInitRateMEarly* | early reception window for initial rate measurement | *pRateCorrectionOut* | mT |
| *pdInitRateMLate* | late reception window for initial rate measurement | *pRateCorrectionOut* | mT |
| *pSyncNode* | denotes that the node is a sync node (sync slot configured; connected to *qChannels*) | Boolean | — |
|  |  |  |  |
| *vListenOnly* | denotes that the node is not allowed to transmit | Boolean | — |
| *vColdStartInhibit* | denotes that the node is not allowed to enter coldstart path | **Boolean** | — |
| *vdStartup* | listen-timeout (counter) in *ListenStatic* state | [0..*gdStartup*] | MT |
| *vdStartupNoise* | listen-timeout (counter) with noise in *ListenStatic* state | [0.. *pdStartupNoise* * *gdStartup*] | MT |
| *vNoise* | denotes that coldstart path has been entered due to the expiration of *pdStartupNoise* | Boolean | — |
| *vColdStartCount* | counter for number of cycles/transitions for which the node has been in the coldstart path | [0..*gColdStartMax*] | — |

| Name | Description | Range/Value | Unit |
|---|---|---|---|
| *vdInitialCheckWindow* | timer for the period for which a node remain in *ColdStartICW* state, if no incident causes the transition into *ListenStatic* beforehand | [0..*gdInitialCheckWindow*] | MT |
| *vdInitRateMEarly* | timer for early reception window for initial rate measurement | [0.. *pdInitRateMEarly*] | mT |
| *vdInitRateMLate* | timer for late reception window for initial rate measurement | [0.. *pdInitRateMLate*] | mT |
| *vInvalidSyncCount* | counter for invalid SYNCFrame$_{startupPCW}$ decisions during gdPlausibilityCheckWindow | [0..31] | — |
| *vValidSyncCount* | counter for valid SYNCFrame$_{startupPCW}$ decisions per slot during gdPlausibilityCheckWindow | [0.. *cSyncNodeMax*] | — |
| *vOffsetOut* | denotes that the application of the extended limit setting for the offset correction term check is prohibited | Boolean | — |
| *vdCycleWithHistory* | timeout counter that covers a period, which is large enough that any periodic transmission that complies to the global communication schedule is visible for an unsynchronized node at least once | [0.. *pdCycleWithHistory*] | MT |
| *vRefSync* | contains the | [0.. 1023] | — |

| Name | Description | Range/Value | Unit |
|---|---|---|---|
| | | | |
| | identifier of the sync frame, which has been originally used to enter the integration path | | |
| vSyncPairs | denotes that enough corresponding sync pairs were available for a rate measurement with at least two reference points; prerequisite for transition into NormalStatic state | Boolean | — |

## Chapter 11

## Error Handling and Diagnosis

**Version 5 Solution:** The entire Error Handling and Diagnosis section is specific to FPGA V5. Subsequent versions of the protocol will likely use a different error management scheme.

## Error Management

## Overall Error Processing

This chapter describes the error handling mechanisms of FlexRay protocol that are intended to ensure the proper operation of the protocol under error conditions. The overall philosophy behind the error management strategy is "never-give-up" until a predefined criticality of error states is reached. The error detection and management mechanisms attempt to avoid faulty behavior of the protocol in the presence of errors. The FlexRay protocol specification and the design of the FlexRay hardware (communication controller, bus guardian, bus driver, etc.) are assumed to be fault-free.

Four error severity levels are defined, ranging from S0 through S3. The definition of the severity level is based on the severity of the failure that the error could cause in the system. The error severity levels are summarized in Table 16.

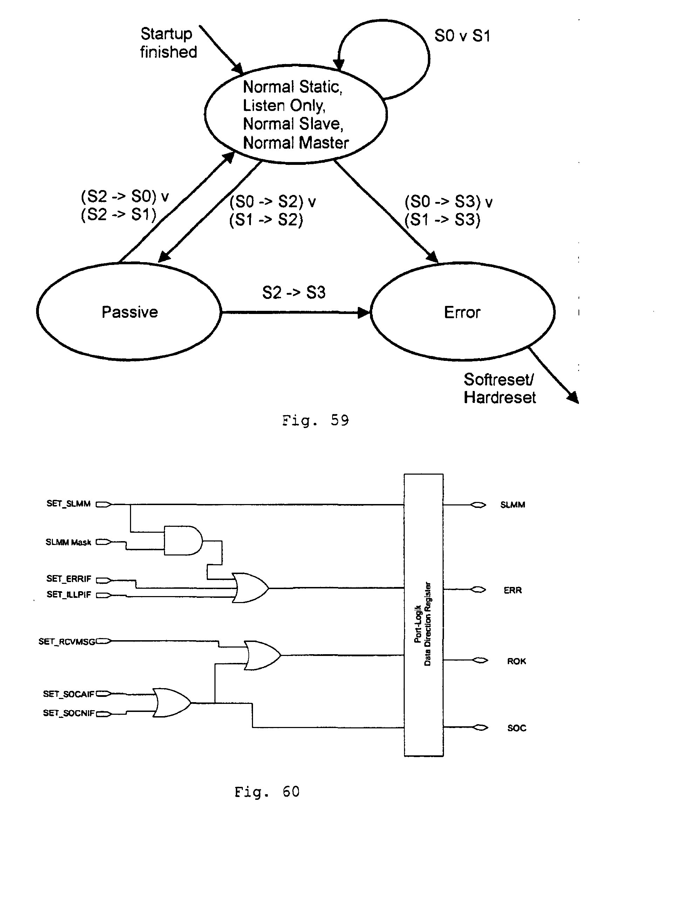

The error severity level directly influences the protocol behavior as described in the table (CC, CC to API, Result, BG, Comment). The FlexRay error handling matches the overall protocol state machine (see Figure 59). The currently active severity level shall be taken into account at each protocol decision.

Table 16:

| Error Severity Levels | | |
|---|---|---|
| **Name** | **Severity Level** | **Behavior** |
| Normal | S0 | CC: full operation. CC to API: no warning, no error flags active. Result: Normal operation. BG: remains synchronized |
| Warning | S1 | CC: full operation. CC to API: flag for detected error. Result: Maintain normal operation, provide error indication to host. BG: Remains synchronized. Comment: No immediate effect on protocol operation. The host is informed of the error condition |

Table 16:   (continued)

| Error Severity Levels | | |
|---|---|---|
| **Name** | **Severity Level** | **Behavior** |
| Error | S2 | CC: reduced operation. CC to API: flag for detected error. Result: The node stops transmitting frames, but received frames are still processed. Clock synchronization mechanism continues based on received frames. BG: Remains synchronized. Comment: CC self rescue is allowed. The fault causing the error was non-fatal. The CC will not act as a coldstart node for the wake-up procedure. |
| Fatal Error | S3 | CC: Operation halted. All signals to the bus driver and bus guardian are placed in defined states. CC to API: flag for detected error. Interaction with host must still be possible. Result: The node stops transmitting and receiving frames. BG: BG enters FailSilent state due to loss of ARM signal. The BG disables transmissions until reset by host. Comment: CC self rescue not allowed. The fault causing the error was fatal. A reset from the host is required to resume operation. |

Figure 59 shows the protocol (error) state machine. After startup a FlexRay CC starts operation in

- Normal Static state, if the node is configured for pure static or mixed static/dynamic operation and at least one other CC is active and in the Normal Static protocol state.

- Listen Only state, if the node is configured to listen only during full operation and does not actively send any frames (see *PassiveStatic* state, Section TBD).

- Normal Master state, if the node is configured for pure dynamic or byteflight compatible operation, the node is currently acting as SOC master (sending SOC symbols), and is actively sending frames.

- Normal Slave mode, if the node is configured for pure dynamic or byteflight operation, the node is not acting as SOC master (is not sending SOC symbols), but is actively sending frames.

The protocol (error) state machine shall remain in the Normal Static, Listen Only, Normal Master or Normal Slave state as long as no errors are detected (remain in error severity S0) or if any detected errors have error severity S1 (see Table 16).
The detection of any error with an error severity of S2 shall cause the protocol state machine to enter the Passive state where the CC is not allowed to send frames but where all protocol mechanisms (frame reception, clock synchronization, etc.) remain active.
The detection of any error with an error severity of S3 shall cause the protocol state machine to enter the Error state, where no frame transmission is allowed and all protocol operation ceases. The CC can only return to normal operation after being reset by the host. (see Table 16).
The protocol (error) state shall be Error while at least one S3 severity error is active, otherwise it shall be Passive while at least one S2 severity error is active, otherwise it shall be in Normal Static (Listen Only, Normal Master, Normal Slave). In other words, the error level of the communication controller shall be the error level of the most severe error that is currently active.

**Error Detection**

The intended "never-give-up" strategy of FlexRay is achieved by several mechanisms for controlling / monitoring the operation. These mechanisms continue to operate even in the presence of faults.
Table 17 lists the error flags and error counters of the FlexRay protocol. The following sections provide detailed description of the various flags and counters.

Table 17:

| Error Flags and Error Counters | |
|---|---|
| **Error Flags** | **Abbreviation** |
| Channel Status and Error Vector | CSEV |
| Frame Status and Error Vector | FSEV |
| **Error Counters** | **Abbreviation** |
| Valid Sync Frame Counter | VSFC |
| Invalid Sync Frame ID Counter | ISIC |
| Invalid Sync Frame Cycle Counter | ISCC |
| Missing Rate Measurement Counter | MRMC |
| Missing Offset Measurement Counter | MOMC |
| Clock Correction Failed Counter | CCFC |

**Error Flags**

**Frame Status and Error Vector (FSEV)**

A FlexRay Communications Controller shall provide two channel-specific Frame Status and Error Vectors (FSEV's) for each communication buffer. CC's that are only capable of single channel communication need only provide an FSEV the channel that it supports. A dual channel controller needs to provide two buffers to allow a host using a "select first" style buffer to understand the communication on the "non-selected" communication channel. If the buffer is operating in a channel-specific mode the information on the other channel is redundant. The FSEV allows the host to determine the status of communications associated with the buffer. Each vector consists of six bits that provide indications of various error or normal conditions that can occur during the reception of a frame. Table 18 lists the contents of the vectors.

Table 18:

| Frame Status and Error Vector | | | |
|---|---|---|---|
| **Name** | **Check Sets[12]** | **Static Segment** | **Dynamic Segment** |
| Bit Coding Error/CRC Error | CodingOrCRCError | Applies | Applies |
| Slot Mismatch | SlotMismatchError | Applies | Applies |
| Cycle Counter Mismatch | CycleMismatchError | Applies | - |
| Missing Frame | MissingFrameError[13] | Applies | - |
| Null Frame | NullFrameDetected | Applies | - |
| Length Mismatch (length code different from real length, real length different from expected length) | LengthMismatchError | Applies | Applies |

[12] Refer to Table 19 for definitions of the check set conditions.

[13] Not yet defined in Frame Check Section

Table 19 gives the sets of checks that make up the various error conditions that are reported in the FSEV and CSEV.

| | vCheckFrameCoding_x | vCheckCRC_x | vCheckHeaderCRC_x | vCheckFrameID_x | vCheckFrameIDStaticRange | vCheckStaticPayloadLength | vCheckReceivedPayloadLeng | vCheckNullFrame_x | vCheckCycleCount_x |
|---|---|---|---|---|---|---|---|---|---|
| CodingOrCRCError | F | X | X | X | X | X | X | X | X |
| | T | F | X | X | X | X | X | X | X |
| | T | X | F | X | X | X | X | X | X |
| SlotMismatchError | T | T | T | F | X | X | X | X | X |
| CycleMismatchError | T | T | T | X | X | X | X | X | F |
| MissingFrameError | X | X | X | X | X | X | X | X | X |

| NullFrameDetected | T | T | T | X | X | X | X | F | X |
|---|---|---|---|---|---|---|---|---|---|
| LengthMismatchError | T | T | T | X | X | X | F | X | X |
| | T | T | T | X | T | F | X | X | X |

**Table 19:** FSEV/CSEV Error Check Conditions

Each static FlexRay frame buffer has corresponding FSEV's. The FSEV is reset (all flags set to 0) during configuration ("Soft Reset" state) and is not updated before the CC is synchronized within other devices in the network ("Normal" protocol state).
The FSEV is updated at the time a frame has been completely received. In case no frame is received, the FSEV is updated upon reaching the end of the slot.
The Null Frame Detection condition has an error severity of S0. All of the other conditions reported in the FSEV have an error severity level of S1.
Error Handling and diagnosis during startup is described in Section "Startup Status Vector (SSV), Startup Status Interrupt Enable Vector (SSIEV)".

**Channel Status and Error Vector**

A FlexRay Communication Controller shall provide a channel-specific Channel Status and Error Vector (CSEV) for each supported communication channel. The CSEV reports the status of all frames received on the communication channel, even if the frames do not have an explicit receive buffer. This implies that a host can get information about errors that may have occurred on the channel in slots that have no associated Frame Status and Error Vector. Table 20 lists the contents of the CSEV.

Table 20:

| Channel Status and Error Vector | | | |
|---|---|---|---|
| **Name** | **Check Sets[14]** | **Static Segment** | **Dynamic Segment** |
| Null Frame | NullFrameDetected | Applies | - |
| Empty Slot | MissingFrameError | Applies | - |
| Bit Coding / CRC Error | CodingOrCRCError | Applies | |
| Length Mismatch | LengthMismatchError | Applies | Applies |
| Slot Mismatch | SlotMismatchError | Applies | Applies |
| Cycle Counter Mismatch | CycleMismatchError | Applies | |

[14] Refer to Table 19 for definitions of the check set conditions.

The data in the CSEV is available to the host via the Communication Host Interface (CHI). The flags in the CSEV may be reset by the host. The CSEV reports the aggregate status of all frames on the communication channel. More specifically, the bit corresponding to a particular condition will be set if any frame has experienced that condition since the CSEV has been reset by the host. Errors that occur more than once will not receive any special indication. The reception of a frame with no errors shall not clear the flags in the CSEV.

The Null Frame condition has an error severity of S0. All of the other conditions reported in the CSEV have an error severity level of S1.

## Error Counters

The following sections define the various error counters used for FlexRay error diagnosis and management. In all cases the counters are not allowed to be incremented past their maximum value, i.e,. the counters shall not "wrap around" back to zero, but rather shall remain at their maximum value.

### Valid Sync Frame Counter (VSFC)

The Valid Sync Frame Counter counts the number of correctly received sync frames in one communication cycle For the purposes of this counter, a sync frame that is received on both channels only counts as a single valid sync frame. The counter shall start at zero at the beginning of the communication cycle. The VSFC from the previous communication cycle shall be available to the host until the end of the current cycle, at which time it shall be replaced by the VSFC of the current cycle.

**Error Handling Level:** An error of severity S1 shall be detected if the Valid Sync Frame Counter exceeds 16 at the end of the communication cycle. An error of severity S1 state shall also be detected if the Valid Sync Frame Counter is zero at the end of the communication cycle.

### Invalid Sync Frame ID Counter (ISIC)

The Invalid Sync Frame ID Counter counts the number of sync frames which are received with a slot mismatch error. The counter shall start at zero at the beginning of the communication cycle. The ISIC from the previous communication cycle shall be available to the host until the end of the current cycle, at which time it shall be replaced by the ISIC of the current cycle.

**Error Handling Level:** An error of severity S2 shall be detected if the Invalid Sync Frame ID Counter is greater than the Valid Sync Frame ID Counter at the end of the communication cycle. This condition indicates that the local CC disagrees with the majority of sync frame senders with respect to the current Slot ID.

### Invalid Sync Frame Cycle Counter (ISCC)

The Invalid Sync Frame Cycle Counter counts the number of sync frames which are received with a cycle counter mismatch. The counter shall start at zero at the beginning of the communication cycle. The ISCC from the previous communication cycle shall be available to the host until the end of the current cycle, at which time it shall be replaced by the ISCC of the current cycle.

**Error Handling Level:** An error of severity S2 shall be detected if the Invalid Sync Frame Cycle Counter is greater than the Valid Sync Frame Counter at the end of the communication cycle. This condition indicates that the local CC disagrees with the majority of sync frame senders with respect to the current cycle count.

**Missing Rate Measurement Counter (MRMC)**

The Missing Rate Measurement Counter counts the number of consecutive even/odd cycle pairs for which it was not possible to compute a clock rate correction term. This counter shall be set to zero when the node begins normal operation. It shall be incremented by one if no rate correction term can be computed at the end of an odd communication cycle. This would occur if the node has not received any matching pairs of even/odd cycle sync frames with the same Frame ID. If a rate correction term can be computed the CC shall reset this counter to zero at the end of the odd communication cycle.

**Error Handling Level:** An error of severity S1 shall be detected if the MRMC is greater than zero but less than the parameter *gMaxWithoutRate*. An error of severity S2 shall be detected if the MRMC is greater than or equal to *gMaxWithoutRate*.

**Missing Offset Measurement Counter (MOMC)**

The Missing Offset Measurement Counter counts the number of consecutive even/odd cycle pairs for which it was not possible to compute a clock offset correction term. This counter shall be set to zero when the node begins normal operation. It shall be incremented by one if no offset correction term can be computed at the end of an odd communication cycle. This would occur if the node has not received any sync frames during an odd communication cycle. If an offset correction term can be computed the CC shall reset this counter to zero at the end of the odd communication cycle.

**Error Handling Level:** An error of severity S1 shall be detected if the MOMC is greater than zero but less than the parameter *gMaxWithoutoffset*. An error of severity S2 shall be detected if the MOMC is greater than or equal to *gMaxWithoutOffset*.

**Clock Correction Failed Counter (CCFC)**

The Clock Correction Failed Counter is used to limit the number of cycles that a node that is currently experiencing a clock offset or rate correction failure can remain at an error severity level of S2 (which allows self recovery) before being forced to an error severity level of S3 (where recovery is only possible via host intervention). This counter shall be set to zero when a node begins normal operation. It shall be incremented by one at the end of any odd communication cycle where either the Offset Correction Failed or Rate Correction Failed errors are active (see Sections "Offset Correction Failed" and "Rate Correction Failed" below). It is assumed that the inability to compute a rate or offset correction term does not affect that term's Correction Failed status. The CCFC shall be reset to zero at the end of an odd communication cycle if neither the Offset Correction Failed nor the Rate Correction Failed errors are active.

**Error Handling Level:** An error of severity S3 shall be detected if the CCFC is greater than or equal to the parameter *gMaxWithoutClockCorrection*.

**Offset Correction Failed**

At the end of an odd communication cycle if the clock synchronization mechanism calculates an offset correction term which is outside of the green region (refer to the Clock Synchronization chapter) the host shall be considered to have detected an Offset Correction Failed error. The Offset Correction Error shall remain active until the node computes an offset correction term that is in the green area, at which time the node shall consider the Offset Correction Failed error inactive. Note that this implies that the inability to compute an offset correction term does not change the Offset Correction Failed status. The status can only change if an offset correction term is actually computed.

**Error Handling Level:** The detection of an active Offset Correction Failed error shall have an error severity level of S2. The detection of this error also starts incrementing the Clock Correction Failed counter; see Section "Clock Correction Failed (CCFC)" for details.

**Rate Correction Failed**

At the end of an odd communication cycle if the clock synchronization mechanism calculates a rate correction term which is outside of the green region (refer to the Clock Synchronization chapter) the host shall be considered to have detected a Rate Correction Failed error. The Rate Correction Error shall remain active until the node computes a rate correction term that is in the green area, at which time the node shall consider the Rate Correction Failed error inactive. Note that this implies that the inability to compute a rate correction term does not change the Rate Correction Failed status. The status can only change if a rate correction term is actually computed.

**Error Handling Level:** The detection of an active Rate Correction Failed error shall have an error severity level of S2. The detection of this error also starts incrementing the Clock Correction Failed counter; see Section "Clock Correction Failed (CCFC)" for details.

### SOC Early (pure dynamic and byteflight modes)

This error is active if the end of a correct SOC occurs before *gdCycleMin*. This condition is reset after a cycle of duration greater than *gdCycleMin* is observed.

**Error Handling Level:** The error has a severity level of S1.

### SOC Lost (pure dynamic and byteflight modes)

This error is active if the end of a valid SOC does not occur before *gdCycleMax*. This error condition is reset with the reception of the next valid SOC.

**Error Handling Level:** This error has a severity level of S2.

### Illegal Pulse Error (ILLPIF) for pure dynamic and byteflight modes

This error flag is set if

- *gdCycleMin* has not expired since the last correct (valid) SOC symbol and a sequence of logic "0" with a duration of between $21 * gdBit$ and $29 * gdBit$ or a duration of more than $31 * gdBit$ has been received, OR

- *gdCycleMin* has expired since the last correct (valid) SOC symbol and some bus activity was recognized other than a valid SOC symbol.

**Error Handling Level:** This error has a severity level of S2. Reset to S0 as soon as the next SOC is received.

### Diagnosis - Interface to Host

### Interrupt Status Vector (ISV), Interrupt Enable Vector (ISEV)

The FlexRay Communication Controller provides error status information to the host via an Interrupt Status Vector (ISV). Each of the error detection mechanisms described above has an associated bit in the ISV. All of the individual flags of the Channel Status and Error Vector are mapped into the ISV, as well as all individual warning/error conditions described above. There is one additional bit in the ISV to signal a receive buffer error. The bits of the ISV are set to one if the condition described above becomes true.

The FlexRay CC provides at least one interrupt line to the application. Each of the interrupt sources in the Interrupt Status Vector (ISV) shall be enabled separately by an Interrupt Status Enable Vector (ISEV) which is set by the host. The ISV will be updated regardless of the contents of the ISEV. The ISEV simply enables the access of the interrupt source to the interrupt line.

An additional Interrupt Enable Vector is used to set interrupt conditions for any of the Frame Status Error Vectors, which exist for each "mailbox/buffer" of a FlexRay CC. This Frame Status Interrupt Enable Vector (FSIEV) enables the interrupt signaling to the host according to the set bits within this enable register, e.g. only CRC errors of any mailbox/buffer cause an interrupt.

The following table summarizes the relations among the error flags of the CSEV, the single error flags to evaluate the error counters, the signal bit for the FSEV as well as the byteflight specific error flags.

| ISV_0 | | | | | | | |
|-----|------|-------|--------|------|-----------|----------|--------|
| 7 | 6 | 5 | 4 | 3 | 2 | 1 | 0 |
| CRC | SLOT | COUNT | LENGTH | FSEV | SOC Early | SOC Lost | ILLPIF |

- CRC: signals a detected Bit Coding/CRC error within the CSEV

- SLOT: signals a detected Slot Mismatch within the CSEV

- COUNT: Signals a detected Cycle Counter Mismatch within the CSEV

- LENGTH: signals a detected Length Mismatch Error within the CSEV

- FSEV: indicates that in at least one FSEV the frame status error vector was modified

- SOC Early: signals the byteflight / pure dynamic SOC Early error. See Section "SOC Early (pure dynamic and byteflight modes)".

- SOC Lost: signals the byteflight / pure dynamic SOC Lost error. See Section "SOC Lost (pure dynamic and byteflight modes)".

- ILLPIF: signals the byteflight specific Illegal Pulse Error (ILLPIF). See Section "Illegal Pulse Error (ILLPIF) for pure dynamic and byteflight modes".

| ISV_1 | | | | | | | |
|---|---|---|---|---|---|---|---|
| 15 | 14 | 13 | 12 | 11 | 10 | 9 | 8 |
| | MRMC | MOMC | Offset Failed | Rate Failed | Max CCFC | Max SYNC | Zero SYNC |

- MRMC: signals that no rate correction term could be computed because no pairs of (even/odd) sync frames were received. See Section "Missing Rate Measurement Counter (MRMC)".

- MOMC: signals that no offset correction term could be computed because no sync frame was received in an odd cycle. See Section "Missing Offset Measurement Counter (MOMC)".

- Offset Failed: signals that the calculated offset correction term was not within the green area of the clock correction algorithm. See Section "Offset Correction Failed".

- Rate Failed: signals that the calculated rate correction term was not within the green area of the clock correction. See Section "Rate Correction Failed".

- Max CCFC: The Clock Correction Failed Counter reached the defined maximum of *gMaxWithoutClockCorrection* odd communication cycles with one or both of the clock correction terms outside of the green area. See Section "Clock Correction Failed Counter (CCFC)".

- MaxSYNC: signals that more than the maximum of 16 valid sync frames were received in the last communication cycle (VSFC > 16). See Section "Valid Sync Frame Counter (VSFC)".

- ZeroSYNC: signals that no valid sync frames were received in the last communication cycle (Valid_Syncframe ID Count = 0). See Section "Valid Sync Frame Counter (VSFC)".

| ISV_2 | | | | | | | |
|---|---|---|---|---|---|---|---|
| 23 | 22 | 21 | 20 | 19 | 18 | 17 | 16 |
| | | | | | | Minority VSCC | Minority VSIC |

- Minority VSCC: signals that the local CC is within the minority of CCs with respect to the view of the current Cycle_Counter of the network. See Section "Invalid Sync Frame Cycle Counter (ISCC)".

- Minority VSIC: signals that the local CC is within the minority of CCs with respect to the view of the current Slot_ID of the network. See Section "Invalid Sync Frame ID Counter (ISIC)".

The following table shows the Interrupt Status Enable Vector (ISEV) for the corresponding signals in ISV_0 to ISV_2:

| ISEV_0 | | | | | | | |
|---|---|---|---|---|---|---|---|
| 7 | 6 | 5 | 4 | 3 | 2 | 1 | 0 |
| ENABLE CRC | ENABLE SLOT | ENABLE COUNT | ENABLE LENGTH | ENABLE FSEV | ENABLE SOC Early | ENABLE SOC Lost | ENABLE ILLPIF |

| ISEV_1 | | | | | | | |
|---|---|---|---|---|---|---|---|
| 15 | 14 | 13 | 12 | 11 | 10 | 9 | 8 |
| | ENABLE MRMC | ENABLE MOMC | ENABLE Offset Failed | ENABLE Rate Failed | ENABLE Max CCFC | ENABLE Max SYNC | ENABLE Zero SYNC |

| ISEV_2 | | | | | | | |
|---|---|---|---|---|---|---|---|
| 23 | 22 | 21 | 20 | 19 | 18 | 17 | 16 |
| | | | | | | ENABLE Minority VSCC | ENABLE Minority VSIC |

A logical ONE enables the error condition to be a source to trigger the interrupt line to the host. A logical ZERO disables the signaling of that error condition to the host. The ISV will always represent the current status regardless of the value in the ISEV.

The following table shows the Frame Status Interrupt Enable Vector (FSIEV) for the corresponding signals in each mailbox's/buffer's Frame Status Vector: This means that, e.g., any CRC error of any mailbox/buffer will cause an interrupt signal to the host if the corresponding Enable bit in FSIEV is set.

| FSIEV | | | | | | | |
|---|---|---|---|---|---|---|---|
| 7 | 6 | 5 | 4 | 3 | 2 | 1 | 0 |
| | | ENABLE CRC/Coding | ENABLE SLOT MISMATCH | ENABLE CYCLE MISMATCH | ENABLE MISSING | ENABLE NULL FRAME | ENABLE LENGHT MISMATCH |

A logical ONE enables the signal to be a source to trigger the interrupt line to the host. A logical ZERO disables the signaling to the host. The FSEV will always represent the current status of the buffer regardless of the value in the FSIEV.

**Startup Status Vector (SSV), Startup Status Interrupt Enable Vector (SSIEV)**

Each of the interrupt sources in the Startup Status Vector shall be enabled separately by Startup Status Interrupt Enable Vector which is set by the application. The SSV will be updated regardless of the values of the SSIEV. The SSIEV enables the access of the interrupt source to the interrupt line. The following signals (error conditions) out of startup shall be summarized in SSV.

| SSV | | | | | | | |
|---|---|---|---|---|---|---|---|
| 7 | 6 | 5 | 4 | 3 | 2 | 1 | 0 |
| | | | coldst art max | Plaus | prefsync | coldst art path | pstart upnoise |

- Coldstart max: The maximum number of allowed retries of a Cold Starting CC is reached. The CC is no longer allowed to initiate a cold start sequence.

- Plaus: The plausibility check of the local CC within the startup sequence failed.

- Coldstart Path: The normal state of the local CC was reached via the coldstart path. (This indicates that the local CC was the node that started the network.)

- Pstartupnoise: The coldstart path within the local CC has been entered due to the expiration of *pStartupNoise*.

The following table shows the Startup Status Interrupt Enable Vector for the corresponding startup status vector.

| SSVE | | | | | | | |
|---|---|---|---|---|---|---|---|
| 7 | 6 | 5 | 4 | 3 | 2 | 1 | 0 |
| | | | ENABLE coldst art max | ENABLE Plaus | ENABLE prefsync | ENABLE coldst art path | ENABLE pstart upnoise |

**Error counters**

The previously described error counters shall be available to the host:

- Valid Sync Frame Counter (VSFC) - see Section "Valid Sync Frame Counter (VSFC)"

- Invalid Sync Frame ID Counter (ISIC) - see Section "Invalid Sync Frame ID Counter (ISIC)"

- Invalid Sync Frame Cycle Counter (ISCC) - see Section "Invalid Sync Frame Cycle Counter (ISCC)"

- Missing Rate Measurement Counter (MRMC) - see Section "Missing Rate Measurement Counter (MRMC)"

- Missing Offset Measurement Counter (MOMC) - see Section "Missing Offset Measurement Counter (MOMC)"

- Clock Correction Failed Counter (CCFC) - see Section "Clock Correction Failed Counter (CCFC)"

**Error Severity Level**

The current error severity level (S0 through S3) shall be made available to the host.

**Chapter 12**

**Host Interface Requirements**

**Purpose**

This chapter contains the requirements for the FlexRay communication Controller-Host Interface (CHI).

**Interface to higher layers**

The CHI is the interface between the higher layers and the data link layer.
The term CHI suggests that a FlexRay node consists always of two primary hardware elements, which are connected via the CHI:

- FlexRay communication controller

- Host in,the form of a general CPU or DSP

For the following it is assumed that the CHI is above the data link layer. A transport layer or a fault tolerant communication layer (FTCom) would be above the CHI.

**Controller-Host Interface Mechanisms**

The layers above the CHI dictate what mechanisms the CHI must contain. To adequately support the layers above it, the CHI must provide mechanisms that:

- De couple the host from the stringent timing requirements of the FlexRay protocol

- Enable the host to provide the controller with

  - Controller configuration data

  - Frame data to be transmitted

  - Bus Guardian status

  - External clock correction parameters

- Control the controller states, e.g. soft-reset, deactivate (force in passive state, sleep)

- Enable the controller to provide host with

  - Controller status information which is not linked to specific frames or slots, e.g. current protocol state, controller awake or sleeping, if the controller is active SOC master, etc.

  - Received frame data including the frame identifier, sync bit, frame length, header CRC, cycle counter, message identifier, data field, possible acknowledgement bits

**Version 5 Solution:** Acknowledgment bits are not supported in V5

- Frame status information, e.g. if a valid frame or a null frame was received, if an coding error or CRC error was detected in a specific slot

- Information about the current cycle, e.g. if the SOC was normal or alarm symbol (pure dynamic mode), number of correctly received SYNC frames

- Information on global time, namely current cycle counter, macrotick, most recently calculated clock offset and rate correction term

  - Filter or demultiplex received frames based on Cycle counter and / or Message ID, namely store frames with the same ID but different Cycle counter and / or Message ID in different receive buffers

- Provide host with mechanisms to:

  - Trigger interrupts on specific Communication Controller conditions

  - Retrieve diagnostic information

The CHI shall be implemented as a 16 bit aligned address/data bus to support Motorola's PPC and Star12 micro controllers, and Texas Instruments' TMS470 family.

**Version 5 Solution:** Texas Instruments TMS470 compatibility is not expected for FPGA V5.

Designated configuration data should be protected from unintended manipulation by the host, by allowing changes only in a specific Communication Controller mode (e.g. soft reset state).

All interrupt flags should be individually maskable.

A FIFO message area should be provided for receiving frames that do not have a dedicated receive buffer. It should support a maskable rejection filter with the following characteristics:

- It can be applied to the following fields of a received frame:

  - Frame ID

- Message ID

- Cycle Counter

- It can be altered by the host at any time using designated mechanisms.

- It is applied to both channels simultaneously.

All information contained in a valid received frame should be stored in the designated receive buffer (or FIFO) except the frame CRC. The receive buffer should contain a field indicating the channel on which the stored frame was received. If the header of the received frame does not match any of the configured filters, the frame should be discarded without storing any frame data.

If no frame or a corrupted frame is received in a slot, the buffer contents prior to the reception should not be deleted or overwritten. If a null frame is received in a slot, the buffer contents prior to the reception should be overwritten if so configured. The discrepancy to the configured frame should be signaled to the host using a suitable bit in the corresponding buffer status register.

When the host forces the CC into soft reset, the status and error registers should keep their data unchanged until the soft reset is released.

## Controller Host Interface

### Controller Status Registers

This section enumerates the registers supported by the Communication Controller to provide the host with status information regarding the operation of the controller.

### Module Version Register

- 8 bit read only register to hold the FlexRay Protocol Implementation Version (05h for FPGA V5)

### Current Cycle Counter Value

- 6 bit; will be incremented by CC; shall be readable by host.

### Current Macrotick Value

- 16 bit; will be incremented by CC and reset at start of cycle; shall be readable by host.

### Rate Correction Value

- Current (cycle related) rate correction value applied by clock sync: 8 bit; shall be readable by host.

### Offset Correction Value

- Current (cycle related) offset correction value applied by clock sync: 8 bit; shall be readable by host.

**Valid Sync Frames Counter**

- 5-bit counter indicating the number of valid Sync Frames received in the previous cycle. The counter is only updated at the end of the static segment and can be read by the host.

**Invalid Sync Frame ID Counter**

- 5-bit counter indicating the number of invalid Sync Frames received with a slot mismatch error in the previous cycle. The counter is only updated at the end of the static segment and can be read by the host. (FPGA V5)

**Invalid Sync Frame Cycle Counter**

- 5-bit counter indicating the number of invalid Sync Frames received with a cycle counter mismatch error in the previous cycle. The counter is only updated at the end of the static segment and can be read by the host. (FPGA V5)

**Missing Rate Measurement Counter**

- 5-bit counter is incremented by one if no rate correction can be performed because no pairs of (even/odd) Sync Frames were received. The counter is reset by the CC after successful rate correction. The counter is not incremented once it reaches maximum value (63).

**Missing Offset Measurement Counter**

- 5-bit counter is incremented by one if no offset correction can be performed because no Sync Frames were received in an odd cycle. The counter is reset by the CC after successful offset correction. The counter is not incremented once it reaches maximum value (63).

**Error Handling Level**

- 2 bits, indicating the current error handling level.

**Version 5 Solution:** Error Handling Level is a characteristic of the V5 Error Management strategy and may not apply if the V5 only Error Management strategy is not retained in V6.

**Startup Status Vector**

The CC shall provide a Startup Status Vector with following status flags:

- Coldstart max reached (see Section "Cold Start Max")

- Plausibility check failed

- Normal state entered via coldstart path

- Coldstart path has been entered due to the expiration of *pStartupNoise*

**Configuration and Control Registers**

This section enumerates the registers supported by the Communication Controller(CC) to allow the host to control the operation of the CC.

**Module Configuration Register**

8 bit; to hold following control bits:

- Soft Reset

- Master select (only modifiable in soft reset)

- Master Alarm

- Sleep Acknowledge

- Sleep Request

- byteflight Compatibility mode (only modifiable in soft reset)

- External SOC Trigger Acceptance (only modifiable in soft reset)

**FIFO Size**

- Number of FIFO mailbox receive buffers: 5 bits (FPGA V5); may be modified only in soft reset.

**Timing Parameters**

- TCR1, TCR2, TCR3: three 8 bit registers; may be modified only in soft reset. The timing parameters apply to both channels.

**Clock Prescaler**

The clock prescaler register may be modified only in soft reset. It consists of the following three fields:

- Bit Rate Index, 4 bits

- Sample Clock Prescaler, 4 bits

- Samples per bit, 2 bits (8 or 10 samples; 01h = 8, 10h = 10 samples)

**Max. Oscillator Drift**

Maximum allowed drift for the oscillator

- 8 bits, value in macroticks, configurable only in soft reset. (Comment: *gdStartup* is derived internally.)

**Glitch Samples**

- 3 bits; configurable in soft reset with the number of samples to be filtered out by the receiver.

**Bit Duration**

• Microticks per bit: 6 bits; may be modified only in soft reset.

**Nominal Macrotick Length**

• Microticks per macrotick: 8 bits; may be modified only in soft reset.

**Bus Guardian Microticks**

The microtick duration, which is provided to the bus guardian.

• 4 bits; multiples of the CC microtick, configurable only in soft reset.

**Static Slot Length**

• Macroticks per slot: 8 bits; may be modified only in soft reset.

**Static Data Frame Length**

• Data length for static frames, in words: 7 bits; may be modified only in soft reset.

**Number of Static Slots**

• Number of static slots in a cycle: 10 bits; may be modified only in soft reset.

**Cycle Length**

• Macroticks per cycle: 16 bits; may be modified only in soft reset.

**Max. Cycle Length Deviation**

• 6 bits; maximum acceptable deviation (+/-) of pure dynamic cycle length in microticks; may be modified only in soft reset.

**Cycle Counter Max.**

• Maximum Cycle Counter value before it is reset: 6 bits; may be modified only in soft reset.

**Network Idle Time**

• Number of Macroticks: 8 bits; may be modified only in soft reset.

**Start of Latest Transmit**

• Max. macrotick value allowed before inhibiting new frame transmissions for the cycle: 16 bit; may be modified only in soft reset.

**Time Window for External SOC Trigger**

• Start of time window in pure dynamic mode for external SOC trigger acceptance; Number of Macroticks: 16 bit; may be modified only in soft reset.

**External Clock Correction (see Clock Sync Chapter)**

• 8 bits

**Offset Correction Warning (see Clock Sync Chapter)**

**External Rate Correction (see Clock Sync Chapter)**

• 8 bits

**Cluster Drift Damping (see Clock Sync Chapter)**

• 4 bits; cluster bit damping, configurable only in soft reset.

**Timer Interrupt Configuration Registers**

The CC shall provide two Timer Interrupt Configuration Registers for configurable timer interrupts. Each shall contain three fields:

• Cycle Set - A 9 bit register is used to specify in which set of cycles the interrupt shall occur. It consists of two fields, the Base Cycle [b] and the Cycle Repetition [c]. The set of cycle numbers where the interrupt is to generated is determined from these two fields using the formula

$$b + n*2^c$$

(n = 0,1,2...):

• Base Cycle [b] - A 6 bit cycle number used to identify the initial value for generating the cycle set

• Cycle Repetition [c] - A 3 bit value used to determine a constant repetition factor to be added to the base. cycle (c = 0 ... 6).

**Comment:** The maximum cycle counter value must be one less than a power of two.

- Macrotick Offset - This 16-bit value is the macrotick offset from the beginning of the cycle where the interrupt is to occur. The interrupt occurs at this offset for each cycle in the Interrupt Cycle Set.

**Transmitter Generated Padding**

In the CC a configuration switch decides whether the transmitter may add missing data bytes if the configured frame data length exceeds the length of the buffer data field.

- Disabled (logical '0') by default, may be Enabled (logical '1') only in soft reset.

**Update Receive Buffers from Null Frame - switch**

This configuration switch determines whether the data is copied out of a received Null Frame into the mailbox buffer or not. The configuration switch applies to all mailbox receive buffers of the CC.

- Disabled (logical '0') by default, may be Enabled (logical '1') only in soft reset.

**Cold Start Max**

The value in this register determines the maximum number of cycles a cold starting node is permitted to try to start up the network without receiving any valid response from another node. If the value is '0' the CC is not allowed to start up the communication.

- 8 bit; configurable only in soft reset.

**Max. Without Rate Correction**

- 5 bits; This register corresponds to the variable *gMaxWithoutRate*. If *gMaxWithoutRate* consecutive cycles transpire without performing rate correction then host notification occurs via interrupt. The register can be configured only in soft reset.

**Version 5 Solution:** After FPGA V5, this register and Max Without Offset Correction will be replaced with a single register, Max Without Clock Correction.

**Max. Without Offset Correction**

- 5 bits, This register corresponds to the variable *gMaxWithoutOffset*. If *gMaxWithoutOffset* consecutive cycles transpire without performing rate correction then host notification occurs via interrupt. The register can be configured only in soft reset.

**Version 5 Solution:** After FPGA V5, this register and Max Without Rate Correction will be replaced with a single register, Max Without Clock Correction.

**Max. Without Clock Correction**

- 5 bit, configurable with the maximum acceptable number of cycles without performing rate correction. The register can be configured only in soft reset. If the Clock Correction Failed Counter equals Max. Without Clock correction (maxwithoutclockcorrection), an interrupt will be raised.

**Startup Status Interrupt Enable Vector**

The CC shall provide a Startup Status Interrupt Enable Vector for Enabling (logical '1') or Disabling (logical '0') interrupts corresponding to the following events:

- Coldstart max reached

- Plausibility check failed

- Normal state entered via coldstart path

- Coldstart path entered due to the expiration *of pStartupNoise*

**Buffer Control Register**

The host access to the mailbox message buffers is controlled by the use of a Buffer Control Register. This control register has one byte for each mailbox buffer.

Table 21:

| Mailbox Buffer Control Register Fields | | | | | |
|---|---|---|---|---|---|
| **Control Flag** | **Bits** | **Tx Buffer** | **Rx Buffer** | **FIFO Buffer** | **Comment** |
| Reserved | 1 | | Reserved | 1 | |
| CFG* | 1 | '1' = Transmit Buffer | '0' = Receive Buffer | '0' | Message Buffer Configurati on Bit |
| CFG_SR* | 1 | '1' = Mailbox Buffer and the associated filter can be configured only during Soft Reset. | '1' = Buffer and the associated filter can be configured only during Soft Reset. | - | '0' = Mailbox Buffer and the associated filter can be configured during normal operation. (not for FPGA V5) |
| IFLG | 1 | '1' = buffer not updated, '0' = buffer updated; Host explicitly resets the IFLG when the buffer is ready for transmit. IFLG is set by the CC after transmission has been completed and the host may access the buffer for writing next message. | '1' = buffer updated (valid), '0' = not updated; Host has to explicitly clear the IFLG. | - | Interrupt Status Flag |
| IENA | 1 | '1' = Interrupt enabled | '1' = Interrupt enabled | - | IFLG Interrupt Enable |
| ABTRQ | 1 | '1' = Abort request; Message will be aborted at next DCT if transmission has not been started before next DCT. | - | - | Abort Request (not for FPGA V5) |
| ABTAK | 1 | '1' = Message has been aborted. | - | - | Abort Acknowledge (not for FPGA V5) |

* The host can modify the control flags CFG and CFG_SR only during soft reset.

Table 21:   (continued)

| Mailbox Buffer Control Register Fields | | | | | |
|---|---|---|---|---|---|
| **Control Flag** | **Bits** | **Tx Buffer** | **Rx Buffer** | **FIFO Buffer** | **Comment** |
| LOCK | 1 | '1' = lock, '0' = release | '1' = lock, '0' = release | - | Message Buffer Lock. A locked buffer is visible in the correspondi ng mailbox window. |

**Mailbox Message Buffers**

The communication controller has to provide 32 configurable mailbox message buffers for data communication with a frame length of up to 32 data bytes. (Values are valid for FPGA V5.) The mailbox buffers can be configured to be used as transmit, dedicated receive or FIFO receive buffers.

Each buffer has to include the complete frame header and data field, and shall not include the frame CRC. The CC must provide suitable mechanisms to grant a secure access to the DPRAM buffers. Using e.g. a locking mechanism, either the CC or the host may get access to one particular mailbox buffer. In order to prevent data mismatch a window access scheme may be used (e.g. one window for the active transmit buffer, one for the active dedicated receive buffer, and one for the active FIFO receive buffer). Only one single buffer of one type may be locked and visible to the host at the same time.

There are mailboxes, which can be configured during Soft Reset only while the others can be reconfigured during runtime.

**Transmit Buffers**

A portion of message buffers can be configured as transmit buffers. The set of transmit buffers shall be contiguous in the register map starting at buffer 32 (for FPGA V5) and ending before the first receive buffer.

For the static segment, fixed configured transmit mailboxes shall be used. The frame ID, Sync Bit, DLC and header CRC are written only once during soft reset and can not be changed by the host during runtime (workaround for FPGA V5).

There is one explicit mailbox (buffer #32 for FPGA V5), which must be configured to hold the transmitted Sync frame of a node, if it transmits one, and which can be reconfigured only in soft reset. This ensures that for Sync Frames, the Sync Frame ID, Sync Bit, DLC and the corresponding header CRC can be changed only during soft reset (FPGA V5 and V6).

If more than one transmit buffer is configured with the same frame ID, cycle counter and channel, the first matching buffer will be sent out by the CC.

For transmit frames in the dynamic part reconfigurable mailboxes can be used. The frame ID and the corresponding DLC can be reconfigured during runtime (FPGA V5 and V6).

The CC does not calculate the transmit header CRC (FPGA V5 and V6). It must be provided by the host for all transmitted frames.

The length field in all messages (static and dynamic) reflects the actual physical frame data length as defined in the frame format. The CC may use mailbox transmit buffer structures shorter than the actual (physical) data frame length in the static segment. In this case, the CC will generate padding bytes to ensure that frames have proper physical length. However, this capability must be enabled via configuration (see Section "Transmitter Generated Padding"). The padding pattern shall be logical ZERO. The padding function shall apply only to frames to be transmitted in the static part. In the dynamic part no frame will be transmitted if the data field in the buffer is shorter than the configured data length.

**Null Frame transmission**

If the host does not update a transmit message for the static part before transmission time (see IFLG in Table 21), the frame will be transmitted containing the current buffer contents consisting of the previously transmitted data. The CC will set the Null Frame Bit in the frame header to indicate that the transmitted message is a Null Frame. (For FPGA V5 this indication will be one single bit). Null Frames are not transmitted in the dynamic part.

It is configurable whether data from received Null Frames shall be copied into the CC receive mailboxes (see Section "Update Receive Buffers from Null Frame - switch"). This configuration applies to all receive mailboxes. It cannot be applied to the mailboxes individually.

**Receive Buffers**

A portion of the CC's message buffers can be configured as dedicated receive buffers. The set of dedicated receive buffers shall be contiguous in the register map starting after the last transmit buffer and ending before the first FIFO receive buffer.

The CC transfers valid received messages from the serial receive message buffer to the dedicated receive buffer with the matching filter configuration.

**FIFO Receive Buffers**

A portion of the CC's message buffers can be configured as FIFO receive buffers. The set of FIFO receive buffers shall be contiguous in the register map starting after the last dedicated receive buffer and ending with the last message buffer.

The CC transfers valid received messages from the serial receive message buffer to the FIFO receive buffer if there is no matching dedicated receive buffer and the header is not rejected by the FIFO Rejection filter (see Section "FIFO Filtering").

**Frame Status and Error Vector**

In addition to the actual transmitted or received data, each message buffer must possess a Frame Status and Error Vector. The Frame Status and Error Vector contains six bits which are summarized in the following table:

Table 22:

| Frame Status and Error Vector | | | | |
|---|---|---|---|---|
| **Status/Error Flag** | **Bits** | **Tx Buffer** | **Rx Buffer** | **FIFO Buffer** |
| Null Frame | 1 | Null Frame transmitted | Null Frame received (static part) | Null Frame received |
| Empty Slot | 1 | - | No bus traffic detected (static part) | - |
| Bit Coding/CRC Error | 1 | - | Error detected (bit coding, header or frame CRC, in static part) | - |
| Length Mismatch | 1 | - | Length Mismatch detected (static part) | - |
| Slot Mismatch | 1 | - | Slot Mismatch detected | - |
| Cycle Counter Mismatch | 1 | - | Cycle Counter Mismatch detected (static part) | - |

**Version 5 Solution:** For FPGA V5 one vector shall be defined for each channel.

The vector content is updated at the end of the slot (defined by the configured Frame ID) by the communication controller and can be checked by the host.

In searching for Frame Id matches, searching commences with the receive buffer adjacent to the last transmit buffer. It proceeds incrementally through the remaining receive buffers. If more than one receive buffer holds the same frame ID, the error vector is updated in the first matching buffer.

The flags are set if one of the listed errors is detected by the communication controller. The host can check the vector any time. An interrupt will be triggered by the CC if the corresponding interrupt enable bit in the General Enable Register is set (see below).

**Filtering and Masking**

**Definitions**

**Message Filtering**

Message filtering is done by checking specific fields in a message against corresponding configuration constants in the buffer, with the stipulation that message is only processed further if the required matches occur. Otherwise, it is discarded. Messages are filtered on the following message fields:

- Channel Number

- Frame Id

- Cycle Counter

- Message Id

**Message Filter Mask**

Masking of message filters means that some (parts) of the filtering parameters may be configured to be disregarded (set to "don't care").

**Filtering Mechanisms**

The filtering mechanisms described below are applied differently for receive and transmit message buffers

- Receive buffer: In order to store a message the filters for channel Id, and cycle counter must match. In addition, depending on a configuration bit either the Frame Id (configuration bit = "0") or the Message Id (configuration bit = "1") must match (but not both).

- Transmit buffer: A message will be transmitted in the time slot corresponding to the frame ID on the configured channel(s) if the cycle counter matches the configured cycle filter value.

**Channel Filtering**

There is a Channel Filtering field (2 bits) associated with each buffer. It serves as a filter for a receive message buffer, and as a control field for a transmit message buffer.
Depending on the buffer configuration

- Receive buffer: received frames are stored if they are received on all the specified in the Channel Filtering Field. Other filtering criteria must also be met.

- Transmit buffer: the content of the buffer is transmitted only on the channels specified in the Channel Filtering Field when the Cycle Counter Filtering and Frame Id Filtering criteria are also met.

Table 23:

| Channel Filtering Configuration | | | |
|---|---|---|---|
| **Config. bit A** | **Config. bit B** | **Tx Buffer Transmit frame** | **Rx Buffer Store valid Rx frame** |
| 1 | 1 | on both channels | received on channel A or B (not for V5) |
| 1 | 0 | on channel A | received on channel A |
| 0 | 1 | on channel B | received on channel B |
| 0 | 0 | no transmission | ignore frame |

**Frame ID Filtering**

Every Transmit and Receive mailbox message buffer contains a frame ID. This frame ID is used differently for receive and transmit message buffers

- Receive message buffers: A received message is stored in the first receive message buffer where the received frame ID matches the receive mailbox frame ID, provided the other receive filtering criteria are also met. If Message Id filtering is being used, this filter is not applied.
- For Transmit buffers the frame ID in the buffer is used to determine the appropriate slot for the message transmission. The frame will be transmitted in the time slot corresponding to the frame ID, provided the channel and cycle counter criteria are also met.

**Cycle Counter Filtering**

Cycle Counter Filtering is based on the notion of a Cycle Set. For filtering purposes, a match occurs if any one of the elements of the set is matched.

- Cycle Set - A 9 bit register is used to specify which cycle numbers are elements of the set. It consists of two fields, the Base Cycle [b] and the Cycle Repetition [c]. The set of cycle numbers belonging to the set determined from these two fields using the formula

$$b + n*2^c$$

(n = 0,1,2...):

- Base Cycle [b] - A 6 bit cycle number used to identify the initial value for generating the cycle set

- Cycle Repetition [c] - A 3 bit value used to determine a constant repetition factor to be added to the base cycle (c = 0 ... 6).

The operation of the filtering mechanism depends on the configuration of the buffer:

- Receive buffer: The received message is stored only if the received cycle counter matches an element of the buffer's Cycle Set. Channel, Frame Id and Message Id criteria must also be met.

- Transmit buffer: the content of the buffer is transmitted when an element of the Cycle Set matches the current cycle counter and the frame ID matches the slot counter value.

**Message ID Filtering**

Message ID filtering applies only for receive message buffers. For message ID filtering the first two data bytes out of the receive buffer are used. The received frame will be stored in the configured receive buffer if the message ID, channel and cycle counter match. The frame ID will be stored in the buffer, but ignored for filtering.
There is no message ID filtering used for frame transmission.

**FIFO Filtering**

For FIFO filtering there is one Rejection Filter and one Rejection Filter Mask available. Each register consists of 36 bits for channel (2 bits), frame ID (12 bits), cycle counter (6 bits), and message ID (16 bits). The two registers can be reconfigured in soft reset as well as during runtime.
A received frame will be stored in the next free FIFO buffer if the channel, frame ID, cycle counter, and message ID are not rejected by the configured reject and mask reject filter and if there is no matching dedicated receive buffer in the mailbox.

**General Interrupts**

In general, interrupts provide a close link to the protocol timing as they are triggered almost immediately when an error is detected by the controller, a frame is received or transmitted, or a configured timer interrupt is activated. This allows the host to react very quickly on specific error conditions, timers and events. On the other hand too many interrupts can cause the host to miss deadlines required for the application. Therefore it must be possible to disable/ enable interrupts, separately and as a whole.

An interrupt may be triggered when

- A status bit is set

- A counter exceeds a specific value

- A timer reaches a configured value.

Tracking status and generating interrupts when a status change occurs are two independent tasks. Regardless of whether an interrupt is enabled, or not, the corresponding status should be tracked

At least one hardware interrupt line shall be available to signal an interrupt to the host.

**General Interrupt Register**

The communication controller has to provide a General Interrupt and Error Indication Register.

Table 24:

| General Interrupt Register | | | |
|---|---|---|---|
| General Interrupt Flag | Bits | Channel Receiver | Channel |
| Bit Coding/CRC Error | 1 | Error detected (bit coding, header or frame CRC)) | A |
| Slot Mismatch | 1 | Slot Mismatch detected | A |
| Cycle Counter Mismatch | 1 | Cycle Counter Mismatch detected | A |
| Length Mismatch | 1 | Length Mismatch detected | A |
| SOC Normal[15] / Collision Avoidance[16] symbol | 1 | SOC Normal or Collision Avoidance symbol detected | A |
| SOC Alarm symbol[17] | 1 | SOC Alarm symbol detected | A |
| SOC Too Early | 1 | SOC received before qdCycleMin | A |
| SOC Lost | 1 | SOC not received before gdCycleMax | A |
| | | | |
| Bit Coding/CRC Error | 1 | Error detected (bit coding, header or frame CRC) | B |
| Slot Mismatch | 1 | Slot Mismatch detected | B |
| Cycle Counter Mismatch | 1 | Cycle Counter Mismatch detected | B |
| Length Mismatch | 1 | Length Mismatch detected | B |
| SOC Normal / Collision Avoidance symbol | 1 | SOC Normal symbol detected | B |
| SOC Alarm symbol | 1 | SOC Alarm symbol detected | B |
| SOC Too Early | 1 | SOC received before gdCycleMin | B |
| SOC Lost | 1 | SOC not received before qdCycleMax | B |

[15] The SOC Normal symbol is only used on byteflight and pure dynamic FlexRay configurations.

[16] The Collision Avoidance symbol is used only used on pure static and mixed (static and dynamic) FlexRay configurations.

[17] The SOC Alarm symbol is only used on byteflight and pure dynamic FlexRay configurations.

The flags are set when the communication controller detects one of the listed errors or SOC symbols. The host can check the vector. The communication controller has to provide a General Error Interrupt, which will be triggered when any of the flags is set, provided the corresponding interrupt is enabled. For this purpose, the CC has to provide for each general interrupt indication flag a General Interrupt Enable flag.

**General Interrupt Enable Register**

Table 25:

| General Interrupt Enable Register | | |
|---|---|---|
| **General Interrupt Enable Flag** | **Bits** | **Channel** |
| Bit Coding/CRC Error | 1 | A |
| Slot Mismatch | 1 | A |
| Cycle Counter Mismatch | 1 | A |
| Length Mismatch | 1 | A |
| SOC Normal / Collision Avoidance symbol | 1 | A |
| SOC Alarm symbol | 1 | A |
| SOC Too Early | 1 | A |
| SOC Lost | 1 | A |
| | | |
| Bit Coding/CRC Error | 1 | B |
| Slot Mismatch | 1 | B |
| Cycle Counter Mismatch | 1 | B |
| Length Mismatch | 1 | B |
| SOC Normal / Collision Avoidance symbol | 1 | B |
| SOC Alarm symbol | 1 | B |
| SOC Too Early | 1 | B |
| SOC Lost | 1 | B |
| | | |

The settings in the General Interrupt Enable Register determine which status changes in the General Interrupt Register will result in interrupts. The Bit Coding/CRC Error, Slot Mismatch, Cycle Counter Mismatch and Length Mismatch flags also Enable/Disable the corresponding interrupts in the Frame Status and Error Vector of the receive buffers.

**Receive Interrupt Status Register**

The communication controller has to provide a Receive Interrupt Status Register to indicate the reception of a valid frame (stored in one of the mailbox buffers), a SOC, or an optical diagnosis signal (when using an optical physical layer). The flags are set by the CC when a corresponding event occurs. If enabled, an interrupt is pending while one of the bits is set.

Following read-only bits shall readable by host:

- Receive Interrupt Flag

- Receive FIFO Not Empty Interrupt Flag

- Receive FIFO Overrun Interrupt Flag

- SOC Normal Interrupt Flag

- SOC Alarm Interrupt Flag

- Optical Diagnosis Flag

**Receive Interrupt Enable Register**

The communication controller has to provide a Receive Interrupt Enable Register to enable each of the Receive Interrupt Status Register flags separately.

**Indication of bus events (not for FPGA V5)**

The communication controller by way of additional output signals indicates the following events:

Table 26:

| Bus Event Indication | | |
|---|---|---|
| **Event** | | **Description** |
| SOC Normal symbol detected on bus | | SET_SOCNIF |
| SOC Alarm detected on bus | | SET_SOCAIF |
| | | |
| Correct message was received which may be copied into a receive buffer | | SET RCVMSG, even if message is not copied into any buffer (in case no adequate receive buffer is configured) |
| Frame Error detected. One of following checks failed: *vCheckIdlebeforeFram e, vCheckCoding, vCheckActiveDuringFr ame, vCheckCRC, vCheckIdleAfterFrame , vCheckBodyLength* | | SET_ERRIF |
| Slot mismatch detected. The check *vCheckSlotID* failed. | | SET_SLMM |

The exact attribution of events to interrupt vectors or lines is described in the specifications in the respective communication controller implementation.

In order to enable error monitoring in a star node the communication controller shall provide four output signals with the setting of internal status flags indicated by means of a pulse.

The following figure shows which internal events should be indicated externally.

Figure 60 shows SLMM, ERR, ROK and SYNC signals.

If an internal event is indicated, the corresponding signal has to be switched to the active state for a defined time, in order to generate a logical "1" signal with a duration of at least 50 ns.

The SLMM signal confirms the reception of a frame with a correct format and correct CRC, even if the frame identifier deviates from the slot counter value at reception time.

The ERR signal indicates an error as described above.

The ROK signal indicates that a correct frame has been received even if the message was not copied into a buffer in the communication controller.

The SOC signal confirms that a valid SOC symbol (Normal or Alarm) has been received or sent. It can be used to trigger timers or to start synchronized software tasks with every SOC.

Every communication controller should be able to generate at least the signals ERR, ROK and SOC.

**Chapter 13**

**Bus Guardian Interface**

The decentralized bus guardian protects the communication channel against illegal medium access by a communication controller. This section describes the expected bus guardian behavior with a focus on the scheduling scheme and the relationship between bus guardian and communication controller. Cycle- and clock synchronization of the bus guardian to the communication controller are described and a subset of the bus guardian configuration parameters is specified.

**Bus Guardian Operation Modes**

**Normal**

In Normal mode the bus guardian is configured and the scheduler is initialized. In normal mode the bus guarding function is enabled, with the BG allowing access to the bus during configured communication slots and disallowing it at all other times. Any bus guardian error results in a fall back to FailSilent mode, causing an error flag will be set and an interrupt to be generated (if enabled).

**FailSilent**

In FailSilent mode bus access is disabled. The FailSilent mode is used at start-up and as a fallback in error cases. FailSilent mode may only be left by an SPI command from the Host.

**Bypass**

The Bypass mode is used for pure dynamic FlexRay configurations and byteflight compatible configurations. For testing purposes like transceiver evaluation the Bypass mode also is entered if a dedicated test input of the BG is HIGH.
Bus access is permanently enabled. The Bypass mode may be entered or left by an SPI command. SPI commands overrule the setting of the dedicated test input.

**WakeUp**

In WakeUp mode the bus access is enabled and the bus guardian does not check for transmission- or reception errors. An ARM trigger during WakeUp mode will cause an arming error and the BG will enter the FailSilent mode. At the end of the wake-up period the Host has to initiate a transition from WakeUp mode to FailSilent mode before the CC may start communicating by sending the initial ARM trigger to the BG.
WakeUp mode is intended for the initial wakeup only, not for sending wakeup messages during normal operation.

**StopCom**

To support the StopCom service, a communication controller stops sending messages at the end of the communication cycle and enters the ShutdownRequest state. The bus guardian supports this service by entering the StopCom mode.
In StopCom mode the bus guardian continues to control the bus access in the same manner as in Normal mode and also continues to monitor the ARM signal. If the ARM trigger is missing in StopCom mode, the bus guardian enters the FailSilent mode without generating an interrupt or setting error flags. This can be contrasted to the behavior in normal mode, where failure to receive the ARM signal would cause the generation of an error interrupt and error flags to be set.
The following sequence allows the CC to make a smooth transition to the ShutdownRequest state.

- the HOST initiates a transition from Normal mode to StopCom mode at the bus guardian

- the StopCom command is sent to the CC

- at the end of the cycle the CC stops sending messages and stops sending the ARM trigger to the BG

- the BG detects the missing ARM trigger and enters FailSilent mode

- the CC switches off all internal clocks

**Disabled (Listen only)**

The Disabled mode is intended for node diagnosis. The bus guardian is powered and synchronized to the CC. Bus access is disabled. Errors are still detected and error flags are set. In case of errors the BG does not enter FailSilent mode, but instead remains in the Disabled mode. The Host may enable or disable interrupt generation. Disabled mode may only be left by an SPI command from the Host.

**Bus guardian Scheduling Scheme**

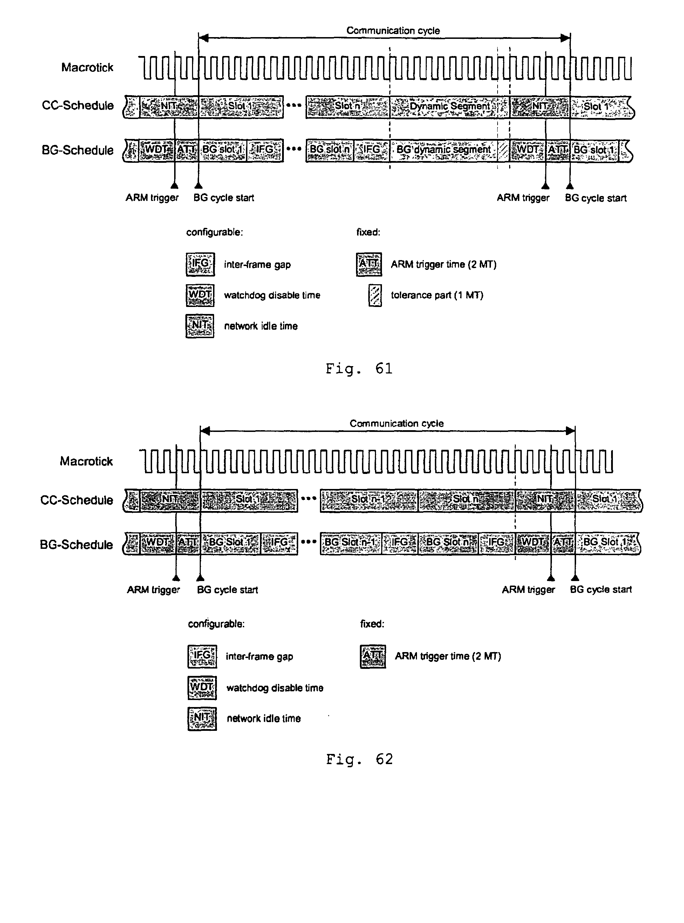

Figure 61 shows an example of the media access pattern for a cluster operating in the mixed static/dynamic mode. The BG communication cycle start is defined at the beginning of static slot 1. Every static slot is followed by an inter-frame gap (IFG) of at least 2 macroticks (MT) in duration. The configuration shown in Figure 61 uses an inter-frame gap of 3 MT. The BG stays open during the BG dynamic segment and closes 1 MT after the end of this segment. The communication cycle is completed by the Watchdog Disable Time (WDT) and the ARM Trigger Time (ATT). The start of the Watchdog Disable Time is aligned with the start of the Network Idle Time, which is used by the clock synchronization algorithm in the CC to apply the clock offset correction. The Bus Guardian's supervision of the macrotick period (MT watchdog) is disabled during this part of the schedule. This allows clock offset correction to shorten or lengthen macroticks by an amount that would exceed the configured limits of the macrotick supervision (see Section "BG-CC Synchronization"). The ARM Trigger Time is needed to allow the Bus Guardian to process the ARM trigger, which synchronizes the BG schedule to the schedule of the CC. The ARM trigger is expected to occur two macrotick periods in advance of the BG cycle start. During the ARM Trigger Time the CC shall not perform clock offset correction.

Figure 62 shows the FlexRay media access pattern for a cluster operating in the pure static configuration.

Configurations using the FlexRay pure dynamic or byteflight compatibility modes are supported using the Bus Guardian Off mode.

**Key features of the bus guardian scheduling:**

- The scheduler at the BG is clocked directly with the corrected MT signal (rising edge) from the communication controller

- The BGEN signal, the signal that controls transmit access to the communication medium, is generated synchronous to the MT signal

- The minimum Inter-Frame Gap duration is 2 macroticks

- The Inter-Frame Gap may be extended by a safe part (the duration of the safe part is a configuration parameter)

- Every BG static slot is followed by an Inter-Frame Gap

- The communication cycle starts 2 macrotick periods after the ARM trigger (falling edge of the ARM signal)

- The ARM trigger time shall not be used for clock offset correction (this restriction applies to FPGA V5)

- The bus guardian is kept open during the BG dynamic segment

- At the end of the BG dynamic segment the bus guardian stays open for the duration of one macrotick, which is equivalent to the tolerance part of an inter-frame gap

- The Bus Guardian schedule contains a part (the Watchdog Disable Time, or WDT) during which the macrotick watchdog functionality is disabled. This part is intended for clock offset correction in the CC.

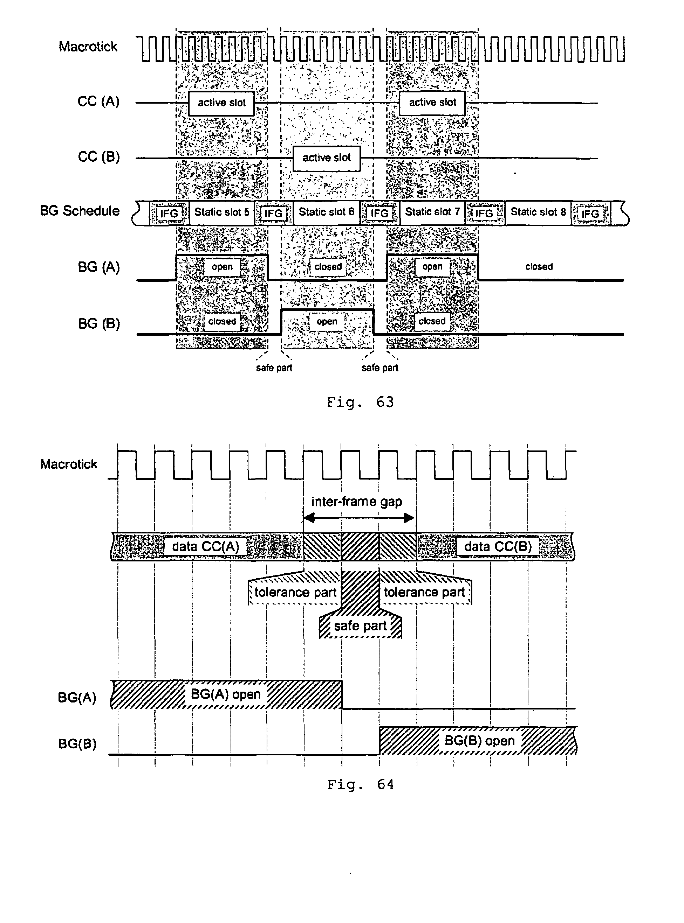

Figure 63 shows a scheduling example with an Inter-Frame Gap of 3 macroticks. With this scheduling scheme the bus guardian open windows do not overlap. This is achieved by adding a safe part to the Inter-Frame Gap pattern. During this safe part no transmission (by any node) is allowed. The Bus Guardian is able to detect media access errors during the safe part without any interaction with the CC. These errors might occur if a node is operating slightly off specification with respect to the global time.

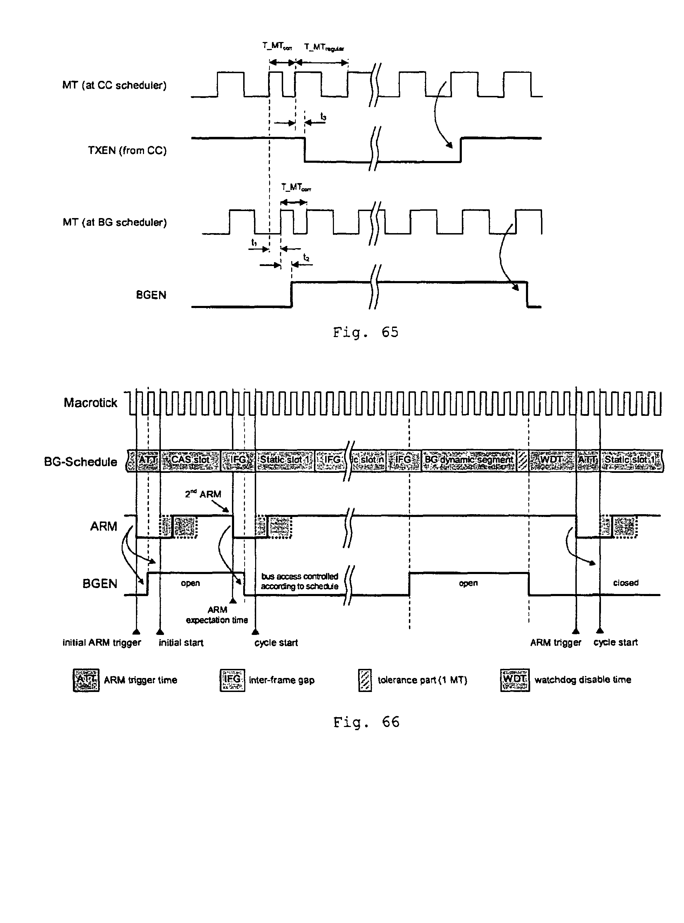

Figure 64 provides a more detailed view of an Inter-Frame Gap of 3 macroticks in duration. The BG open window always starts one macrotick before the frame start and ends one macrotick after the frame end. With a scheduling scheme based on the macrotick, these "tolerance" parts are needed to avoid cutting of frame data by the BG open window. The IFG shown includes a safe part of one macrotick in duration. This safe part may be added in order to avoid overlapping BG open windows of adjacent static slots. The safe part is also required to support the detection of reception errors by the bus guardian.

Table 27 summarizes the fixed and configurable parts of the bus guardian scheduling scheme.

**Version 5 Solution:** The ranges of the configurable parameters shown in Table 27 are the ranges currently specified. The final ranges for these configurable parameters have not yet been determined and may be changed in future versions of the protocol specification.

Table 27:

| Key Bus Guardian Schedule Parameters | | |
|---|---|---|
| **Name** | **Length** | **Remarks** |
| **Fixed Length** | | |
| **Tolerance part** | 1 MT | mandatory part of the interframe gap; also needed to close the BG after the end of the BG dynamic segment |
| **Arm Trigger Time** | 2 MT | no clock offset correction allowed |
| **Configurable Length** | | |
| **Static slot length** | 0 to 4095 MT | CAS slot length assumed to be identical to static slot length |
| **BG dynamic segment length** | 0 to 65535 MT | BG is kept open during BG dynamic segment |
| **Safe part** | 0 to 15 MT | optional part of the interframe gap; enables detection of reception errors at the BG |
| **Watchdog disable time** | up to 255 MT | to be used for clock offset correction |

**Bus Guardian / Communication Controller Interface**

**BG - CC Interface Signals**

Table 28 shows a list of bus guardian inputs and outputs at the interface between bus guardian and communication controller. The transition of the ARM signal from HIGH to LOW is referred to as ARM trigger.

Table 28:

| BG - CC Interface Signals | | | |
|---|---|---|---|
| **Symbol** | **DIR[18]** | **ACTIVE** | **Description** |
| MT | I | - | Corrected Macrotick - clock signal from CC |
| BGT | I | - | Bus guardian tick - clock signal from CC |
| ARM | I | LOW | ARM trigger signal from CC |
| BGEM | O | LOW | BG Enable Monitor signal (inverted BGEN signal from BG scheduler).[19] Allows CC to monitor BG operation. |

[18] Data direction relative to the Bus Guardian. 'I' represents an input to the BG, 'O' represents an output from the BG.
[19] Depending on the implementation a bus driver instead of the bus guardian may generate the BGEM signal. This would allow the CC to monitor BG operation directly at the medium access point.

**BG-CC Synchronization**

The FlexRay bus guardian approach maintains synchronization of the local BG schedule to the global time by basing all BG scheduling operations on a corrected macrotick signal provided by the CC. This allows the BG to perform its media access protection function (opening the transmit path one macrotick in advance of an active slot and closing it one macrotick after the end of an active slot) while being continuously synchronized to the global clock using the clock synchronization algorithm of the CC. Figure 65 shows the relation between the TXEN signal, which is activated by the CC in order to transmit data, and the BGEN signal, that enables the transmit path at the BG. Both signals are derived from the MT signal available to both the CC and the BG.

Figure 65 also shows that the effect of the propagation delays $t_1$, $t_2$ and $t_3$ in relation to the minimum MT period $T\_MT_{corr}$ must be considered, in order to open the transmit path before the transmission starts. (V5: The detailed timing depends on implementation restrictions and will be specified in a separate document.)

An second clock signal, bus guardian tick (BGT), is used for supervising the period of the MT signal provided by the CC. The Communication Controller shall generate the BGT signal such that its period is independent from the clock correction performed by the CC. For example, the BGT signal could be derived from the application of a programmable prescaler to the oscillator input of the Communication Controller. The Bus Guardian uses the BGT signal to perform a supervision of the duration of the corrected macrotick by checking if the MT / BGT ratio deviates from the nominal ratio by more than a pre-defined configurable limit. Acceptable deviations from the nominal limit may be caused by the clock rate correction algorithm as it increases or decreases the length of certain macroticks to maintain the overall clock rate.

Clock offset correction is applied during the network idle time and may require the application of large correction terms that would result in macroticks that are shortened or lengthened such that they would exceed the configured limits for the macrotick period supervision at the BG. In order to allow the application of such large clock offset correction terms, the macrotick period supervision is disabled during the part of the schedule where these offsets are corrected. The period the macrotick supervision is disabled, referred to as the Watchdog Disable Time (WDT), is aligned with the Network Idle Time at the CC.

**Expected ARM Timing**

Before the initial ARM trigger the MT signal is ignored to allow large initial offset corrections without BG-related restrictions to the MT period. After the initial ARM trigger the BG scheduler is directly clocked with the MT signal and the ARM trigger is used to indicate the start of the communication cycle. The bus guardian expects the regular occurrence of the ARM trigger and check for this at the end of each cycle.

Figure 66 shows the expected ARM timing of a cold start node. When receiving the initial ARM trigger, the BG initializes the schedule and opens for the Collision Avoidance Symbol (CAS) slot. After transmitting the CAS, the CC sends a second ARM trigger. The BG detects this second ARM trigger, reinitializes the BG schedule, and starts controlling bus access according to the schedule.

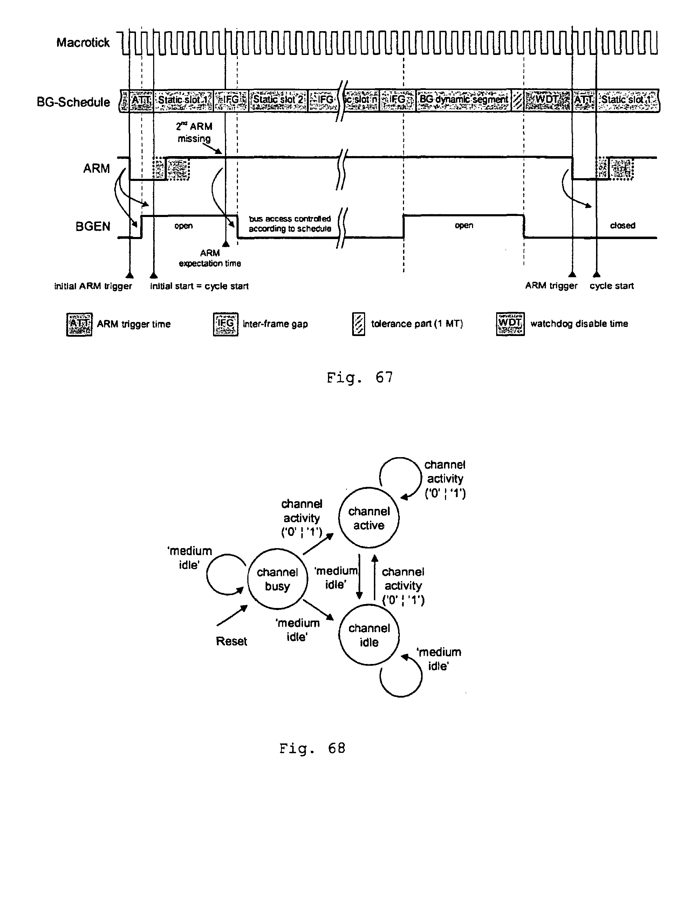

Figure 67 shows the expected ARM timing of an integrating node, which starts with the regular schedule and does not transmit a Collision Avoidance Symbol. When receiving the initial ARM trigger, the BG initializes the schedule. At this point the BG can not determine whether a node is a cold start node or an integrating node and thus has to open for the CAS slot. As a result, the bus guardian of an integrating node does not protect the first static slot of the first communication cycle. If the node is an integrating node the CC starts with the regular schedule and the next ARM trigger does not occur until the end of the cycle. Specifically, an integrating node does not send a second ARM at the end of the first static slot. (A cold start node would provide an ARM trigger after transmission of the Collision Avoidance signal.) The bus guardian detects the "missing" second ARM trigger and continues to work according to the regular schedule.

**BG - CC Interface Requirements Summary**

- The initial offset correction (up to 3000 ppm) must be completed before the initial ARM trigger occurs. Before this initial ARM trigger the BG ignores the MT signal.

- After detection of the initial ARM trigger the following requirements are valid:

- Expected minimum regular MT period: $T_{MT(nom)} \geq 1$ µs

- Expected minimum corrected MT period: $T_{MT(min)} \geq 0.5$ µs

- Expected minimum MT pulse width (low or high): 250 ns

- The CC provides an MT signal, that is used as the clock for the BG scheduler

- The MT signal that the CC provides to the BG shall be the same internal corrected macrotick signal that the CC uses to schedule its internal activities. This implies that the CC must do more than provide a MT signal that is at the correct frequency; it must match CC's internal view of a corrected macrotick.

- The ARM signal from the CC is generated synchronous to the MT (falling edge of the ARM signal is aligned to the rising edge of the MT signal)

- The communication cycle is preceded by a period two macroticks in duration (the ARM trigger time), which the CC shall not use for clock offset correction. Clock rate correction may be performed during ARM Trigger Time (ATT).

- Expected minimum ARM active duration: $T_{ABM(min)}$ = 2 MT

- Expected maximum ARM active duration: tbd (shall be shorter than CAS slot)

- Expected minimum BGT period: $T_{BGT(min)} \geq 250$ ns

- Expected BGT duty cycle: 50% (tolerance tbd)

- The BG communication cycle starts at the beginning of the first static slot

- The number of macroticks per cycle is not variable

**BG Schedule Reset**

FlexRay nodes that enter communication via the coldstart path have a requirement to be able to reset the BG schedule if they need to re-enter listen static state. The BG is able to detect this situation by monitoring the ARM signal. The bus guardian continuously monitors the ARM signal and detects if the ARM trigger at the cycle start is missing. The communication controller causes a bus guardian schedule reset by not sending the regular ARM trigger to the bus guardian.

Bus guardian schedule resets are allowed only during startup of a cold start node. For this purpose the BG needs to distinguish between nodes in cold start state and integrating nodes. Cold start nodes are identified by detection of a second ARM trigger at the end of the first static slot (see Section *0*); this pair of ARM trigger events is called 'double ARM trigger'.

BG schedule reset requests need to be handled at the bus guardian in a way that is closely related to the protocol specification. So, any change of the FlexRay startup procedure may influence the required BG schedule reset procedure, described in the pseudo-code below.

```
Cold_Start_Count = 0;
```

```
init:                                       // BG normal mode;
waiting for initial ARM
if double ARM trigger detected              // CC cold
start state
    BG_reset = enabled;
    Cold_Start_Count ++;
    while (Cold_Start_Count < pColdStartMax)
      wait for start of next cycle;
      if double ARM trigger detected        // error
condition
        ARM error (BG enters fail-silent mode);
      elseif single ARM trigger detected        // CC stays
in cold start state
        Cold_Start_Count ++;
      else                              // missing ARM trigger
        BG schedule reset - goto init       // CC re-
entered listen static state
      end;
    end;
end;
BG reset = disabled;                        // integrating node
                                    // or cold start concluded

while (1)                               // BG normal operation
mode
    if no ARM at cycle start detected
      ARM error;                            // BG schedule reset
permanently disabled
    end;
end;
```

**Bus Guardian Configuration Parameters**

A subset of the bus guardian configuration parameters, related to the bus guardian scheduling scheme is shown in Table 29.

Table 29:

| Bus Guardian Configuration Parameters (Subset) | | | |
|---|---|---|---|
| **Name** | **Description** | **Range / Value** | **Unit** |
| *qdBGSlot* | static slot length [20] [21] | 0 .. 4095 | MT |
| *gdBGDynSegment* | BG dynamic segment length[22] | 0 .. 65535 | MT |
| *qdBGSafePart* | inter-frame gap safe | 0 .. 15 | MT |
| | part | | |
| *gdBGNatchdogDisable* | watchdog disable time length[23] | 0 .. 255 | MT |
| | | | |
| *pActiveStaticSlot1* | open static slot number 1[24] | 0, 1 .. 1023[25] | — |
| *pActiveStaticSlot2* | open static slot number 2 | 0,1.. 1023 | — |

[20] Does not include the inter-frame gap (*gdBGSafePart* + 2 MT)

[21] By definition CAS slot length is identical to static slot length

[22] Does not include the tolerance part (a constant 1 MT) - see Figure 61

[23] Does not include the ARM trigger time (a constant 2 MT)

[24] Open static slots must be configured in ascending order

[25] Unused entries are identified by slot number = 0

Table 29: (continued)

| Bus Guardian Configuration Parameters (Subset) | | | |
|---|---|---|---|
| **Name** | **Description** | **Range / Value** | **Unit** |
| ... | | | |
| *pActiveStaticSlot16* | open static slot number 16 | 0, 1 .. 1023 | — |
| *gNumberOfStaticSlots* | last static slot number | 2 .. 1023 | — |

**Frame Checks**

**Introduction**

When a frame is received a set of checks must be performed to determine if the data in the frame, or information about the reception of the frame (arrival time, cycle counter, etc.) should be accepted into the Communications Controller. For example, before frame data is passed up to the host through the CHI the Communications Controller performs a check of the Frame CRC. As another example, before a frame's reception time is used for the clock synchronization algorithm the CC performs a check to determine if the frame has the Sync Bit field set.

At a conceptual level, a FlexRay Communications Controller has several logical blocks that act as consumers of frame data (or information about the reception of the frame). Examples of these logical blocks include the clock synchronization mechanism, the startup mechanism, the error management mechanism, the host interface, etc. Each of these logical blocks may have different requirements for the criteria that determine whether a frame is "accepted" for the purposes of that block. For example, the clock synchronization mechanism may require that a frame has the Sync Bit set in order to accept the frame, but the host interface has no such requirement. Also, it is possible that within a single logical block the state of the Communication Controller may affect that block's criteria for "accepting" a frame. For example, the startup mechanism may check that a frame's cycle counter matches the CC's current view of cycle count after the system has been synchronized, but may ignore this check prior to synchronization.

The individual logical blocks need to specify the acceptance criteria that determine whether they will accept a particular frame. These criteria may be thought of being constructed out of a set of "fundamental" tests that are applicable to one or more criteria. For example, the concept of checking for a valid CRC is likely to apply to many criteria. This section defines these "fundamental" tests that are referenced in other sections of the specification.

**Notation**

The result of the check is represented by a variable of the form *vCheckName*, where CheckName is the name of the particular check. A value of "T" indicates that the respective check was successful for that frame. The concept of "successful" or "unsuccessful" checks is actually somewhat ambiguous. In general, a check is considered "successful" if it would tend to result in the acceptance of a frame. The formal definitions of the individual checks, and the inclusion of those checks in acceptance criteria, resolve any ambiguities. A value of "F" indicates that the check was unsuccessful.

Several of the checks or variables defined in this section are individually applicable to the frames received on both channels of a multiple channel system. In this case, there are actually two checks or variables, one for Channel A and the other for Channel B. When this is the case, the check or variable is given a name of the form CheckName_x. A check of this form shall be interpreted as applying to the channel in question (i.e., the channel on which the frame was received). Where it is necessary to be explicit as to which channel is actually being referenced, the suffix _x will be replaced with a suffix indicating the appropriate channel (_A or _B).

**Frame consistency checks**

**Frame Coding Checks**

The check CheckFrameCoding_x summarizes the results of coding checks performed against a set of coding-dependent coding rules that are applied upon frame reception.

For NRZ 8N1 coding the following applies:

```
if (vCheckFSS_x == "T" AND vCheckByteDelimiterBits_x == "T")  //
    vCheckFrameCoding_x = "T";                               //
else                                            //
    vCheckFrameCoding_x = "F";                               //
end;                                            //
```

**Comment:** This section will be expanded as other coding methods are defined.

## Frame CRC Checks

The check CheckCRC_x checks the consistency of a frame and it's CRC. This test is performed according to the procedure described in the chapter "Frame and Symbol Formats". The variable *vCheckCRC_x* denotes the result of the check for the respective communication channel:

```
if CRC_x(fFrame_x) == gCRCseed_x          //
    vCheckCRC_x = "T";                    //
else                                //
    vCheckCRC_x = "F";                    //
end;                                //
```

In the pseudocode above the variable *fFrame_x* represents the entire frame received on the channel, including the frame CRC.

Note that CRC_x() implies that the CRC check appropriate for the frame and channel are applied - for example, byteflight frames use a different CRC mechanism than FlexRay frames. Also, for FlexRay frames the CRC mechanism for channel A is different than the CRC mechanism for channel B. Similarly, the variable *gCRCseed_x* represents the appropriate value for the CRC generator that is being used (byteflight or FlexRay). Although FlexRay frames use different initialization values for the CRC generators on channels A and B, the CRC seed value

used in this check is identical. bytefilght frames use a different seed value.

## Header CRC Checks

The check CheckHeaderCRC_x checks the consistency of the header and the header CRC. This test is performed according to the procedure described in the chapter "Frame and Symbol Formats". The variable $vCheckHeaderCRC\_x$ denotes the result of the check for the respective communication channel:

```
   if CRC(fPayloadLength_x, fSyncBit_x, fHeaderCRC_x) ==
gHeaderCRCseed     //
      vCheckHeaderCRC_x = "T";                                        //
   else                                                   //
      vCheckHeaderCRC_x = "F";                                        //
   end;                                                   //
```

In the pseudocode above the CRC function is the generator for the header CRC. The arguments shown are concatenated in the order indicated to form the input to the generator.

## Frame content checks

## Sync Bit Checks

The check CheckSyncBitSet_x checks whether the sync bit is set within the received frame. The variable $vCheckSyncBitSet\_x$ denotes the result of the check for the respective communication channel.

```
   if fSyncBit_x == 1                              //
      vCheckSyncBitSet_x = "T";                          //
   else                              //
      vCheckSyncBitSet_x = "F";                          //
   end;                              //
```

The check CheckSyncBitMatch checks whether the sync bits received on the respective communication channels within one communication slot have identical values. The variable $vCheckSyncBitMatch$ denotes the result of the check.

```
if fSyncBit_A == fSyncBit_B                         //
   vCheckSyncBitMatch = "T";                        //
else                                        //
   vCheckSyncBitMatch = "F";                        //
end;                                        //
```

## Frame ID Checks

The check CheckFrameIDMatch checks whether the frame IDs received on the respective communication channels within one communication are identical. The variable *vCheckFrameIDMatch* denotes the result of the check.

```
if fFrameID_A == fFrameID_B                         //
   vCheckFrameIDMatch = "T";                        //
else                                        //
   vCheckFrameIDMatch = "F";                        //
end;
```

The check CheckFrameID_x checks whether the frame ID *fFrameID_x* matches the current view of the slot ID *vCurrentSlotID* within the communication controller. The variable *vCheckFrameID_x* denotes the result of the check for the respective communication channel.

```
if fFrameID_x == vCurrentSlotID                          //
   vCheckFrameID_x = "T";                        //
else                                        //
   vCheckFrameID_x = "F";                        //
end;                                        //
```

The check CheckFrameIDStaticRange_x checks whether the frame ID *fFrameID_x* is within the configured range of acceptable static segment slot ID's. The variable *vCheckFrameIDStaticRange _x* denotes the result of the check for the respective communication channel.

```
if ((fFrameID_x >= 1) AND                         //
   (fFrameID_x <= gNumberOfStaticSlots ))                 //
   vCheckFrameIDStaticRange_x = "T";                 //
else                                        //
```

```
    vCheckFrameIDStaticRange_x = "F";              //
end;                                      //
```

The check CheckFrameIDDynamicRange_x checks whether the frame ID *fFrameID_x* is within the configured range of acceptable dynamic segment slot ID's. The variable *vCheckFrameIDDynamicRange_x* denotes the result of the check for the respective communication channel.

```
if ((fFrameID_x > gNumberOfStaticSlots ) AND      //
  (fFrameID_x <= gSlotIDMax))                     //
    vCheckFrameIDDynamicRange_x = "T";            //
else                                     //
    vCheckFrameIDDynamicRange_x = "F";            //
end;                                     //
```

**Static Frame Payload Length Checks**

The check CheckStaticPayloadLength_x checks whether the number of bytes claimed to be contained within the payload segment (via the *fPayloadLength* field) of the frame matches the number of payload segment bytes configured within the communication controller in the variable *gPayloadLengthStatic*. The variable *vCheckStaticPayloadLength_x* denotes the result of the check for the respective communication channel.

```
if fPayloadLength_x == gPayloadLengthStatic       //
  vCheckStaticPayloadLength_x = "T";            //
else                                     //
  vCheckStaticPayloadLength_x = "F";            //
end;                                     //
```

**Payload Length Range Checks**

The check CheckReceivedPayloadLength_x checks whether the value in the *fPayloadLength* field of a frame is consistent with the number of payload segment bytes actually received by the communication controller. The variable *vCheckReceivedPayloadLength_x* denotes the result of the check for the respective communication channel.

```
if ((2 * fPayloadLength_x ) == vPayloadBytesReceived_x)    //
   vCheckReceivedPayloadLength_x = "T";                    //
else                                          //
   vCheckReceivedPayloadLength_x = "F";                  //
end;                                          //
```

In the pseudocode above, the variable *vPayloadBytesReceived_x* represents the number of bytes actually received in the payload segment of the frame received on channel x.

**Version 5 Solution:**   FPGA V5 does not actually do an explicit payload length check. This check is implicit in the frame reception mechanism, however – a short frame would generate a NRZ 8N1 coding error, and a long frame would fail the idle check at the end of the frame.

## Cycle Counter Checks

The check CheckCycleCountMatch checks whether the cycle count values received on the respective communication channels within one communication slot are identical. The variable *vCheckCycleCountMatch* denotes the result of the check.

```
if fCycleCount_A == fCycleCount_B              //
   vCheckCycleCountMatch = "T";                //
else                            //
   vCheckCycleCountMatch = "F";                //
end;                            //
```

The check CheckCycleCount_x checks whether the received cycle count value *fCycleCount_x* matches the communication controller's current view of the cycle count contained in the variable *vCycle*. The variable *vCheckCycleCount_x* denotes the result of the check for the respective communication channel.

```
if fCycleCount_x == vCycle                 //
   vCheckCycleCount_x = "T";               //
else                          //
   vCheckCycleCount_x = "F";               //
```

```
end;                                         //
```

The check CheckCycleCounterEven_x checks whether the received cycle count value *fCycleCount_x* is even. The variable *vCheckCycleCounterEven_x* denotes the result of the check for the respective communication channel.

```
if (fCycleCount_x mod 2) == 0               //
   vCheckCycleCountEven_x = "T"              //
else                             //
   vCheckCycleCountEven_x = "F";        //
end;                             //
```

**NullFrameChecks**

The check CheckNullFrame_x checks whether the received frame was a null frame, i.e., a frame with the Data Update Bit field set to zero. The variable vCheckNullFrame_x denotes the result of the check for the respective communication channel.

```
if fDataUpdateBit_x == 1                     //
   vCheckNullFrame_x = "T";                  //
else                             //
   vCheckNullFrame_x = "F";         //
end;                             //
```

**Frame Timing Checks**

The check CheckT_RW1_x checks whether the time reference point of the frame on channel x was received within the receive window *pdT_RW1*. The variable *vCheckT_RW1_x* denotes the result of the check for the respective communication channel.

```
   if (((vtExpectedTRP - pdT_RW1) < vtTimeReferencePoint_x )
AND  //
   (vtTimeReferencePoint_x <= (vtExpectedTRP +pdT_RW1)))
   //
   vCheckT_RW1_x = "T";                            //
else                                     //
   vCheckT_RW1_x = "F";                            //
```

```
end;                                              //
```

In the pseudocode above, the variable *vtExpectedTRP* represents the expected time of reception of the frame's time reference point. A single parameter is used to express the expected arrival time on both channels. This assumes that the expected time reference point of frames on both channels is identical, implying that any channel-specific delay time corrections are applied to the received reference point times prior to any testing. The variable *vtTimeReferencePoint_x* represents the actual arrival time of the reference point of the frame on channel x, as measured by the local clock.

**Channel Idle Detection**

The mechanism for the detection of channel idle depends on the characteristics of the physical layer. In particular, the idle detection method is different for 2-State physical layers (which have states of '1' and '0') than it is for 3-State physical layers (which have states of '0', '1', and "medium idle").

The following sections define the idle detection mechanisms for these different types of physical layers.

**Channel Idle Detection for 3-State Physical Layer**

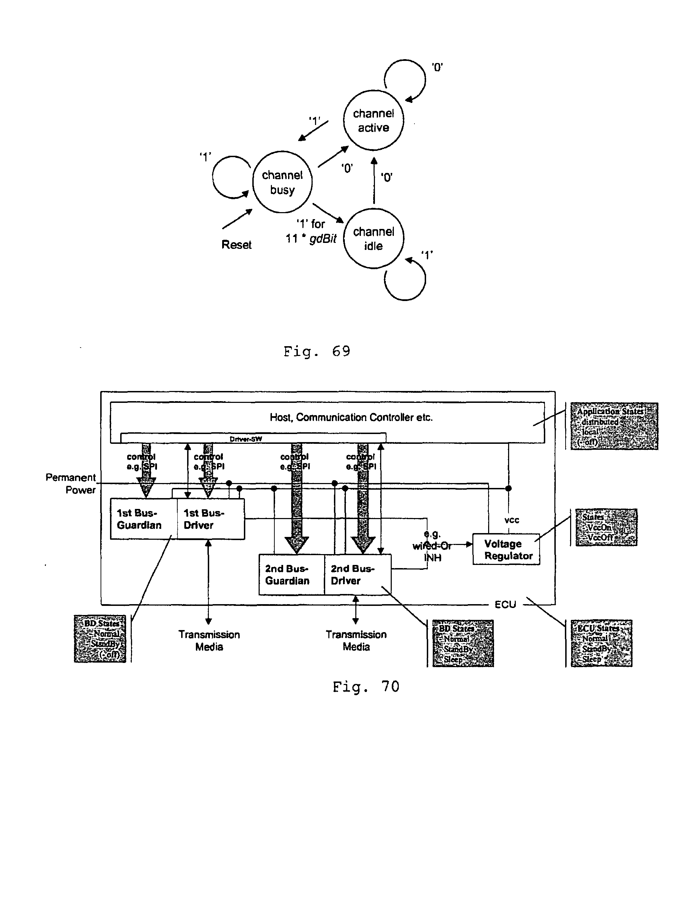

3-State physical layers have a specific state for "medium idle". Channel idle shall be detected if the "medium idle" state is signaled continuously for at least 1 * *gdBit*. This idle detection mechanism is independent of the coding method. This is in contrast to idle detection for the 2-State physical layer which is coding method-dependent. Figure 68 shows the specifics of the 3-State idle detection mechanism.

**Channel Idle Detection for 2-State Physical Layer**

**Comment:** Channel idle detection for 2-State physical layers is coding method-dependent. Currently the only defined coding method is NRZ 8N1. As additional coding methods are added to the protocol addition coding specific sections will be added to this section.

2-State physical layers do not have a state that signals that the medium is idle, and thus must base their idle detection mechanisms on the data levels available on the medium. The particular idle detection mechanisms are coding method-dependent, and are defined in the following sections.

**2-State Physical Layer with NRZ 8N1 Coding**

For 2-State physical layers using the NRZ 8N1 coding method, channel idle shall be detected if the '1' state is signaled continuously for at least 11 * *gdBit*. Figure 69 shows the specifics of the 2-State NRZ 8N1 idle detection mechanism.

**Comment:** Is a coding method other than NRZ 8N1 possible? How is bus idle detection performed in the case of a 2-State physical layer and a new coding method?. It is likely that the NRZ 8N1 idle detection mechanism would work in all cases. Depending on the coding method a shorter check may be possible, however.

**Channel Idle Checks**

The check CheckIdleBeforeReception_x checks if the channel idle detection state machine is in the channel idle state before a transition into the frame reception state occurs.

The check CheckIdleAfterReception_x checks if the channel idle detection state machine is in the channel idle state after the expected end of a frame. The expected end of frame is derived from the payload length field of the frame.

Example: When using NRZ8N1 coding the expected end of frame is the last stop bit of the last CRC byte.

**Symbol checks**

The check CheckNormalSymbol_x checks if an SOC Normal symbol is received on the respective channel. This check is only applicable for systems in the FlexRay pure dynamic or byteflight compatibility mode. The check passes if

- the check CheckIdleBeforeReception_x passes, and

- a continuous sequence of logic '0' samples with a duration between $28.5 * gdBit - 31.5 * gdBit$ are received.

The check CheckAlarmSymbol_x checks if an SOC Alarm symbol is received on the respective channel. This check is only applicable for systems in the FlexRay pure dynamic or byteflight compatibility mode. The check passes if

- the check CheckIdleBeforeReception_x passes, and

- a continuous sequence of logic '0' samples with a duration between $18.5 * gdBit - 21.5 * gdBit$ are received.

The check CheckCollisionAvoidanceSymbol_x checks if a collision avoidance symbol is received on the respective channel. This check is only applicable for systems in the FlexRay pure static or mixed static/dynamic mode. The check passes if

- the check CheckIdleBeforeReception_x passes, and

- a continuous sequence of logic '0' samples with a duration between 28.5 * $gdBit$ – 31.5 * $gdBit$ are received.

**Chapter I**

**FlexRay Acknowledgement Service (FAS)**

**General**

- Acknowledgment is not required for V5.

- Acknowledgement must be discussed together with a functional network management and other diagnosis services like link diagnosis.

**Potential**

The FlexRay acknowledgement service is an optional and configurable service that could be used for the following functions

- Link diagnosis (outgoing, incoming, local, remote)

- Communication channel and star diagnosis

- Frame transmission acknowledgement

- Support of data consistency protocols which have to be established on application level

- Functional network management services

**General Description**

* The acknowledgement service is a diagnosis service for the communication subsystem. It can be exploited by the application according to the safety requirements of the overall application system. It is designed to provide basic data transmission status information throughout the distributed communication subsystem.

* The acknowledgement service is based on individual data frames, not on nodes.

* The basic diagnosis procedure is the status information of the correct reception of an a-priori known frame identifier in combination with the acknowledgement of the application. This can be configured.

* The acknowledgment service does not evaluate the content of the frame itself. This has to be done in the application and given to the acknowledgement protocol service.

* It is assumed that every frame identifier is transmitted periodically.

* The application can lookup status information on whether sent frames have been received by other communication controllers correctly, i.e. the sender's view. The receiver's view provides status information on whether received frames have also been received correctly by other communication controllers.

* The acknowledgement service is an optional and configurable protocol service.

* Several groups of related frames can be established.

* The acknowledgment status information can be overruled by the application (invalidated or validated).

* The acknowledgment service is individually executed for each channel. It is therefore possible to retrieve status information on every individual frame on every individual channel.

* The service can be applied for frames in the dynamic part. Therefore it can be checked whether specific dynamic frames have been sent within a round.

**Frame Format**

**Header**

Two bits indicate the length of the acknowledgement vector which will be transmitted in the frame body (see Frame Format in Section xxx):

Table 30:

| Acknowledgment Header Field | | | |
|---|---|---|---|
| AckBit A1 | AckBit A0 | AckVector length | Remark |
| 0 | 0 | 0 bit | No acknowledgement configured |
| 0 | 1 | 8 bit | |
| 1 | 0 | 16 bit | |
| 1 | 1 | 24 bit | |

**Open Topic:** The header information for acknowledgement can be reduced to a single bit indicating the presence of an configured acknowledgement vector within the frames.

**Frame Body**

According the two bits in the frame header 0...3 bytes of the acknowledgement vector ( or according the configuration and the single indicating bit in the header.

Table 31:

| Frame Formats | | | | | | | | | | |
|---|---|---|---|---|---|---|---|---|---|---|
| Header | | Frame Body | | | | | | | | |
| A1 | A0 | Byte | 0 | 1 | 2 | 3 | 4 | 5 | 6 | ... |
| 0 | 0 | | MsgId | MsgId | Data 0 | Data 1 | Data 2 | Data 3 | Data 4 | ... |
| 0 | 1 | | MsgId | MsgId | Ack Byte 1 | Data 0 | Data 1 | Data 2 | Data 3 | ... |
| 1 | 0 | | MsgId | MsgId | Ack Byte 1 | Ack Byte 2 | Data Data 0 1 2 | | Data | ... |
| 1 | 1 | | MsgId | MsgId | Ack Byte 1 | Ack Byte 2 | Ack Byte 3 | Data 0 | Data 1 | ... |

**Algorithm**

**Conventions**

On every node a set of ID's of related frame identifiers can be configured which is called an acknowledgement group. Several groups can be established depending on the implementation. Each ID should be assigned to only one group in order to get a consistent acknowledgement matrix.

Every acknowledgment group is defined by an acknowledgment group vector. The acknowledgment group vector is an ordered list of frame identifiers. Every entry of the acknowledgement group vector is set of {ID, Channels, Direction}. ID specifies the frame identifier, Channels specifies one or more channels on which the ID is broadcast, Direction specifies if the ID is either sent (TX) or received (RX).

Every communication controller collects status information on the correct reception of group members in a so-called local status vector (LocStatVec).

The application status vector (ApplStatVec) is controlled by the application. Each bit of this vector reflects the application view of a specific ID.

The acknowledgement status vector (AckStatVec) is derived from the LocStatVec and the ApplStatVec.

Every communication controller holds a local acknowledgment matrix (AcknMat) for every group. Line i of the acknowledgment matrix holds the last acknowledgment status vector of frame IDi, i.e. its local view of frame status before sending. Therefore it is called the external status vector (ExtStatVec). Column j represents the (collected) global status vector (GlobalStatVec) on frame IDj over all group members.

**Fehler! Keine gültige Verknüpfung.**

**Table 32:** Acknowledgement matrix of an acknowledgement group

**Basic Principle**

The communication controller checks the correctness of incoming frames and marks the specific ID flag in the LocStatVec.

Before sending the local status vector along with a specific frame, the local status vector can be combined with the application status vector (ApplStatVec). The combination procedure can be defined to be AND, OR, or PURE. The AND combination with the ApplStatVec acknowledges only frames which are proved correctly by the communication controller and the application. The OR combination with the ApplStatVec acknowledges either frames proved correctly by the communication controller or the application, i.e. the application can overrule the local view of the protocol. The PURE combination completely fades out the local view of the protocol.

The ExtStatVec is cleared at the beginning of each cycle.

The resulting global status vector for every frame is stored in the last global status vector at the end of the cycle to present consistent status information to the application. (Please note that the acknowledgment matrix is permanently updated during the communication cycle).

**Open Topic:** Since the acknowledgement matrix is updated during every cycle a shadow buffer concept must be established in order a transmit a consisting view.

**Extensions**

**Static and Dynamic Communication**

Static and dynamic frames can be included in the acknowledgment scheme. It has to be guaranteed, that dynamic frames are sent once in a communication cycle. For dynamic frames the controller has to detect, if a certain frame is not sent in the dynamic part, i.e. its min-slot is empty.

**Multiplexed Communication**

The Acknowledgement Diagnosis Service for multiplexed communication in the sense that one slot is multiplexed between several nodes is not supported.

**Multi-Channel Communication**

The acknowledgment group vector holds information on the respective communication channel. It is therefore possible to retrieve status information on every individual frame on every individual channel.

**Integrity Level Counters**

Every global status vector can be combined with an alpha-counter, the so-called integrity level counter. To be defined later.

**Agreement Service**

There is no agreement mechanism to provide a consistent view of the global status vector within fault-free nodes. Nevertheless, the global status vector provides a cluster wide snapshot of the individual views of all communication partners. If the local view of a specific frame differs from the global view, the application decides if it uses its content.
It is the philosophy of the FlexRay acknowledgement service to provide sufficient status information, but to refrain from implementing higher-level agreement and consistency protocols. The requirements for such mechanisms are highly application dependent and should therefore not be implemented in the communication protocol.

**Chapter J**

**Operation Modes and HW States (not V5)**

**FlexRay Node**

**Concept**

**Hardware Modules and their Operation Modes**

*Assumption*

A FlexRay node consists of several modules

- CC and host (and the software)

- one BD at least

- one voltage regulator at least

- optional one or two BG

Each of this module supports several operation-modes (states) which cause the operation modes (states) of the node.

Figure 70 shows a block chart of a FlexRay node and operating modes (states) of each module. Each of the modules is integrated into a main control loop. Starting from the ECUs sleep-mode we can find:

**Wake-up:**

- stable state (sleep-mode of the ECU)

    - the voltage regulator is off

    - the host is not powered

    - the BD monitors the bus to detect the wake-up sequence

- if the wake-up sequence is recognised by the BD or a local wake-up signal is set, the BD activates the voltage regulator by a suitable control signal (e. g. INH)

- the host is powered by the voltage regulator

- the host does his job

- ...

**Sleep:**

- the sleep request is acknowledged by a NM protocol running on the host

- each host initiates synchronous the shutdown of the communication system or communication subgroup (selective sleep) by de-activating the CC and BG by a suitable control signal (e.g. SPI - StopCom)

- the host de-activates the BD by a suitable control signal (e. g. SLPN or SPI)

- the BD de-activates the voltage regulator and monitors the bus

- stable state (sleep-mode of the ECU)

    - see 1st dot

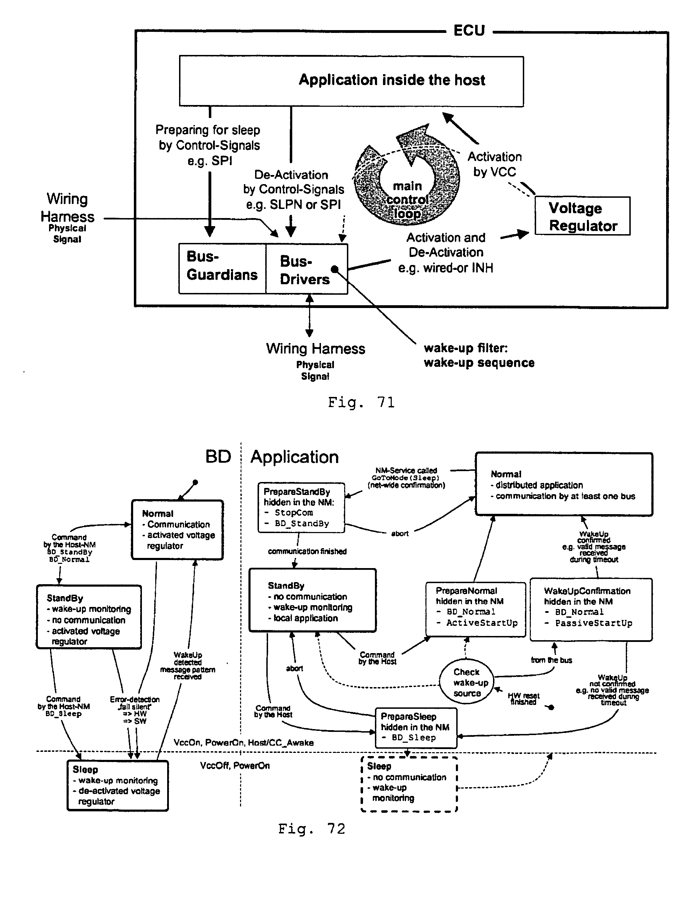

Figure 71 shows operating modes of a FlexRay ECU regarding HW and HW controlling.

**Operating Modes of the Application and their Controlling**

Proposal each ECU supports 3 operating modes (states):

- Normal

    - one bus is active at least
    - distributed application active

- StandBy

    - each bus is inactive
    - local application active or in-active
    - one voltage regulator is active inside an ECU at least

- Sleep

- the application is inactive
- the host is not powered
- the ECU is powered

**Operating Modes of the Application and the corresponding HW**

This chapter describes the ECU as a state transition chart combining host, voltage regulator(s) and the bus driver(s).

*Assumptions*

- the NM manages the operation modes of the node and the net supported by net-wide negations

- a wake-up from the bus has to be confirmed

  - to be protected against e. g. electromagnetic interference

  - by the CC-driver-service "PassiveStartUp"

- a sleep command has to be confirmed

  - to be protected against unstable states of the net

  - by a NM-service "GotoMode(Sleep)"

- the source of a wake-up event has to be detected

- to be able to start suitable confirmation procedures

Figure 72 shows operating modes (states) inside a FlexRay node, whereby dotted arrows state transitions specific to the application.
A typical operation cycle from the ECU will work in the following way:

- stable state (sleep-mode of the ECU)

  - the voltage regulator is off

  - the host is not powered

  - the ECU is powered

  - the BD monitors the bus to detect any wake-up sequence

- if the BD detects any wake-up sequence

  - the BD switches to normal mode

  - the BD switches the voltage regulator to VccOn

  - the host (and the CC) will be powered

- after finishing the reset procedure the host detects the wake-up source

- a detected wake-up from the bus activates the WakeUpConfirmation Mode hidden in the NM

  - the bus wake-up could be caused by any electromagnetic interference

- the host-NM makes the CC to start-up the net passively ("PassiveStartUp")

  - just valid communication on the bus make the CC to participate in the start-up

- if the CC is able to start-up the net, the host can do his distributed job

- ...

- to finish the distributed job, the host has to wait for a net-wide negotiation (in case of selective sleep: sub-net-wide negotiation) result activated by a NM-service "GotoMode(Sleep)"

- as soon as the net confirms this sleep-request, the CC has to stop the communication ("StopCom") and the BD has to pass the bus to the low-power state ("BD_Standby")

  - hidden inside the NM

- Hint: the state transition from Normal to Standby can be aborted e. g. when receiving an urgent application request

- if having finished the net-communication the host can do his local job

- ...

- to re-activate the distributed job, the host has to make the CC to start-up the net actively ("ActiveStartUp")

  - valid communication can be detected by all the other nodes
  - they can participate in the distributed start-up

- to finish the local job, the host has to

  - switch the BD to its sleep mode ("BD_Sleep")

  - wait for the power de-activation

- **Hint:** the state transition from Standby to Sleep can be aborted e. g. when receiving an urgent application request

- stable state

  - see 1st dot

**FlexRay Active Star**

**Expected Behavior**

***without a CC and without a host***

- · active if

  - a message pattern was received

- · fail silent

  - e.g. in case of a permanent bus busy on one branch

- · passive if

  - no message pattern was received during a predefined time-out

*with a CC and with a host*

- · according a FlexRay node

**Bus-Wake-Up**

**Concept**

**Wake-up via the bus**

The FlexRay CC supports a dedicated wake-up sequence. The wake-up sequence is sent out once before the startup of the protocol for a defined duration. The sending of the wake-up sequence is initiated by the host and generated by the CC. The wake-up sequence is detected by the BD. Different wake-up sequences for optical and electrical physical layers due to robustness of the wake-up detection in the BD are supported.
The CC can be configured for active wake-up (initiate wake-up) and passive wake-up (only wake-up if initiated by other nodes).
The unintended sending of the wake-up sequence during normal operation must be prohibited.

**Selective Bus Wake-Up Filter**

not required

**Bus Wake-Up Filter inside the BD**

TBD

**Bus Wake-Up Filter outside the BD**

The BD will not be able to prevent a node being waked-up by any kind of noise. In this case the node will be powered and the software will start-up.
To ensure the operation robustness just valid communication should be able to start-up the networked system.
    **Requirement:** A node has to confirm a bus-wake-up request.
    **Requirement:** A node may start-up the networked communication actively after having confirmed the bus-wake-up request.
    **Definition:** "confirmed bus-wake-up request": valid message

**Bus Wake-Up Filter inside the CC**

The CC has to support the confirmed wake-up.
    **Requirement:** the CC has to support 2 start-up procedures:

1. active start-up
2. passive start-up

    **Requirement:** The active start-up procedure may initialize the start-up of the network by sending dedicated messages.
    **Requirement:** The passive start-up procedure may not initialize the start-up of the network.
    **Requirement:** The passive start-up procedure may participate actively in the start-up when receiving start-up messages.
    **Requirement:** The passive start-up has to be aborted if no start-up message was received during a time-out
    **Explanation:** If a transient interference wakes up the BD, each node will activate the passive start-up procedure. No valid message can be received by any node. Each passive start-up will be aborted after the time-out.
    **Explanation:** If at least one node activates the active start-up the start-up of the networked system will run perfect.

**Bus Wake-Up Filter inside the Host**

The host has to prevent the networked system from being activated by wake-up interference passed the BD. **Requirement:** the host has to detect two states:

1. the host received a confirmed wake-up event - it has to select the active start-up procedure of the CC
2. the host received a non-confirmed wake-up event - it has to select the passive start-up procedure of the CC

**Optical wake-up scheme (byteflight compatible)**

In order to support the wake-up method of byteflight optical transceivers for waking up a byteflight network on the one hand the generation of wake-up pulses and on the other hand recognition of activity on the Receiver input (Logic "L" on RX Pin connected to transceiver) and generation of a wake-up interrupt for the host must be supported.

**Stand-by mode and wake-up of the optical transceiver modules**

The transceiver modules have the operating states "active" and "stand-by". In the active state, SOC symbols at least are transmitted via the bus. In the "stand-by" state, only the receiver is active in the transceiver modules; the rest of the circuit is switched off to save power.

When the transceiver module is switched on, i.e. when the operating voltage is present, the transceiver modules are initially in the "active" state.

The transition from the active state to the stand-by mode takes place if no bus activities are detected via the optical or electrical input for a length of cdOptSleep which is defined as t_sleep in the transceiver specification. In a pure dynamic system this is initiated by the SOC master switching off the SOC symbols.

Transition from the "stand-by" state to the "active" state of the transceiver modules takes place when a High-Low transition is detected at the electrical data input (connected to TX of a communication controller) input or when the following wake-up pulse is received via the optical fiber cable. The necessary duration of cdOptWake-up refers to one optical connection, e.g. from a node to the star coupler and its value is given in the transceiver specification.

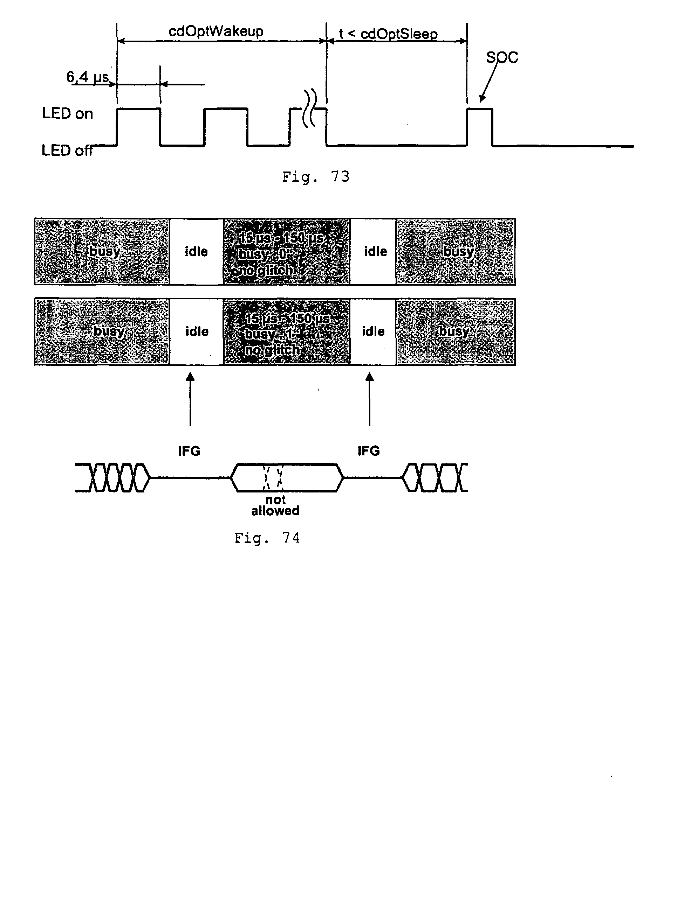

Figure 73 shows an optical wake-up pulse.

The wake-up pulses are generated by the bus controllers. For this purpose, one μC starts the generation of these pulses and, after a specified time, switches them off again, the duration of the pulses thus being under the control of the μC.

Once the wake-up pulse has been switched off or the operating voltage for the transceiver modules has been switched on, the bus master must start transmission of the sync pulses within cdOptSleep to prevent the transceivers from switching back into "stand-by" mode.

In order to support this wake-up method a node is able to generate wake-up pulses. For this purpose, a host may start the generation of these pulses and, after a specified time, switches them off again, the duration of the pulses thus being under the control of the host. Wake-up pulses are continuing, alternating pulses with 6,4 μs logic 'High' and 6,4 μs logic 'Low' levels as shown in the figure above.

Once the wake-up pulse has been switched off or the operating voltage for the transceiver modules has been switched on, the SOC master or cold-start node must start bus activity within to prevent the transceivers from switching back into "stand-by" mode.

The generation of wake-up pulses must be protected against unintended initiation by the host.

The Generation of wake-up pulses may be initiated for each channel separately and only for at most one of the two channels at the same time in order to prevent the occupation of both channels by wake-up pulses in an error case.

**Electrical wake-up scheme**

Figure. 74 shows an electrical wake-up pulse.

The wake-up scheme for electrical physical layer have to be defined. Requirements for the wake-up sequence are:

• there must be a clear difference between the wake-up sequence and every normal message/SOC.

• the wake-up sequence should be unequal as possible from signals generated by disturbance, e.g. EMC.

• the wake-up sequence must be robust against disturbance e.g. EMC

- the bus driver shall not be woken by normal bus activity

**Proposal for the wake-up sequence:**

Proposal #1 (see Figure 74):

- busy

- idle during TBD (e.g. IFG)

- busy permanent "0" or permanent "1" without any glitch

- idle during TBD (e.g. IFG)

- busy

- wake-up during the last "busy"-detection

Proposal #2:

- idle during TBD (e.g. IFG)

- busy permanent "1"

- idle during TBD (e.g. IFG)

- busy permanent "0"

**Service Proposal supported by the SW**

**GotoMode**

Service name: **GotoMode**

Parameter (In):

- NetId Addressed communication network

- NewMode operating mode to be set.

Parameter (Out): none
Description: The NM-service GotoMode serves to set the operating mode specified by <NewMode>.
Particularities: none
Status:
Standard:

**StartUp**

Service name: **StartUp**
Parameter (In):

- type: active or passive

Parameter (Out):
Description: This CC-driver-service starts up the protocol - it makes the CC to start-up the protocol.
Particularities: The service must support 2 behaviors:

- active: initializing the global start-up by sending messages

- passive: participate in the global start-up, time-out monitored

- This service is used by the NM, hidden from the application.

Status: none

**Service Proposal supported by the CC**

**StopCom**

Service name: **StopCom**
Parameter (In):
Parameter (Out):

- communication stopped

Description: The CC stops to send messages after finishing the current communication cycle.

- The service must work with several behaviors:

  - to support the fault-free communication (finish the current communication cycle, do not start the next cycle)

  - to support a faulty communication (stop the communication when there is no traffic on the bus (timeout parameter))

  - to support the recognition of a re-start command (CancelStopCom)

**CancelStopCom**

Service name: **CancelStopCom**
Parameter (In):
Parameter (Out):
Description: The CC does not stop to send messages after finishing the current communication cycle.

**RequestSleep**

Following service is only required for NM support of the protocol:

Service name: **RequestSleep**

Parameter (In):

Parameter (Out):

Description: The CC set the request for sleep bit in the frame header

**CancelRequestSleep**

Following service is only required for NM support of the protocol:

Service name: **CancelRequestSleep**

Parameter (In):

Parameter (Out):

Description: The CC reset the request for sleep bit(s) in the frame header

**Bus-Shut-Down**

**Objectives**

According the state of the art, a shutdown of the communication system has to be synchronized among the networked nodes and controlled by the application.
Assumptions:

- an adapted NM synchronises the bus-shutdown timing among the nodes

- an dedicated FlexRay service does finish the communication

TBD:

- Support of the NM by a special protocol service

**Concept**

The shutdown of the whole communication system or of a selected subgroups of nodes has to be synchronized among the networked nodes. The NM executed by the host, synchronize and control the protocol shutdown. If a shutdown command is signaled to the CC, the CC stops to send messages after finishing the current communication cycle.

**TBD: NM support by the protocol**

Protocol service for the NM to synchronize the shutdown of the communication system or subgroups of nodes. As a benefit of this service the number of receive buffers and the code size of the NM can be reduced.
Assumptions:

- Use of one reserved bit in the header as sleep indication flag, which signal a sleep request by the sending node.

- Possibility to define a configurable sleep group in the CHI of the CC, e.g. selected frame IDs.

- Sleep acknowledge interrupt, which is set if all nodes in a sleep group set there sleep indication flag.

**Principle of operation:**

A node could signal by setting the sleep indication flag a request to shutdown the communication system or the sleep group, which it belongs to. Every node has configured in the CHI his sleep group by defining a set of frame IDs. If in all configured frame IDs the sleep indication flag is set, the CC rise his sleep acknowledge interrupt to the host. The shutdown of the CCs must now initiated synchronous by each host.

**Service Proposals supported by the SW**

**GotoMode**

Service name: **GotoMode**
Parameter (In):

- NetId Addressed communication network

- NewMode operating mode to be set.

Parameter (Out): none
Description: The NM-service GotoMode serves to set the operating mode specified by <NewMode>.
Particularities: none
Status:

Standard:

**StopCom**

Service name: StopCom
Parameter (In): none
Parameter (Out): none
Description: This CC-driver-service stops the communication via the bus by a algorithm confirmed by the protocol - it makes the CC to stop the communication after finishing the current communication cycle.
Particularities: This CC-driver-service has to support the recognition of a re-start command e. g. from the bus

- This service is used by the NM, hidden from the application.

Status: none

**CancelStopCom**

Service name: **CancelStopCom**
Parameter (In): none
Parameter (Out):
Description: This CC-driver-service cancels a current service StopCom
Particularities: This service is used by the NM, hidden from the application.
Status:

Advantages StopCom

- simple behavior inside the protocol in a perfect net

- a master-driven behavior can be realized a distributed multi-slave behavior can be realized as well

- BD/BG power modes are handled separately

- the behavior of a NM can be adapted to the application requirements easily

Disadvantages StopCom

- the BusSleep agreement has to be done by other layers

  - e.g. by the NM service GotoMode

- the limp-home behavior inside a faulty net has to be specified

**Service Proposals supported by the CC**

**StopCom**

Service name: **StopCom**
Parameter (In):
Parameter (Out):

- communication stopped

Description: The CC stops to send messages after finishing the current communication cycle.

- The service must work with several behaviors:

  - to support the fault-free communication (finish the current communication cycle, do not start the next cycle)

  - to support a faulty communication (stop the communication when there is no trafic on the bus (timeout parameter))

  - to support the recognition of a re-start command (CancelStopCom)

**CancelStopCom**

Service name: **CancelStopCom**
Parameter (In):
Parameter (Out):
Description: The CC does not stop to send messages after finishing the current communication cycle.

**States and Operating Modes**

**HW States and Operating Modes of the CC**

**Overview**

**Power off**: The communication controller is not supplied, the communication controller must be passive
**Power down**: The controller is supplied, the voltage is too low, the communication controller must be passive
**Power On:** The controller is supplied correctly

- Init (byteflight: SoftReset)

  - supply voltage is detected to support operating

  - initialization data are cleared

  - immediate halt CC clock (except host interface registers) and therefore stop communication abruptly

- Normal

  - Communication is possible

- NormalRequest:

  - The communication controller has to be prepared to reach the state Normal

- ShutdownRequest (byteflight: Sleep)

  - stop all CC clocks except host interface registers;

  - orderly communication shut down by request/acknowledgement protocol

  - configuration data is not available

  - the state can be left by host command

- - StandBy (byteflight: PowerSave)

  - on demand of the host

  - in a failure condition

- all CC clocks off, no power consumption except leakage

- configuration data is not available

- the state can be left by any recognised wake-up event or on request of the host

**Example of a CC State Diagram**

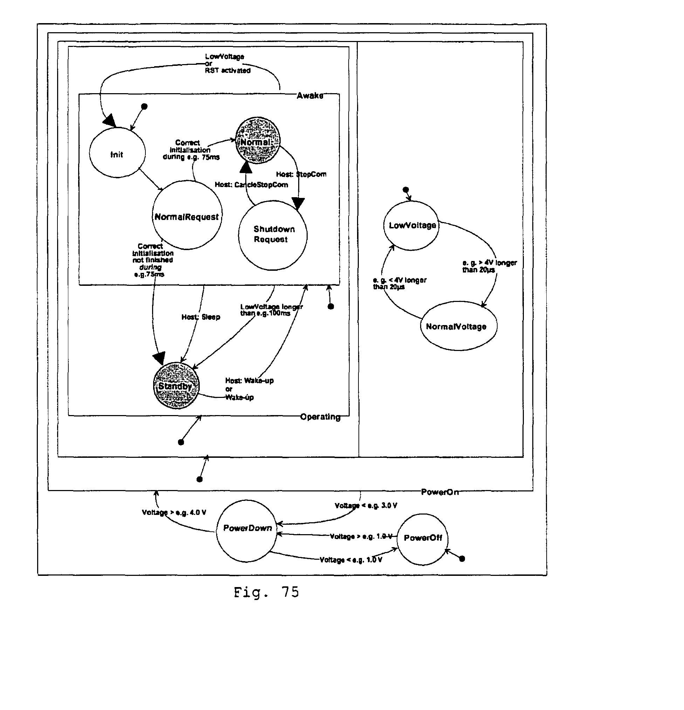

Figure 75 shows an example of a communication controller state transition diagram.

**HW States and Operating Modes of the BD**

**Overview**

Operating modes of the bus driver:
**Power off**: The BD is not supplied, the BD must be passive (no reverse current).
**Power down:** The BD is supplied, the voltage is too low, the BD must be passive (no reverse current).
**PowerOn:** The BD is supplied.

- Awake

  - Init:

    - low supply voltage is detected

  - Normal

    - NOT(Sleep) signaled (e.g., voltage regulator(s) active)

    - communication possible

  - StandBy

    - Not(Sleep) signaled (e.g., voltage regulator active)

    - communication not supported

    - the state can be left on demand of the host

- Sleep

  - on demand of the host

  - in a failure condition

  - Sleep is to be signaled (e.g. voltage regulator passive)

  - communication not supported

  - wake-up monitoring active

  - the state can be left by any recognized wake-up event

  - EmergencyLimpHome

    - on demand of the host

    - Sleep is to be signaled (e.g. voltage regulator passive)

- bus high impedance

- the state can be left just by deactivation and reactivation of the power supply

**Example of a BD State Diagram**

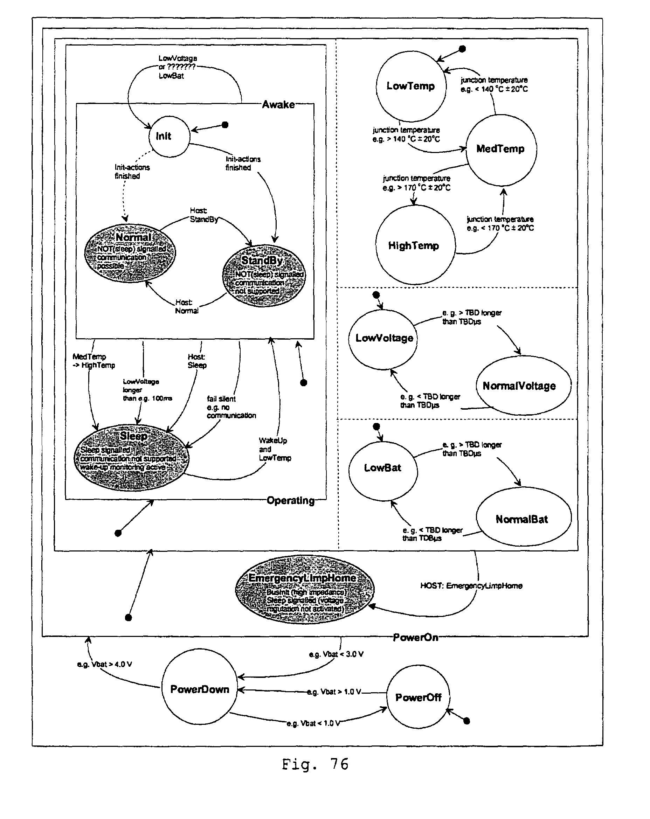

Figure 76 shows part 1 of an example of a bus driver state transition diagram. The bus guardian states are disregarded (see separate chapter)

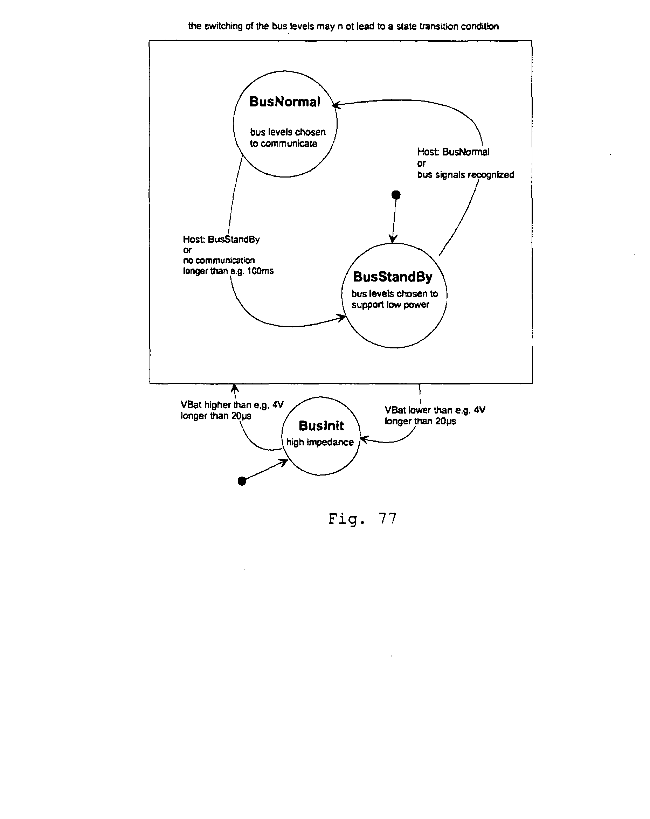

Figure 77 shows part 2 of an example of a bus driver state transition diagram.

**Overview**

**Power off:** The BG is not supplied, the BG must be passive

**Power down:** The BG is supplied, the voltage is too low, the BG must be passive

**Power On:**

- Init

  - low supply voltage is detected

  - initialisation data are cleared

  - immediate halt BG clock (except host interface registers) and therefore stop communication abruptly

- Normal

  - Communication is possible

- NormalRequest

  - The BG has to be prepared to reach the state Normal

- ShutdownRequest

  - stop all BG clocks except host interface registers;

  - orderly communication shut down by request/acknowledgement protocol

  - configuration data is not available

  - the state can be left by host command

- StandBy

  - on demand of the host

  - in a failure condition

  - all BG clocks off, no power consumption except leakage

  - configuration data is not available

  - the state can be left by any recognized wake-up event or on request of the host

Comment:

The StopCom command of the host has first to be send to the BG and second to the CC. If after the StopCom command the ARM signal is not longer send by the CC, the BG is set to the ShutdownRequest state.

The CancleStopCom command of the host has first to be send to the BG and second to the CC. After the CancleStopCom command is received the BG enter Normal state. The sending of the ARM signal by the CC restarts the BG functions.

**Example of a BG State Diagram**

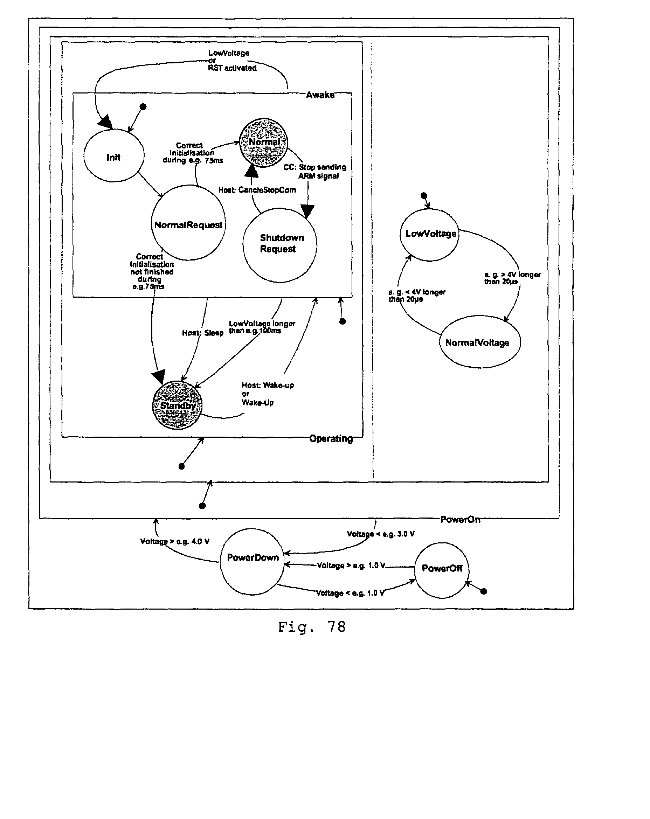

Figure 78 shows an example of a BG state transition diagram.

**Shutdown and Wake-Up handled by the OSEK-NM**

**Concept**

**OSEK-NM inside FlexRay**

Requirements

- A FlexRay system needs functionality comparable to the OSEK-NM ones

  - network-wide synchronized shutdown
  - network-wide consistency check (confirmed shutdown)

Assumption

- integration of an adapted OSEK-NM into FlexRay

  - some NM API services are implemented in FlexRay

Implementation of OSEK-NM

- Software of direct OSEK NM

- S-Class model 98 body control network

- 1.5 - 1.7 kByte ROM

- 4 - 8 Byte RAM

- 1% bus load (10 messages at 1ms per second - stable state of the ring)

Advantages

- the behavior is validated

Disadvantages

- FlexRay has to send and receive messages to build a node-oriented monitoring algorithm

  - protocol adaptations

  - bus-load

- the asynchronous OSEK-NM approach does not fit to the FlexRay approach perfectly

**Proposal to support Shut-Down and StartUp**

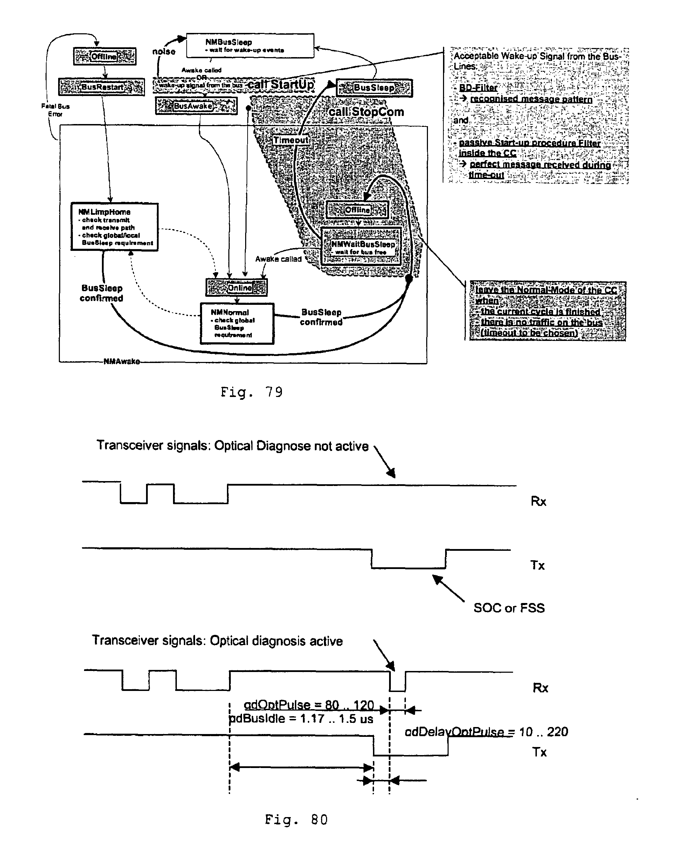

The next figure 79 visualizes the 1st step to adapt the OSEK-NM to be used inside FlexRay. In particular, Figure 79 shows a proposal (lst adaptation step) to implement a shutdown-service and a start-up service (to be called by the application "NM") embedded into the FlexRay protocol the fault-free and the faulty operation has to be taken into considerationfaulty e. g. stop if there is no traffic since TBDfault-free e. g. finish the current cycle and stop

Service to FlexRay

- to start-up the communication actively

- to start-up the communication passively (confirmed wake-up)

- time-out monitored

Service at FlexRay

- to stop the communication when finishing the current cycle

- to stop the communication when there is no traffic on the bus

- to wait for a re-start command from the bus

- to wait for a re-start command from any FlexRay service

FlexRay does not check the consistency of the shut-down service inside the whole network

- task of a higher layer outside FlexRay (e. g. by a suitable NM)

Hints

- Behavior to switch the BD modes is not included

**Appendix K**

**Error Handling and Diagnosis**

**Diagnosis Interface to Physical Layer (byteflight)**

**Optical Physical Layer Diagnosis**

**Overview**

To supervise the quality of the optical connection between two devices to be assessed, the interval between the level of the dark current and the dark current plus the photoelectric current is monitored in the transceiver module. If the interval falls below a certain value (i.e. interval between dark current and dark current plus photoelectric current incorrect) an error bit in the transceiver module is set to '0'. If the interval between dark current and dark current plus photoelectric current is sufficient (optical transmission quality correct), this error bit is reset to '1'.

The optical diagnosis function is only supported by the communication controller if NRZ 8N1 is chosen as coding method and if 10 Mbit/s is chosen as gross bitrate

**Behavior of the Optical Transceiver**

In order to signal the optical diagnosis information the transceiver modules behave as follows:

While the transceiver module is transmitting a SOC symbol or an FSS (frame start sequence) via the LED driver (SOC or FSS is transmitted via Tx Pin of the communication controller), it outputs the state of this error bit at its data out pin which is connected to Rx of the communication controller. The transceiver detects the beginning of the SOC symbol or FSS (frame start sequence) by determining the bus idle state for more than 11 *gdBit and a subsequent 'L' bit to its data input which is connected to Tx of the communication controller. Then the error bit is connected to the data output of the

transceiver for 100 ns. The 100 ns 'L' pulse at the data output starts between 10 ns and 220 ns after the start of the SOC symbol or the frame start sequence at the communication controller's Tx Pin. Detailed timing information may be found in Figure 80 below.

## Behavior of the Communication Controller

Monitoring of the optical connections as described serves as an early warning system for any deterioration in the quality of optical transmission.

The communication controller monitors the optical diagnosis information of the connected transceiver module at the nodes. The communication controller sets a bit in the host interface as soon as the transceiver signals that optical diagnosis is active. The bit may be cleared by the host.

The optical diagnosis information corresponds to the error level "warning".

**Chapter M**

**Bus Guardian**

**Integrated Central Bus Guardian Concepts in FlexRay (not V5)**

**System Concepts**

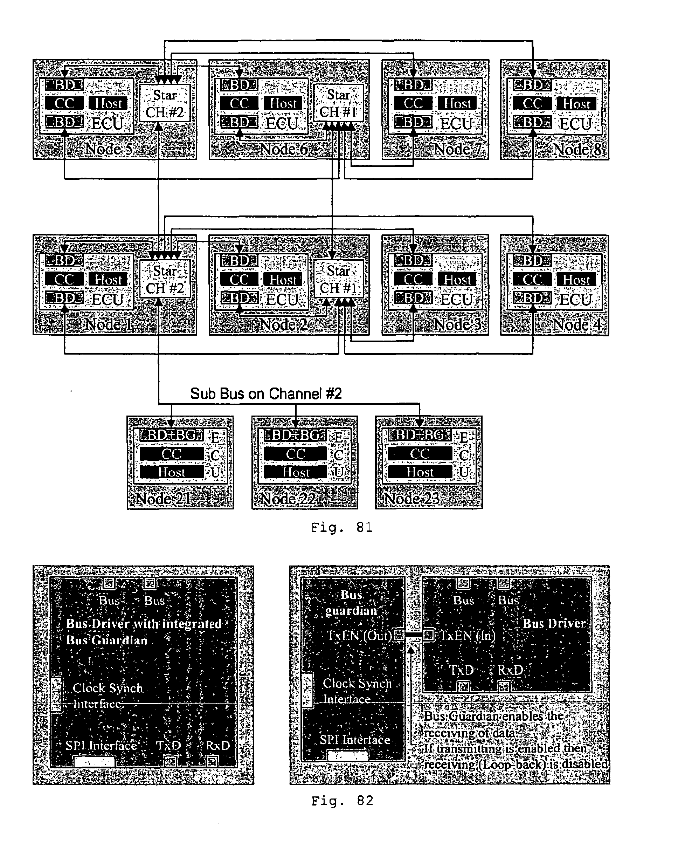

The central bus guardian protects one communication channel against illegal medium access by the connected communication controllers. If a local sub-bus is connected to a branch of a star, the communication controllers could be protected separately by decentral bus guardians. Otherwise a single failure in one communication controller can be led to the failure of the complete branch. The bus guardian and the host in the star are working tightly coupled so that a failure of either the host or the central bus guardian can affect the entire communication channel, but not both channels. In the case of a failure the bus guardian can be configured to close the entire communication or to open the communication for all slots depending on the overall application requirements. Figure 81 shows an example of a system with two cascaded stars and sub-bus on channel #2.

**Basic Concepts**

Two basic concepts are considered:

- Concept A: bus driver with integrated bus guardian

- Concept B: dedicated bus guardian chip.

Comment:

- One advantage of concept A is that nodes on a sub-bus of a branch require the same integrated bus driver with bus guardian.

Figure 82 shows two different concepts: Concept A comprising a bus driver chip with an integrated bus guardian, and concept B comprising a dedicated bus guardian chip.

**Concept A**

**Block Diagram**

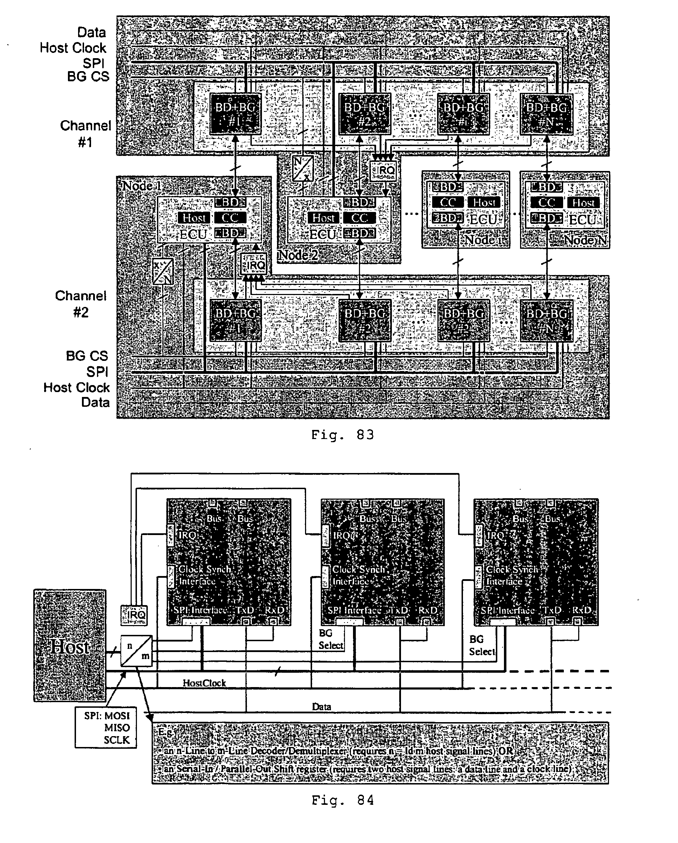

Figure 83 shows a detailed graphic of concept A of nodes containing ECU and integrated bus drivers with integrated bus guardian.

**Bus Guardian Addressing**

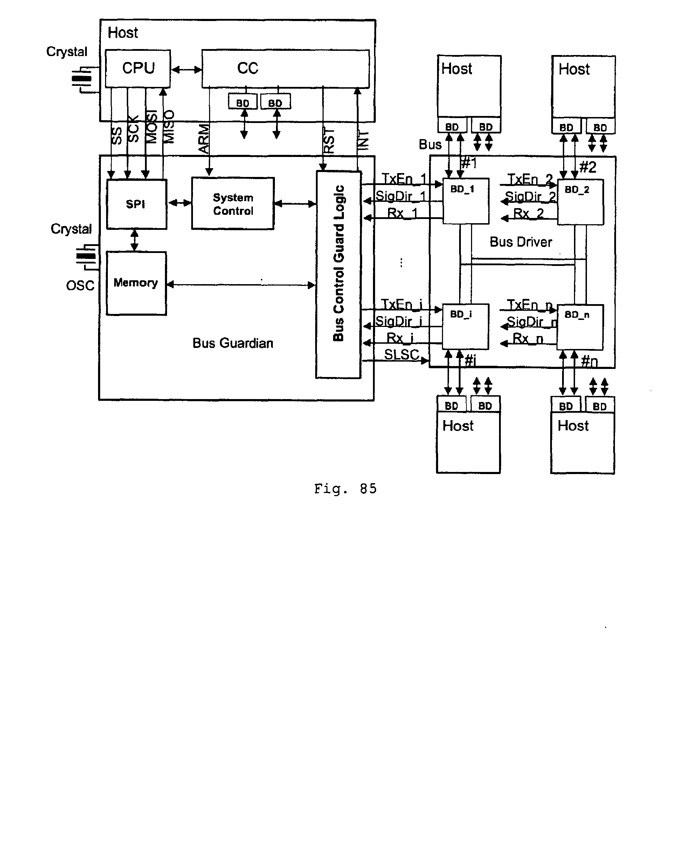

Figure 84 shows a detailed graphic of concept B of nodes containing an ECU and integrated bus drivers with an integrated bus guardian.

**Concept B**

**Block Diagram**

Figure 85 shows the basic architecture of Concept B.

Table 33:

| Signals used in concept B | | | |
|---|---|---|---|
| **Symbol** | **Pin** | **Dir** | **Description** |
| INT | X | O | Interrupt PUSH-PULL output (active LOW) |
| ARM | X | I | Arm signal (active LOW) from CC |
| TXEN_1 | X | I | Enable Reception of Bus Driver #1 (active LOW) |
| RX_1 | X | O | Signals that Bus Driver #1 receives data (active LOW) |
| SigDir_1 | X | O | Signals whether Bus Driver #1 is in direction from outside to inside (active LOW) |
| ... | | | |
| TXEN_n | X | I | Enable Reception of Bus Driver #n (active LOW) |
| RX_n | X | O | Signals that Bus Driver #n receives data |
| | | | (active LOW) |
| SigDir_n | X | O | Signals whether Bus Driver #n is in direction from outside to inside (active LOW) |
| OSC | X | I | Bus Guardian clock input |
| RST | X | I | Bus guardian reset (active LOW) from HOST |
| SS | X | I | SPI select input (active LOW) |
| MISO | X | O | SPI data output |
| MOSI | X | I | SPI date input |
| SCK | X | I | SPI clock input |
| SLSC | X | O | Sleep signal to switch off inhibit at star coupler |

**Functional Description**

**System Controller**

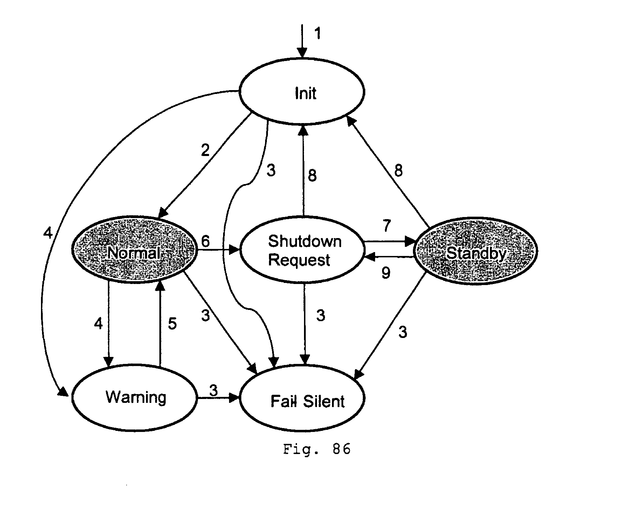

Figure 86 shows a state diagram of the operation modes.

Table 34:

| Signals used in concept B | |
|---|---|
| **Transition** | **Condition** |
| 1 | RST input low, Power on |
| 2 | Configuration finished AND ARM signal |
| 3 | SPI command, entering fail silent mode Initialisation not correct finished |
| 4 | Illegal star coupler access detected (e.g. illegal sending slot, access to the star coupler to long) |
| 5 | Counter expired, tbd |
| 6 | CC: Stop sending ARM signal |
| 7 | Host: Sleep Host: Wake-up Local Wake-up Low Voltage longer than e.g. 100ms |
| 8 | Bus activity detected |
| 9 | Host: CancleStopCom |

**Init Mode**

In the init mode the bus guardian enables the star coupler access for all bus drivers. A monitoring due to the time access schema is not performed, but the access time to the star coupler could be monitored within concept B.

**Normal Mode**

In the normal mode the bus guarding function is enabled.

**Warning Mode**

In the warning mode a illegal bus access has been detected and the responsible bus driver is switched off.

**Fail-Silent Mode**

The fail-silent mode of the central bus guardian shall be configured to disable the star coupler access or to enable for all bus drivers due to safety or availability requirements of the application. Entering the fail-silent mode is only possible via a SPI access. The fail-silent mode can only be left by a reset or power off/on.

**Standby Mode**

In the standby mode the bus guardian (tbd) disables the star coupler access for all bus drivers. The standby mode is intended to switch off the voltage regulator (via falling edge of SLPN output). In the time the bus guardian is still powered any bus detection results in a fall back to the init mode. Further more the inhibit in the bus drivers will be switched on again (via setting SLPN output). The configuration data is only lost in case of power loss. Changing the operation mode via a SPI access is not possible.

**ShutdownRequest Mode**

In the standby mode the bus guardian enables the star coupler access for all bus drivers. On detection of bus activity the bus guardian falls back to init mode. The configuration data is not lost in standby mode. It is also possible to leave the standby mode via a SPI access.

**Startup**

The central BG must enable the communication for all nodes during startup. The bus guardian can be armed when the clock sync has stabilized. This can be handled over the clock sync interface. Arming by the SPI should also be supported.

**Faulty Node during startup - concept B**

By limiting the access time of each #1 input line within concept B a fault that hold a driver busy for longer. To guarantee that no single fault block the startup, the access time of each bus driver is monitored in the initial phase. If a node exceed the maximal allow access time, the bus driver is deactivated.

**Self-test**

tbd, open topic

**Diagnosis**

Diagnosis Data can be transmitted by SPI from the bus guardians to the host. Within concept A the bus guardians must be selected. Either polling or interrupt lines can be used. The hosting ECU with communications controller can transmit the diagnosis data via configured diagnosis frames.

**Configuration**

Configuration data are transmitted via the connected SPI interface from the hosting ECU to the bus guardian (concept B) respectively to the selected bus guardian (concept A).

**Claims**

1.  A network-system with at least one node, whereby the at least one node is coupled to a communication line and with means for communication which are able to create a communication cycle on said communication line **characterized in that** said communication cycle consists at least of a static segment and/or a dynamic segment.

2.  A device, especially a node in a network-system, with means for communication, which are able to create a communication cycle, **characterized in that** said communication cycle consists at least of a static segment and/or a dynamic segment.

3.  A method for creating a communication cycle, **characterized in that** said communication cycle consists at least of a static segment and/or a dynamic segment.

4.  A computer program comprising code means adapted to perform the method according to claim 3, when implemented on a computer.

5.  A computer system product, especially a memory, having a computer program according to claim 4 embodied therein.

## Application Layer

## Presentation Layer
- Frame Filtering and Masking
- Frame and Status Handling

## Transfer Layer
- Fault Confinement
- Error Detection and Signalling
- Message Validation
- Message Framing
- Communication Cycle
- Synchronization
- Transfer Rate and Timing

## Physical Layer
- Fault Confinement
- Error Detection and Signalling
- Error Confinement in Time Domain (Bus Guardian)
- Signal Level and Bit Representation
- Transmission Medium

Fig. 1

Fig. 2

Communication Controller
(and Host)

Node A   Node B   Node C   Node D   Node E

Bus
Driver

Channel 1

Channel 2

Active Star

Redundancy

Fig. 3

**Communication cycle**

**Static segment**

**Dynamic segment**

Slot

9

Channel 0 | 1 | 2 | 3 | 4 | 5 | 6 | 7 | 8 | 10 | ...

7

Channel 1 | 1 | 2 | 3 | 4 | 5 | 6 | 8 | 9 | ...

Node A      Node B      Node C      Node D      Node E
ID: 1,5,9   ID: 2,4     ID: 3,8     ID: 2,4,7   ID: 6,10

Fig. 4

## Communication cycle - dynamic system

**Channel 0** | SoC | 1 | 3 | 4 | 5 | 6 | 7 | 8 | 10 | ...

**Channel 1** | SoC | 1 | 2 | 3 | 4 | 5 | 6 | 8 | 9 | ...

| Node A ID: 1,5,9 | Node B ID: 2,4 | Node C ID: 3,8 | Node D ID: 4,7 | Node E ID: 6,10 |

Fig. 5

Fig. 6

**Header 5 Bytes**   **Data 0 ... 246 Bytes**   **CRC Code 3 Bytes**

| Res | Frame ID | Sync | DLC | H-CRC | NF | CYCO | Message ID | Data | CRC |
|-----|----------|------|-----|-------|----|----|----|------|-----|
| 4 | 12 | 1 | 7 | 9 | 1 | 6 | 16 | 0...1968 | 24 |

**Configurable**

Fig. 7

**Header 2 Bytes**   **Data 0 ... 12 Bytes**   **CRC Code (15 Bit) + Frame Completion Bit**

| ID | RES | LEN | DATA | CRC | FCB |
|----|-----|-----|------|-----|-----|
| 8 | 4 | 4 | 0 ... 96 | 15 | 1 |

Fig. 8

Fig. 9

Fig. 10

**Bus Idle**                                                                 **Bus Idle**

| Start Sequence | FlexRay Frame | End Sequence |
| --- | --- | --- |

Fig. 11

communication controller (and host)

Bus Driver

Physical 1:1 Communication Links

Active Star

Redundancy

Node

Fig. 12

communication
controller
(and host)

Bus Driver

passive
bus

Redundancy

Node

Fig. 13

communication
controller
(and host)

Bus Driver

several nodes
connected to one
branch

Redundancy

Fig. 14

**Permanent
Power**

ECU

**Microcontroller
(Host)**

**Communication Controller**

Bus
Guardian | Bus
Driver | Bus
Guardian | Bus
Driver

**Power Supply**

**Bus**          **Bus**

Fig. 15

**Permanent
power**

Active Star

Bus
Driver   o o o  Bus
Driver

**Power Supply**

**Bus**          **Bus**

Fig. 16

Permanent
Power

Control

Parameter          Data

Bus

Fig. 17

Fig. 18

Fig. 19

Fig. 20

Fig. 21

Start triggered by synchronzed timebase

pure static configuration
(available only in FlexRay mode)

Start triggered by synchronzed timebase    Start triggered by synchronzed timebase

mixed static/dynamic configuration
(available only in FlexRay mode)

Start triggered by SOC

pure dynamic configuration
(available in FlexRay and byteflight modes)

Fig. 22

Fig. 23

Fig. 24

Fig. 25

wait time for message after DCT was received:
vdWaitTime = pdWx0Rx + pdWxDelta . vFrameID

Fig. 26

End of last message
vFrameID$_{t-1}$ = 01

possible start of next message
02  03

actual start
of ID = 04

**A:** A_TX_Pin

**B:** A_RX_Pin

**A:** A_Slot_Cnt    01    02  03  04

**B:** B_Slot_Cnt    01    02  03  04

long transmit
slot

pdWx0Rx =
offset to ensure minimum
idle time

transmit
slot

wait time for next message:
vdWaitTime = pdWx0Rx + pdWxDelta · (vFrameID - vFrameID$_{t-1}$)

pdWxDelta = 200 ns
short wait slots

Fig. 27

recognition of
CRC error

start
vdWait-
Time

start
vdWait-
Time

Bus Idle Checksuccessful

**RX**

last CRC Byte

**slot**    4    5 | 6 | 7 | 8 | 9

pdWx0Rx= 900 ns

pdWxDelta = 200 ns

Fig. 28

Fig. 29

Fig. 30

Fig. 31

byteflight Frame 2 + (0 ... 12) + 2 Bytes

1 bit (FCB)

Fig. 32

Fig. 33

Fig. 34

Bus Idle — 10 * gdBit — | — 30 * gdBit — Bus Idle

State "1"    State "0"

Fig. 35

Bus Idle — 20 * gdBit — | — 20 * gdBit — Bus Idle

State "1"    State "0"

Fig. 36

Fig. 37

*pSamplePeriod*

*pGlitchSamples*

**Bus Signal:**
**(glitch filter input)**

**Glitch filter output:**

**Sample Points**

Fig. 38

*pSamplePeriod*

*pGlitchSamples = 2*

**Bus Signal:**
**(glitch filter input)**

**Glitch filter output:**

**Sample Points**

Fig. 39

pGlitchSamples = 1

Bus Signal:
(glitch filter input)

Glitch filter output:

Sample Points

Fig. 40

pVotingOffset = 2

pVotingSamples = 5

Glitch filter output:

Bit edge
detection

Majority Voting

Fig. 41

Fig. 42

Fig. 43

Fig. 44

Fig. 45

Fig. 46

expected frame

Cycle Node m

| Slot 1 | Slot 2 | Slot 3 | Slot 4 |

n-1 | n | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 // n-5 | n-4 | n-3 | n-2 | n-1 | n | 1 | 2

measured time difference f1

measured time difference f2

measured time difference f3

measured time difference f4

received frame

Fig. 47

15
13
11
...
6
-3
-5

$+ \rightarrow 17/2 = 8$

Fig. 48

| | Offset correction 1 | | Offset correction 2 | | Offset correction 3 | | Offset correction 4 |

Rate correction 1

Rate correction 2

Rate correction 3

| cycle 0 | cycle 1 | cycle 2 | cycle 3 | cycle 4 | cycle 5 | cycle 6 | cycle 7 | cycle 8 |

time

Measurement 1

Measurement 2

Measurement 3

Measurement 4

Rate and offset correction value calculation 1

Rate and offset correction value calculation 2

Rate and offset correction value calculation 3

Rate and offset correction value calculation 4

Fig. 49

-gRateCorrectionOut  **0**  +gRateCorrectionOut

Fig. 50

-gOffsetCorrectionOut  **0**  +gOffsetCorrectionOut

Fig. 51

Fig. 52

Fig. 53

Fig. 54

Fig. 55

Fig. 56

EP 1 355 456 A1

Fig. 57

Fig. 58

Fig. 59

Fig. 60

Fig. 61

Fig. 62

Fig. 63

Fig. 64

Fig. 65

Fig. 66

Macrotick

BG-Schedule | ATT | Static slot 1 | IFG | Static slot 2 | IFG | ic slot n | IFG | BG dynamic segment | | WDT | ATT | Static slot 1 |

2ⁿᵈ ARM missing

ARM

BGEN    open    bus access controlled according to schedule    open    closed

ARM expectation time

initial ARM trigger    initial start = cycle start    ARM trigger    cycle start

| ATT | ARM trigger time | | IFG | inter-frame gap | | | tolerance part (1 MT) | | WDT | watchdog disable time |

Fig. 67

channel activity ('0' | '1')

channel active

channel activity ('0' | '1')

'medium idle'

channel busy

'medium idle'

channel activity ('0' | '1')

Reset

'medium idle'

channel idle

'medium idle'

Fig. 68

204

Fig. 69

Fig. 70

## Fig. 71

**ECU**

**Application inside the host**

Preparing for sleep
by Control-Signals
e.g. SPI

De-Activation
by Control-Signals
e.g. SLPN or SPI

**main
control
loop**

Activation
by VCC

**Voltage
Regulator**

Wiring
Harness
**Physical
Signal**

Activation and
De-Activation
e.g. wired-or INH

**Bus-
Guardians**

**Bus-
Drivers**

Wiring Harness
**Physical
Signal**

**wake-up filter:
wake-up sequence**

Fig. 71

## Fig. 72

**BD** | **Application**

**Normal**
- Communication
- activated voltage
regulator

Command
by the Host-NM
BD_StandBy
BD_Normal

**StandBy**
- wake-up monitoring
- no communication
- activated voltage
regulator

WakeUp
detected
message pattern
received

Command
by the Host-NM
BD_Sleep

Error-detection
„fail silent"
=> HW
=> SW

**Sleep**
- wake-up monitoring
- de-activated voltage
regulator

**PrepareStandBy**
hidden in the NM:
- StopCom
- BD_StandBy

communication finished

**StandBy**
- no communication
- wake-up monitoring
- local application

abort

Command
by the Host

NM-Service called
GoToMode(Sleep)
(net-wide confirmation)

**Normal**
- distributed application
- communication by at least one bus

abort

**PrepareNormal**
hidden in the NM
- BD_Normal
- ActiveStartUp

**WakeUpConfirmation**
hidden in the NM
- BD_Normal
- PassiveStartUp

WakeUp
confirmed
e.g. valid message
received
during timeout

Check
wake-up
source

from the bus

HW reset
finished

WakeUp
not confirmed
e.g. no valid message
received during
timeout

Command
by the Host

**PrepareSleep**
hidden in the NM
- BD_Sleep

VccOn, PowerOn, Host/CC_Awake

VccOff, PowerOn

**Sleep**
- no communication
- wake-up
monitoring

Fig. 72

Fig. 73

Fig. 74

Fig. 75

Fig. 76

the switching of the bus levels may n ot lead to a state transition condition

**BusNormal**

bus levels chosen
to communicate

Host: BusNormal
or
bus signals recognized

Host: BusStandBy
or
no communication
longer than e.g. 100ms

**BusStandBy**
bus levels chosen to
support low power

VBat higher than e.g. 4V
longer than 20µs

**BusInit**
high impedance

VBat lower than e.g. 4V
longer than 20µs

Fig. 77

Fig. 78

Fig. 79

Transceiver signals: Optical Diagnose not active

Rx

Tx

SOC or FSS

Transceiver signals: Optical diagnosis active

Rx

adOptPulse = 80 .. 120
pdBusIdle = 1.17 .. 1.5 us

adDelayOptPulse = 10 .. 220

Tx

Fig. 80

Fig. 81

Fig. 82

Fig. 83

Fig. 84

Fig. 85

215

Fig. 86

**European Patent Office**

# EUROPEAN SEARCH REPORT

Application Number

EP 02 00 8171

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 161 786 A (DAHOD ASHRAF M ET AL) 17 July 1979 (1979-07-17)<br>* page 1, line 49 - line 62 *<br>* column 2, line 35 - line 67 *<br>* column 3, line 39 - line 59 *<br>* column 5, line 34 - column 6, line 10 *<br>----- | 1-5 | H04L12/64 |

TECHNICAL FIELDS SEARCHED (Int.Cl.7)

H04L

The present search report has been drawn up for all claims

| Place of search | Date of completion of the search | Examiner |
|---|---|---|
| THE HAGUE | 7 October 2002 | Gregori, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 00 8171

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2002

| Patent document cited in search report | Publication date | Patent family member(s) | Publication date |
|---|---|---|---|
| US 4161786 A | 17-07-1979 | CA 1133154 A1 | 05-10-1982 |
| | | EP 0003849 A2 | 05-09-1979 |
| | | JP 55030291 A | 04-03-1980 |

EPO FORM P0459

For more details about this annex : see Official Journal of the European Patent Office, No. 12/82